(19) Europäisches Patentamt
European Patent Office
Office européen des brevets

(11) EP 4 410 073 B1

# (12) EUROPÄISCHE PATENTSCHRIFT

(45) Veröffentlichungstag und Bekanntmachung des Hinweises auf die Patenterteilung:
**29.10.2025 Patentblatt 2025/44**

(21) Anmeldenummer: **22777265.4**

(22) Anmeldetag: **28.09.2022**

(51) Internationale Patentklassifikation (IPC):
***H10K 85/60*** *(2023.01)* *H10K 50/11* *(2023.01)*
*H10K 101/00* *(2023.01)* *H10K 101/10* *(2023.01)*

(52) Gemeinsame Patentklassifikation (CPC):
**H10K 85/636; H10K 85/633; H10K 85/654; H10K 85/657; H10K 85/6572; H10K 85/6574;**
H10K 50/11; H10K 85/342; H10K 2101/10; H10K 2101/90

(86) Internationale Anmeldenummer:
**PCT/EP2022/076885**

(87) Internationale Veröffentlichungsnummer:
**WO 2023/052377 (06.04.2023 Gazette 2023/14)**

## (54) ORGANISCHE ELEKTROLUMINESZIERENDE VORRICHTUNG

ORGANIC ELECTROLUMINESCENT APPARATUS

APPAREIL ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.09.2021 EP 21200284**

(43) Veröffentlichungstag der Anmeldung:
**07.08.2024 Patentblatt 2024/32**

(73) Patentinhaber: **Merck Patent GmbH**
**64293 Darmstadt (DE)**

(72) Erfinder:
- **PARHAM, Amir Hossain**
  **64293 Darmstadt (DE)**
- **EHRENREICH, Christian**
  **64293 Darmstadt (DE)**
- **EICKHOFF, Christian**
  **64293 Darmstadt (DE)**
- **KROEBER, Jonas Valentin**
  **64293 Darmstadt (DE)**

(74) Vertreter: **Merck Patent Association**
**Merck Patent GmbH**
**64271 Darmstadt (DE)**

(56) Entgegenhaltungen:
**WO-A1-2017/148565**
**WO-A1-2018/060307**
**WO-A1-2020/067657**
**US-A1- 2021 028 370**
**US-A1- 2021 119 135**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Technisches Gebiet

Die vorliegende Erfindung betrifft eine organische elektrolumineszierende Vorrichtung enthaltend eine Mischung, die ein elektronentransportierendes Hostmaterial und ein lochtransportierendes Hostmaterial umfasst, sowie eine Formulierung enthaltend eine Mischung der Hostmaterialien und eine Mischung enthaltend die Hostmaterialien. Das elektronentransportierende Hostmaterial entspricht einer Verbindung der Formel (1) aus der Klasse von Verbindungen enthaltend eine Diazadibenzofuran oder Diazadibenzothiophen-Einheit und das lochtransportierende Hostmaterial entspricht einem deuterierten Monoamin der Formel (2).

Stand der Technik

Der Aufbau organischer Elektrolumineszenzvorrichtungen (z.B. OLEDs - organic light emitting diodes oder OLECs - organic light emitting electrochemical cells), in denen organische Halbleiter als funktionelle Materialien eingesetzt werden, ist seit Langem bekannt. Als emittierende Materialien werden hierbei neben fluoreszierenden Emittern zunehmend metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfach gesteigerte Energie- und Leistungseffizienz möglich. Generell gibt es bei OLEDs, insbesondere auch bei OLEDs die Triplettemission (Phosphoreszenz) zeigen, jedoch immer noch Verbesserungsbedarf, beispielsweise im Hinblick auf Effizienz, Betriebsspannung und Lebensdauer.

Die Eigenschaften organischer elektrolumineszierender Vorrichtungen werden nicht nur durch die eingesetzten Emitter bestimmt. Hier sind insbesondere auch die anderen verwendeten Materialien, wie Host- und Matrixmaterialien, Lochblockiermaterialien, Elektronentransportmaterialien, Lochtransportmaterialien und Elektronen- bzw. Exzitonenblockiermaterialien von besonderer Bedeutung, und davon insbesondere die Host- bzw. Matrixmaterialien. Verbesserungen dieser Materialien können zu deutlichen Verbesserungen elektrolumineszierender Vorrichtungen führen.

Hostmaterialien zur Verwendung in organischen elektronischen Vorrichtungen sind dem Fachmann gut bekannt. Im Stand der Technik wird häufig auch der Begriff Matrixmaterial verwendet, wenn ein Hostmaterial für phosphoreszierende Emitter gemeint ist. Diese Verwendung des Begriffs gilt auch für die vorliegende Erfindung. Mittlerweile wurde eine Vielzahl von Hostmaterialien sowohl für fluoreszierende als auch für phosphoreszierende elektronische Vorrichtungen entwickelt.

Eine weitere Möglichkeit, die Leistungsdaten elektronischer Vorrichtungen, insbesondere von organischen Elektrolumineszenzvorrichtungen, zu verbessern, besteht darin, Kombinationen aus zwei oder mehr Materialien, insbesondere Hostmaterialien bzw. Matrixmaterialien, zu verwenden. Im Stand der Technik hat sich die Verwendung einer Mischung bestehend aus einem Elektronentransportmaterial, einem Lochtransportmaterial und einem phosphoreszierenden Emitter in der Emissionsschicht einer OLED etabliert, wobei die Emissionsschicht noch weitere Materialien enthalten kann.

Gemäß WO17204556, WO18060307, WO19229583 und WO20067657 können beispielsweise spezielle Diazadibenzofuran bzw. Diazadibenzothiophenderivate in einer lichtemittierenden Schicht als Hostmaterialien in Kombination mit Aminen verwendet werden.

Gemäß WO18234932, WO19058200, WO19229584, WO19190101, WO19190239 und WO2019059577 werden jeweils spezielle Diazadibenzofuran oder Diazadibenzothiophen-Verbindungen beschrieben, die in einer elektrolumineszierenden Vorrichtung, insbesondere in einer emittierenden Schicht, verwendet werden können.

In US2017186969 wird eine organische lichtemittierende Vorrichtung beschrieben, wobei in der organischen Schicht spezielle Monoarylamine enthalten sind, die unsubstituiert oder teilweise deuteriert sein können, insbesondere enthalten in einer emittierenden Hilfsschicht.

Spezielle Monoarylamine, die unsubstituiert oder teilweise deuteriert sein können, werden in den Offenlegungsschriften WO2015022051, WO2017148564, WO2018083053 CN112375053, WO2019192954, WO2021156323 und WO21107728 beschrieben. Weitere lichtemittierende Vorrichtungen werden in der WO 2018/060307 A1, WO 2017/148565 A1, US 2021/119135 A1, und US 2021/028370 A1 beschrieben.

Allerdings besteht bei Verwendung dieser Materialien oder bei der Verwendung von Mischungen der Materialien noch Verbesserungsbedarf, insbesondere in Bezug auf Effizienz, Betriebsspannung und/oder Lebensdauer der organischen elektrolumineszierenden Vorrichtung.

Aufgabe der vorliegenden Erfindung ist daher die Bereitstellung einer Kombination von Hostmaterialien, welche sich für den Einsatz in einer organischen elektrolumineszierenden Vorrichtung, insbesondere in einer fluoreszierenden oder phosphoreszierenden OLED eignen und zu guten Device-Eigenschaften insbesondere im Hinblick auf eine verbesserte Lebensdauer, führen, sowie die Bereitstellung der entsprechenden elektrolumineszierenden Vorrichtung.

Es wurde nun gefunden, dass die Kombination mindestens einer Verbindung der Formel (1) als erstes Hostmaterial und mindestens einer lochtransportierenden Verbindung der Formel (2) als zweites Hostmaterial in einer Licht emittierenden Schicht einer organischen elektrolumineszierenden Vorrichtung, diese Aufgabe lösen und die Nachteile aus dem Stand der Technik beseitigen. Die Verwendung einer derartigen Materialkombination zur Herstellung der lichtemittierenden Schicht in einer organischen elektrolumineszierenden Vorrichtung führt zu sehr guten Eigenschaften dieser Vorrichtungen, insbesondere hinsichtlich der Lebensdauer, insbesondere bei gleicher oder verbesserter Effizienz und/oder Betriebsspannung. Die Vorteile zeigen sich insbesondere auch bei Anwesenheit einer lichtemittierenden Komponente in der Emissionsschicht, insbesondere bei Kombination mit Emittern der Formeln (IIIa), (I) bis (VIII) bei Konzentrationen zwischen 2 und 15 Gew.-%. Die Vorteile zeigen sich insbesondere bei Anwesenheit einer lichtemittierenden Komponente der Formel (IIIa), wie nachfolgend beschrieben, bei Konzentrationen zwischen 2 und 15 Gew.-%.

Zusammenfassung der Erfindung

Ein erster Gegenstand der vorliegenden Erfindung ist daher eine organische elektrolumineszierende Vorrichtung umfassend eine Anode, eine Kathode und mindestens eine organische Schicht, enthaltend mindestens eine lichtemittierende Schicht, wobei die mindestens eine lichtemittierende Schicht mindestens eine Verbindung der Formel (1) als Hostmaterial 1 und mindestens eine Verbindung der Formel (2) als Hostmaterial 2 enthält,

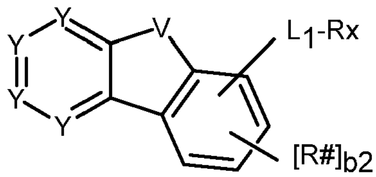

Formel (1),

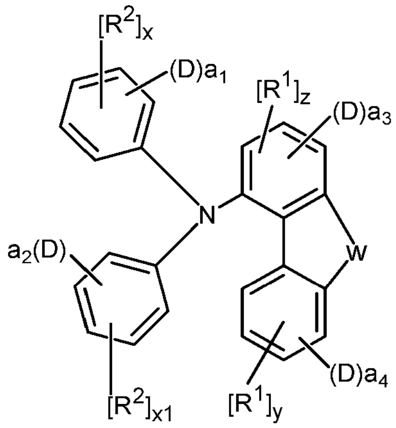

Formel (2),

wobei für die verwendeten Symbole und Indizes gilt:

| | |
|---|---|
| Y | ist bei jedem Auftreten unabhängig voneinander N, $[L]b\text{-}Ar_2$ oder $[L]b1\text{-}Ar_3$, wobei genau zwei Y für N stehen, die durch mindestens eine Gruppe $[L]b\text{-}Ar_2$ oder $[L]b1\text{-}Ar_3$ getrennt sind; |
| V | ist O oder S; |
| $L_1$ | ist eine Einfachbindung oder ein aromatisches oder heteroaromatisches Ringsystem mit 5 bis 30 Ringatomen, das teilweise oder vollständig deuteriert sein kann; |
| Rx | ist F, Cl, Br, I, CN, $NO_2$, eine geradkettigen Alkyl-, Alkoxy- oder Thioalkylgruppe mit 1 bis 40 C-Atomen oder eine verzweigte oder cyclische Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei ein oder mehrere H-Atome durch D, F, Cl, Br, I, CN oder $NO_2$ ersetzt sein können, ein aromatisches oder heteroaromatisches Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme; |
| b, b1 | sind jeweils unabhängig voneinander 0 oder 1; |
| b2 | ist 0, 1, 2 oder 3; |
| L | ist bei jedem Auftreten gleich oder verschieden ein aromatisches oder heteroaromatisches Ringsys- |

tem mit 5 bis 30 Ringatomen, das teilweise oder vollständig deuteriert sein kann;

R# ist D, F oder eine Arylgruppe mit 6 bis 20 C-Atomen, die mit einem oder mehreren Resten $R^3$ substituiert sein kann;

$Ar_2$, $Ar_3$ sind bei jedem Auftreten gleich oder verschieden ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann;

W ist O, S, $C(R)_2$;

R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;

$Ar_1$ ist bei jedem Auftreten gleich oder verschieden ein aromatisches oder heteroaromatisches Ringsystem mit 5 bis 30 Ringatomen, das mit einem oder mehreren Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$R^1$ ist bei jedem Auftreten gleich oder verschieden ausgewählt aus der Gruppe bestehend aus F, Cl, Br, I, CN, $NO_2$, $P(=O)(Ar_1)_2$, $P(Ar_1)_2$, $B(Ar_1)_2$, $Si(Ar_1)_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, wobei eine oder mehrere nicht-benachbarte $CH_2$-Gruppen durch C=O, C=S, SO, $SO_2$, O oder S ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einer geradkettigen Alkylgruppe mit 1 bis 20 C-Atomen oder einer verzweigten oder cyclischen Alkylgruppe mit 3 bis 20 C-Atomen, wobei eine oder mehrere nicht-benachbarte CH2-Gruppen durch O oder S ersetzt sein können und wobei ein oder mehrere H-Atome durch D, F, oder CN ersetzt sein können oder einem aromatischen oder heteroaromatischen Ringsystem mit 5 bis 30 Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;

a3 ist 0, 1, 2 oder 3;

a4 ist 0, 1, 2, 3 oder 4; und

a1+a2+a3+a4 ist 3, 4, 5, 6, 7, 8, 9, 10, 11, 12, 13, 14, 15, 16 oder 17.

Weitere Gegenstände der Erfindung umfassen ein Verfahren zur Herstellung der organischen elektrolumineszierenden Vorrichtungen sowie Mischungen enthaltend mindestens eine Verbindung der Formel (1) und mindestens eine Verbindung der Formel (2), spezielle Materialkombinationen und Formulierungen, die derartige Mischungen bzw. Materialkombinationen enthalten. Die entsprechenden bevorzugten Ausführungsformen, wie nachfolgend beschrieben, sind ebenfalls Gegenstand der vorliegenden Erfindung. Die überraschenden und vorteilhaften Effekte werden durch spezifische Selektion der Verbindungen der Formel (1) und der Verbindungen der Formel (2) erreicht.

Beschreibung der Erfindung

Die erfindungsgemäße organische elektrolumineszierende Vorrichtung ist beispielsweise ein organischer lichtemittierender Transistor (OLET), ein organisches Feld-Quench-Device (OFQD), eine organische lichtemittierende elektrochemische Zelle (OLEC, LEC, LEEC), eine organische Laserdiode (O-Laser) oder eine organische lichtemittierende Diode (OLED). Die erfindungsgemäße organische elektrolumineszierende Vorrichtung ist insbesondere eine organische lichtemittierende Diode oder eine organische lichtemittierende elektrochemische Zelle. Besonders bevorzugt ist die erfindungsgemäße Vorrichtung eine OLED.

Die organische Schicht der erfindungsgemäßen Vorrichtung, die die lichtemittierende Schicht enthaltend die Materialkombination aus mindestens einer Verbindung der Formel (1) und mindestens einer Verbindung der Formel (2) enthält, wie zuvor beschrieben oder nachfolgend beschrieben, enthält bevorzugt neben dieser lichtemittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL). Es können in der erfindungsgemäßen Vorrichtung auch mehrere Schichten dieser Gruppe ausgewählt aus EML, HIL, HTL, ETL, EIL und HBL enthalten sein.

Die Vorrichtung kann aber auch anorganische Materialien enthalten oder auch Schichten, welche vollständig aus anorganischen Materialien aufgebaut sind.

Es ist bevorzugt, dass die lichtemittierende Schicht enthaltend mindestens eine Verbindung der Formel (1) und mindestens eine Verbindung der Formel (2) eine phosphoreszierende Schicht ist, die dadurch gekennzeichnet ist, dass sie zusätzlich zu der Hostmaterialienkombination der Verbindungen der Formel (1) und Formel (2), wie zuvor beschrieben, mindestens einen phosphoreszierenden Emitter enthält. Eine geeignete Auswahl an Emittern und bevorzugte Emitter werden nachfolgend beschrieben.

In der vorliegenden Patentanmeldung bezeichnet "D" oder "D-Atom" Deuterium.

Eine Arylgruppe im Sinne dieser Erfindung enthält 6 bis 40 Atome, bevorzugt C-Atome. Eine Heteroarylgruppe im Sinne dieser Erfindung enthält 5 bis 40 Atome, wobei die Atome C-Atome und mindestens ein Heteroatom umfassen, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Phenyl, abgeleitet von Benzol, bzw. ein einfacher heteroaromatischer Cyclus, beispielsweise abgeleitet von Pyridin, Pyrimidin oder Thiophen, oder eine kondensierte Aryl- oder Heteroarylgruppe, beispielsweise abgeleitet von Naphthalin, Anthracen, Phenanthren, Chinolin oder Isochinolin, verstanden. Eine Arylgruppe mit 6 bis 18 C-Atomen ist daher vorzugsweise Phenyl, Naphthyl, Phenanthryl oder Triphenylenyl, wobei die Anbindung der Arylgruppe als Substituent dabei nicht eingeschränkt ist. Die Aryl- oder Heteroarylgruppe im Sinne dieser Erfindung kann einen oder mehrere Reste $R^3$ tragen, wobei der Substituent $R^3$ nachfolgend beschrieben wird.

Ein aromatisches Ringsystem im Sinne dieser Erfindung enthält 6 bis 40 C-Atome im Ringsystem. Das aromatisches Ringsystem umfasst auch Arylgruppen, wie zuvor beschrieben.

Ein aromatisches Ringsystem mit 6 bis 18 Ringatomen wird vorzugsweise aus Phenyl, vollständig deuteriertes Phenyl, Biphenyl, Naphthyl, Phenanthryl und Triphenylenyl ausgewählt.

Ein heteroaromatisches Ringsystem im Sinne dieser Erfindung enthält 5 bis 40 Ringatome und mindestens ein Heteroatom. Ein bevorzugtes heteroaromatisches Ringsystem hat 6 bis 40 Ringatome und mindestens ein Heteroatom. Das heteroaromatische Ringsystem umfasst auch Heteroarylgruppen, wie zuvor beschrieben. Die Heteroatome im heteroaromatischen Ringsystem sind bevorzugt ausgewählt aus N, O und/oder S.

Unter einem aromatischen oder heteroaromatischen Ringsystem im Sinne dieser Erfindung wird ein System verstanden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C- oder O-Atom oder eine Carbonylgruppe, unterbrochen sein können. So sollen beispielsweise auch Systeme wie 9,9'-Spirobifluoren, 9,9-Diarylfluoren, 9,9-Dialkylfluoren, Diarylether, Stilben, etc. als aromatische bzw. heteroaromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sind Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls von der Definition des aromatischen bzw. heteroaromatischen Ringsystems umfasst.

Unter einem aromatischen oder heteroaromatischen Ringsystem mit 5 - 40 Ringatomen, welches über beliebige Positionen am Aromaten bzw. Heteroaromaten verknüpft sein kann, werden beispielsweise Gruppen verstanden, die

abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die Abkürzung $Ar_1$ oder "Aryl" bedeutet bei jedem Auftreten gleich oder verschieden ein aromatisches oder heteroaromatisches Ringsystem mit 5 bis 30 Ringatomen, das mit einem oder mehreren Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein, wobei der Rest $R^3$ oder die Substituenten $R^3$ eine Bedeutung hat/haben, wie zuvor oder nachfolgend beschrieben.

Die Abkürzung $Ar_2$ oder $Ar_3$ bedeutet jeweils unabhängig voneinander bei jedem Auftreten ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann, wobei der Rest $R^3$ oder die Substituenten $R^3$ eine Bedeutung hat/haben, wie zuvor oder nachfolgend beschrieben. Die genannten Ausführungen für die Aryl- und Heteroarylgruppen mit 5 bis 40 Ringatomen gelten hier entsprechend.

Unter einer cyclischen Alkyl-, Alkoxy- oder Thioalkylgruppe im Sinne dieser Erfindung wird eine monocyclische, eine bicyclische oder eine polycyclische Gruppe verstanden.

Im Rahmen der vorliegenden Erfindung werden unter einer geradkettigen, verzweigten oder cyclischen $C_1$- bis $C_{20}$-Alkylgruppe beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden.

Unter einer geradkettigen oder verzweigten $C_1$- bis $C_{20}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einer geradkettigen $C_1$- bis $C_{20}$-Thioalkylgruppe werden beispielsweise S-Alkylgruppen verstanden, beispielsweise Thiomethyl, 1-Thioethyl, 1-Thio-i-propyl, 1-Thio-n-propoyl, 1-Thio-i-butyl, 1-Thio-n-butyl oder 1-Thio-t-butyl.

Eine Aryloxy- oder Heteroaryloxygruppe mit 5 bis 40 Ringatomen bedeutet O-Aryl oder O-Heteroaryl und bedeutet, dass die Aryl- bzw. Heteroarylgruppe über ein Sauerstoffatom gebunden wird, wobei die Aryl- bzw. Heteroarylgruppe eine Bedeutung hat, wie zuvor beschrieben.

Ein phosphoreszierender Emitter im Sinne der vorliegenden Erfindung ist eine Verbindung, die Lumineszenz aus einem angeregten Zustand mit höherer Spinmultiplizität zeigt, also einem Spinzustand > 1, insbesondere aus einem angeregten Triplettzustand. Im Sinne dieser Anmeldung sollen alle lumineszierenden Komplexe mit Übergangsmetallen oder Lanthaniden als phosphoreszierende Emitter angesehen werden. Eine genauere Definition erfolgt nachfolgend.

Wenn die Hostmaterialien der lichtemittierenden Schicht umfassend mindestens eine Verbindung der Formel (1), wie zuvor beschrieben oder nachfolgend bevorzugt beschrieben, und mindestens eine Verbindung der Formel (2), wie zuvor beschrieben oder nachfolgend beschrieben, für einen phosphoreszierenden Emitter eingesetzt wird, ist es bevorzugt, wenn deren Triplettenergie nicht wesentlich kleiner als die Triplettenergie des phosphoreszierenden Emitters ist. Dabei gilt bevorzugt für das Triplettniveau $T_1(\text{Emitter}) - T_1(\text{Matrix}) \leq 0.2$ eV, besonders bevorzugt $\leq 0.15$ eV, ganz besonders bevorzugt $\leq 0.1$ eV. Dabei ist $T_1$(Matrix) das Triplettniveau des Matrixmaterials in der Emissionsschicht, wobei diese Bedingung für jedes der beiden Matrixmaterialien gilt, und $T_1$(Emitter) ist das Triplettniveau des phosphoreszierenden Emitters. Enthält die Emissionsschicht mehr als zwei Matrixmaterialien, so gilt die oben genannte Beziehung

bevorzugt auch für jedes weitere Matrixmaterial.

Im Folgenden wird das Hostmaterial 1 und dessen bevorzugte Ausführungsformen beschrieben, welches/welche in der erfindungsgemäßen Vorrichtung enthalten ist/sind. Die bevorzugten Ausführungsformen des Hostmaterials 1 der Formel (1) gelten auch für die erfindungsgemäße Mischung und/oder Formulierung.

In Verbindungen der Formel (1) ist Y bei jedem Auftreten unabhängig voneinander N, $[L]_b$-$Ar_2$ oder $[L]_{b1}$-$Ar_3$, wobei genau zwei Y für N stehen, die durch mindestens eine Gruppe $[L]_b$-$Ar_2$ oder $[L]_{b1}$-$Ar_3$ getrennt sind.

Bevorzugte Ausführungsformen der Verbindungen der Formel (1) sind Verbindungen der Formeln (1a), (1b) oder (1c), in denen die Position der beiden N-Atome näher beschrieben wird, die restlichen Y $[L]_b$-$Ar_2$ und $[L]_{b1}$-$Ar_3$ bedeuten, V O oder S bedeutet und $L_1$, Rx, R# und b2 eine zuvor angegebene oder nachfolgend bevorzugt genannte Bedeutung haben,

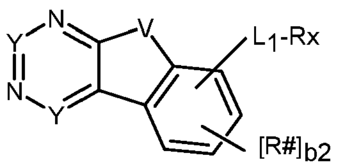
Formel (1a)
,
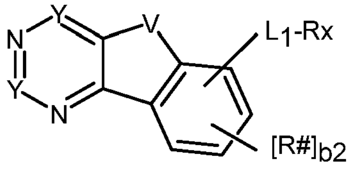
Formel (1b)
,
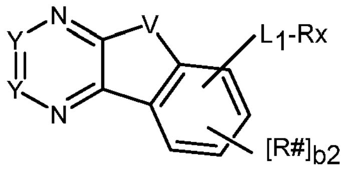
Formel (1c)
.

Ein weiterer Gegenstand der Erfindung ist die organische elektrolumineszierende Vorrichtung, wie zuvor beschrieben, wobei das Hostmaterial 1 einer der Formeln (1a), (1b) oder (1c) entspricht, wie zuvor beschrieben.

Bevorzugte Verbindungen der Formel (1) entsprechen den Formeln (1a) und (1b). Besonders bevorzugt Verbindungen der Formel (1) sind Verbindungen der Formel (1b).

In Verbindungen der Formeln (1), (1a), (1b) und (1c) steht der Substituent Rx bevorzugt für ein aromatisches oder heteroaromatisches Ringsystem mit 5 bis 60 Ringatomen, das jeweils mit einem oder mehreren Resten $R^3$ substituiert sein kann, wobei der Rest $R^3$ eine zuvor genannte oder nachfolgend bevorzugt genannte Bedeutung hat. In Verbindungen der Formeln (1), (1a), (1b) und (1c) steht der Substituent Rx besonders bevorzugt für ein aromatisches Ringsystem mit 6 bis 30 Ringatomen, das jeweils mit einem oder mehreren Resten $R^3$ substituiert sein kann, oder für Dibenzofuran, Dibenzothiophen, Carbazol, Indolocarbazol oder Indenocarbazol, die jeweils mit einem Rest $R^3$ oder mehreren Resten $R^3$ substituiert sein können, wobei der Rest $R^3$ eine zuvor genannte oder nachfolgend bevorzugt genannte Bedeutung hat und Carbazol, Indolocarbazol und Indenocarbazol über deren N-Atom oder eines Ihrer C-Atome gebunden sein kann. Sind Carbazol, Indolocarbazol und/oder Indenocarbazol über C gebunden, so trägt deren N-Atom einen Substituenten "Aryl", wie zuvor beschrieben, der bevorzugt ausgewählt wird aus Phenyl, 1,3-Biphenyl, 1,4-Biphenyl, Dibenzothiopen, 9,9-Dimethylfluoren oder Triphenylen, wobei die Anbindung von "Aryl" an das entsprechende N-Atom nicht eingeschränkt ist, sofern nicht anders bezeichnet. Ist der Substituent Rx mit einem oder mehreren Resten $R^3$ substituiert, so wird $R^3$ bevorzugt jeweils unabhängig aus der Gruppe D, CN, Phenyl, N-Aryl-carbazolyl und Dibenzofuranyl ausgewählt, wobei "Aryl" in N-Aryl-carbazolyl eine zuvor genannte Bedeutung oder zuvor genannte bevorzugte Bedeutung hat. In einer Ausführungsform des Substituenten Rx im Hostmaterial 1, wie zuvor beschrieben oder bevorzugt beschrieben, ist dieser Substituent deuteriert. In einer bevorzugten Ausführungsform des Substituenten Rx im Hostmaterial 1, wie zuvor beschrieben oder bevorzugt beschrieben, hat der Substituent Rx einen Rest $R^3$ oder er ist nicht substituiert, wobei der Rest $R^3$ eine zuvor genannte oder bevorzugt genannte Bedeutung hat. Ein bevorzugtes aromatisches Ringsystem als Rx ist beispielsweise Phenyl, 1,3-Biphenyl, 1,4-Biphenyl, Spirobifluorenyl, 9,9-Dimethylfluorenyl, 9-Phenyl-9-Methylfluorenyl, Triphenylenyl oder Fluoranthenyl, das teilweise oder vollständig deuteriert sein kann.

In Verbindungen der Formeln (1), (1a), (1b) und (1c) steht das Symbol $L_1$ als Linker für eine Einfachbindung oder ein aromatisches oder heteroaromatisches Ringsystem mit 5 bis 30 Ringatomen, das teilweise oder vollständig deuteriert sein kann.

In Verbindungen der Formeln (1), (1a), (1b) und (1c) steht das Symbol $L_1$ bevorzugt für eine Einfachbindung oder einen Linker ausgewählt aus der Gruppe L-1 bis L-34,

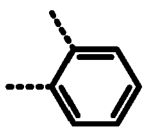
L-1

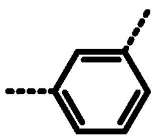
L-2

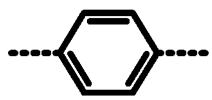
L-3

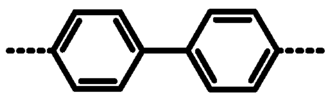
L-4

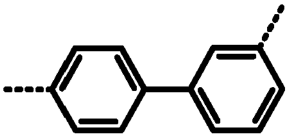

L-5

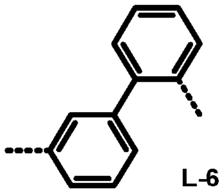

L-6

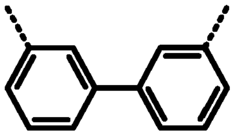

L-7

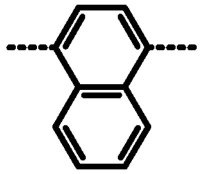

L-8

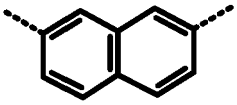

L-9

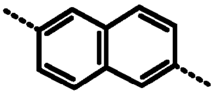

L-10

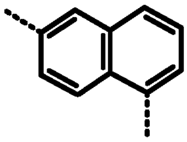

L-11

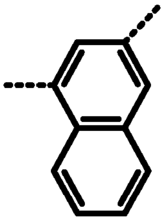

L-12

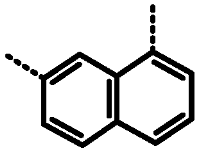

L-13

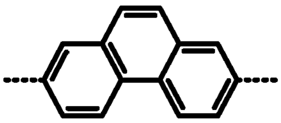

L-14

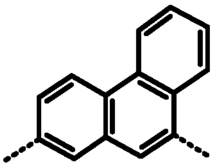

L-15

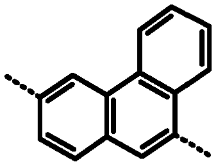

L-16

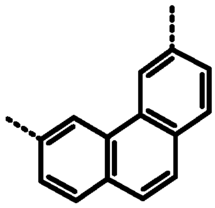

L-17

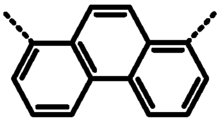

L-18

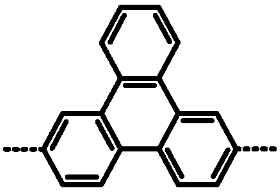

L-19

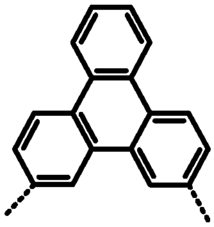

L-20

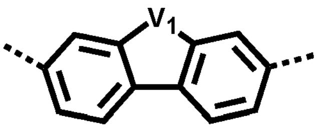

L-21

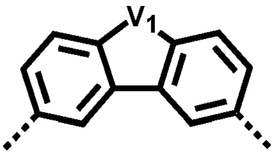

L-22

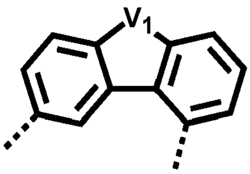

L-23

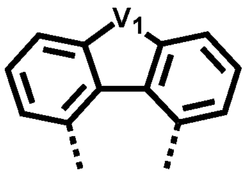

L-24

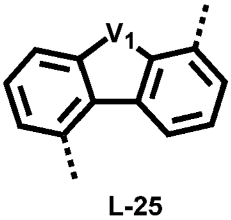

L-25

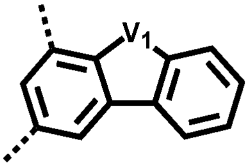

L-26

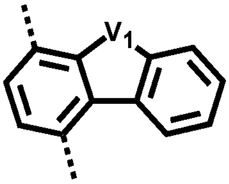

L-27

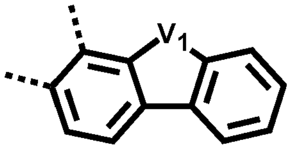

L-28

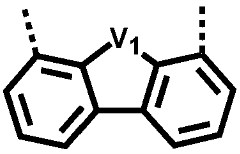 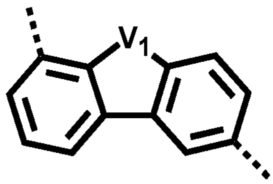 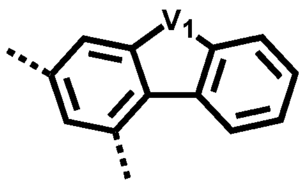 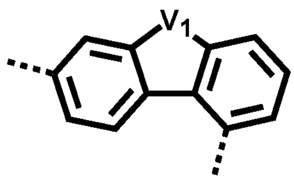

L-29 L-30 L-31 L-32

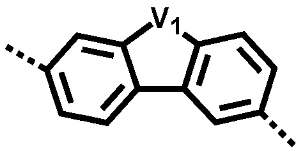 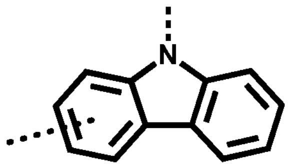

L-33 , L-34 ,

wobei $V_1$ jeweils unabhängig voneinander O, S oder N-Aryl bedeutet und Aryl eine zuvor angegebene oder bevorzugt angegebene Bedeutung hat und die gestrichelten Linien die Anbindung an Rx und Rest der Formeln (1), (1a), (1b) und (1c) bedeutet. Die Linker L-1 bis L-34 können teilweise oder vollständig deuteriert sein. Bevorzugt ist $V_1$ O oder N-Aryl. Besonders bevorzugt ist $V_1$ O. Bevorzugt sind die Linker L-1 bis L-34 teilweise deuteriert oder vollständig deuteriert.

In Verbindungen der Formeln (1), (1a), (1b) und (1c) steht das Symbol $L_1$ bevorzugt für eine Einfachbindung oder einen Linker ausgewählt aus der Gruppe L-2, L-3, L-4, L-5, L-21 bis L-34, wie zuvor beschrieben oder bevorzugt beschrieben.

In Verbindungen der Formeln (1), (1a), (1b) und (1c) steht das Symbol $L_1$ in einer Ausführungsform besonders bevorzugt für eine Einfachbindung oder einen Linker ausgewählt aus L-2, L-22, L-23, L-27, L-33 und L-34, wobei $V_1$ jeweils unabhängig voneinander eine zuvor angegebene oder als bevorzugt angegebene Bedeutung hat.

In Verbindungen der Formeln (1), (1a), (1b) oder (1c), oder bevorzugt genannten Verbindungen der Formeln (1), (1a), (1b) oder (1c) steht V bevorzugt für O.

In Verbindungen der Formeln (1), (1a), (1b) oder (1c), oder bevorzugt genannten Verbindungen der Formeln (1), (1a), (1b) oder (1c) steht R# für D, F oder eine Arylgruppe mit 6 bis 20 C-atomen, die mit einem oder mehreren Resten $R^3$ substituiert sein kann.

In Verbindungen der Formeln (1), (1a), (1b) oder (1c), oder bevorzugt genannten Verbindungen der Formeln (1), (1a), (1b) oder (1c) steht R# bevorzugt für D oder eine Arylgruppe mit 6 bis 20 C-Atomen, die mit einem oder mehreren Resten $R^3$ substituiert sein kann, wobei $R^3$ bevorzugt jeweils unabhängig aus der Gruppe D, CN, Phenyl, N-Aryl-carbazolyl und Dibenzofuranyl ausgewählt wird, wobei "Aryl" in N-Aryl-carbazolyl eine zuvor genannte Bedeutung oder zuvor genannte bevorzugte Bedeutung hat. R# ist bevorzugt D wenn b2 3 bedeutet.

In Verbindungen der Formeln (1), (1a), (1b) oder (1c), oder bevorzugt genannten Verbindungen der Formeln (1), (1a), (1b) oder (1c) steht b2 bevorzugt für 0, 1 oder 3, besonders bevorzugt für 0 oder 1, ganz besonders bevorzugt für 0.

In Verbindungen der Formeln (1), (1a), (1b) und (1c), oder bevorzugt beschriebenen Verbindungen der Formeln (1), (1a), (1b) und (1c), sowie den nachfolgend beschriebenen Verbindungen der Formeln (1d), (1e), (1f) und (1g) steht der Substituent $L_1$-Rx bevorzugt in Position 2, 3 und 4, besonders bevorzugt in Position 2 und 3, ganz besonders bevorzugt in Position 2 des Diazadibenzofurans oder Diazadibenzothiophens. Die Positionen sind in dem folgenden Schema entsprechen angegeben:

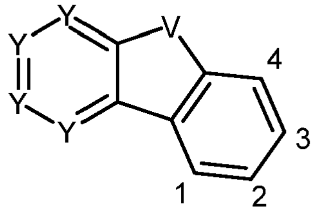

.

In Verbindungen der Formeln (1), (1a), (1b) und (1c) steht der Linker L in $[L]_b$-$Ar_2$ oder $[L]_{b1}$-$Ar_3$ bei seinem Auftreten unabhängig voneinander bevorzugt für einen Linker ausgewählt aus der Gruppe L-1 bis L-34, wie zuvor beschrieben.

In Verbindungen der Formeln (1), (1a), (1b) und (1c) steht der Linker L in $[L]_b$-$Ar_2$ oder $[L]_{b1}$-$Ar_3$ bei seinem Auftreten unabhängig voneinander bevorzugt für einen Linker ausgewählt aus der Gruppe L-2, L-3, L-4, L-5, L-7, L-21 bis L-34, wie zuvor beschrieben oder bevorzugt beschrieben.

In Verbindungen der Formeln (1), (1a), (1b) und (1c) steht der Linker L in $[L]_b$-$Ar_2$ oder $[L]_{b1}$-$Ar_3$ bei seinem Auftreten unabhängig voneinander bevorzugt für einen Linker ausgewählt aus der Gruppe L-2, L-3, L-7, L-22, L-23, L-25, L-29, L-30, L-32 und L-33, wie zuvor beschrieben oder bevorzugt beschrieben.

In einer bevorzugten Ausführungsform der Verbindungen der Formel (1b) steht $[L]_{b1}$-$Ar_3$ bevorzugt in 4-Position und $[L]_b$-$Ar_2$ steht bevorzugt in 2-Position, wie in Formel (1d) beschrieben,

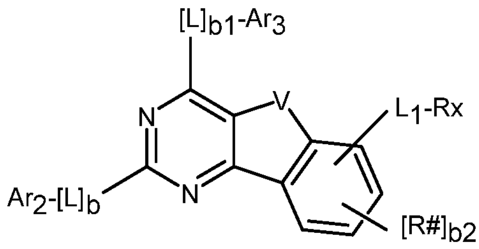

Formel (1d)

,

wobei L, $L_1$, Rx, R#, b2 und V eine zuvor angegebene oder bevorzugt angegebene Bedeutung haben und wobei b1, b, $Ar_2$ und $Ar_3$ eine zuvor genannte oder nachfolgend bevorzugt genannte Bedeutung haben.

In einer bevorzugten Ausführungsform der Verbindungen der Formel (1b) steht $[L]_{b1}$-$Ar_3$ bevorzugt in 2-Position und $[L]_b$-$Ar_2$ steht bevorzugt in 4-Position, wie in Formel (1e) beschrieben,

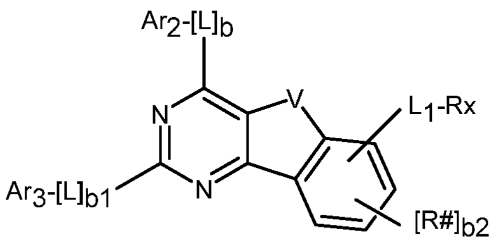

Formel (1e)

,

wobei L, $L_1$, Rx, R#, b2 und V eine zuvor angegebene oder bevorzugt angegebene Bedeutung haben und wobei b1, b, $Ar_2$ und $Ar_3$ eine zuvor genannte oder nachfolgend bevorzugt genannte Bedeutung haben.

In einer bevorzugten Ausführungsform der Verbindungen der Formel (1a) steht $[L]_{b1}$-$Ar_3$ bevorzugt in 1-Position und $[L]_b$-$Ar_2$ steht bevorzugt in 3-Position, wie in Formel (1f) beschrieben,

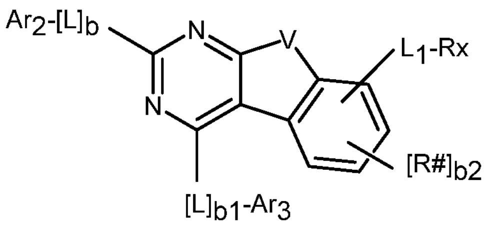

Formel (1f)

,

wobei L, $L_1$, Rx, R#, b2 und V eine zuvor angegebene oder bevorzugt angegebene Bedeutung haben und wobei b1, b, $Ar_2$ und $Ar_3$ eine zuvor genannte oder nachfolgend bevorzugt genannte Bedeutung haben.

In einer bevorzugten Ausführungsform der Verbindungen der Formel (1a) steht $[L]_{b1}$-$Ar_3$ bevorzugt in 3-Position und $[L]_b$-$Ar_2$ steht bevorzugt in 1-Position, wie in Formel (1g) beschrieben,

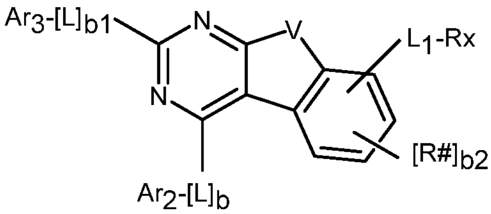

Formel (1g)

,

wobei L, $L_1$, Rx, R#, b2 und V eine zuvor angegebene oder bevorzugt angegebene Bedeutung haben und wobei b1, b, $Ar_2$ und $Ar_3$ eine zuvor genannte oder nachfolgend bevorzugt genannte Bedeutung haben.

In Verbindungen der Formeln (1), (1a), (1b), (1c), (1d), (1e), (1f) und (1g) oder bevorzugt beschriebenen Verbindungen der Formeln (1), (1a), (1b), (1c), (1d), (1e), (1f) und (1g), steht b1 bevorzugt für 0.

In Verbindungen der Formeln (1), (1a), (1b), (1c), (1d), (1e), (1f) und (1g) oder bevorzugt beschriebenen Verbindungen der Formeln (1), (1a), (1b), (1c), (1d), (1e), (1f) und (1g), steht b für 0 oder 1, bevorzugt für 1.

In Verbindungen der Formeln (1), (1a), (1b), (1c), (1d), (1e), (1f) und (1g) oder bevorzugt beschriebenen Verbindungen der Formeln (1), (1a), (1b), (1c), (1d), (1e), (1f) und (1g), bedeutet $Ar_3$ ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann. In Verbindungen der Formeln (1), (1a), (1b), (1c), (1d), (1e), (1f) und (1g) oder bevorzugt beschriebenen Verbindungen der Formeln (1), (1a), (1b), (1c), (1d), (1e), (1f) und (1g), bedeutet $Ar_3$ bevorzugt Phenyl, 1,4-Biphenyl, Dibenzofuranyl und 9,9-Dimethylfluorenyl, die mit einem oder mehreren Resten $R^3$ substituiert sein können, wobei $R^3$ eine zuvor angegebene oder bevorzugt angegebene Bedeutung hat.

In Verbindungen der Formeln (1), (1a), (1b), (1c), (1d), (1e), (1f) und (1g) oder bevorzugt beschriebenen Verbindungen der Formeln (1), (1a), (1b), (1c), (1d), (1e), (1f) und (1g) steht $Ar_2$ bevorzugt für ein aromatisches Ringsystem mit 6 bis 25 Ringatomen, wie zuvor beschrieben oder bevorzugt beschrieben, das mit einem oder mehreren Resten $R^3$ substituiert sein kann, oder für ein heteroaromatisches Ringsystem mit 6 bis 25 Ringatomen, das mit einem oder mehreren Resten $R^3$ substituiert sein kann, wobei $R^3$ eine zuvor angegebene oder bevorzugt angegebene Bedeutung hat. Die Verknüpfung des aromatischen oder heteroaromatischen Ringsystems ist dabei nicht eingeschränkt und kann über ein C-Atom oder über ein Heteroatom, beispielsweise ein N-Atom, erfolgen. Ein bevorzugtes aromatisches Ringsystem als $Ar_2$ ist beispielsweise Phenyl, Spirobifluorenyl, 9,9-Dimethylfluorenyl, 9-Phenyl-9-Methylfluorenyl, Triphenylenyl oder Fluoranthenyl, das mit einem oder mehreren Resten $R^3$ substituiert sein kann, wobei $R^3$ eine zuvor angegebene oder bevorzugt angegebene Bedeutung hat.

Ein bevorzugtes heteroaromatisches Ringsystem als $Ar_2$ ist beispielsweise Triazinyl, Dibenzofuranyl, Dibenzothiophenyl, Diazadibenzofuranyl, Diazadibenzothiophenyl, N-Aryl-carbazolyl, Indenocarbazolyl, Indolocarbazolyl, das mit einem oder mehreren Resten $R^3$ substituiert sein kann, wobei $R^3$ eine zuvor angegebene oder bevorzugt angegebene Bedeutung hat.

$R^3$ als Substituent für $Ar_2$ wird bevorzugt ausgewählt aus der Gruppe D, einem aromatischen oder heteroaromatischen Ringsystem mit 5 bis 20 Ringatomen, das jeweils teilweise deuteriert oder vollständig deuteriert sein kann. $R^3$ als Substituent für $Ar_2$ wird bevorzugt ausgewählt aus der Gruppe Phenyl, 1,3-Biphenyl, 1,4-Biphenyl, N-Aryl-Carbazolyl, das jeweils teilweise deuteriert oder vollständig deuteriert sein kann und wobei "Aryl" eine zuvor genannte oder bevorzugt genannte Bedeutung haben kann.

Beispiele für geeignete Hostmaterialien der Formeln (1), (1a), (1b), (1c), (1d), (1e), (1f) und (1g), die erfindungsgemäß ausgewählt werden, und bevorzugt in Kombination mit mindestens einer Verbindung der Formel (2) in der erfindungsgemäßen elektrolumineszierenden Vorrichtung verwendet werden, sind die nachstehend genannten Strukturen der Tabelle 1.

Tabelle 1:

| | | |
|---|---|---|
| 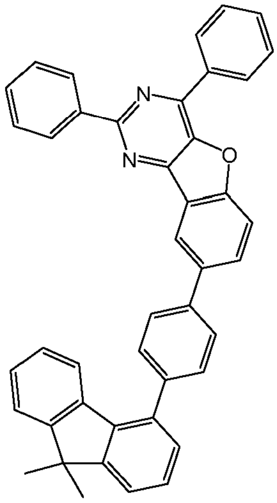 | 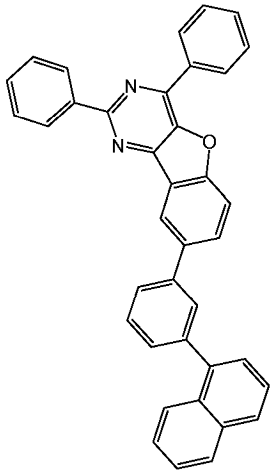 | 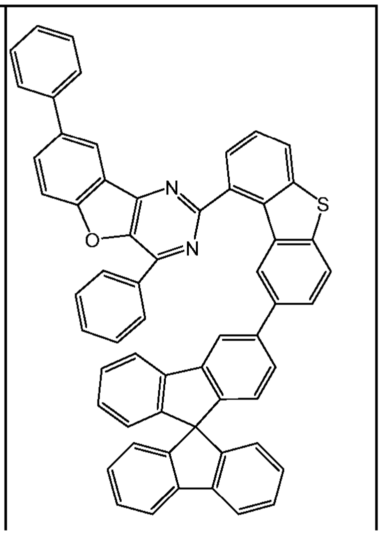 |

| | | |
|---|---|---|
| 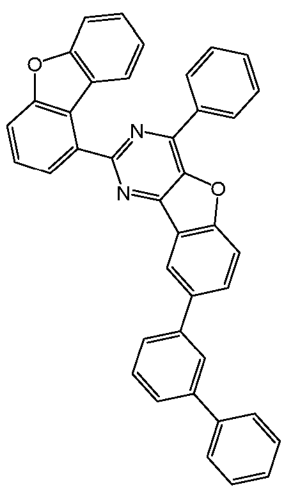 | 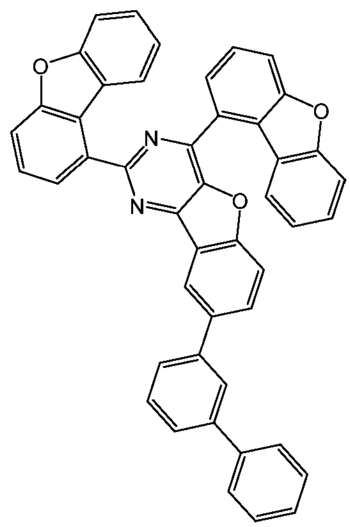 | 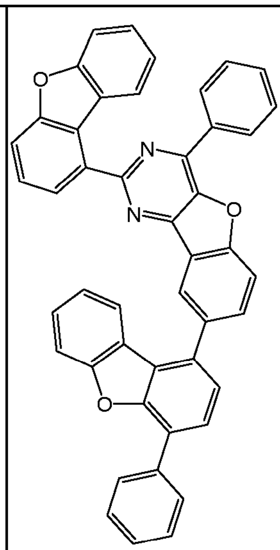 |
| 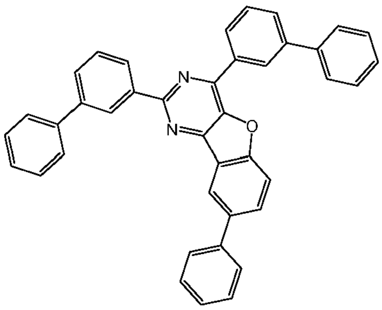 | 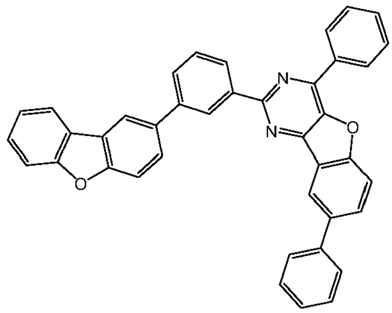 | 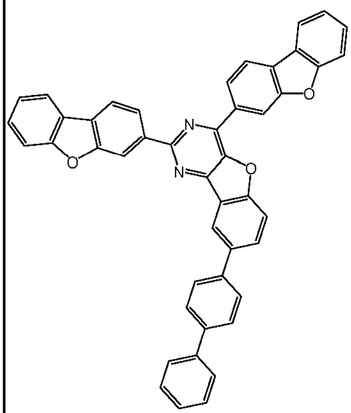 |
| 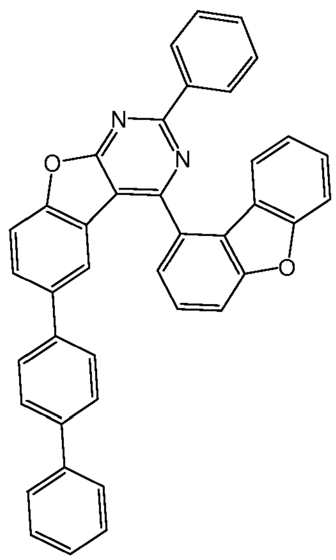 | 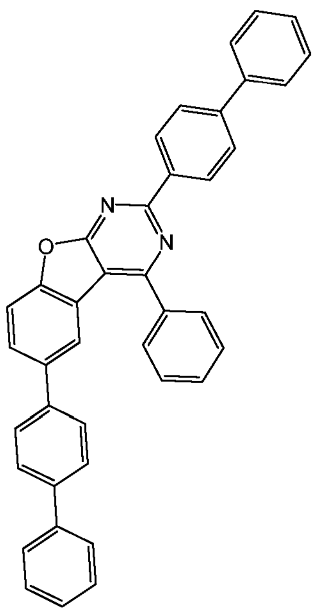 | 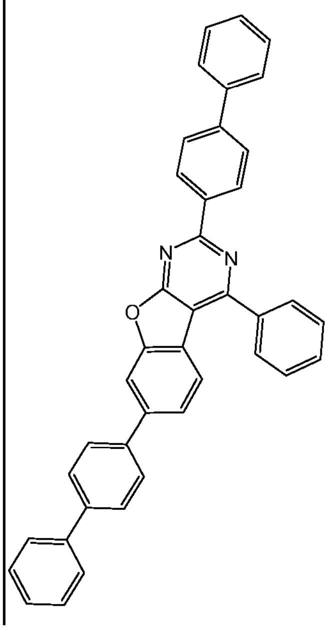 |

| | | |
|---|---|---|
| 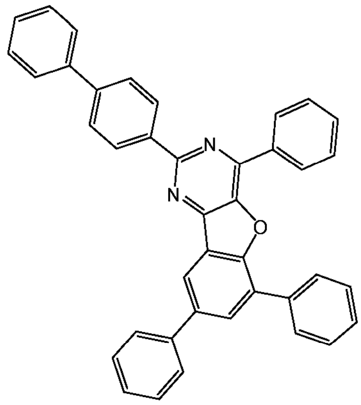 | 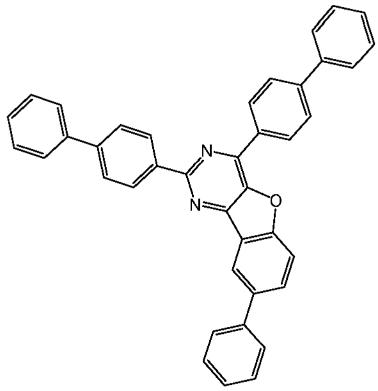 | 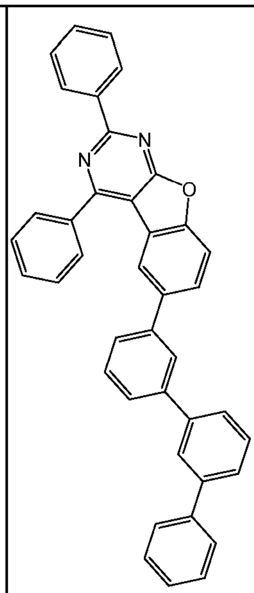 |
| 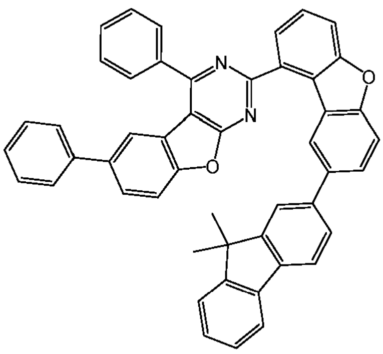 | 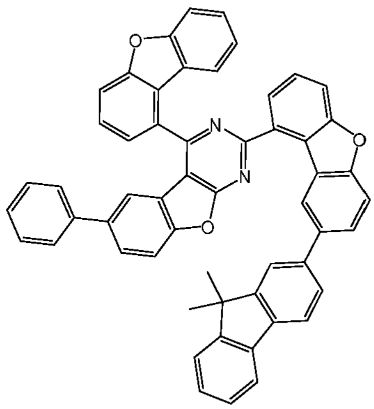 | 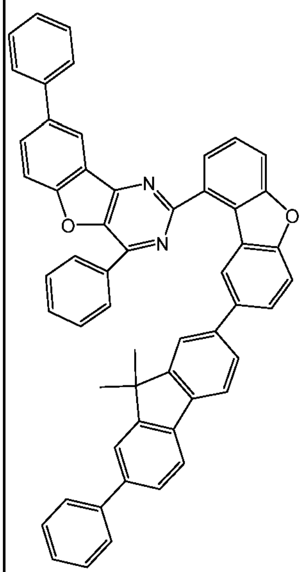 |
| 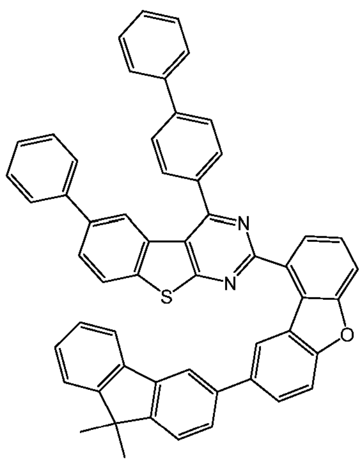 | 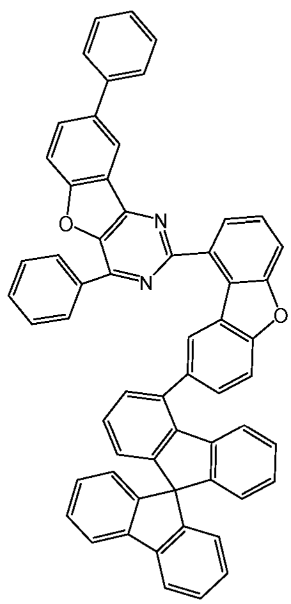 | 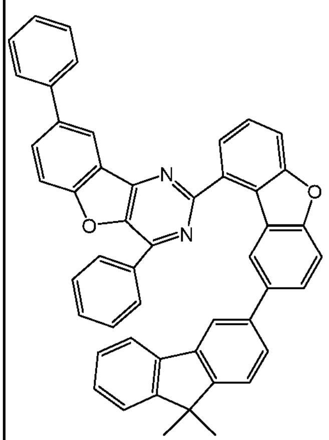 |

| | | |
|---|---|---|
| 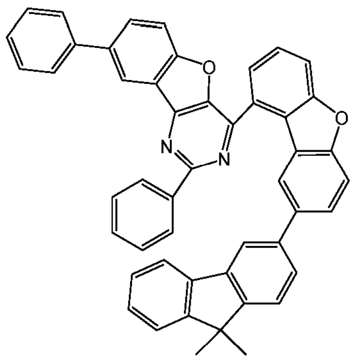 | 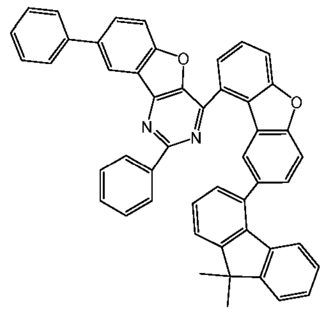 | 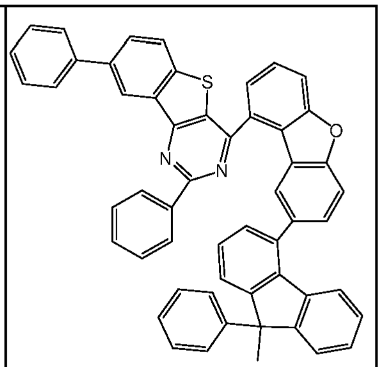 |
| 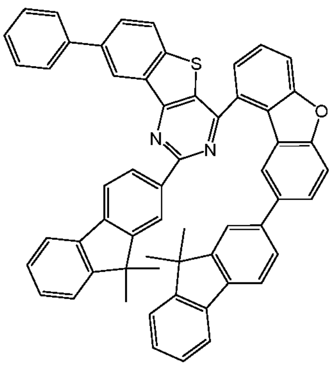 | 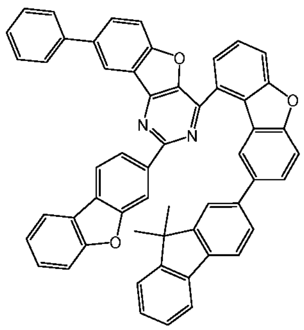 | 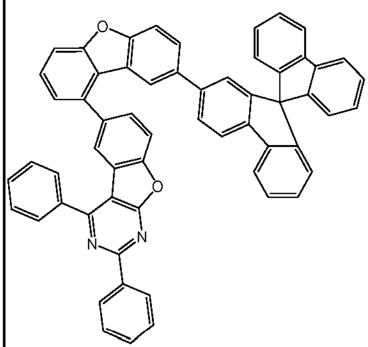 |
| 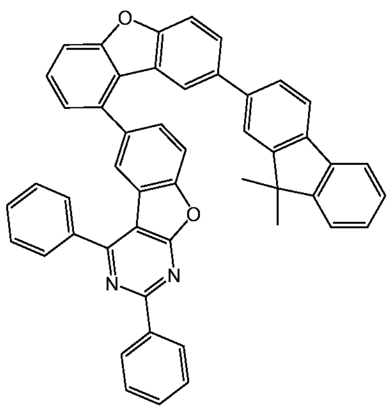 | 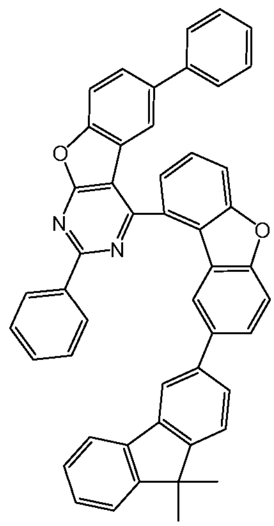 | 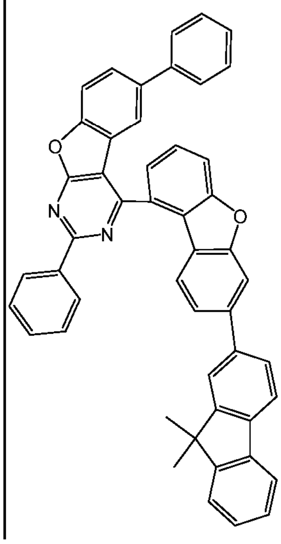 |

| | | |
|---|---|---|
| 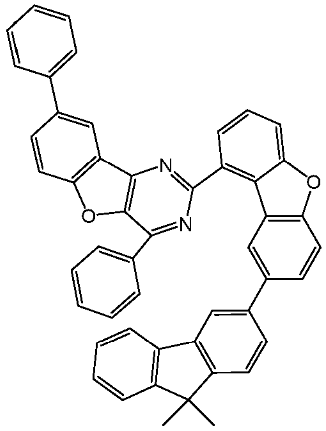 | 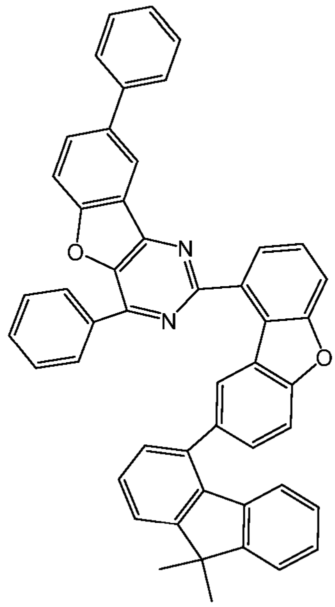 | 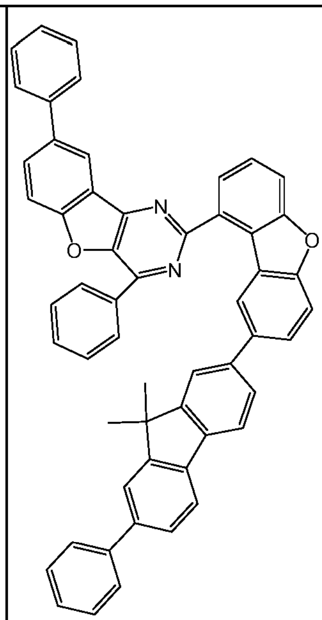 |
| 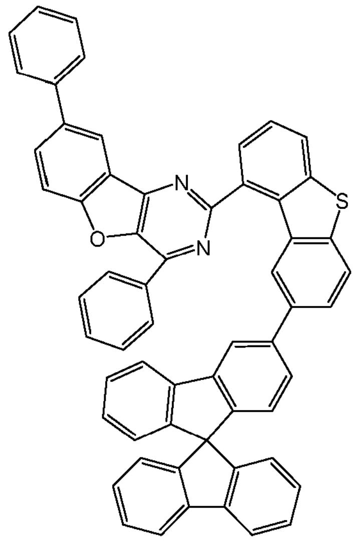 | 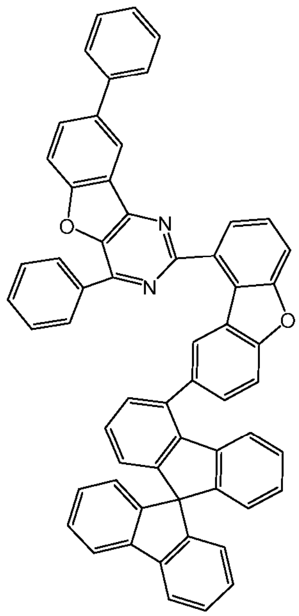 | 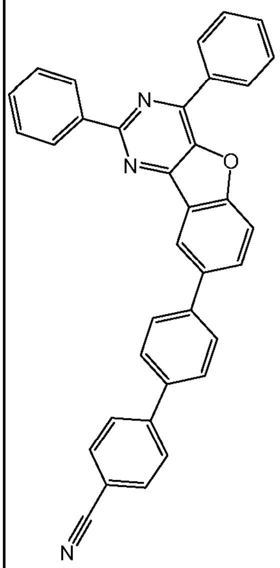 |
| 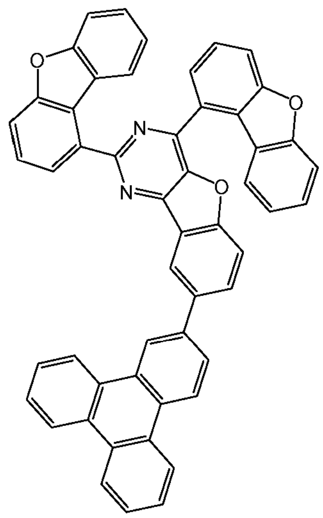 | 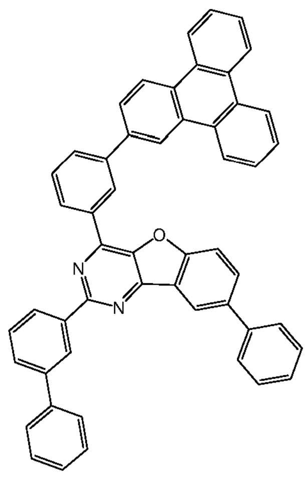 | 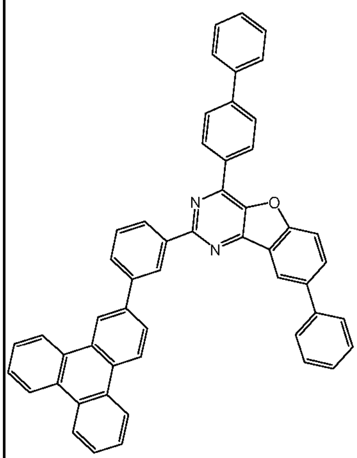 |

| | | |
|---|---|---|
| 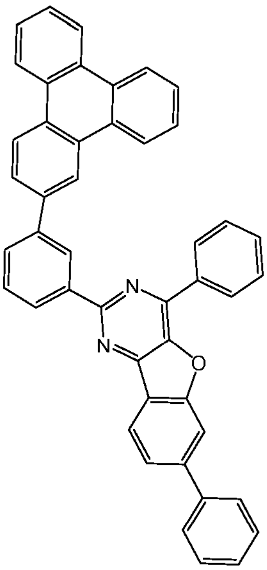 | 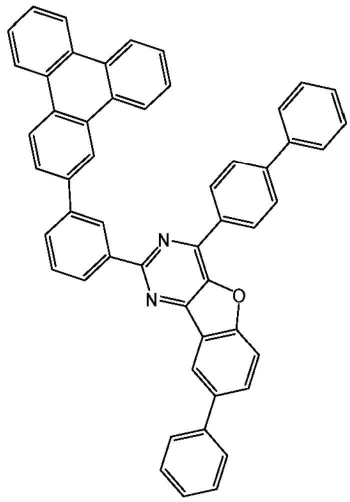 | 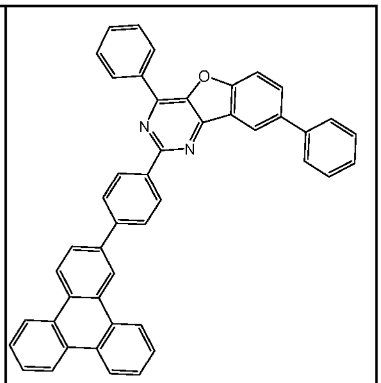 |
| 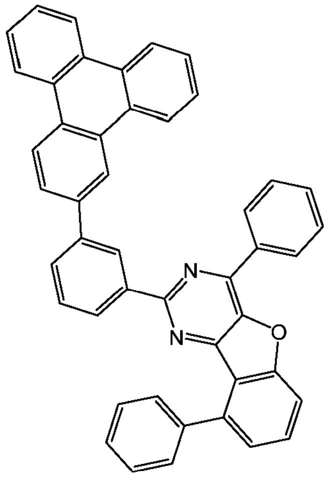 | 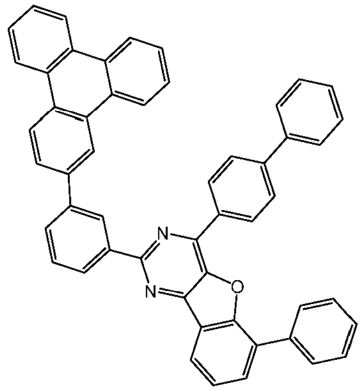 | 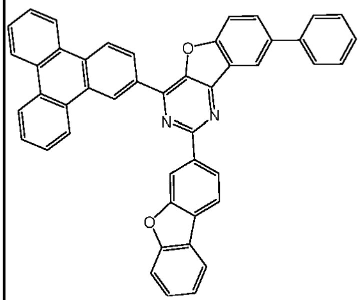 |
| 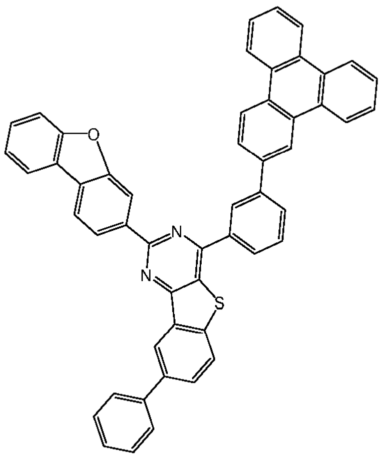 | 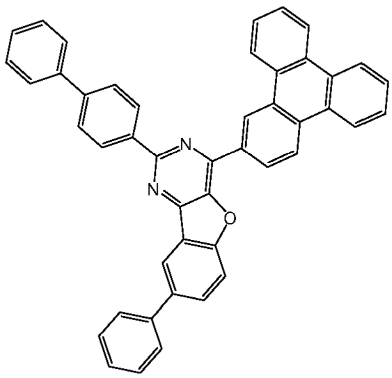 | 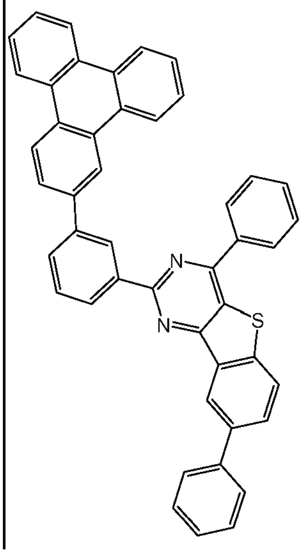 |

| | | |
|---|---|---|
| 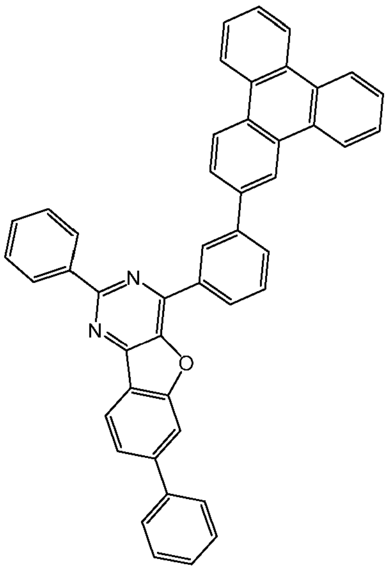 | 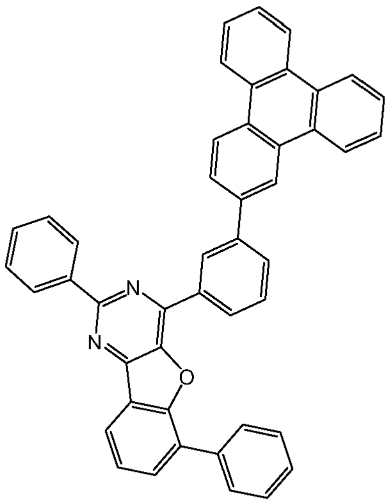 | 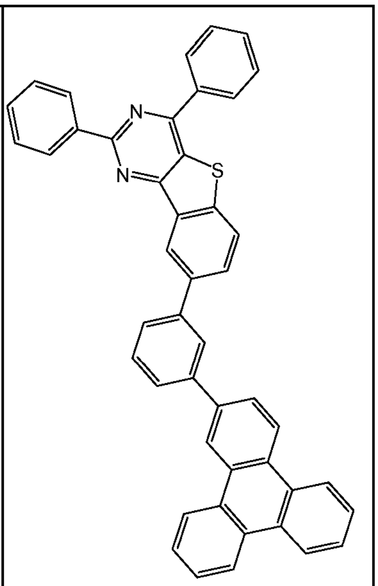 |
| 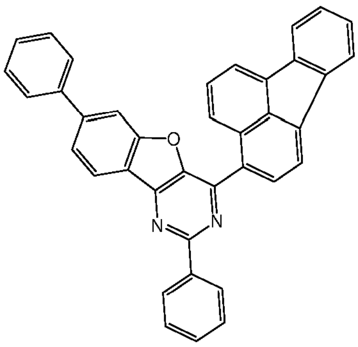 | 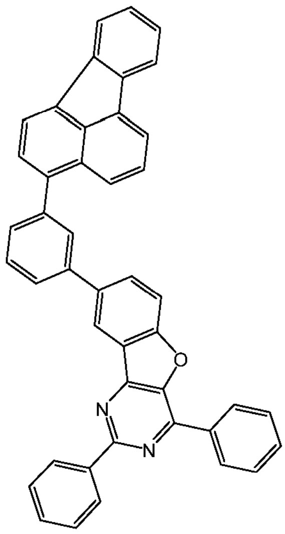 | 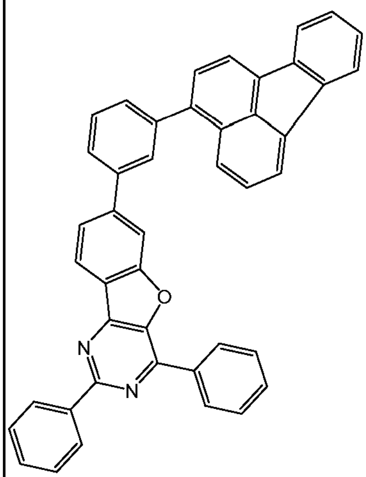 |
| 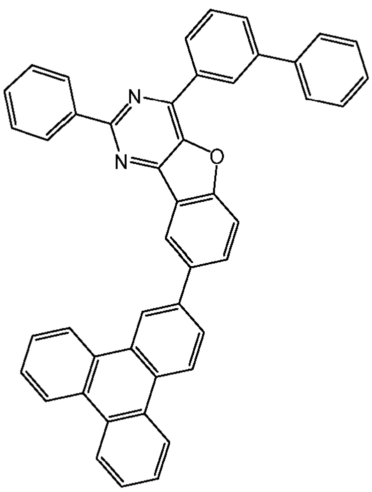 | 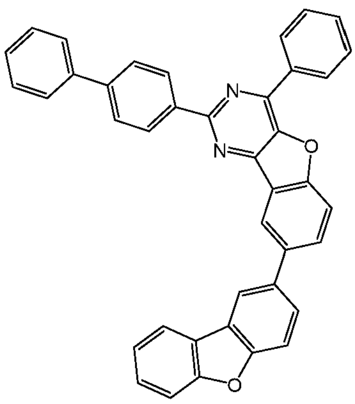 | 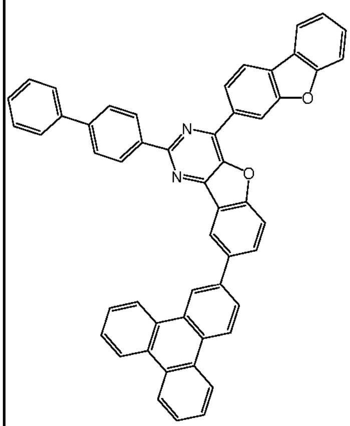 |

| | | |
|---|---|---|
| 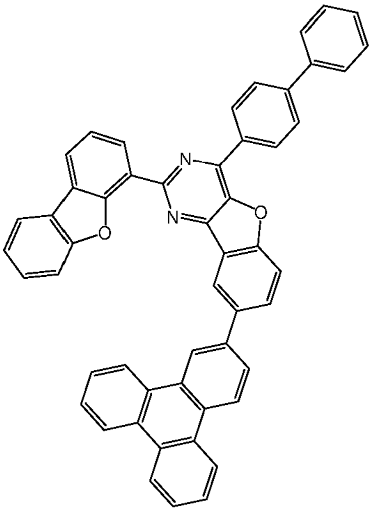 | 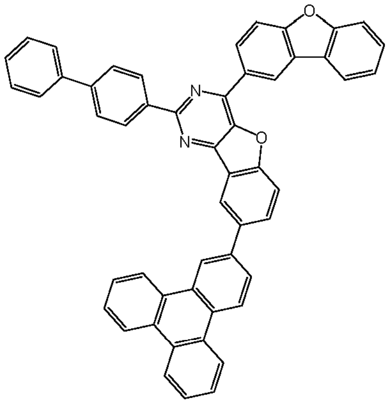 | 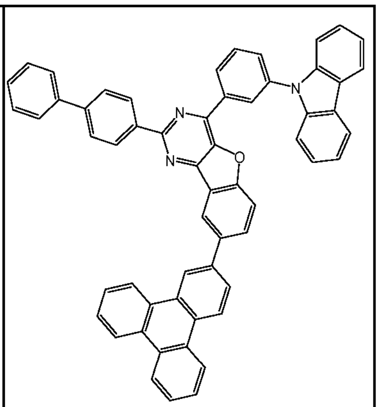 |
| 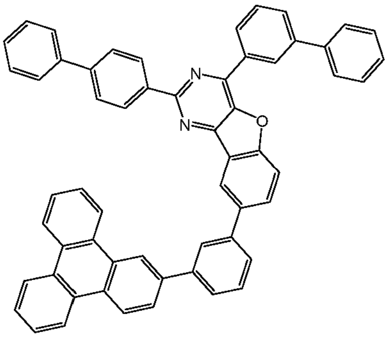 | 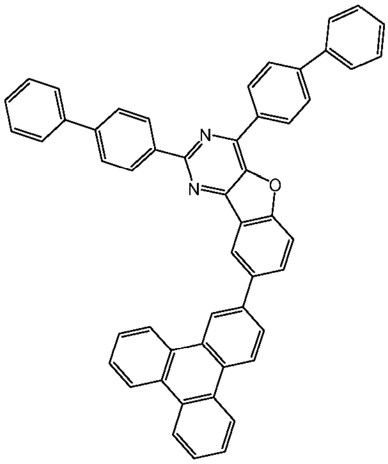 | 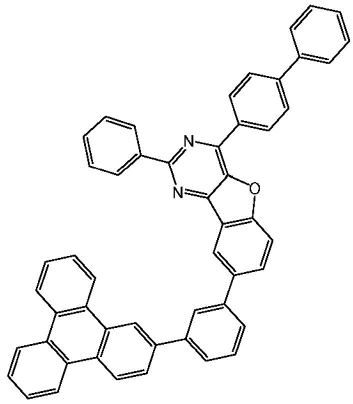 |
| 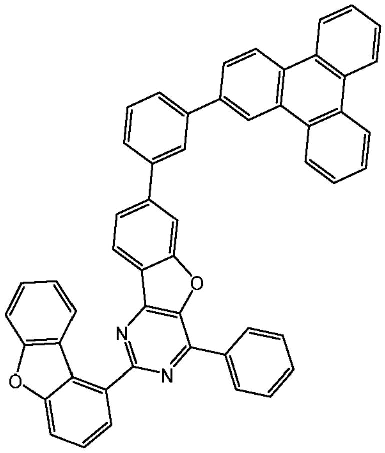 | 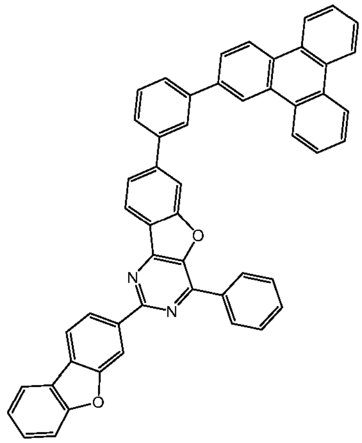 | 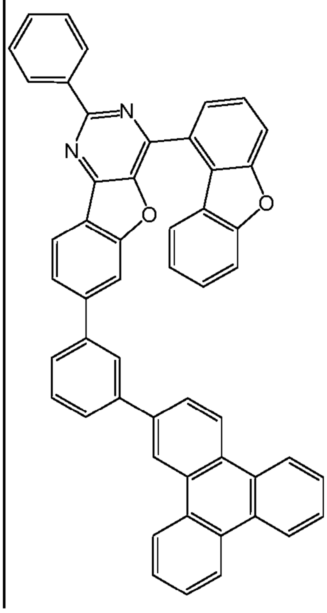 |

| | | |
|---|---|---|
| 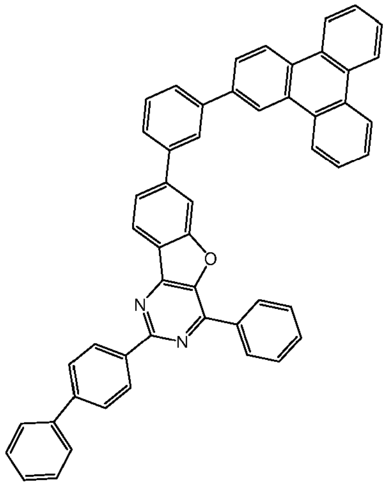 | 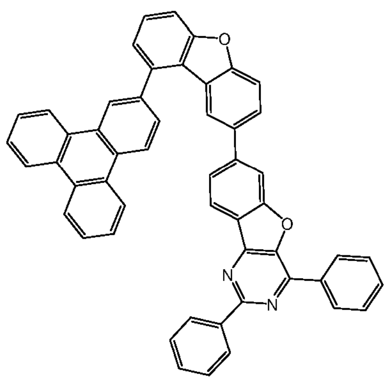 | 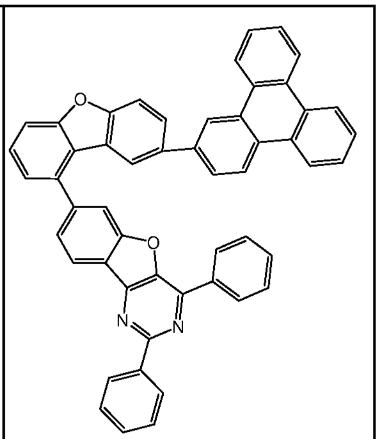 |
| 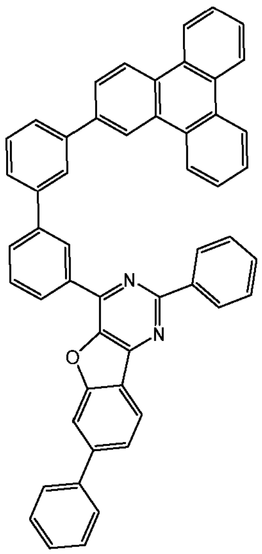 | 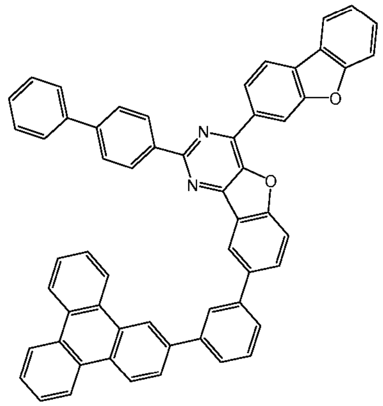 | 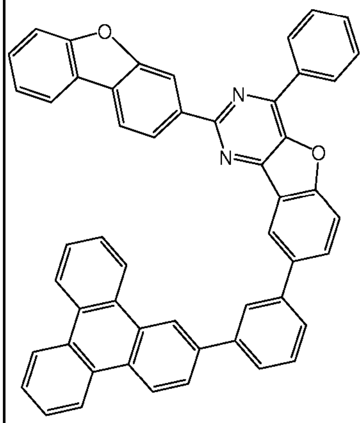 |
| 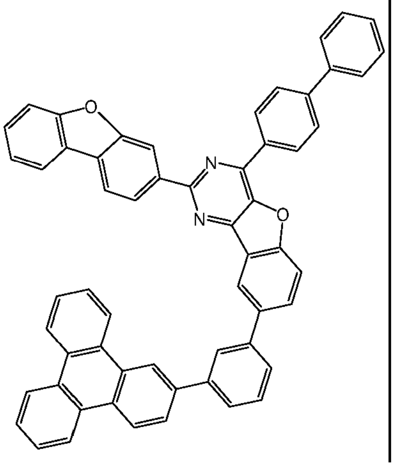 | 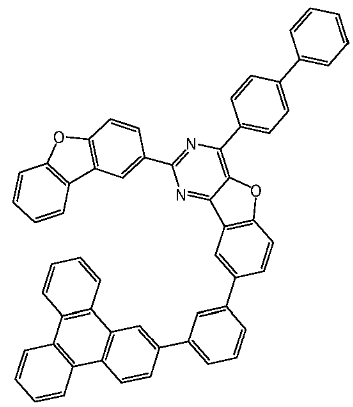 | 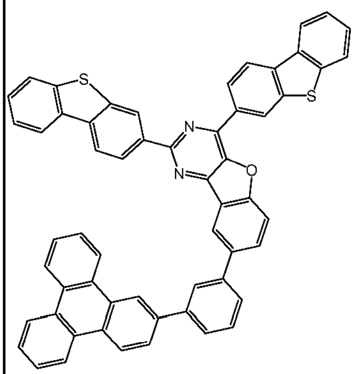 |

| | | |
|---|---|---|
| 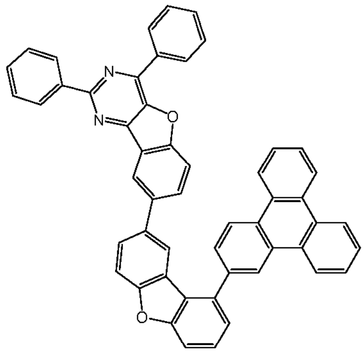 | 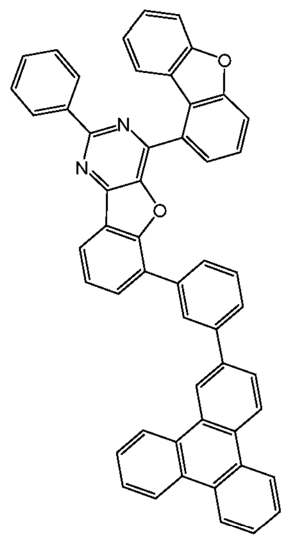 | 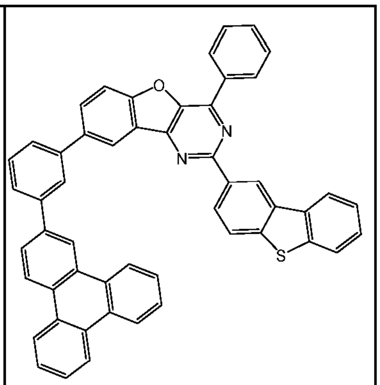 |
| 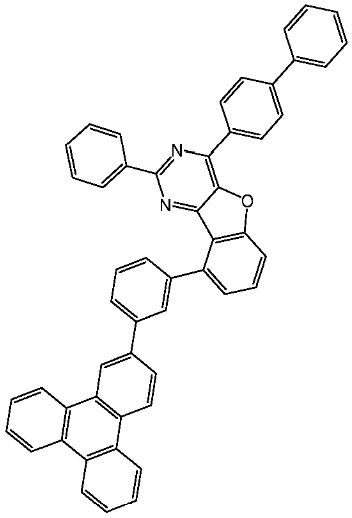 | 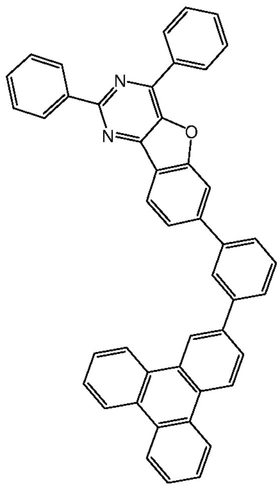 | 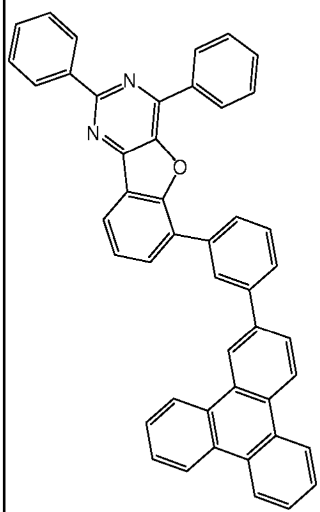 |
| 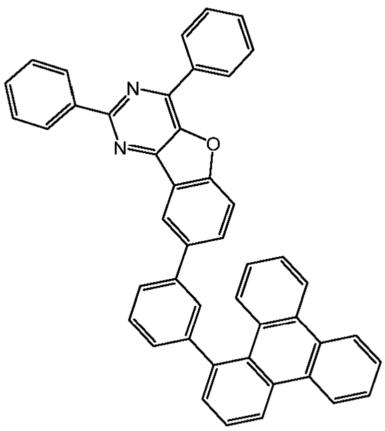 | 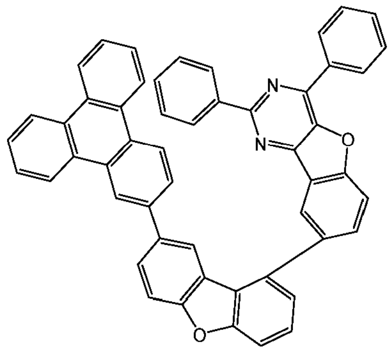 | 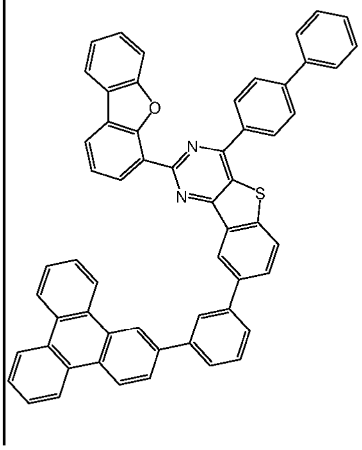 |

| | | |
|---|---|---|
| 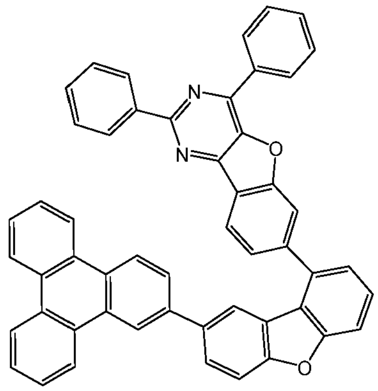 | 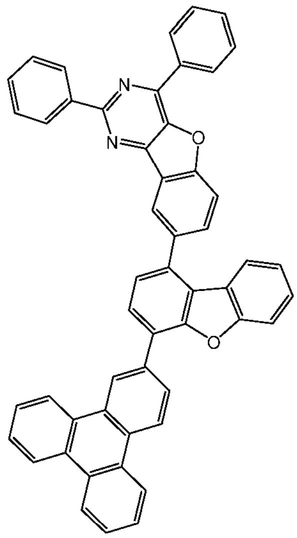 | 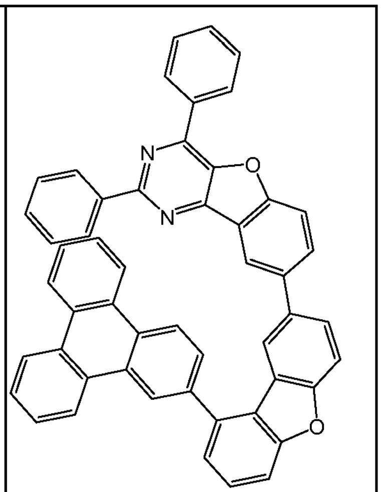 |
| 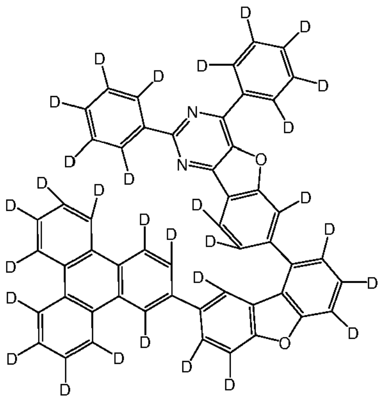 | 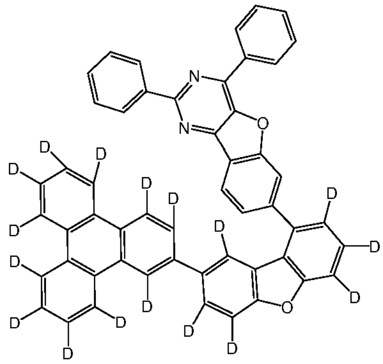 | 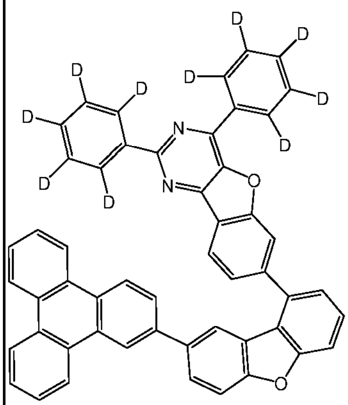 |
| 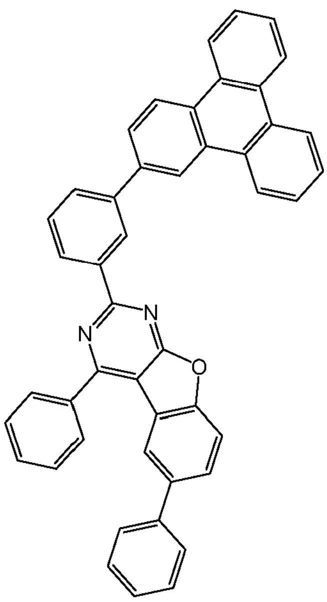 | 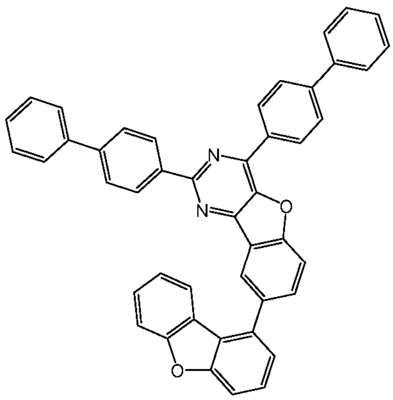 | 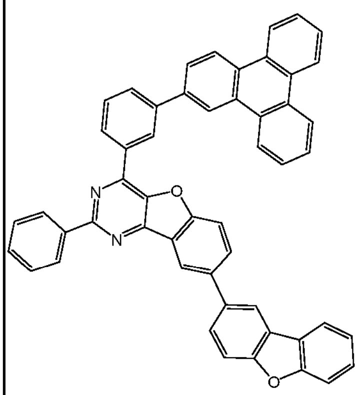 |

| | | |
|---|---|---|
| 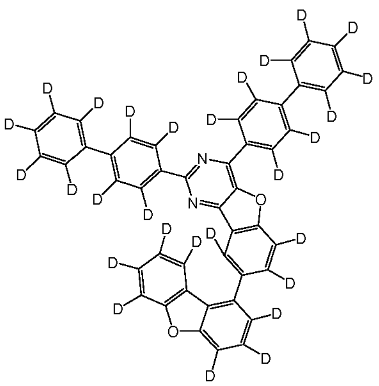 | 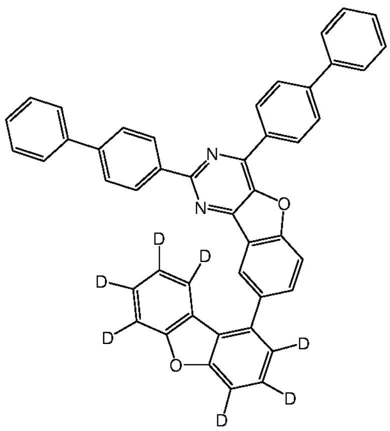 | 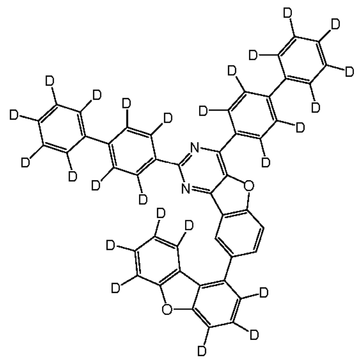 |
| 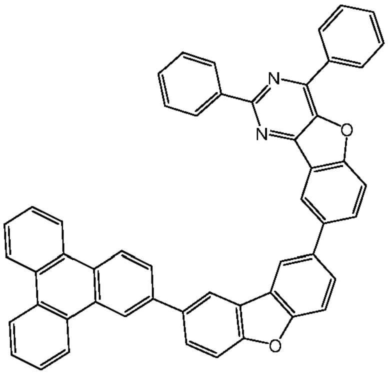 | 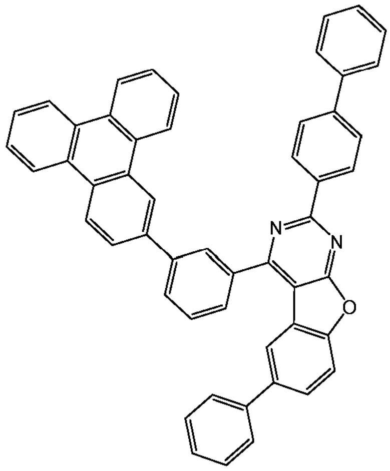 | 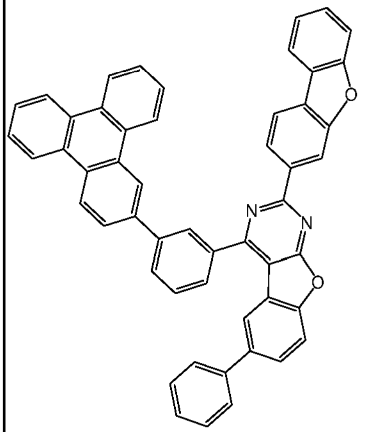 |
| 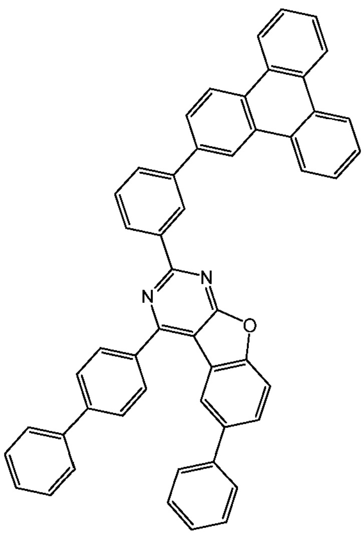 | 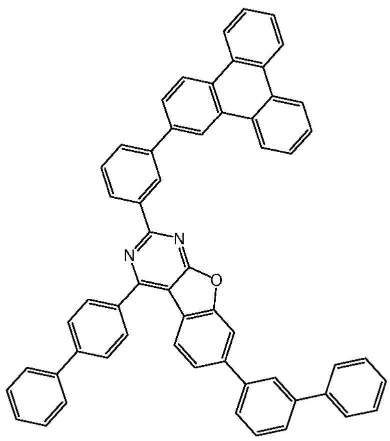 | 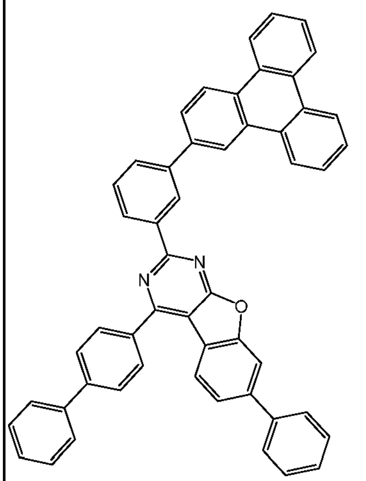 |

| | | |
|---|---|---|
| 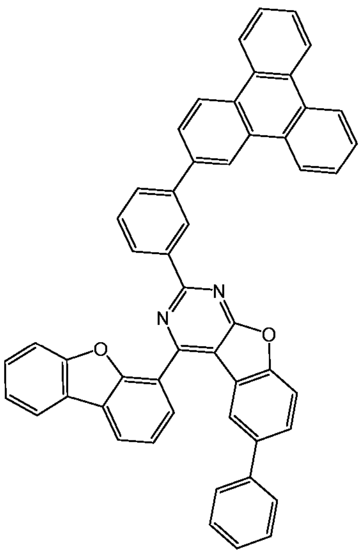 | 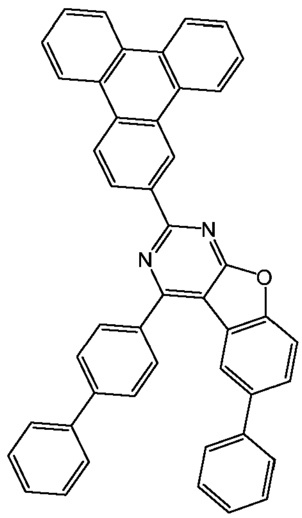 | 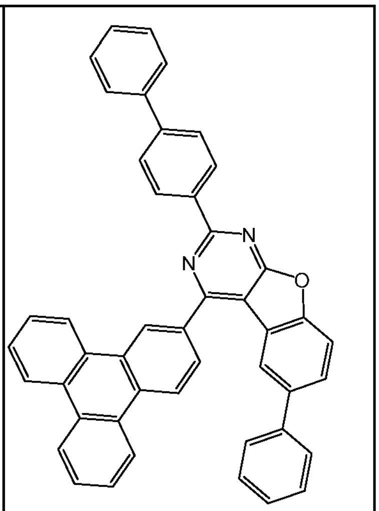 |
| 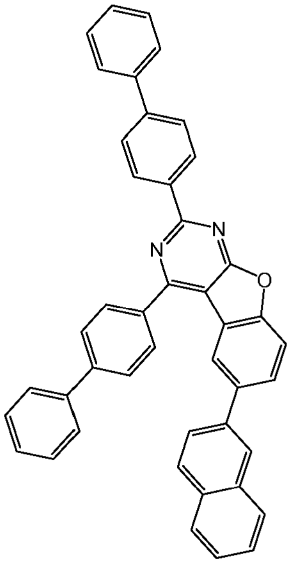 | 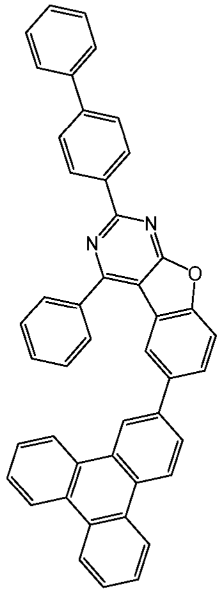 | 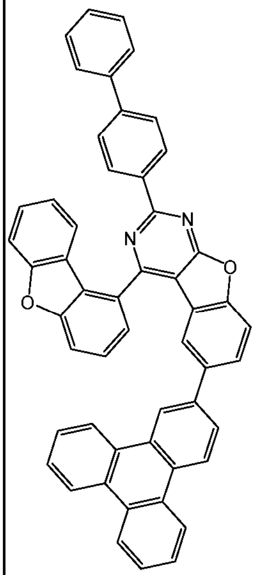 |
| 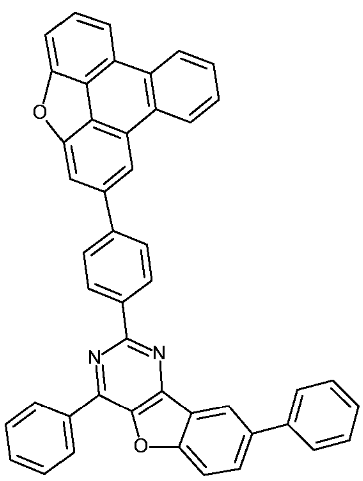 | 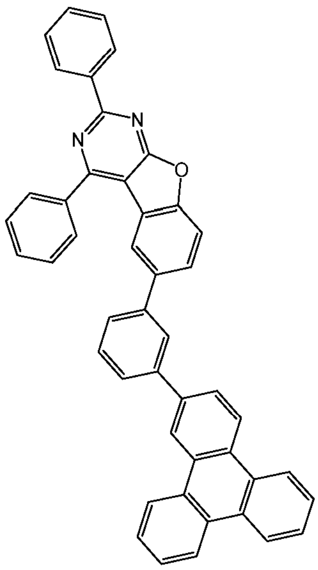 | 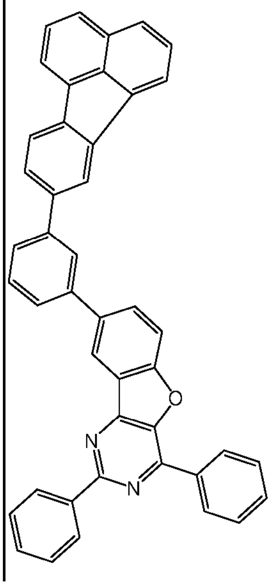 |

| | | |
|---|---|---|
| 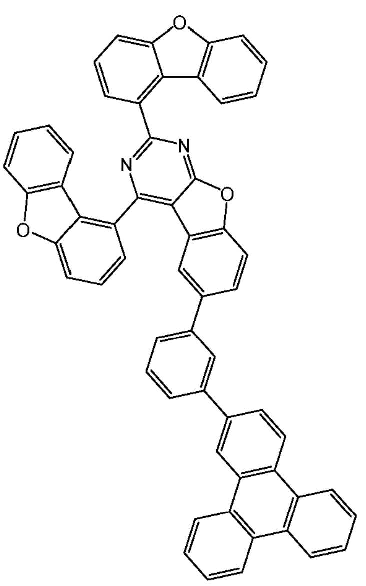 | 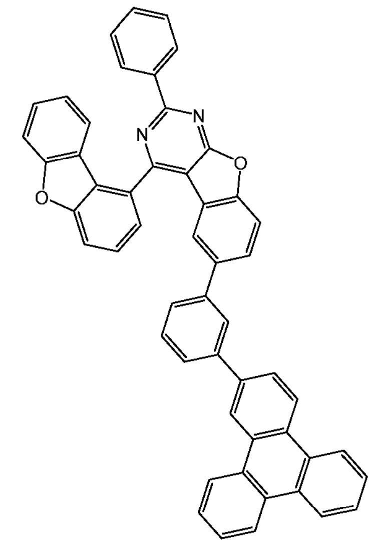 | 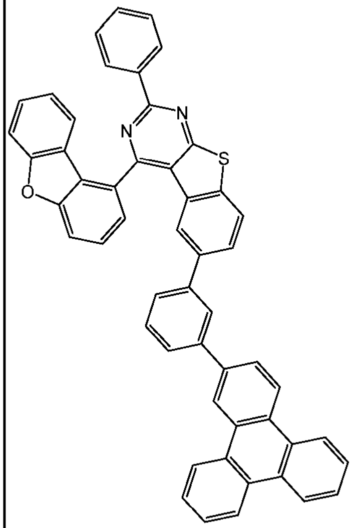 |
| 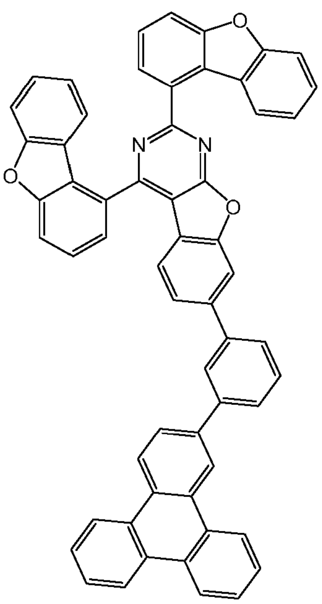 | 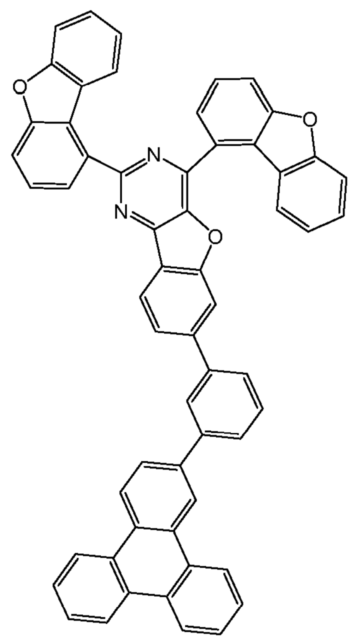 | 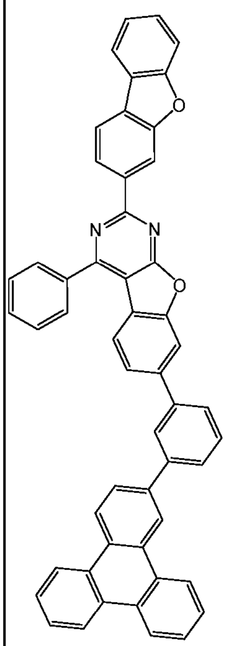 |
| 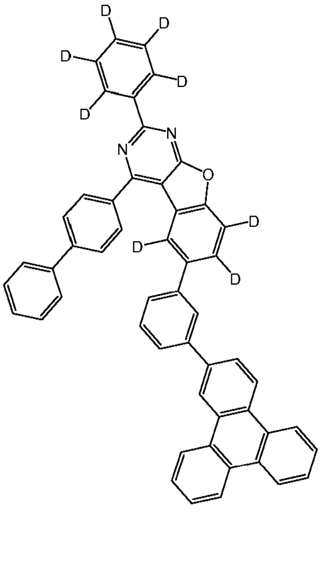 | 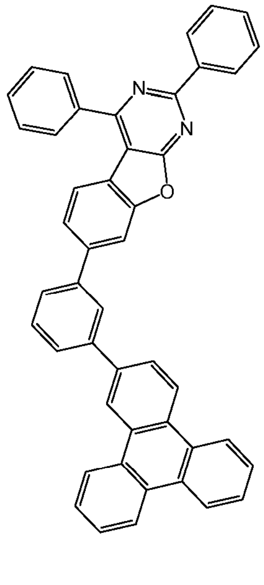 | 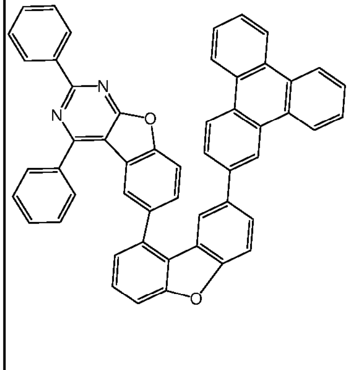 |

| | | |
|---|---|---|
| 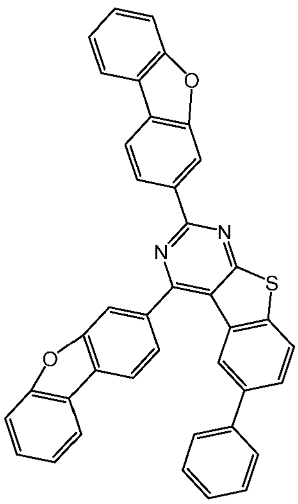 | 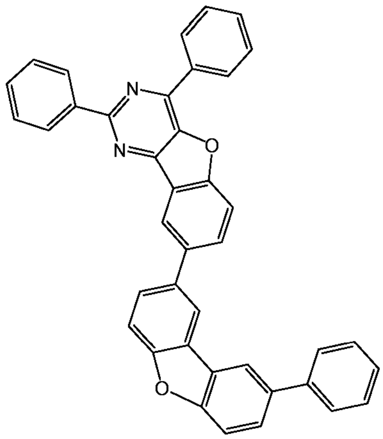 | 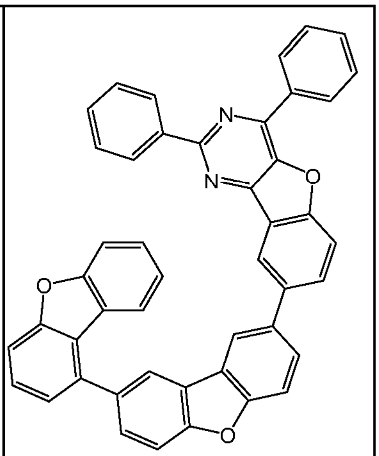 |
| 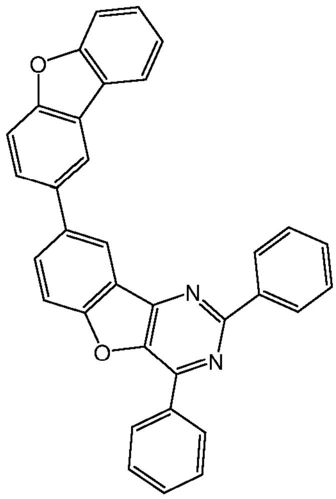 | 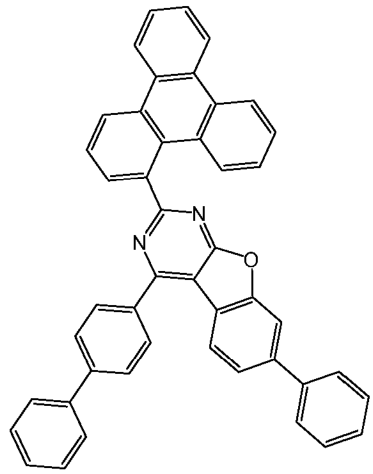 | 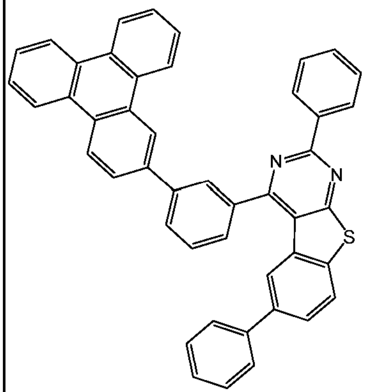 |
| 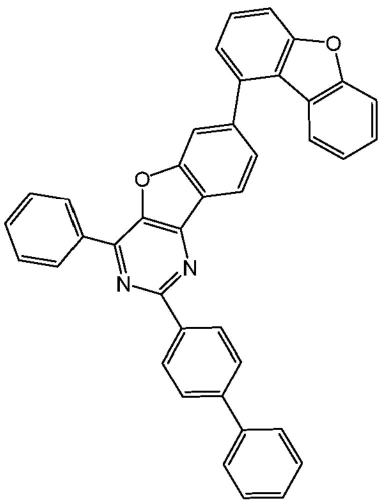 | 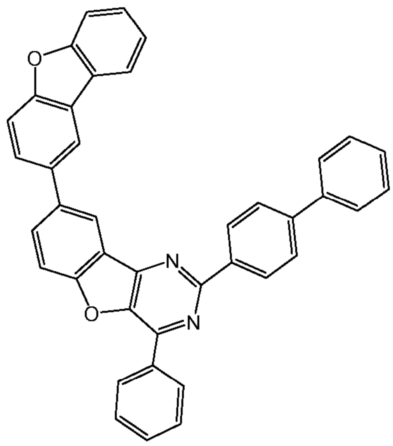 | 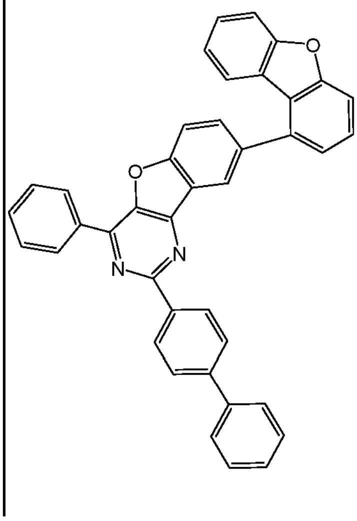 |

| | | |
|---|---|---|
| 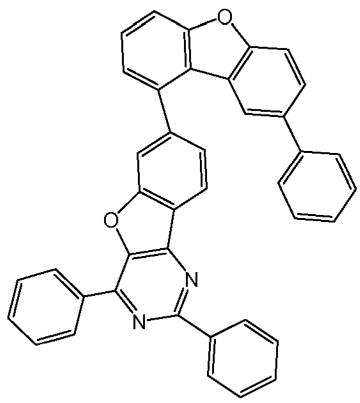 | 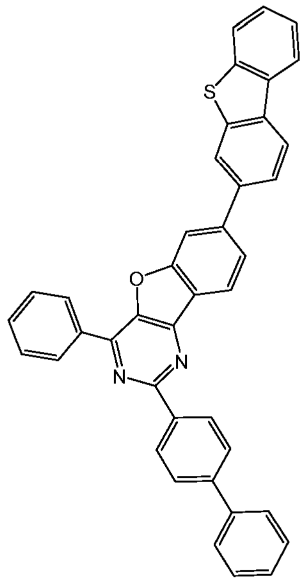 | 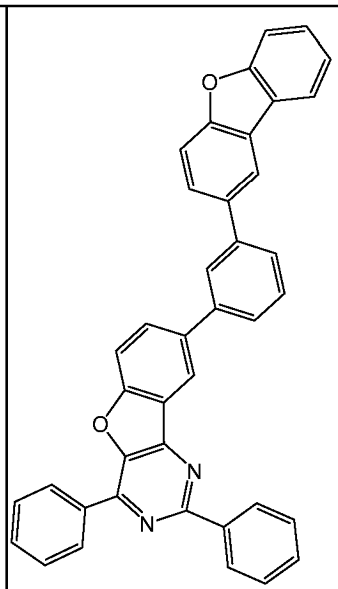 |
| 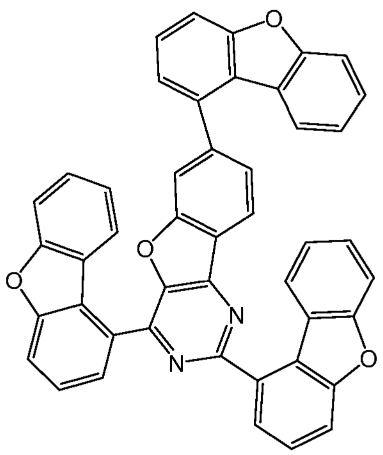 | 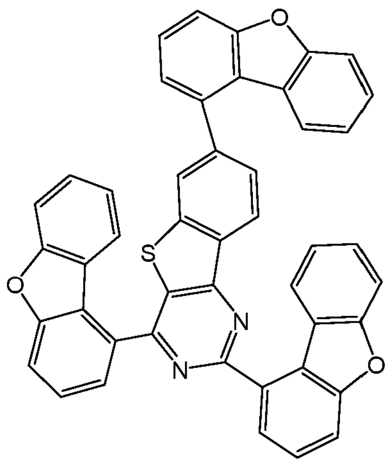 | 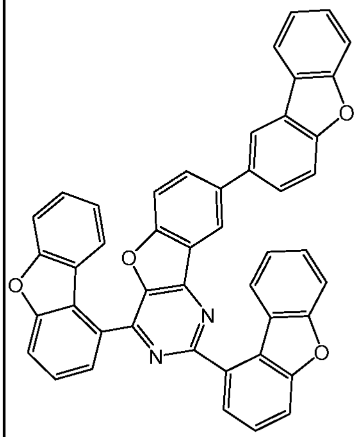 |
| 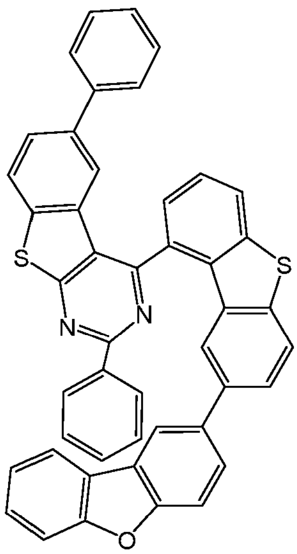 | 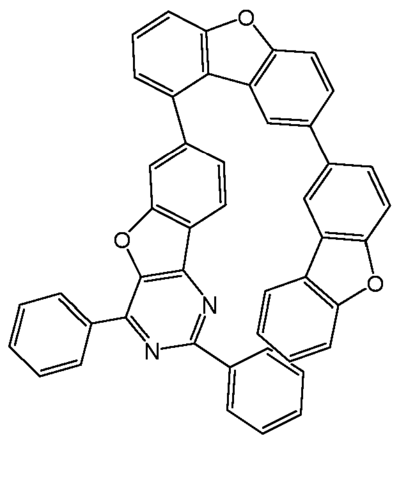 | 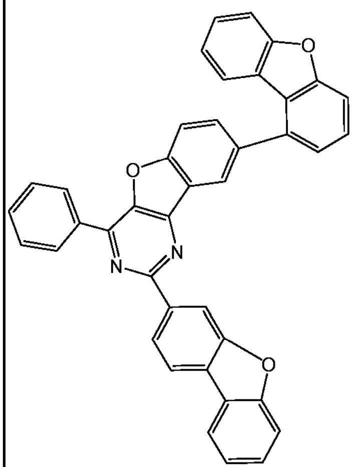 |

| | | |
|---|---|---|
| 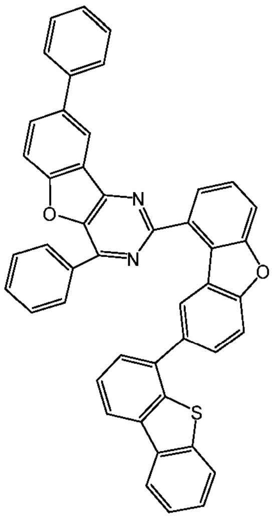 | 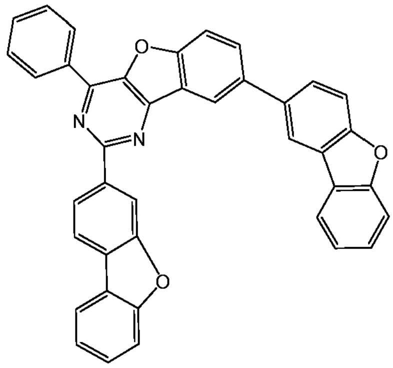 | 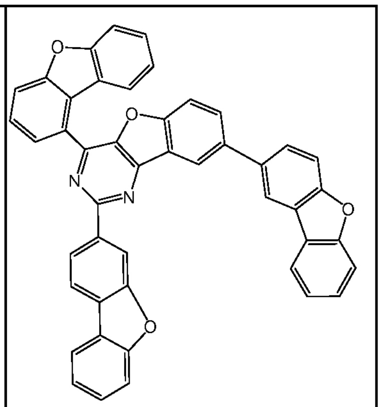 |
| 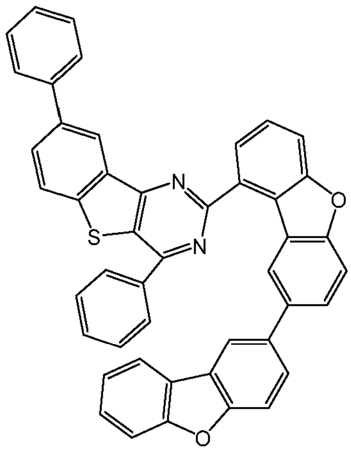 | 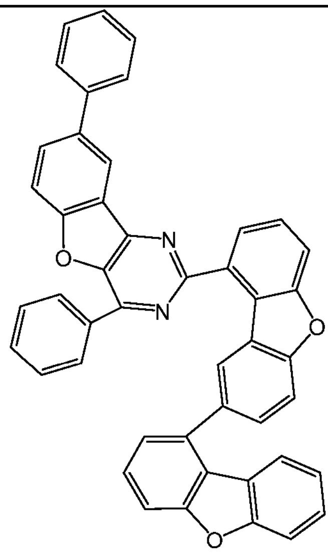 | 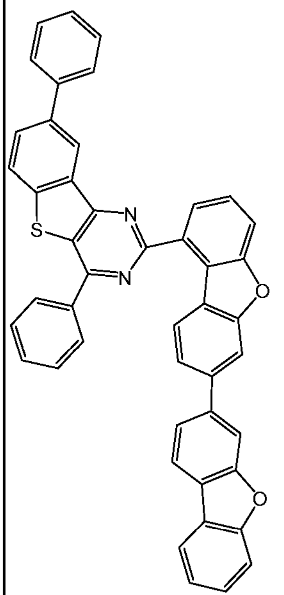 |
| 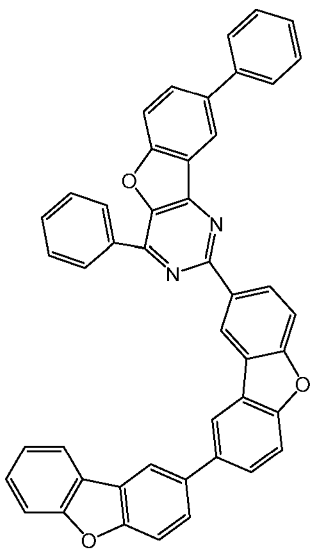 | 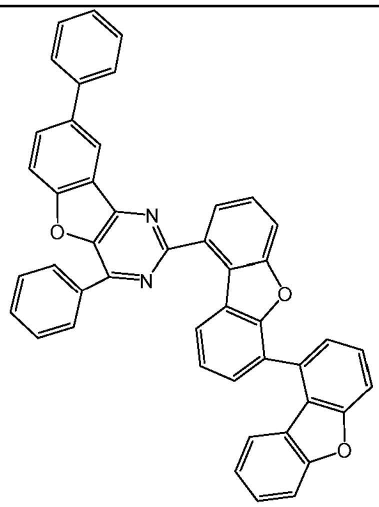 | 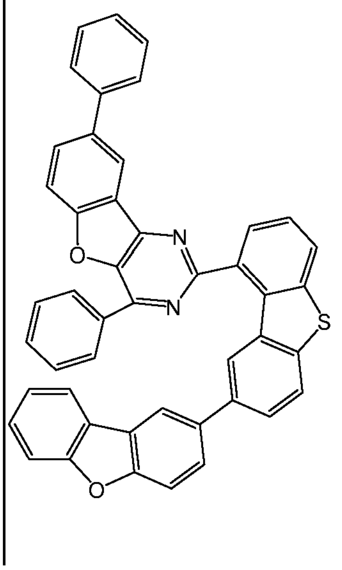 |

| | | |
|---|---|---|
| 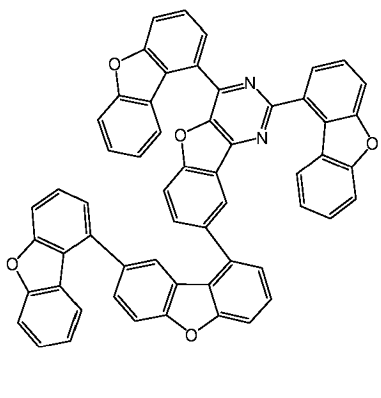 | 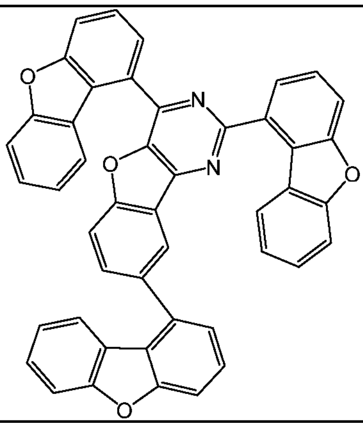 | 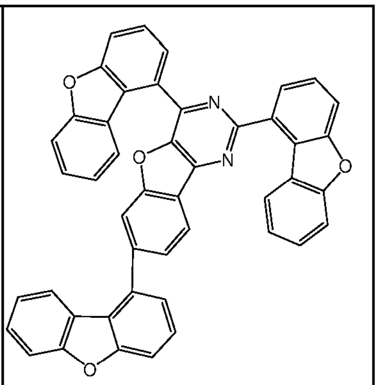 |
| 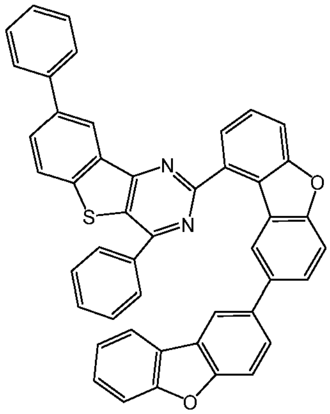 | 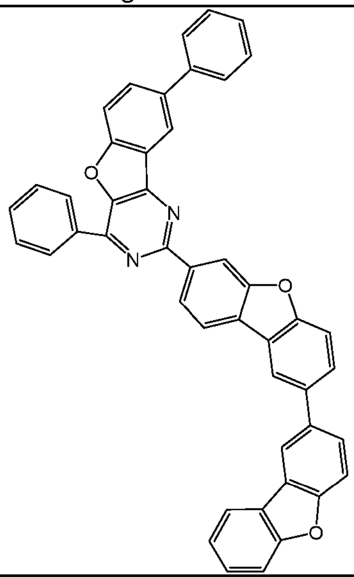 | 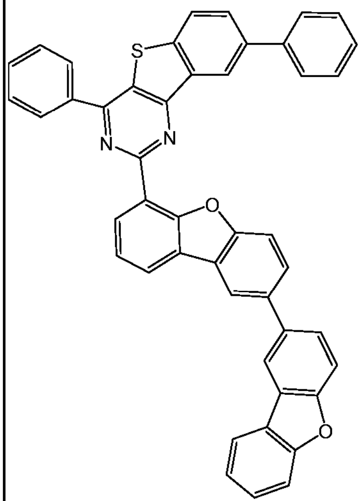 |
| 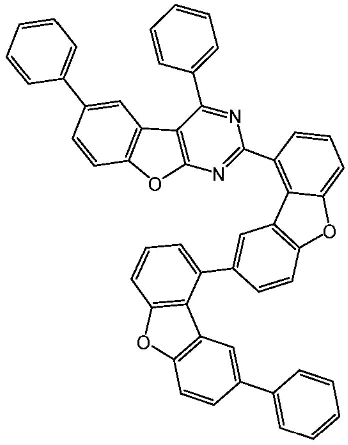 | 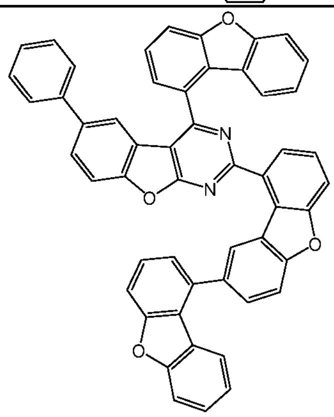 | 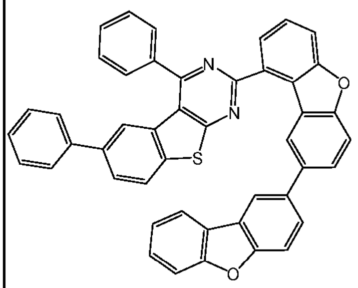 |

| | | |
|---|---|---|
| 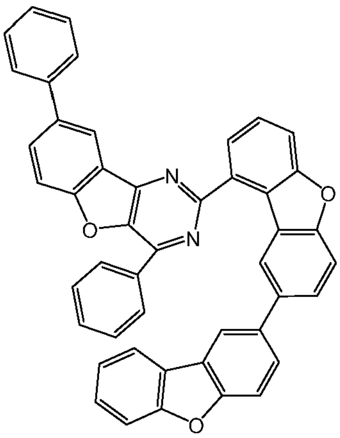 | 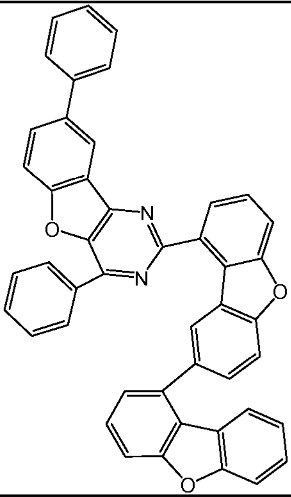 | 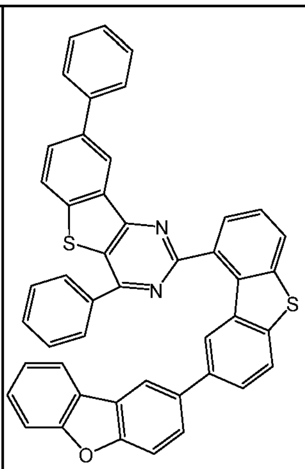 |
| 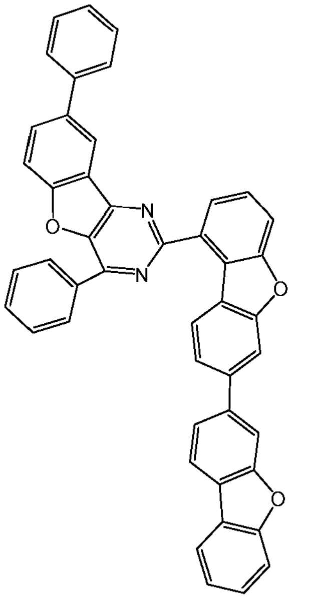 | 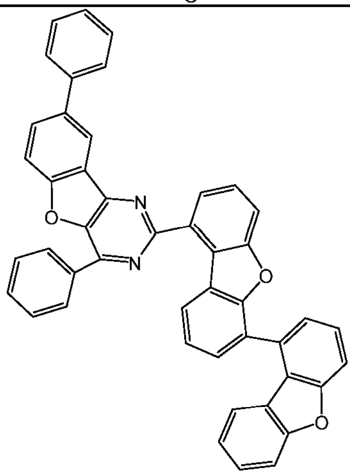 | 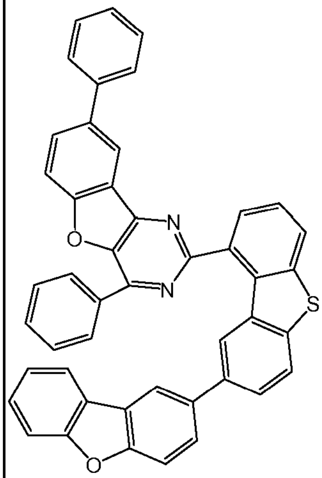 |
| 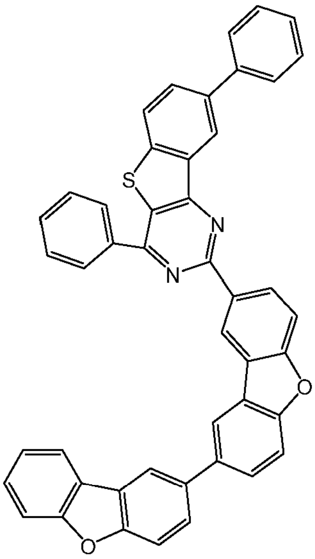 | 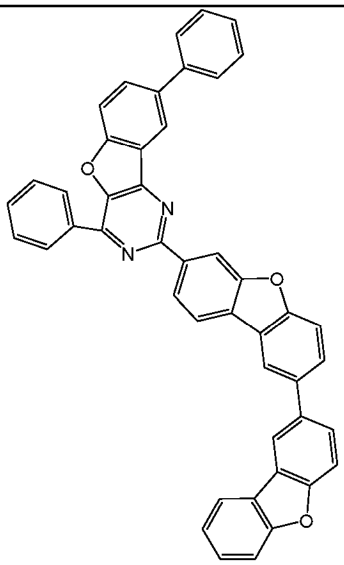 | 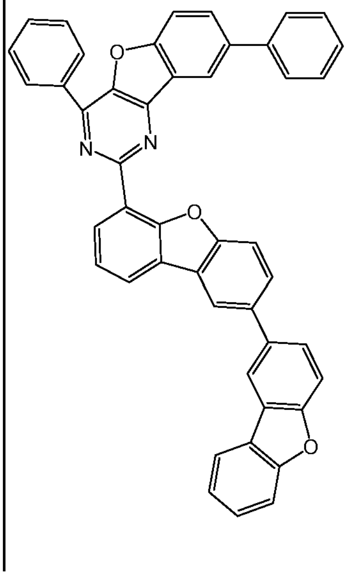 |

| | | |
|---|---|---|
| 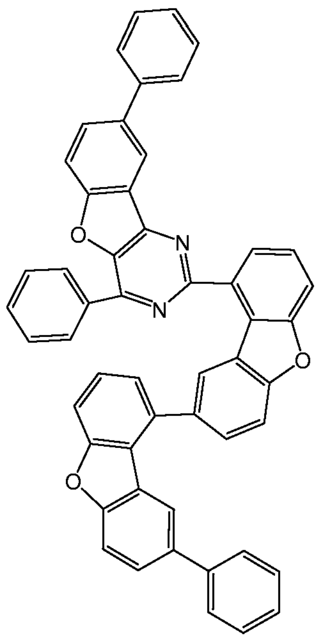 | 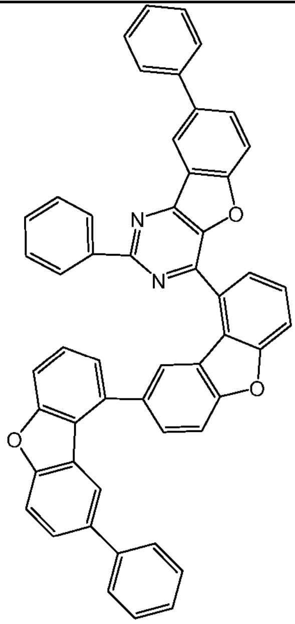 | 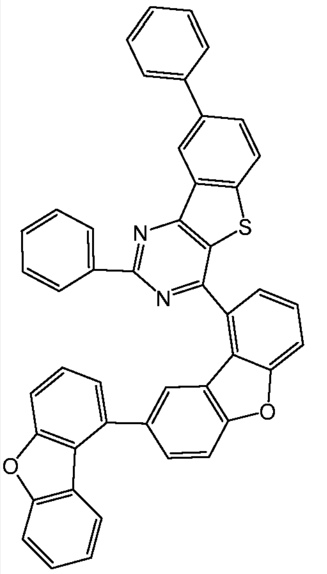 |
| 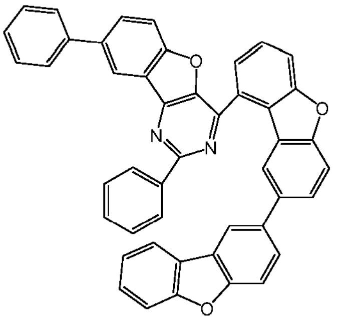 | 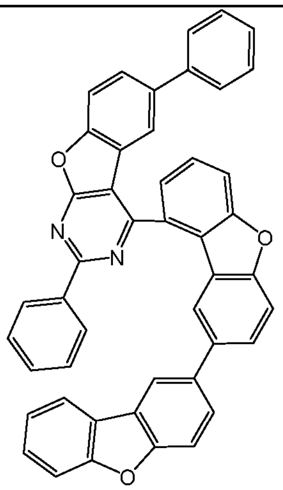 | 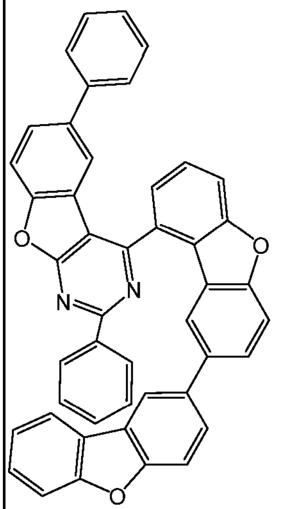 |
| 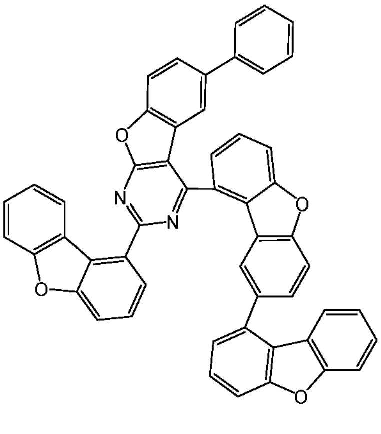 | 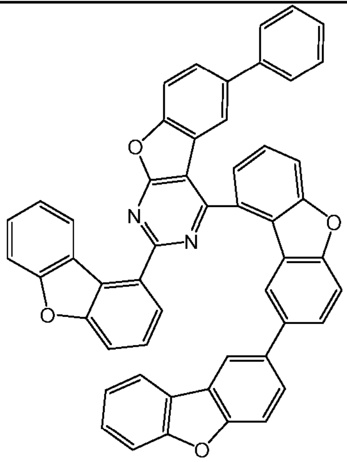 | 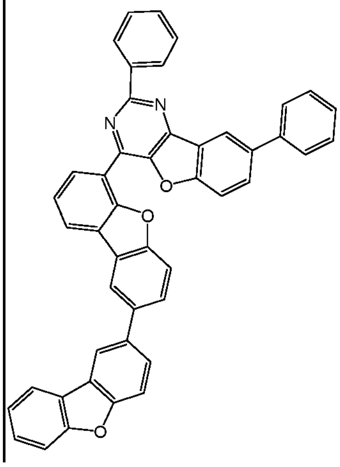 |

| | | |
|---|---|---|
| 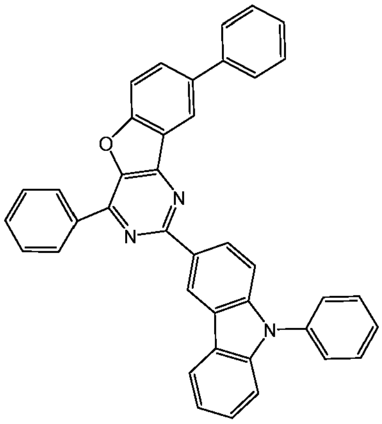 | 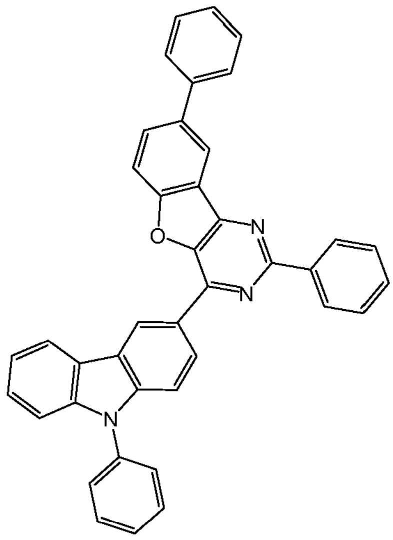 | 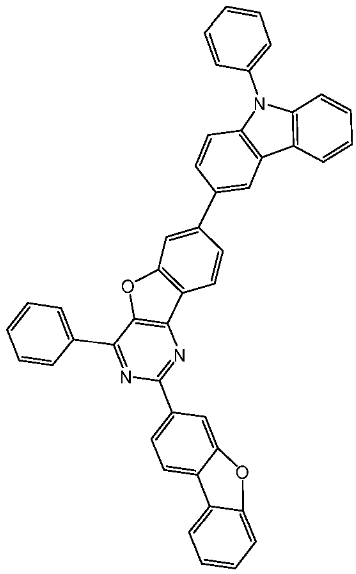 |
| 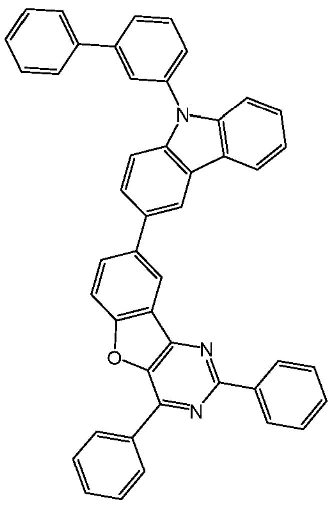 | 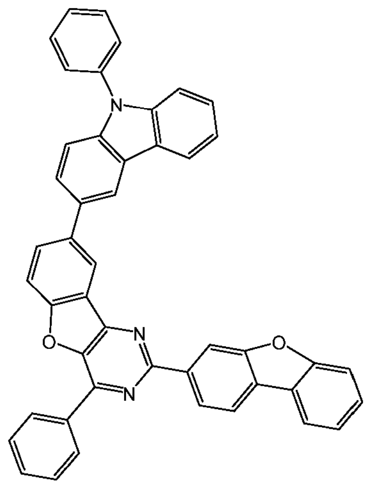 | 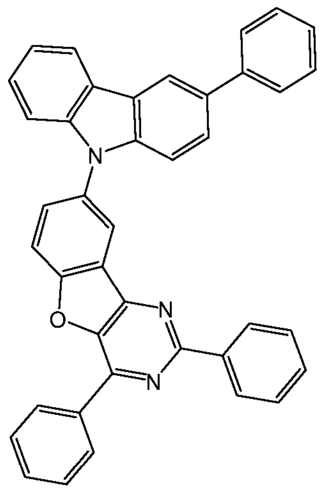 |
| 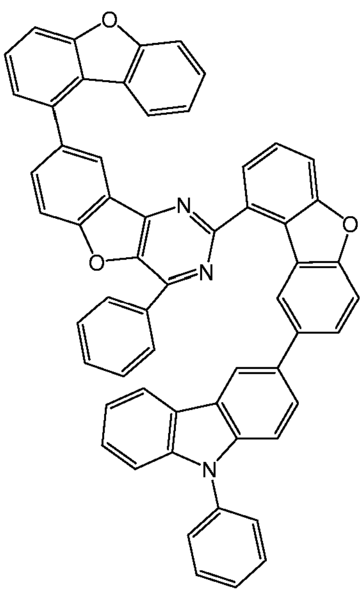 | 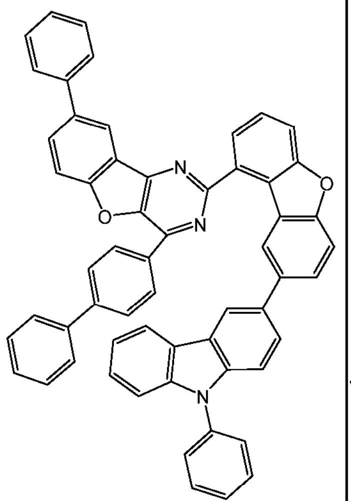 | 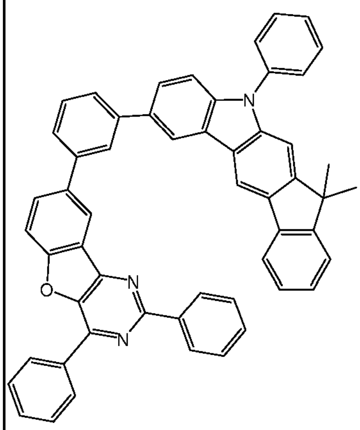 |

| | | |
|---|---|---|
| 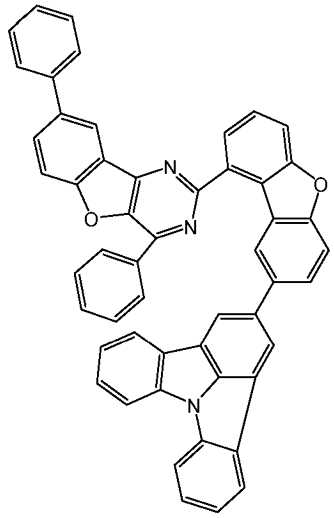 | 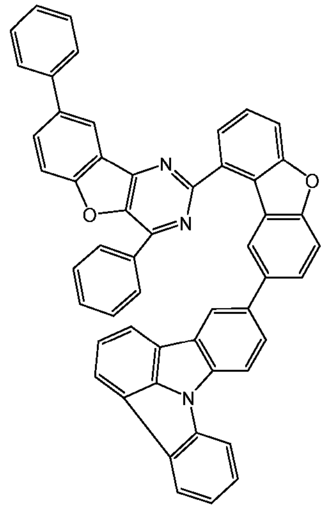 | 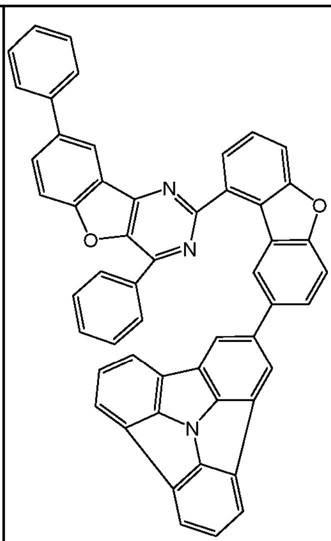 |
| 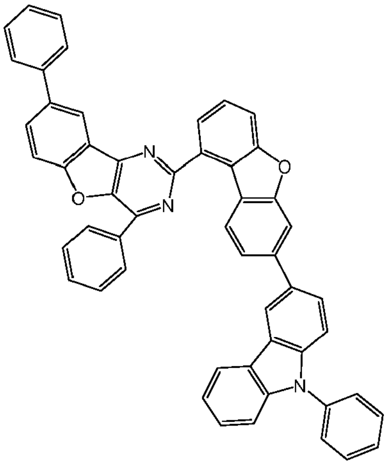 | 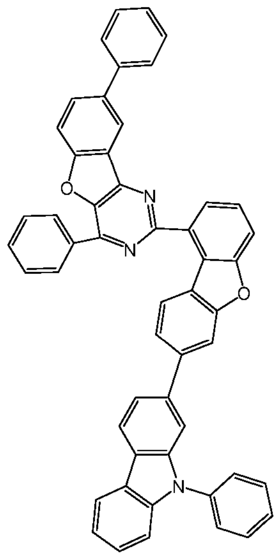 | 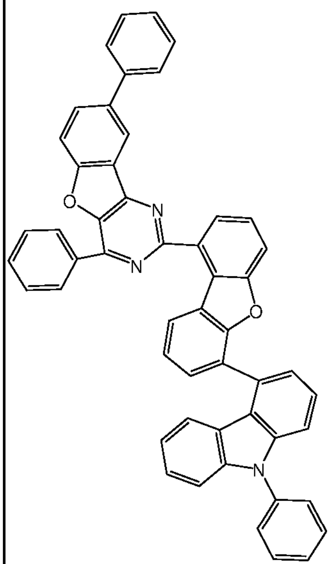 |
| 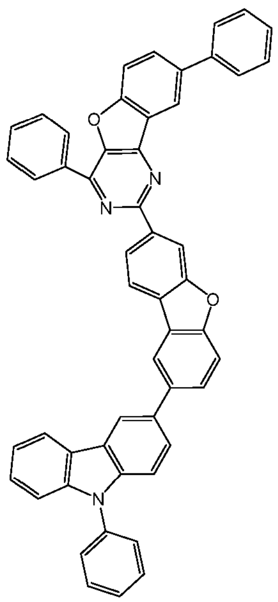 | 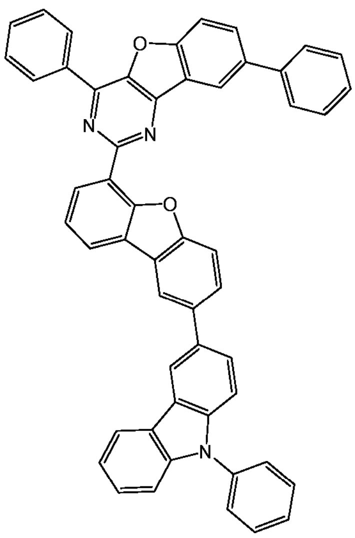 | 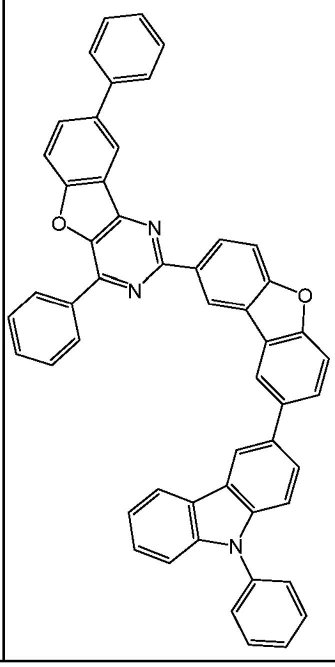 |

| | | |
|---|---|---|
| 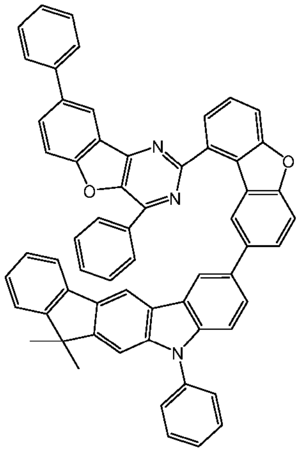 | 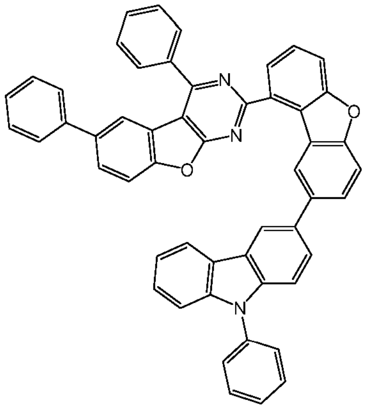 | 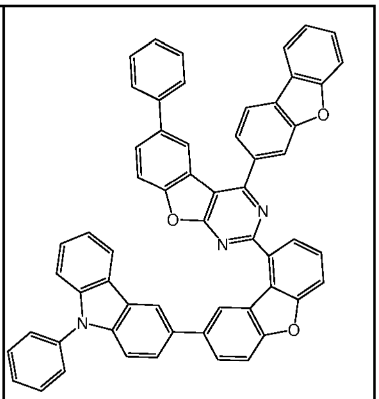 |
| 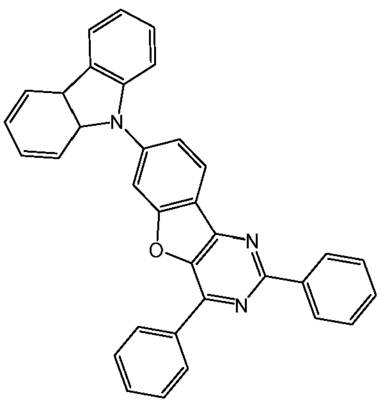 | 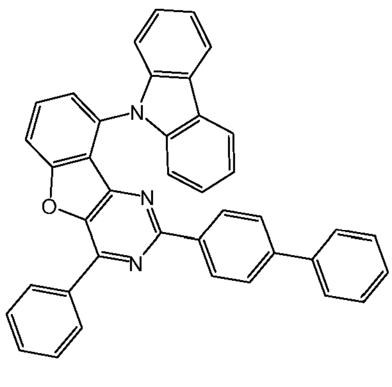 | 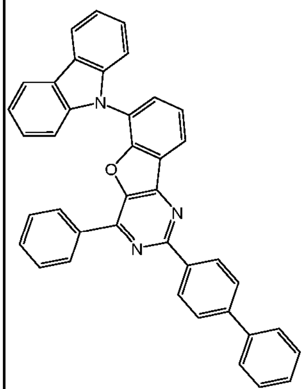 |
| 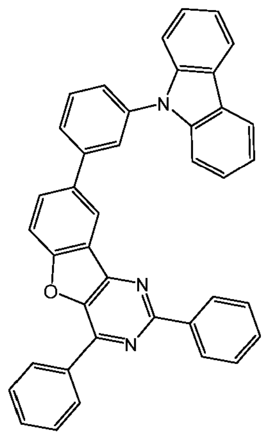 | 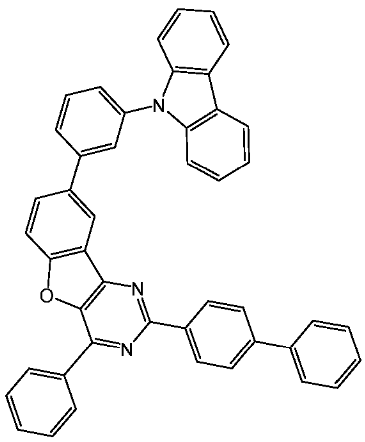 | 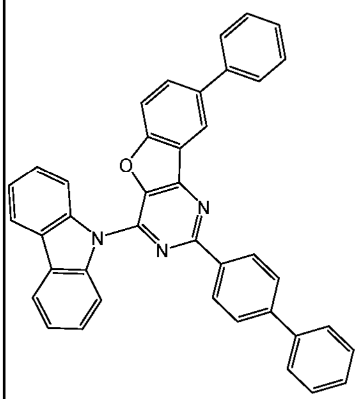 |
| 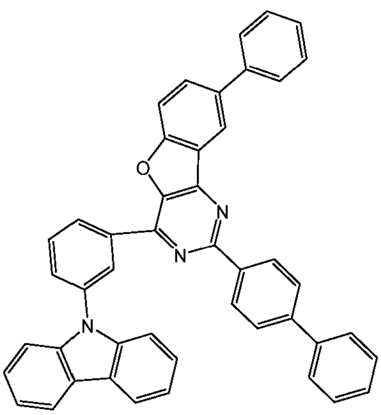 | 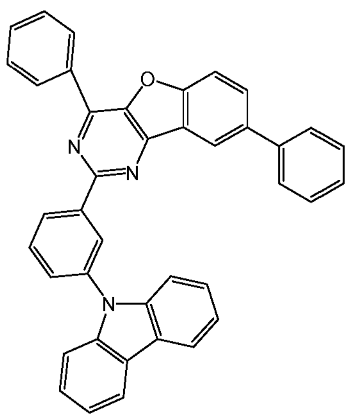 | 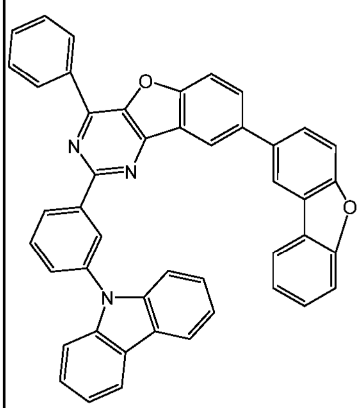 |

| | | |
|---|---|---|
| 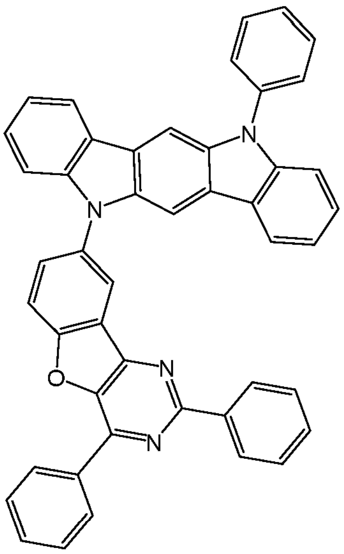 | 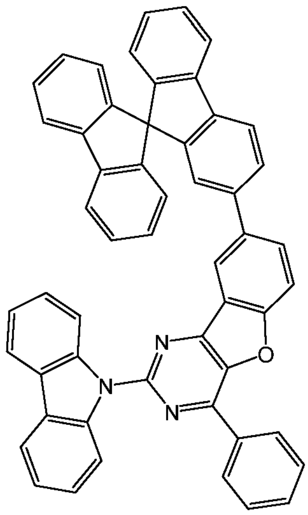 | 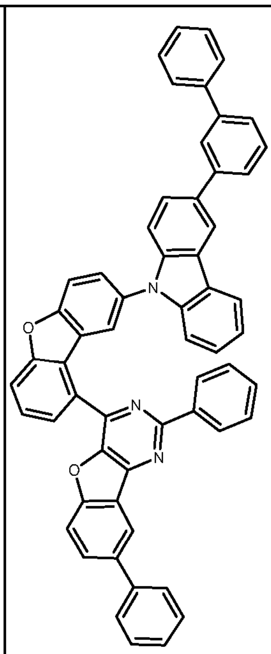 |
| 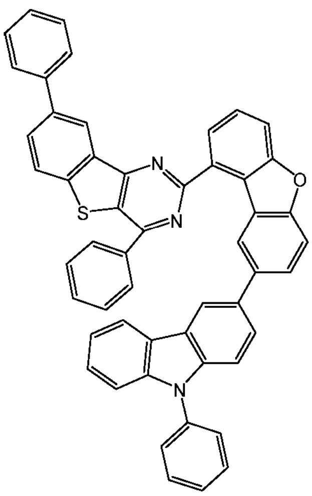 | 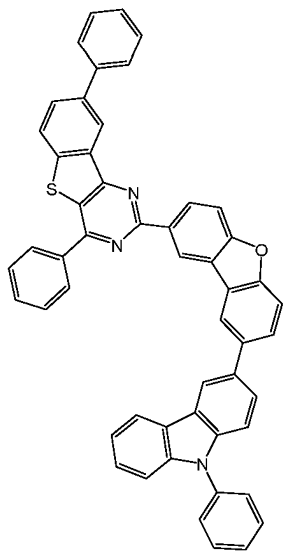 | 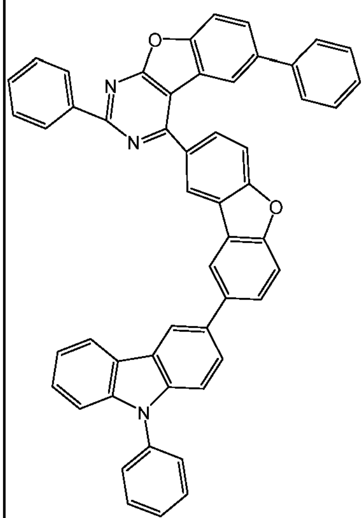 |
| 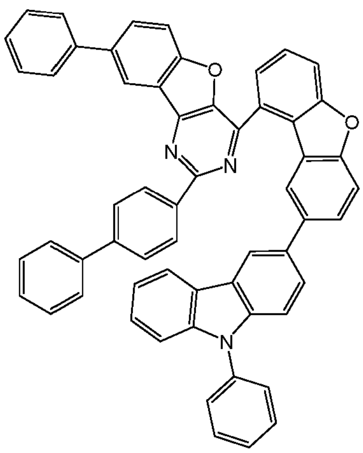 | 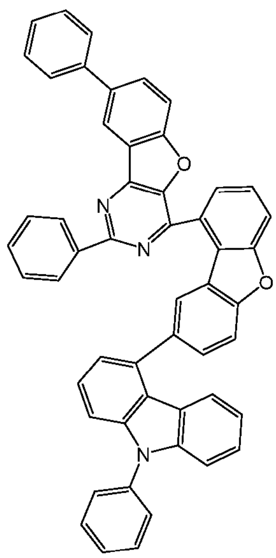 | 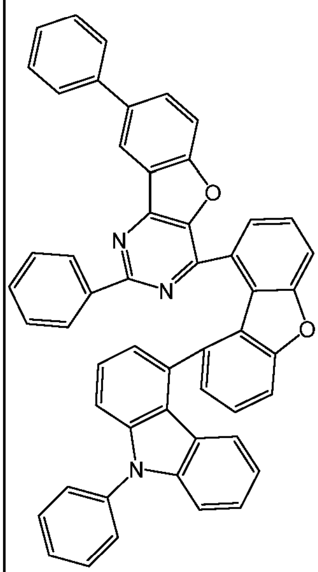 |

| | | |
|---|---|---|
| 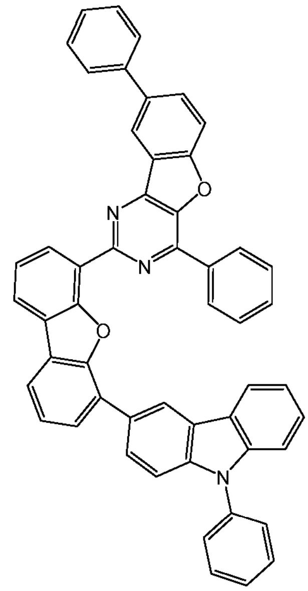 | 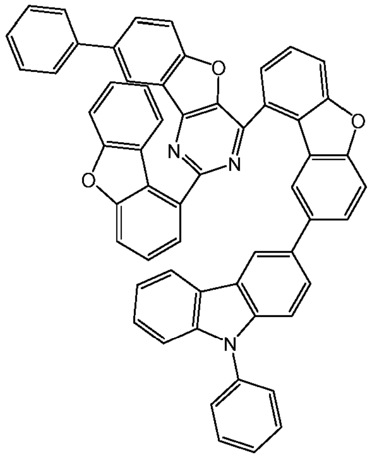 | 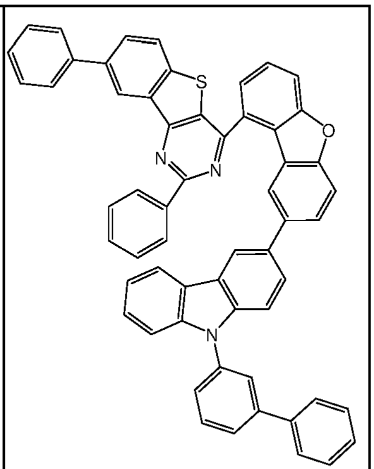 |
| 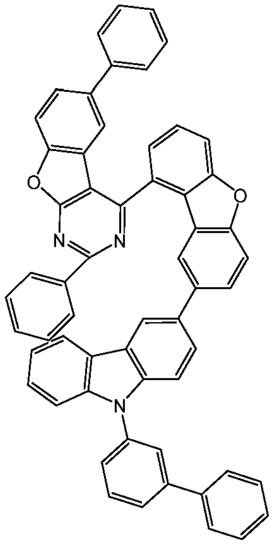 | 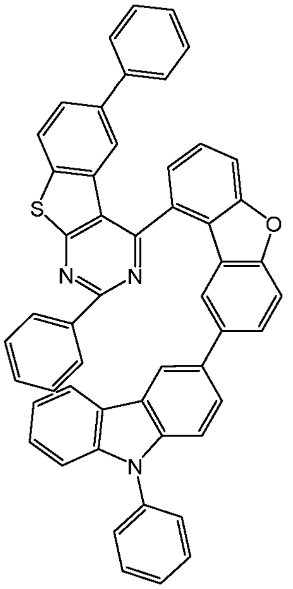 | 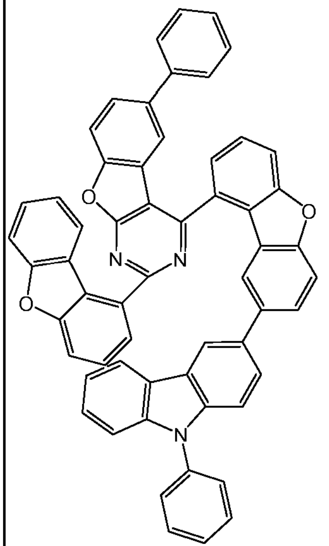 |
| 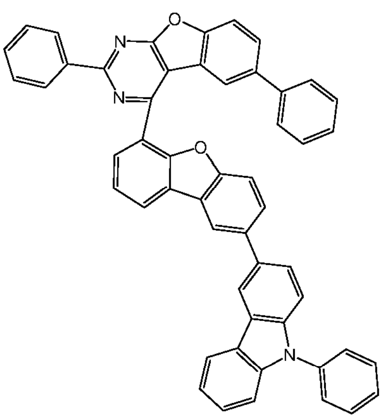 | 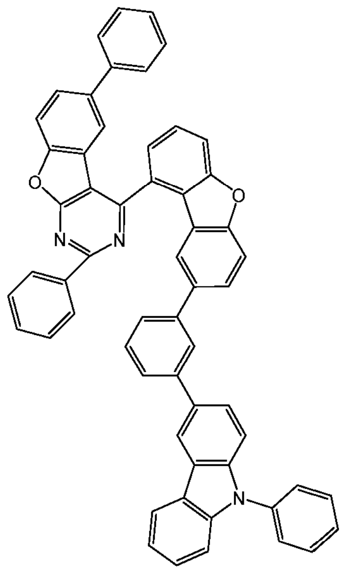 | 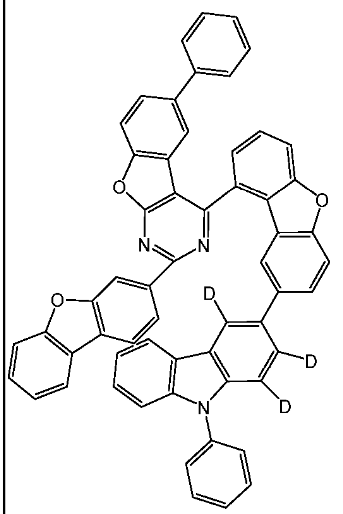 |

| | | |
|---|---|---|
| 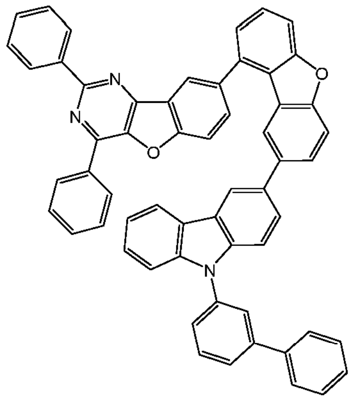 | 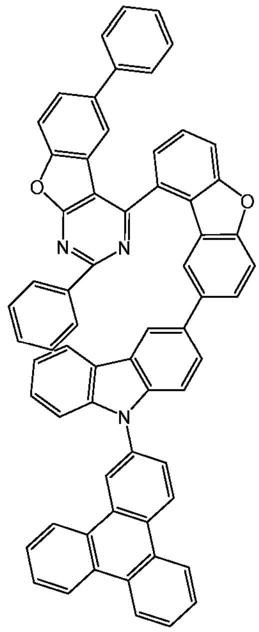 | 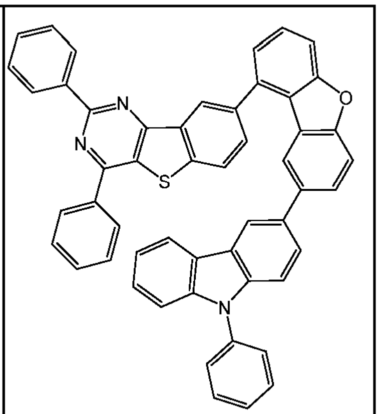 |
| 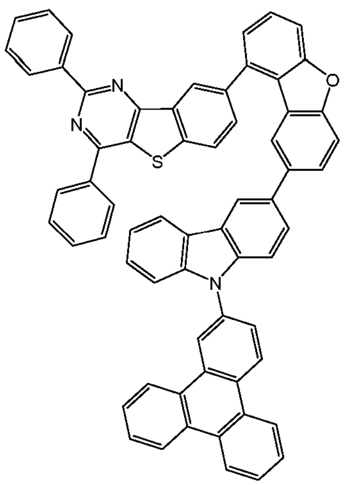 | 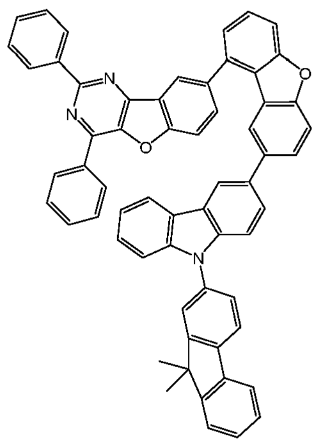 | 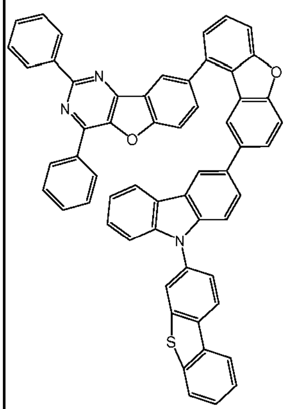 |
| 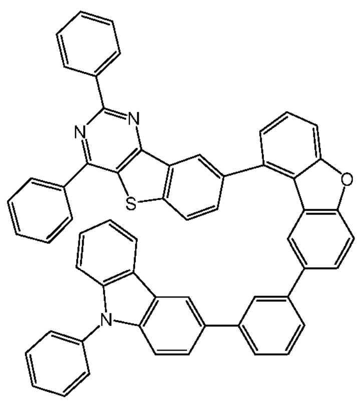 | 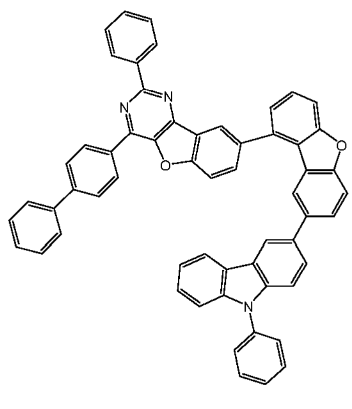 | 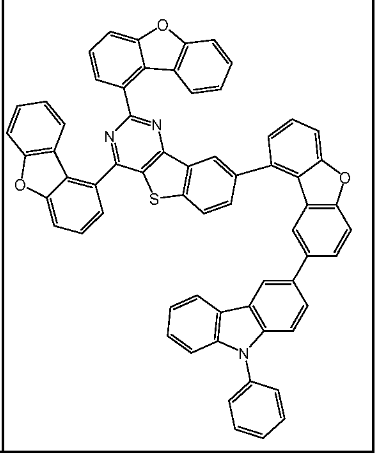 |

| | | |
|---|---|---|
| 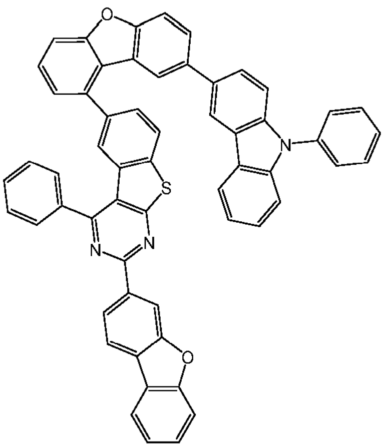 | 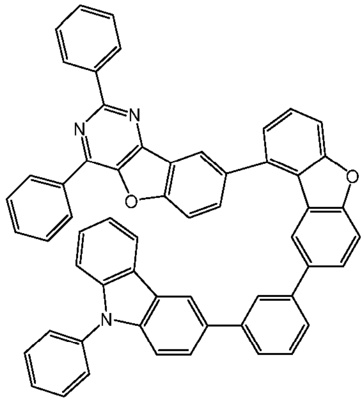 | 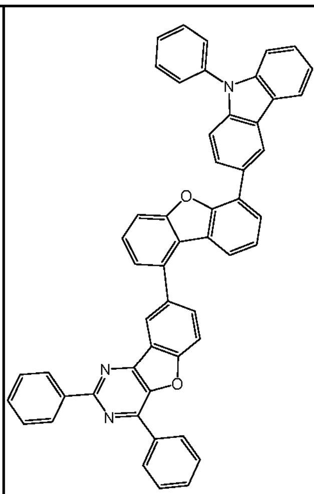 |
| 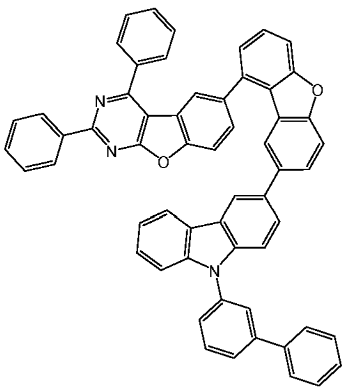 | 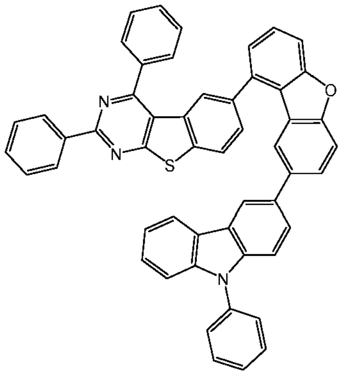 | 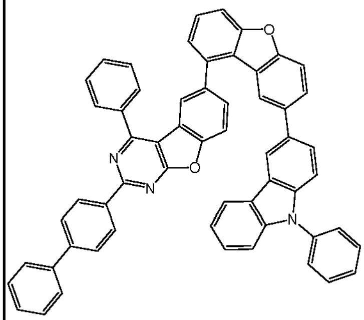 |
| 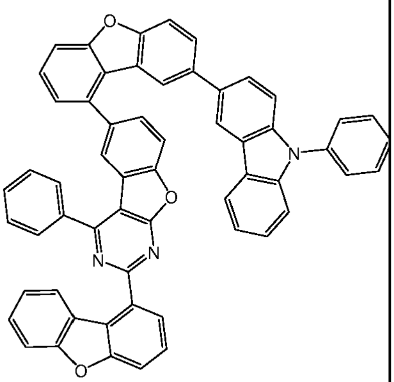 | 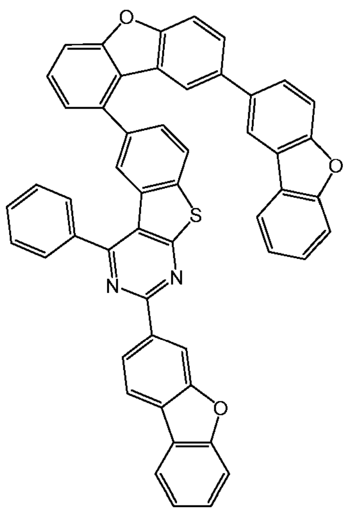 | 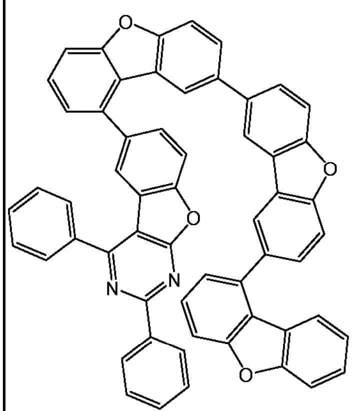 |

| | | |
|---|---|---|
| 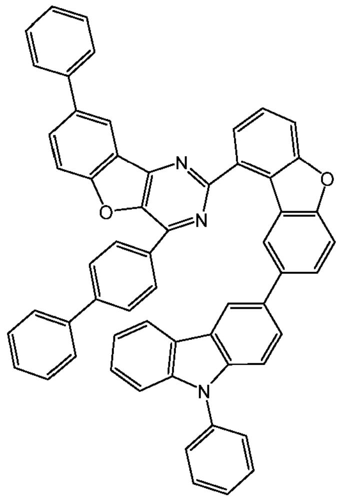 | 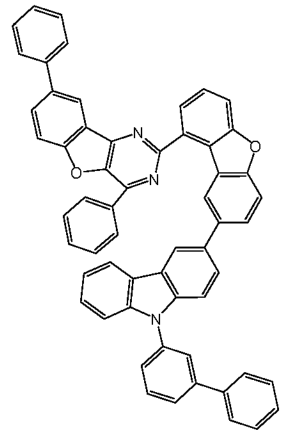 | 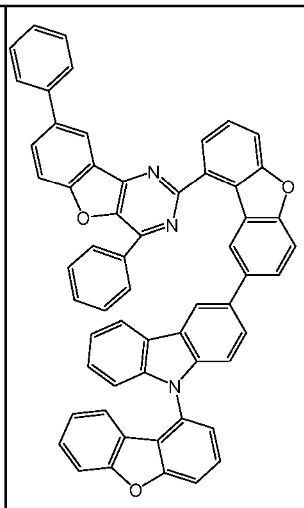 |
| 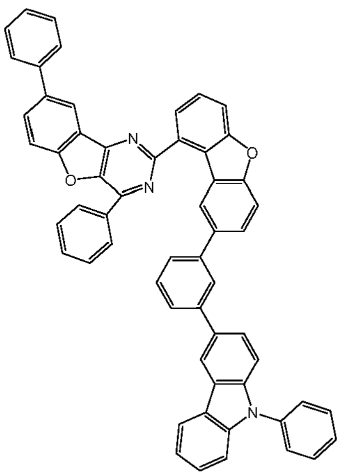 | 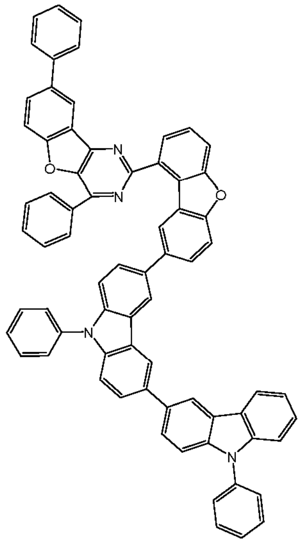 | 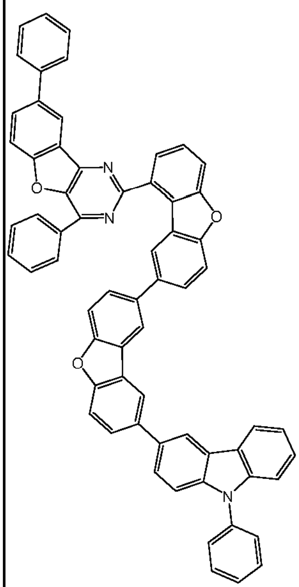 |
| 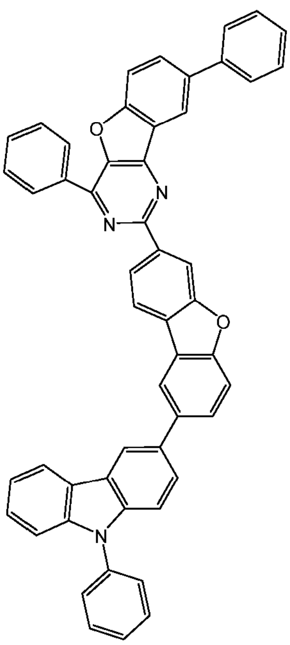 | 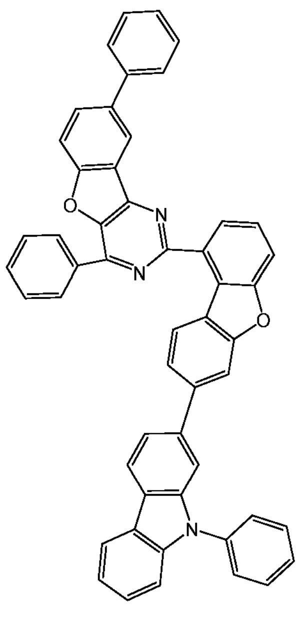 | 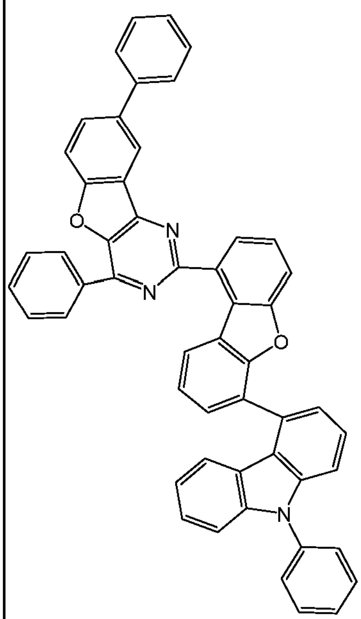 |

| | | |
|---|---|---|
| 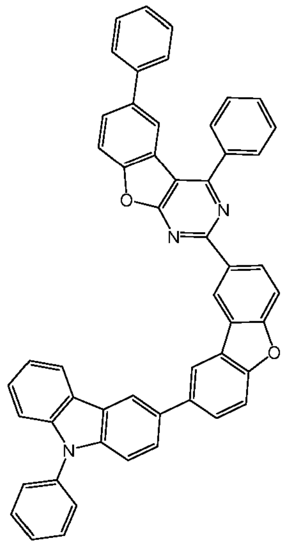 | 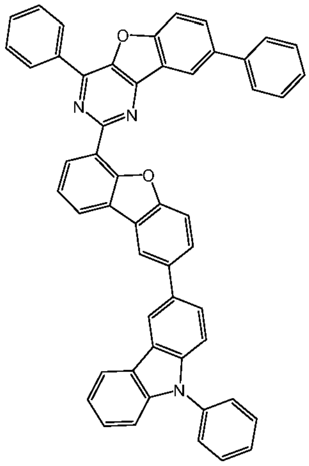 | 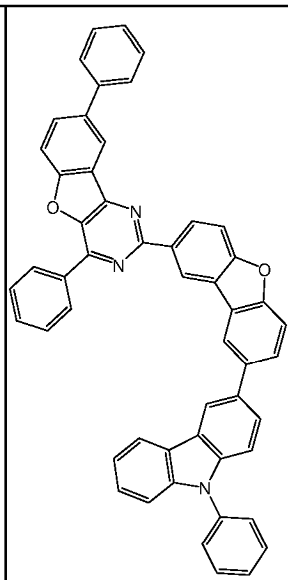 |
| 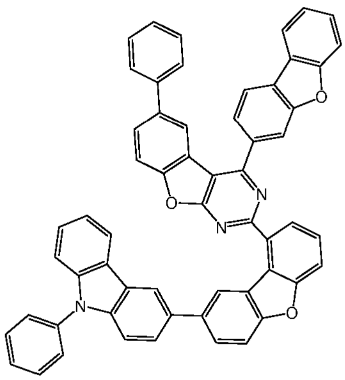 | 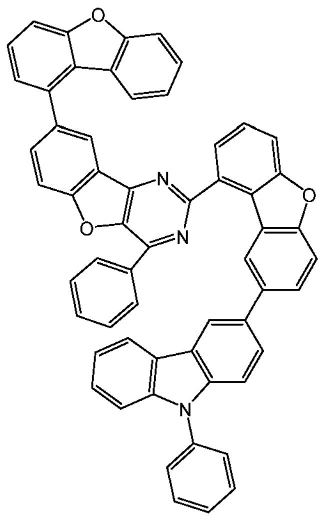 | 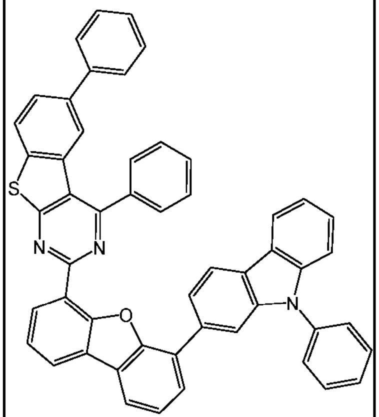 |
| 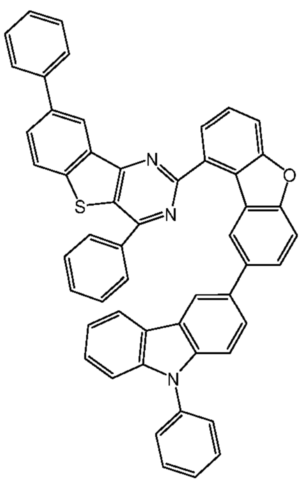 | 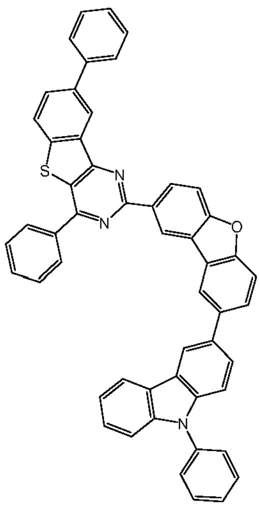 | 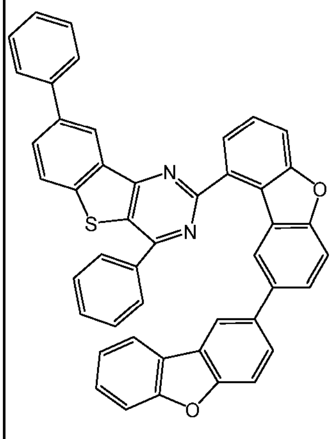 |

| | | |
|---|---|---|
| 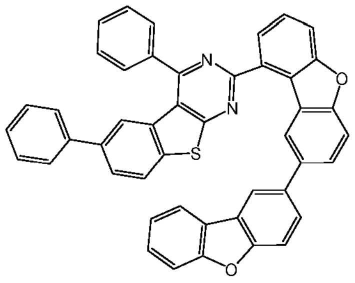 | 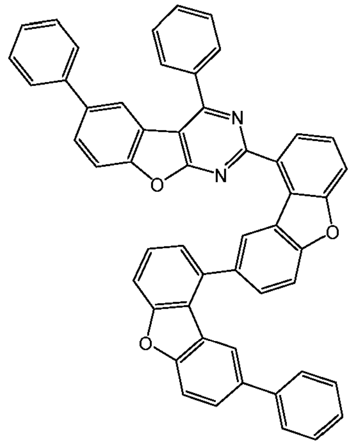 | 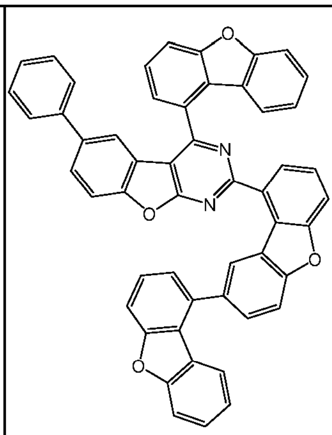 |
| 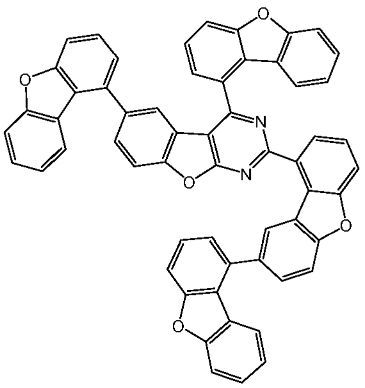 | 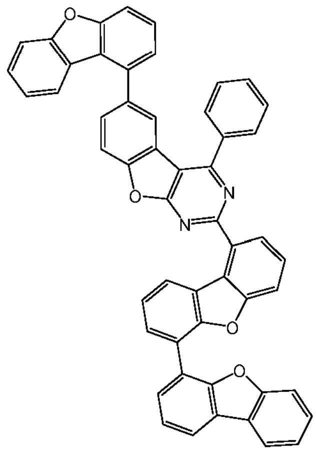 | 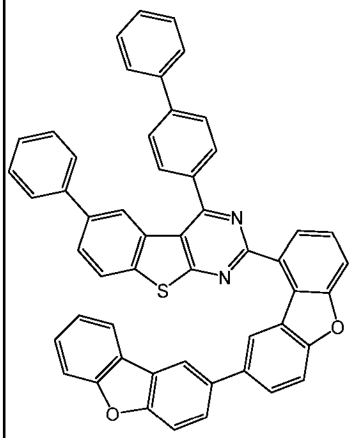 |
| 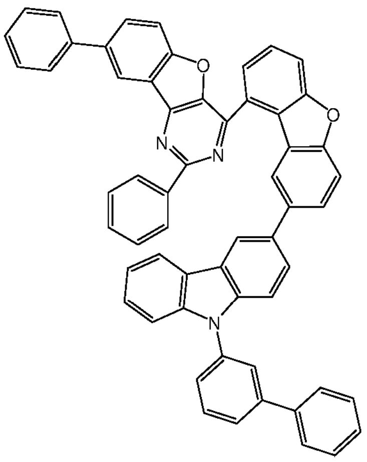 | 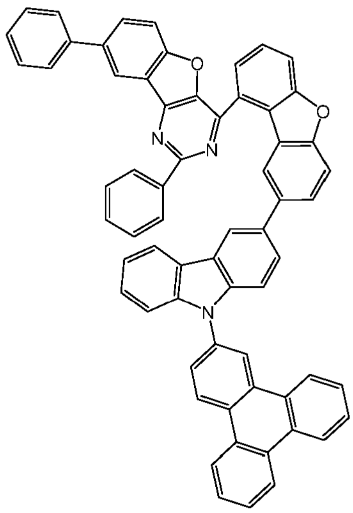 | 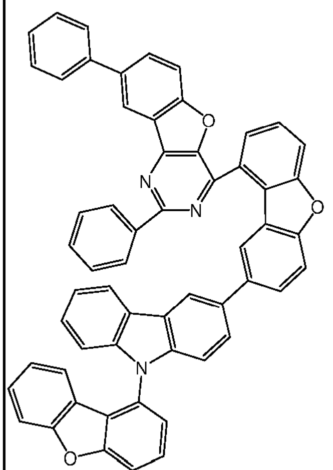 |

| | | |
|---|---|---|
| 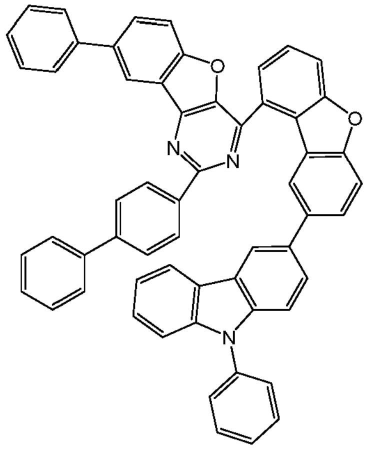 | 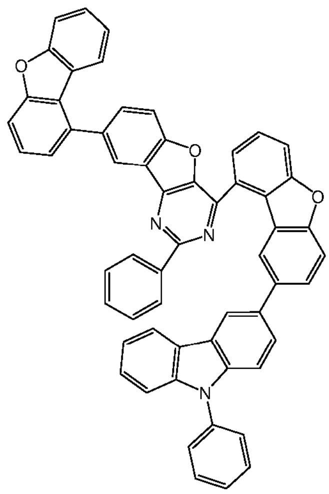 | 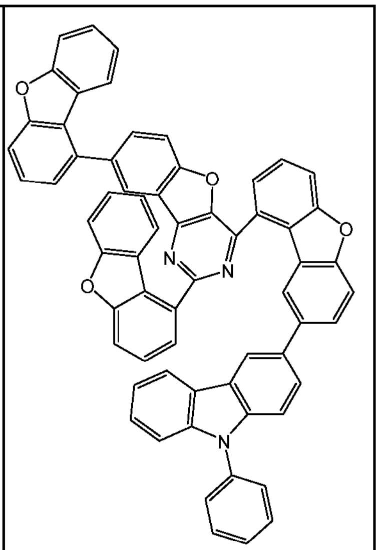 |
| 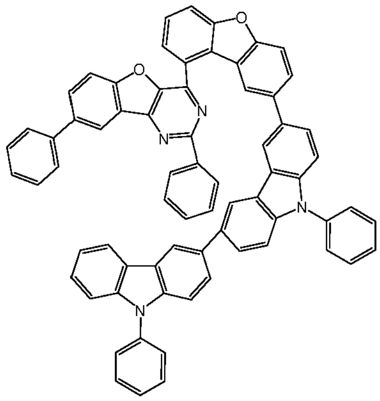 | 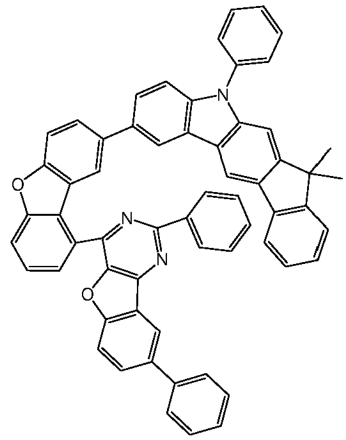 | 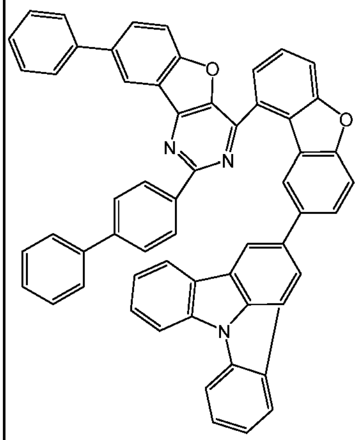 |
| 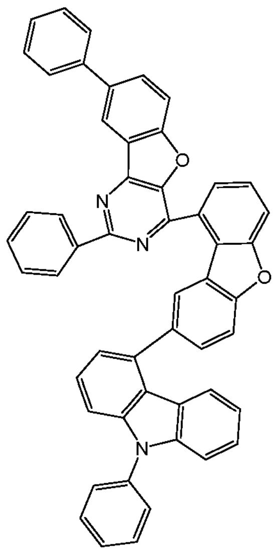 | 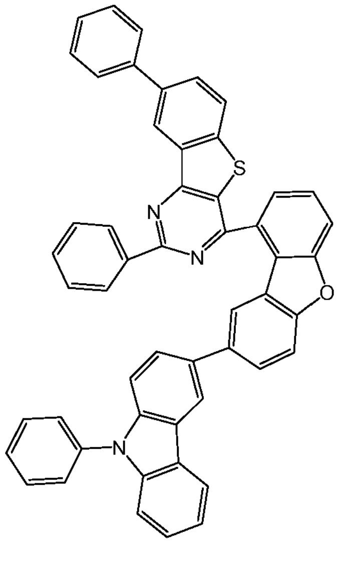 | 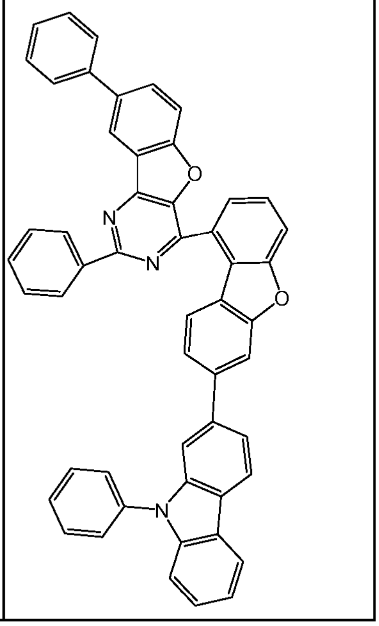 |

| | | |
|---|---|---|
| 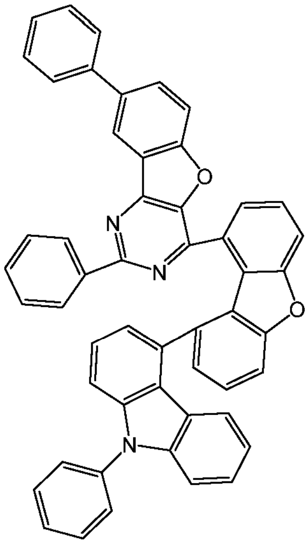 | 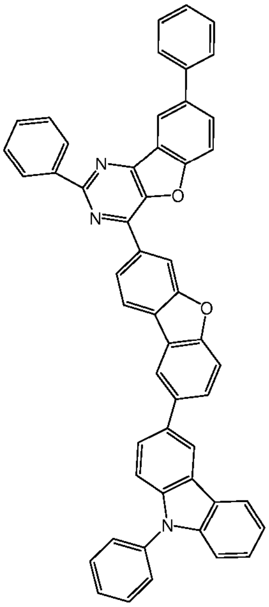 | 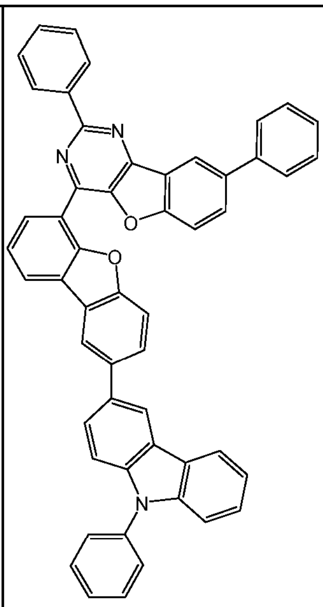 |
| 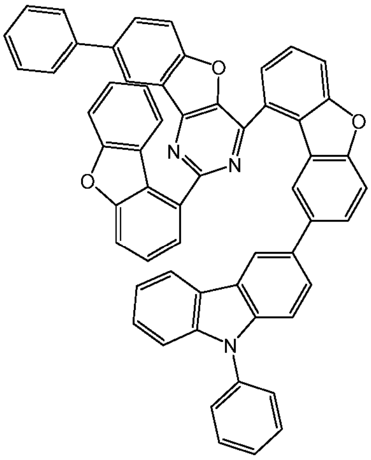 | 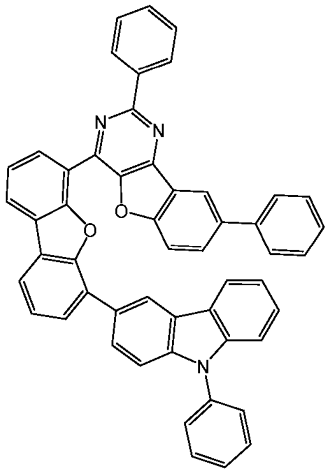 | 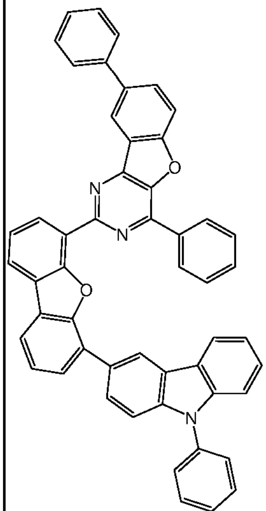 |
| 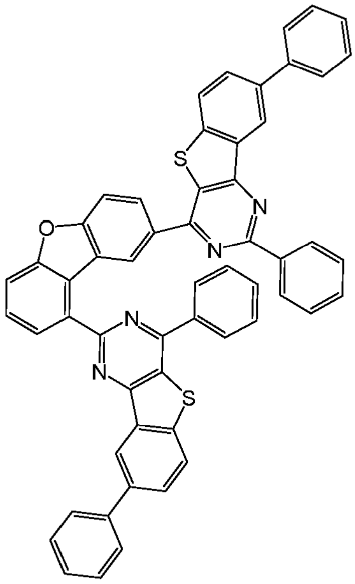 | 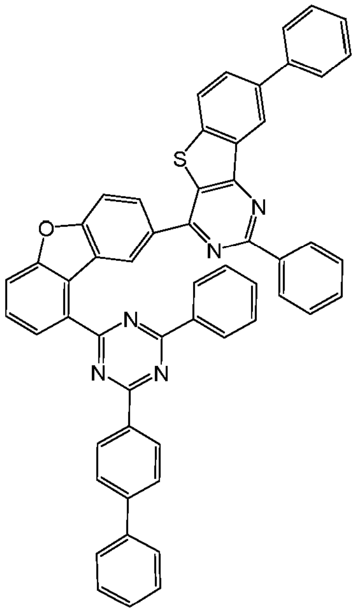 | 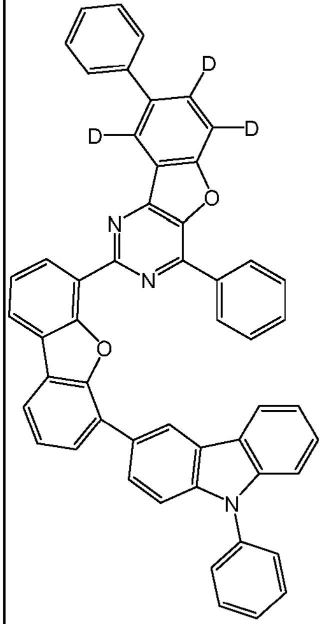 |

Bevorzugt ist das Hostmaterial 1, wie zuvor beschrieben oder zuvor oder nachfolgend bevorzugt beschrieben teilweise deuteriert oder vollständig deuteriert.

Besonders geeignete Verbindungen der Formeln (1), (1a), (1b), (1c), (1d), (1e), (1f) und (1g), die bevorzugt in Kombination mit mindestens einer Verbindung der Formel (2) in der erfindungsgemäßen elektrolumineszierenden Vorrichtung verwendet werden, sind die Verbindungen E1 bis E39 der Tabelle 2.

Tabelle 2:

| | | |
|---|---|---|
| 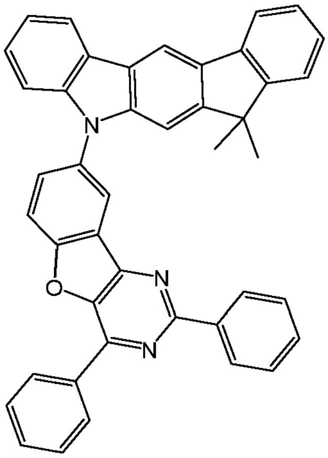 | 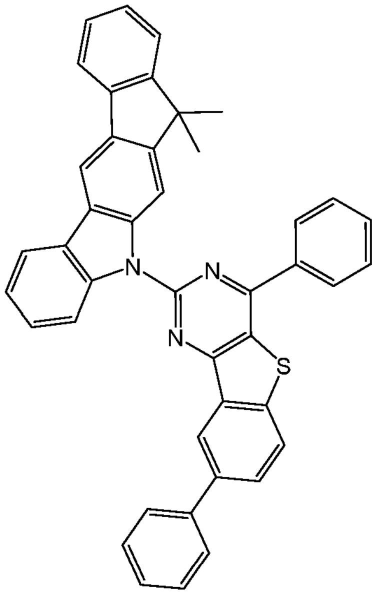 | 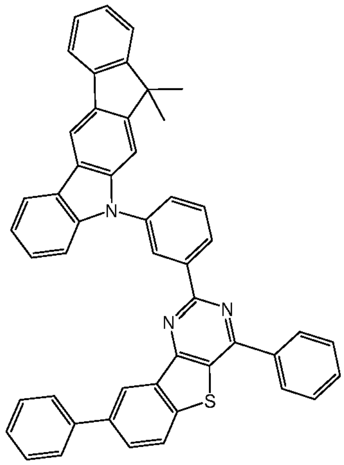 |
| E1 | E2 | E3 |
| 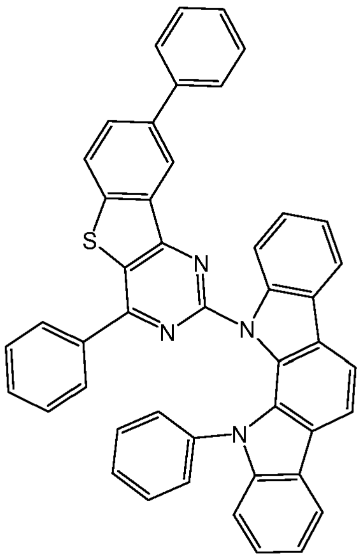 | 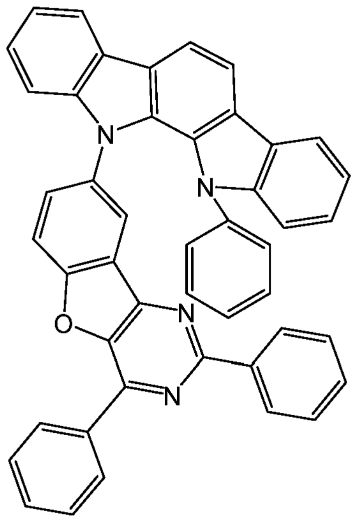 | 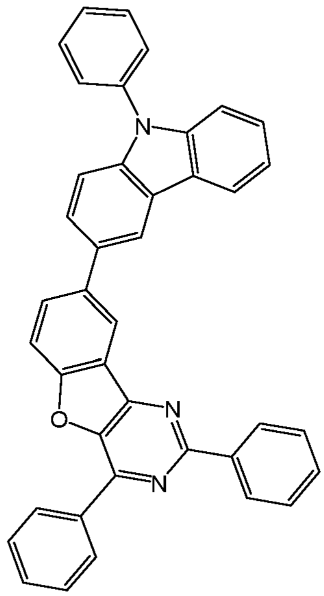 |
| E4 | E5 | E6 |

(fortgesetzt)

| | | |
|---|---|---|
| 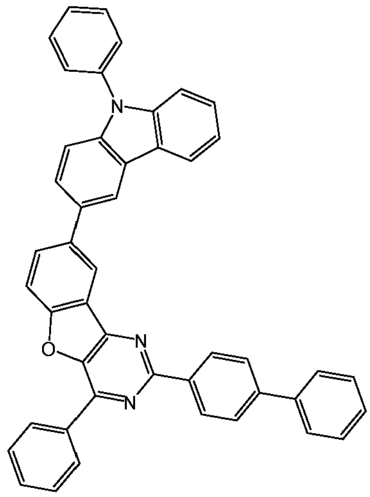 | 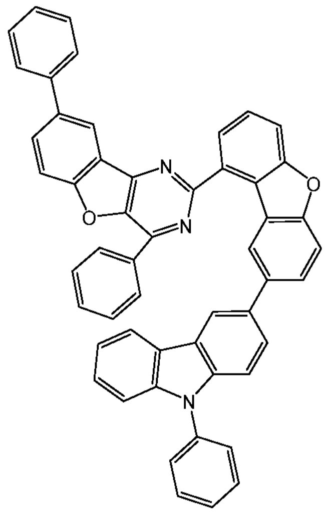 | 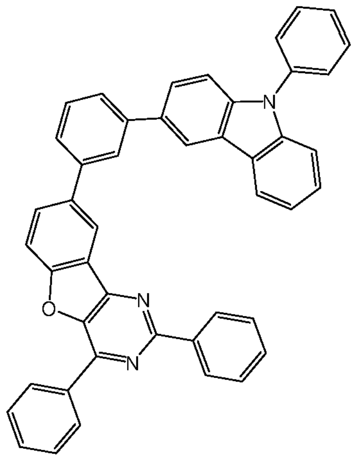 |
| E7 | E8 | E9 |
| 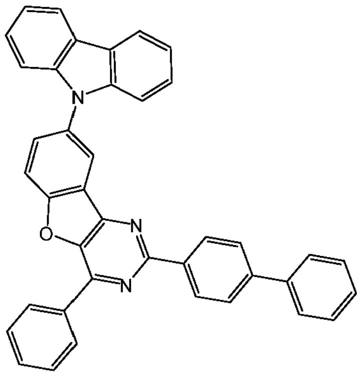 | 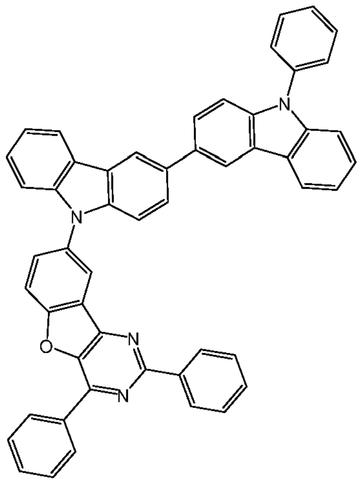 | 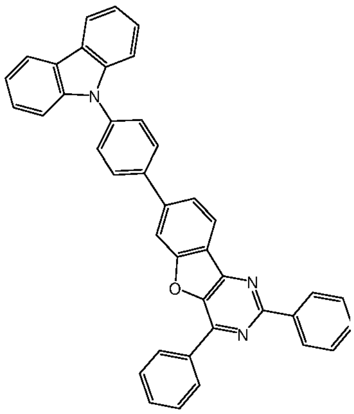 |
| E10 | E11 | E12 |
| 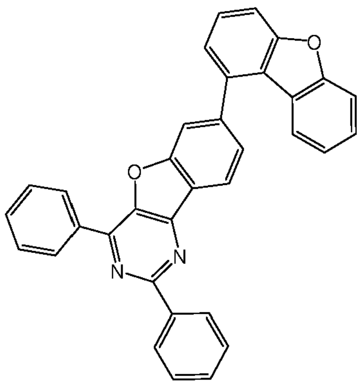 | 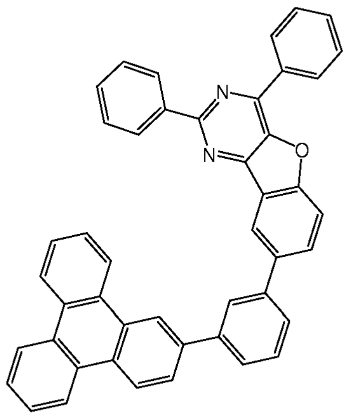 | 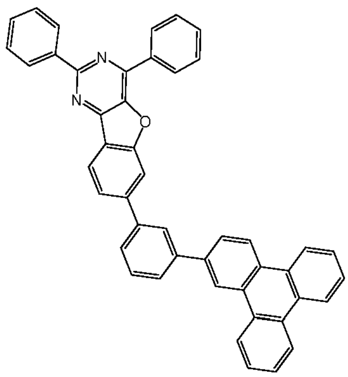 |
| E13 | E14 | E15 |

(fortgesetzt)

| | | |
|---|---|---|
| 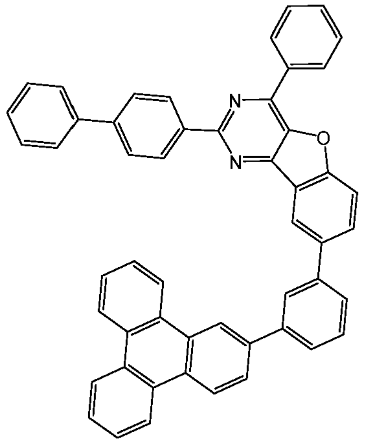 | 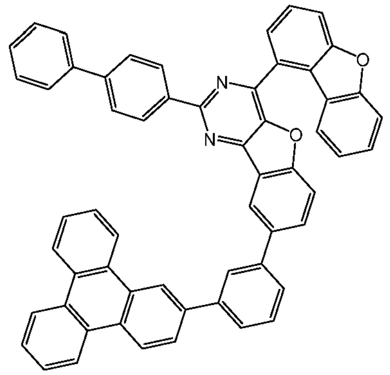 | 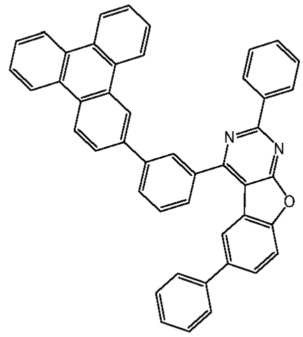 |
| E16 | E17 | E18 |
| 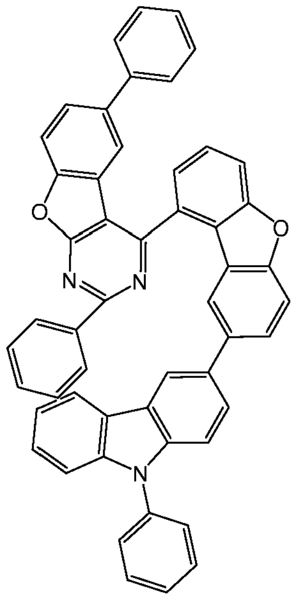 | 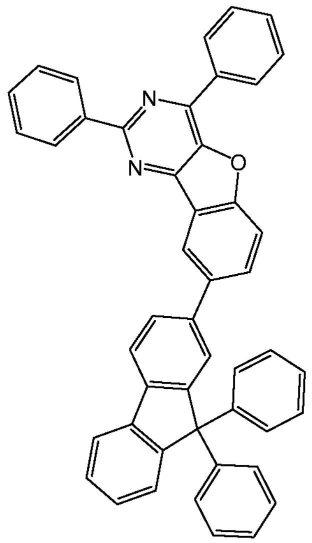 | 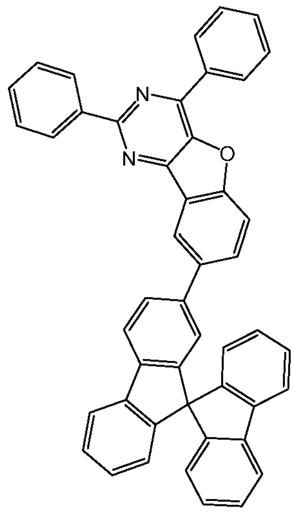 |
| E19 | E20 | E21 |
| 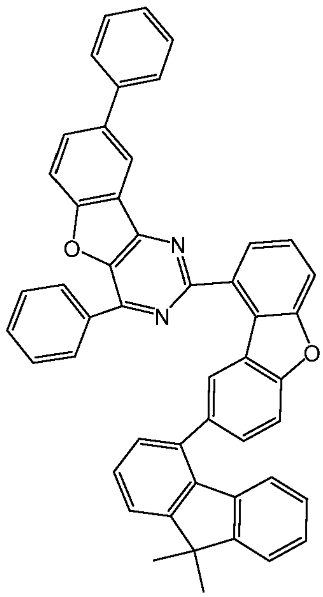 | 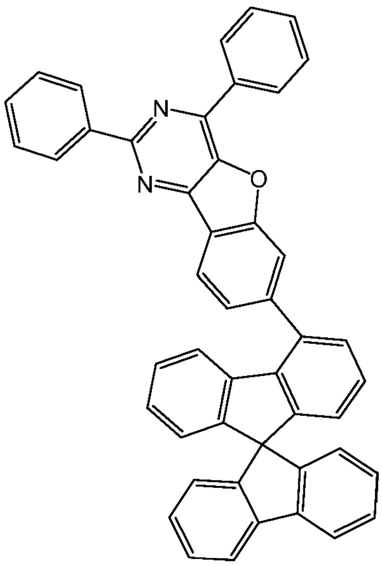 | 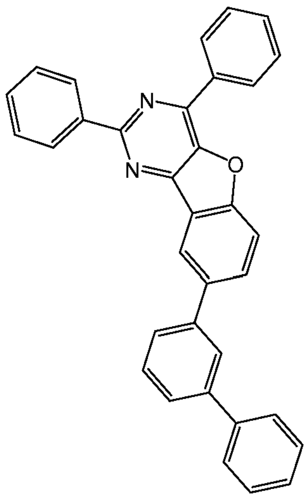 |

(fortgesetzt)

| | | |
|---|---|---|
| E22 | E23 | E24 |
| 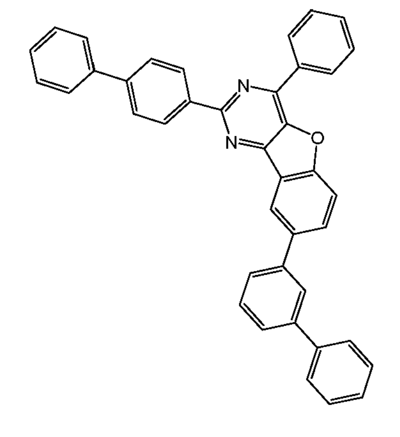 | 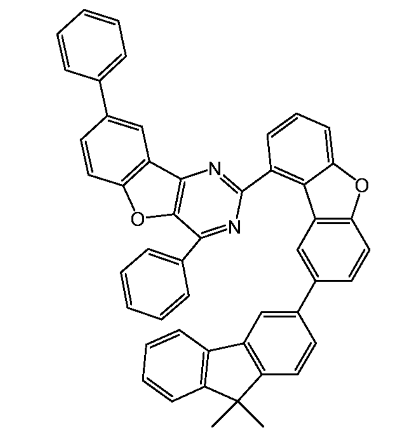 | 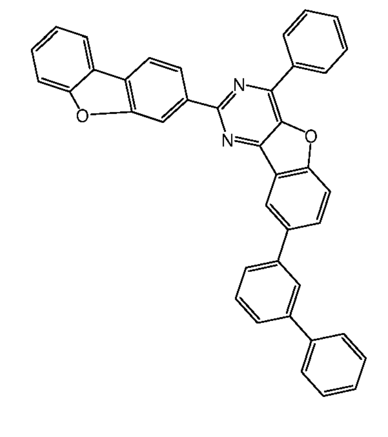 |
| E25 | E26 | E27 |
| 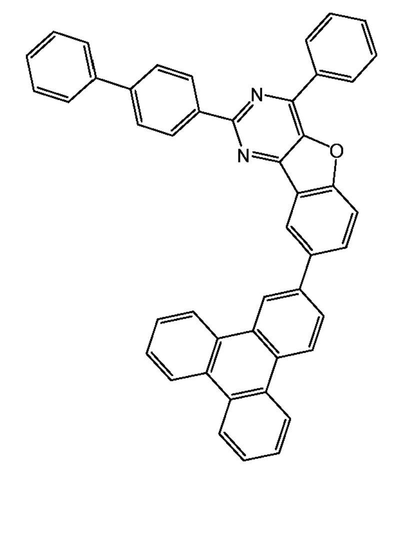 | 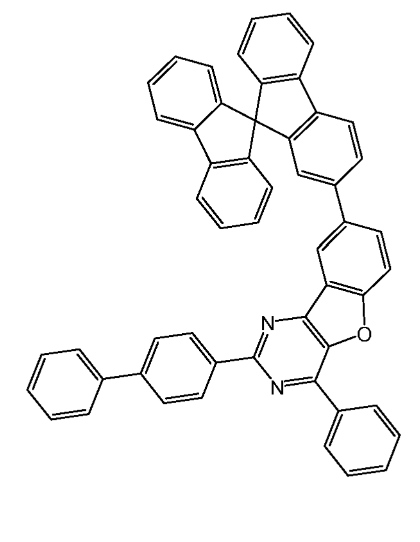 | 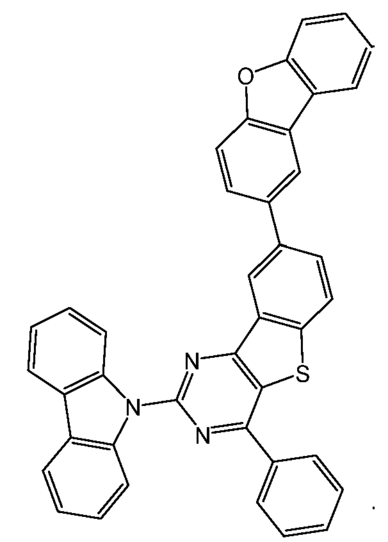 |
| E28 | E29 | E30 |
| 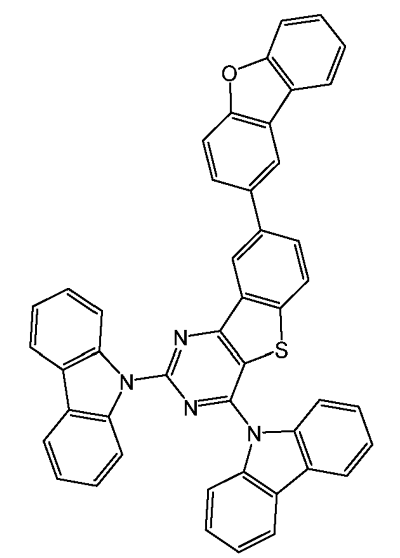 | 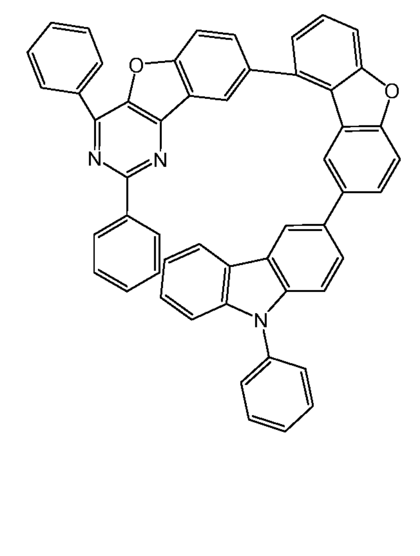 | 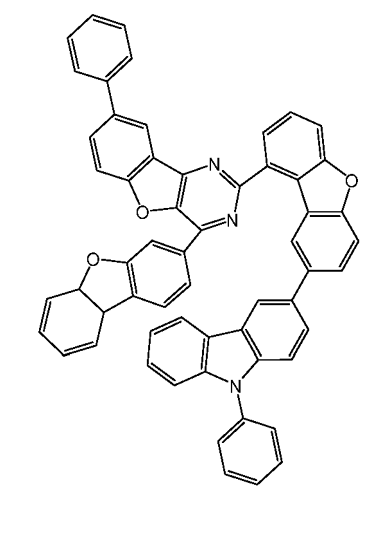 |
| E31 | E32 | E33 |

(fortgesetzt)

| | | |
|---|---|---|
| 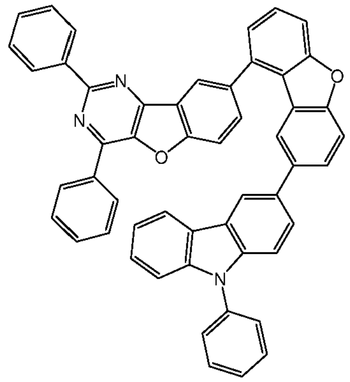 | 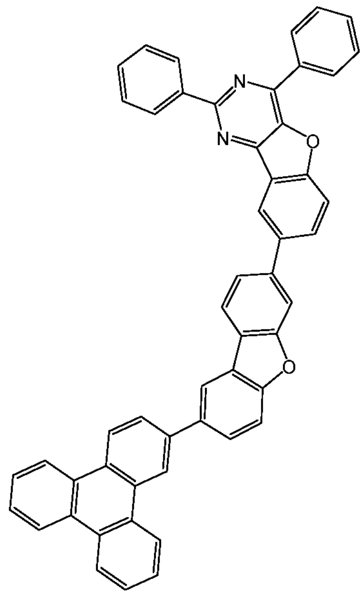 | 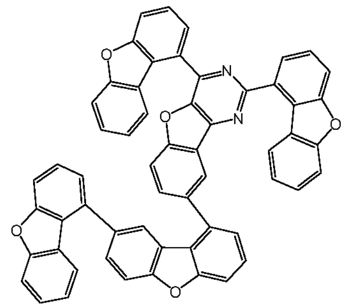 |
| E34 | E35 | E36 |
| 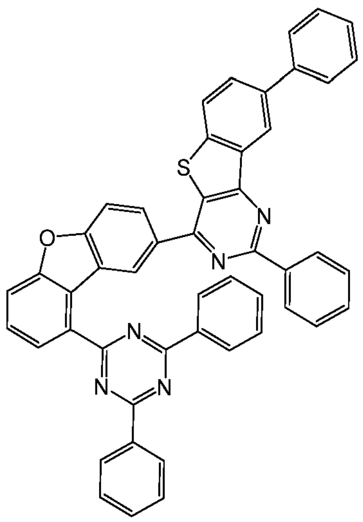 | 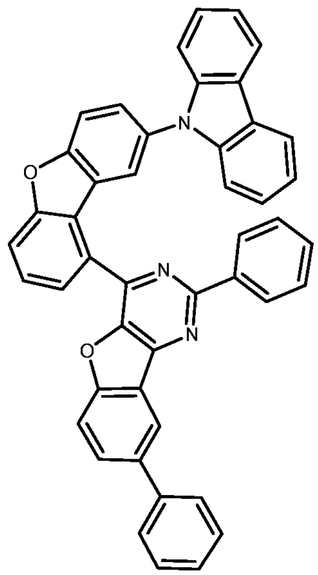 | 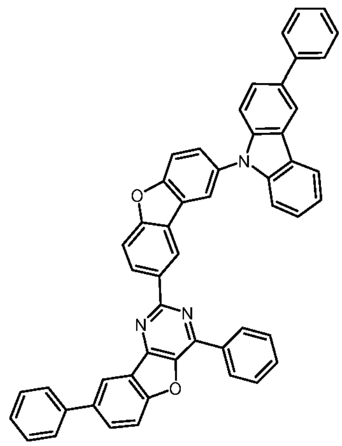 |
| E37 | E38 | E39 |

Die Herstellung der Verbindungen der Formel (1) oder der bevorzugten Verbindungen der Tabelle 1 sowie der Verbindungen E1 bis E39 ist dem Fachmann bekannt. Die Verbindungen können nach dem Fachmann bekannten Syntheseschritten, wie z.B. Halogenierung, bevorzugt Bromierung, und einer sich anschließenden metallorganischen Kupplungsreaktion, z.B. Suzuki-Kupplung, Heck-Kupplung oder Hartwig-Buchwald-Kupplung, hergestellt werden. Die Herstellung der Verbindungen gemäß Formel (1) ist bevorzugt, bei dem in einer Kupplungsreaktion eine Verbindung, umfassend mindestens eine Diazadibenzofuran- oder Diazadibenzothiophen-Gruppe, mit einer Gruppe, umfassend mindestens einen Carbazol-, Fluoren-, Phenanthren-, Dibenzofuran- und/oder Dibenzothiophen-Rest, verbunden wird.

Besonders geeignete und bevorzugte Kupplungsreaktionen, die alle zu C-C-Verknüpfungen und/oder C-N-Verknüpfungen führen, sind solche gemäß BUCHWALD, SUZUKI, YAMAMOTO, STILLE, HECK, NEGISHI, SONOGASHIRA und HIYAMA. Diese Reaktionen sind weithin bekannt, wobei die Beispiele dem Fachmann weitere Hinweise bereitstellen.

Geeignete Verbindungen mit einer Diazadibenzofuran- oder Diazadibenzothiophen-Gruppe können vielfach kommerziell erhalten werden, wobei die in den Beispielen dargelegten Ausgangsverbindungen durch bekannte Verfahren erhältlich sind, so dass hierauf verwiesen wird.

Die Herstellung von Vorstufen für Verbindungen der Formel (1) kann beispielsweise nach folgendem Schema 1 erfolgen, wobei V,b2 und R# eine der zuvor angegebenen oder bevorzugt angegebenen Bedeutungen haben.

Schema 1:

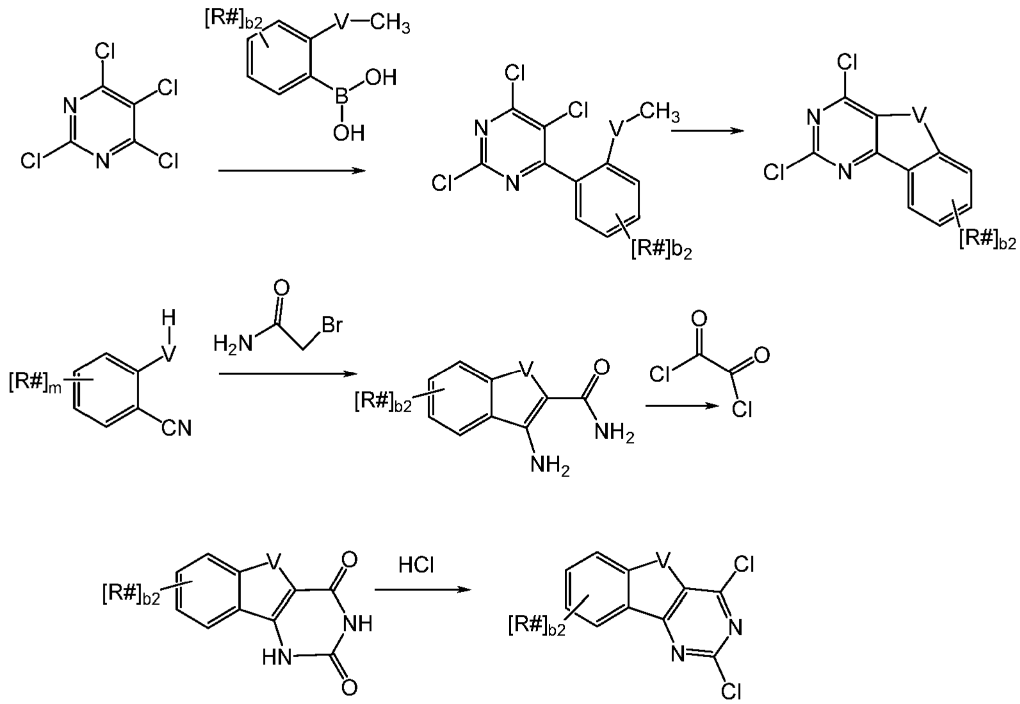


Im allen folgenden Syntheseschemata sind die Verbindungen zur Vereinfachung der Strukturen mit einer geringen Anzahl an Substituenten gezeigt. Dies schließt das Vorhandensein von beliebigen weiteren Substituenten in den Verfahren nicht aus. Die gezeigten Verfahren zur Synthese der erfindungsgemäßen Verbindungen sind exemplarisch zu verstehen. Der Fachmann kann alternative Synthesewege im Rahmen seines allgemeinen Fachwissens entwickeln.

Eine Umsetzung ergibt sich beispielhaft gemäß folgenden Schemata, ohne dass hierdurch eine Beschränkung erfolgen soll. Die Teilschritte der einzelnen Schemata können hierbei beliebig kombiniert werden.

Schema 2:

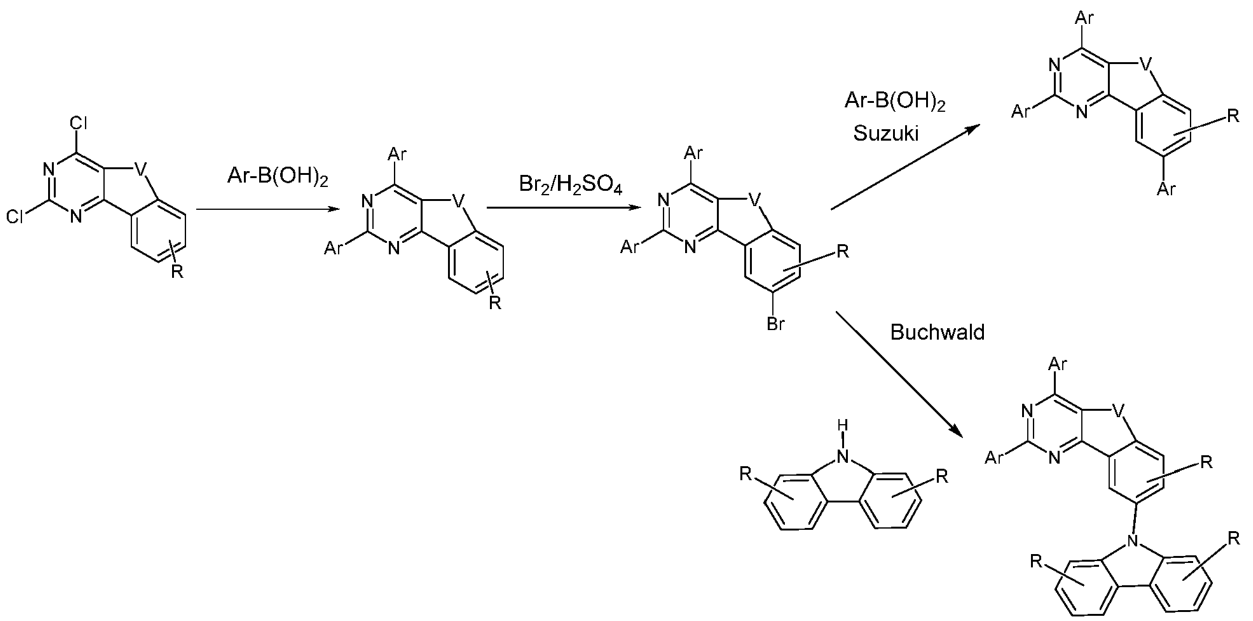

Schema 3:

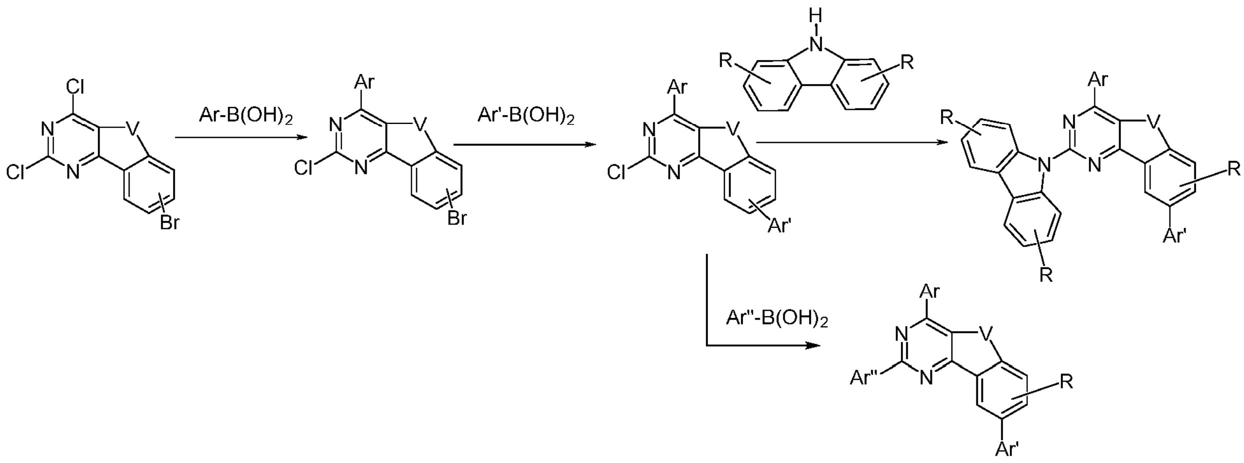


Schema 4:

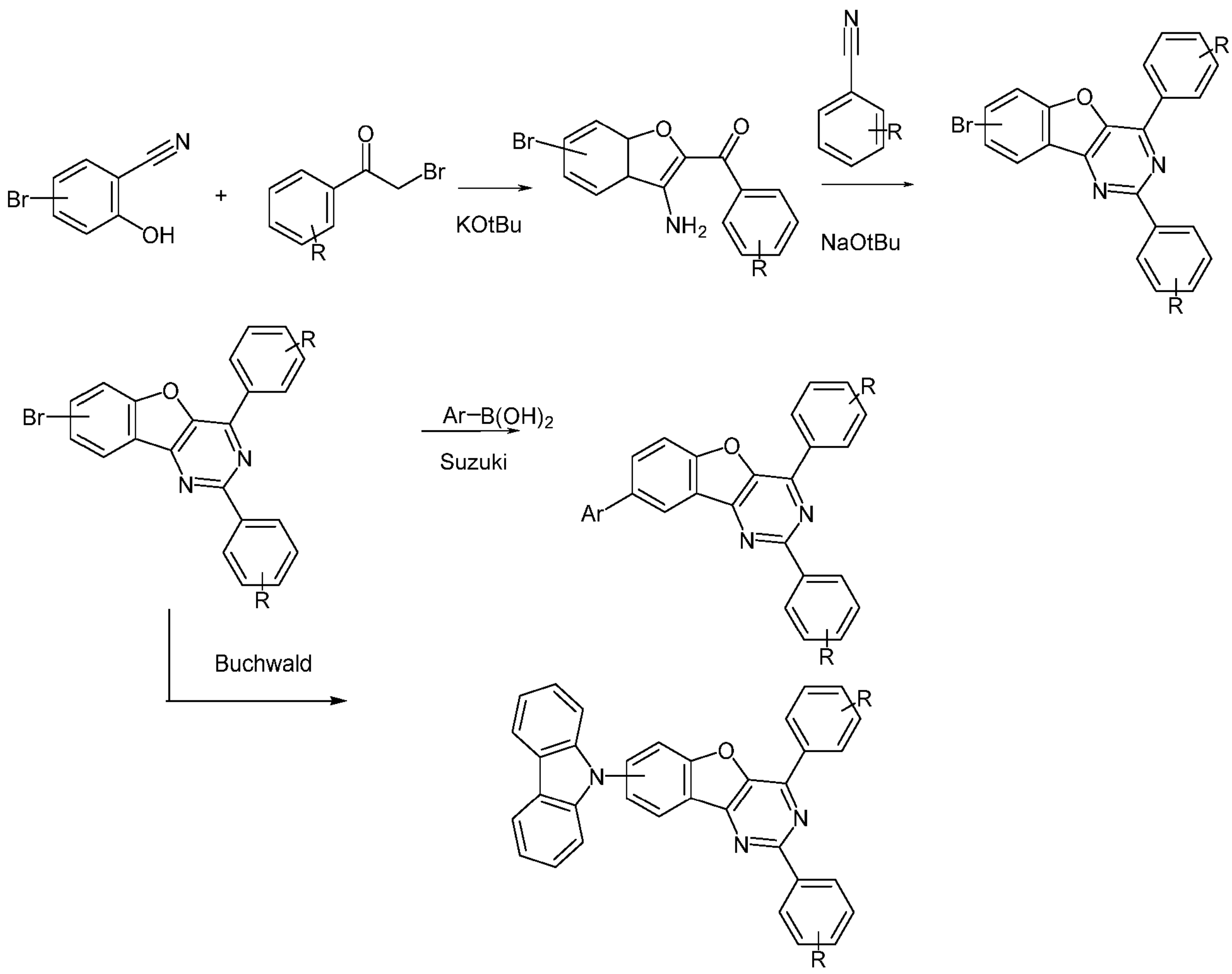


Durch diese Verfahren, gegebenenfalls gefolgt von Aufreinigung, wie z. B. Umkristallisation oder Sublimation, lassen sich die Hostmaterialien der Formel (1) in hoher Reinheit, bevorzugt mehr als 99 % (bestimmt mittels $^{1}$H-NMR und/oder HPLC) erhalten.

Im Folgenden wird das Hostmaterial 2 und dessen bevorzugte Ausführungsformen beschrieben, welches/welche in der erfindungsgemäßen Vorrichtung enthalten ist/sind. Die bevorzugten Ausführungsformen des Hostmaterials 2 der Formel (2) gelten auch für die erfindungsgemäße Mischung und/oder Formulierung.

In einer Ausführungsform der Erfindung werden für die erfindungsgemäße Vorrichtung Verbindungen der

Formel (2) ausgewählt, wie zuvor beschrieben, die mit Verbindungen der Formel (1), wie zuvor beschrieben oder bevorzugt beschrieben, oder mit den Verbindungen der Tabelle 1 oder den Verbindungen E1 bis E39, in der lichtemittierenden Schicht verwendet werden.

In Verbindungen der Formel (2), wie zuvor beschrieben, ist die Summe der Indizes $a_1+a_2+a_3+a_4$ ausgewählt aus 3, 4, 5, 6, 7, 8, 9, 10, 11, 12, 13, 14, 15, 16 oder 17. Das Hostmaterial 2 ist demzufolge an jedem N-gebundenen Substituenten mindestens teilweise deuteriert. In einer bevorzugten Ausführungsform sind zwei der N-gebundenen Substituenten in Hostmaterial 2 teilweise deuteriert und der dritte N-gebundene Substituent ist vollständig deuteriert. In einer weiteren bevorzugten Ausführungsform sind zwei der N-gebundenen Substituenten in Hostmaterial 2 vollständig deuteriert und der dritte N-gebundene Substituent ist teilweise deuteriert. In einer weiteren bevorzugten Ausführungsform ist jeder N-gebundenen Substituent in Hostmaterial 2 vollständig deuteriert.

In einer bevorzugten Ausführungsform des Hostmaterials 2 ist dieses ein Gemisch aus deuterierten Verbindungen der Formel (2), wie zuvor beschrieben oder nachfolgend bevorzugt beschrieben, wobei der Deuterierungsgrad der Verbindungen der Formel (2) mindestens 50% bis 90% beträgt, bevorzugt 70% bis 100 % beträgt. Entsprechende Deuterierungsmethoden sind nachfolgend beschrieben.

Ein weiterer Gegenstand der Erfindung ist demzufolge eine organische lumineszierende Vorrichtung, wie zuvor beschrieben oder bevorzugt beschrieben, wobei das Hostmaterial 2, wie zuvor beschrieben oder nachfolgend als bevorzugt beschrieben, vollständig deuteriert ist.

In Verbindungen der Formel (2), oder den im Folgenden offenbarten Verbindungen der Formeln (2a), (2b), (2c), (2d) und (2e), steht x bevorzugt für 1 oder 2, wobei $R^2$ bei jedem Auftreten gleich oder verschieden bevorzugt ausgewählt wird aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$,

$P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten.

Steht in Verbindungen der Formel (2), oder den im Folgenden offenbarten Verbindungen der Formeln (2a), (2b), (2c), (2d) und (2e), x für 1 und $a_1$ für 1, 2, 3 oder 4, so wird der Substituent $R^2$ bevorzugt aus der Gruppe der folgenden Substituenten R2-1 bis R2-221 ausgewählt, wobei die Substituenten R2-1 bis R-221 auch teilweise deuteriert oder vollständig deuteriert sein können, sofern nicht schon als Solches beschrieben:

| | | |
|---|---|---|
| 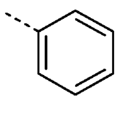 | 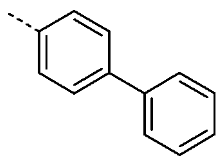 | 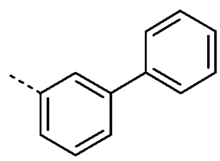 |
| R2-1 | R2-2 | R2-3 |
| 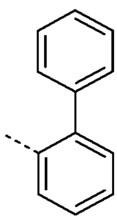 | 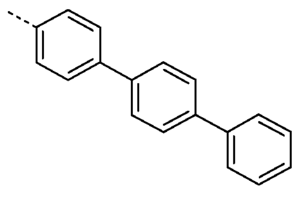 | 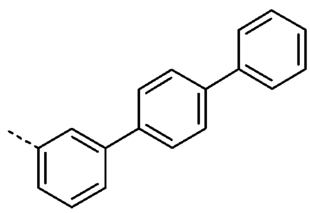 |
| R2-4 | R2-5 | R2-6 |

(fortgesetzt)

| | | |
|---|---|---|
| 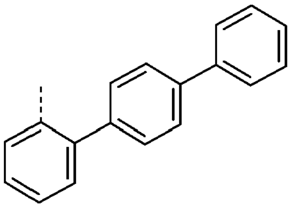 | 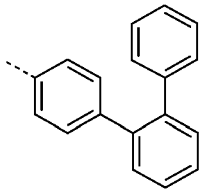 | 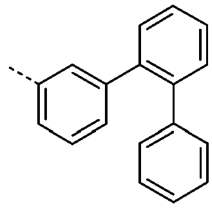 |
| R2-7 | R2-8 | R2-9 |
| 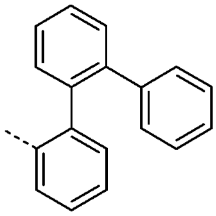 | 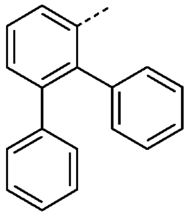 | 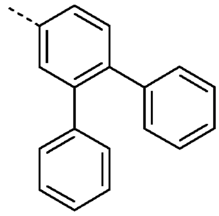 |
| R2-10 | R2-11 | R2-12 |
| 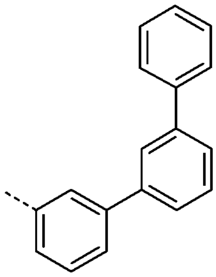 | 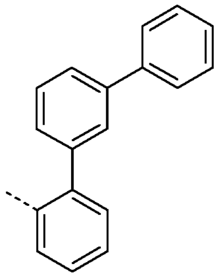 | 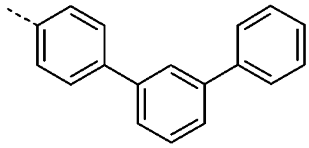 |
| R2-13 | R2-14 | R2-15 |
| 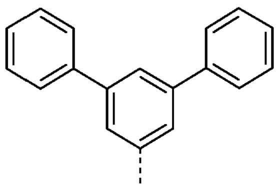 | 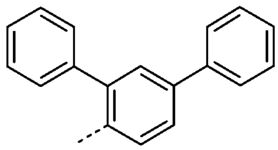 | 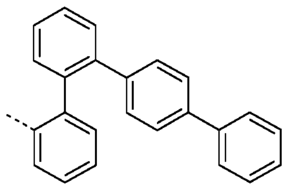 |
| R2-16 | R2-17 | R2-18 |
| 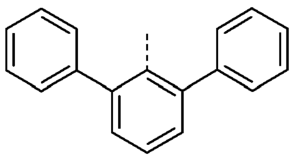 | | |
| R2-19 | | |
| 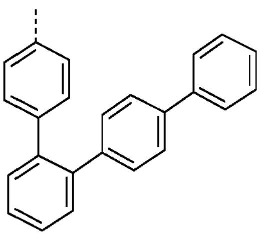 | 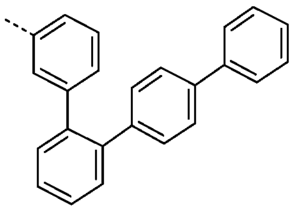 | 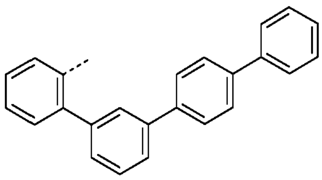 |
| R2-20 | R2-21 | R2-22 |

(fortgesetzt)

| | | |
|---|---|---|
| 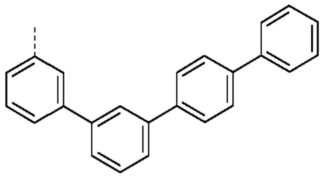 | 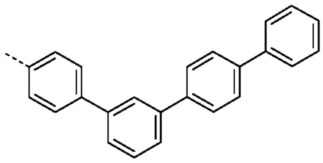 | 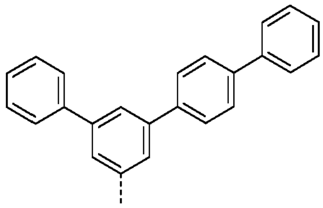 |
| R2-23 | R2-24 | R2-25 |
| 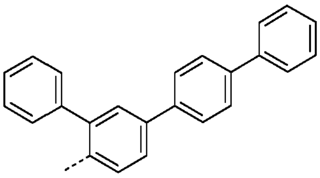 | 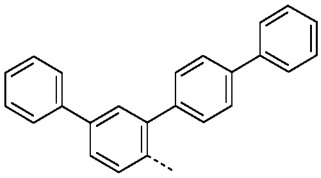 | 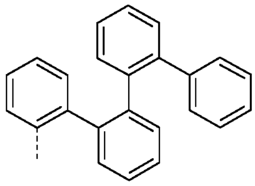 |
| R2-26 | R2-27 | R2-28 |
| 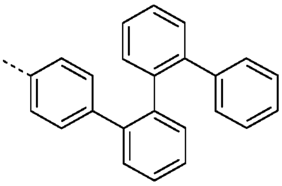 | 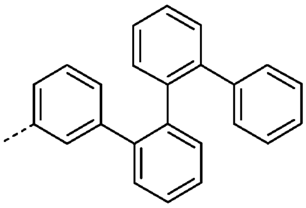 | 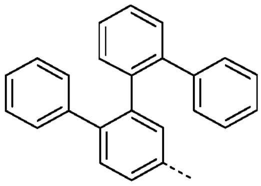 |
| R2-29 | R2-30 | R2-31 |
| 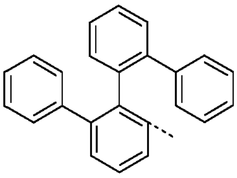 | 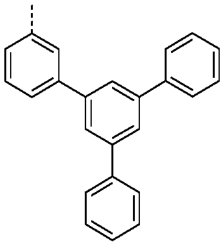 | 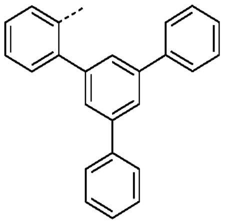 |
| R2-32 | R2-33 | R2-34 |
| 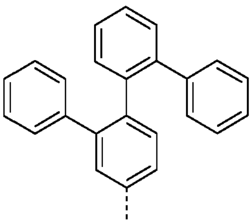 | 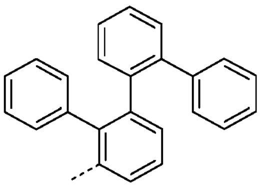 | 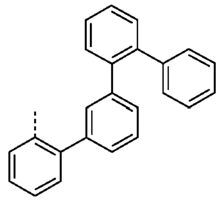 |
| R2-35 | R2-36 | R2-37 |
| 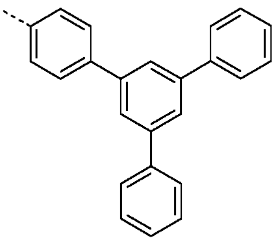 | 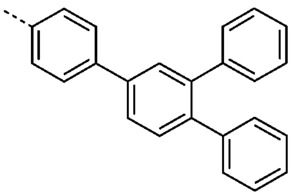 | 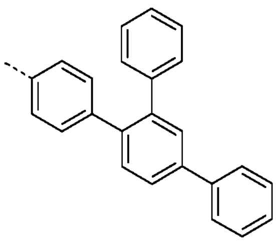 |
| R2-38 | R2-39 | R2-40 |

(fortgesetzt)

| | | |
|---|---|---|
| 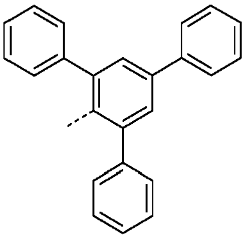 | 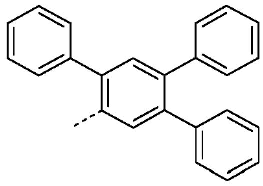 | 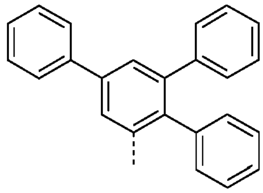 |
| R2-41 | R2-42 | R2-43 |
| 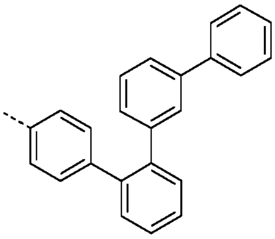 | 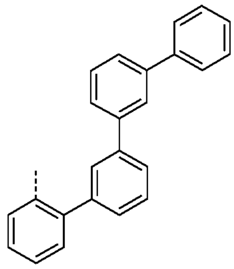 | 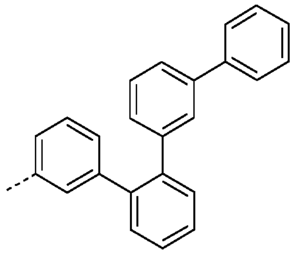 |
| R2-44 | R2-45 | R2-46 |
| 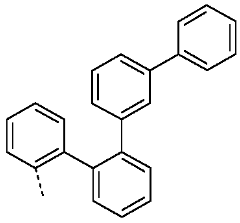 | | |
| R2-47 | | |
| 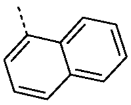 | 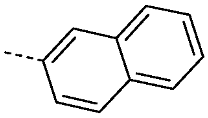 | 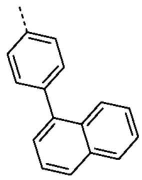 |
| R2-48 | R2-49 | R2-50 |
| 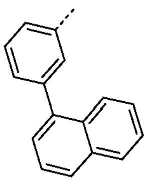 | 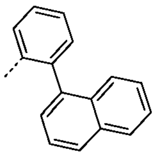 | 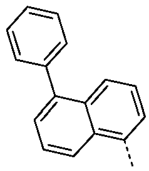 |
| R2-51 | R2-52 | R2-53 |
| 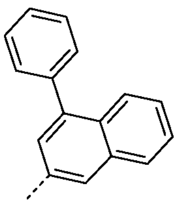 | 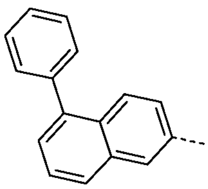 | 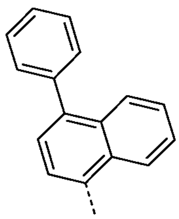 |
| R2-54 | R2-55 | R2-56 |

(fortgesetzt)

| | | |
|---|---|---|
| 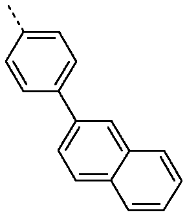 | 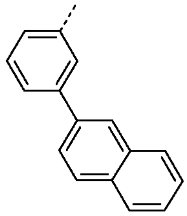 | 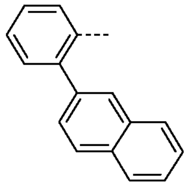 |
| R2-57 | R2-58 | R2-59 |
| 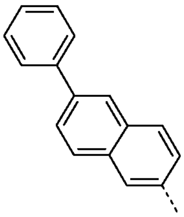 | 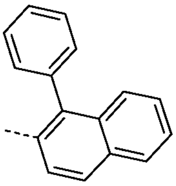 | 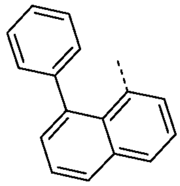 |
| R2-60 | R2-61 | R2-62 |
| 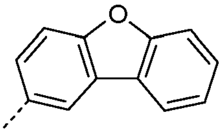 | 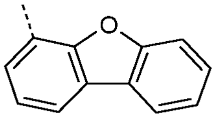 | 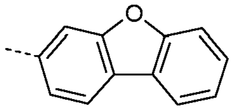 |
| R2-63 | R2-64 | R2-65 |
| 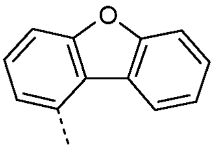 | 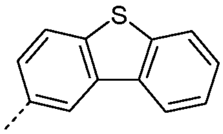 | 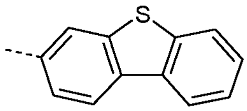 |
| R2-66 | R2-67 | R2-68 |
| 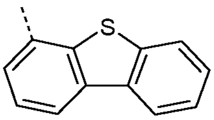 | 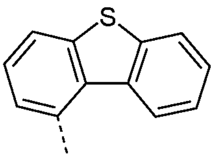 | 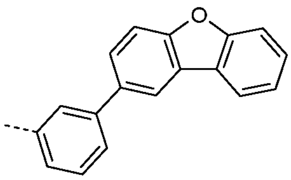 |
| R2-69 | R2-70 | R2-71 |
| 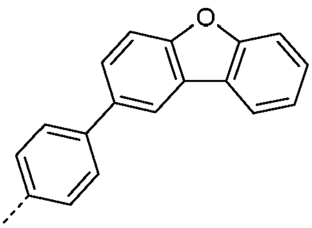 | 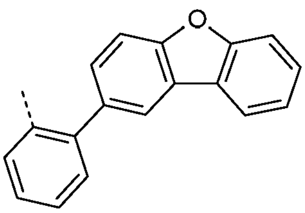 | 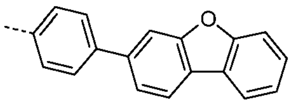 |
| R2-72 | R2-73 | R2-74 |
| 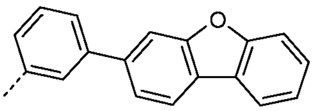 | 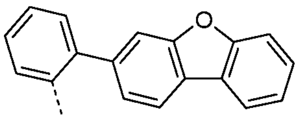 | 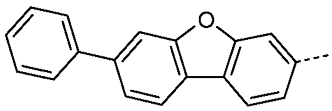 |
| R2-75 | R2-76 | R2-77 |

(fortgesetzt)

| | | |
|---|---|---|
| 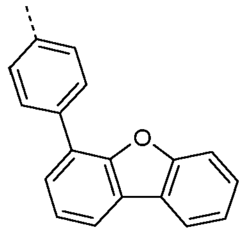 | 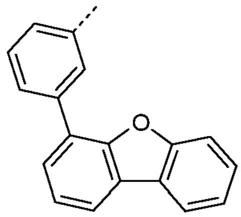 | 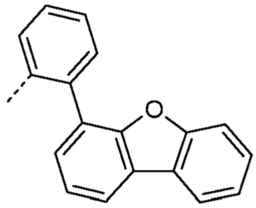 |
| R2-78 | R2-79 | R2-80 |
| 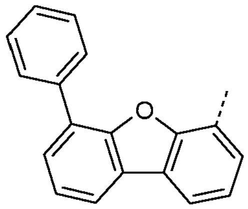 | 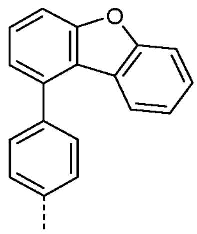 | 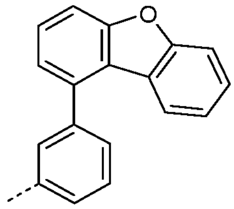 |
| R2-81 | R2-82 | R2-83 |
| 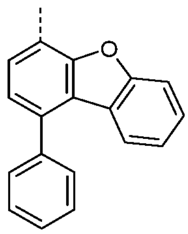 | 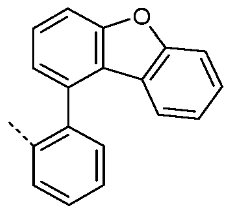 | 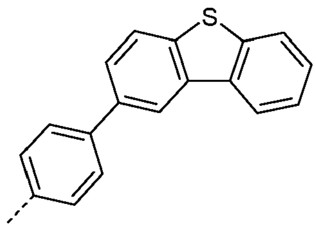 |
| R2-84 | R2-85 | R2-86 |
| 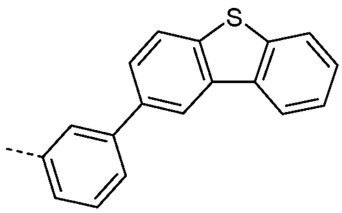 | 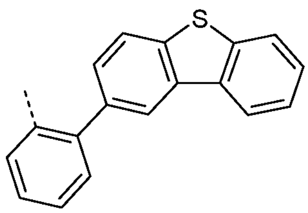 | 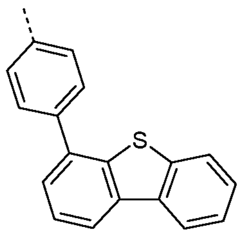 |
| R2-87 | R2-88 | R2-89 |
| 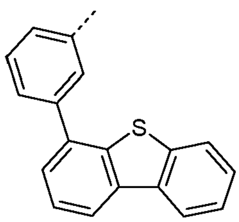 | 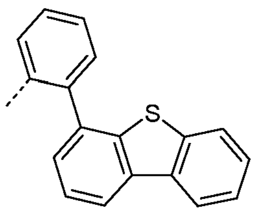 | 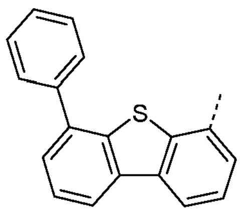 |
| R2-90 | R2-91 | R2-92 |
| 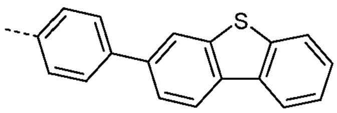 | 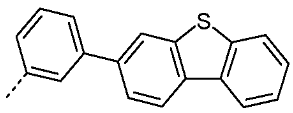 | 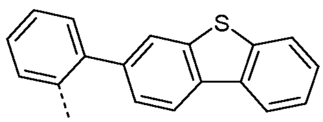 |
| R2-93 | R2-94 | R2-95 |

(fortgesetzt)

| | | |
|---|---|---|
| 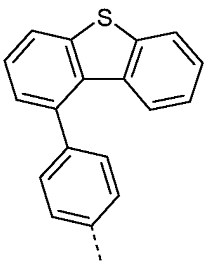 | 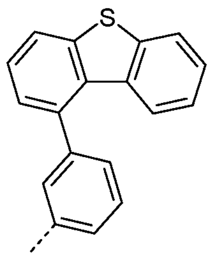 | 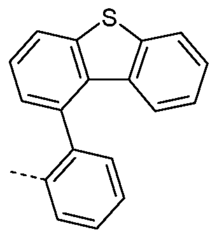 |
| R2-96 | R2-97 | R2-98 |
| 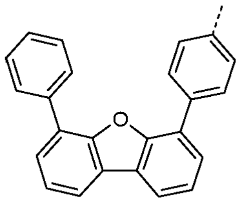 | 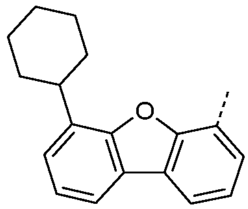 | 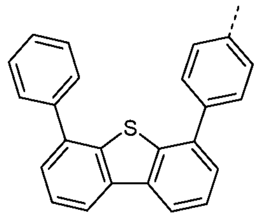 |
| R2-99 | R2-100 | R2-101 |
| 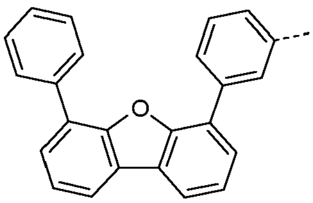 | 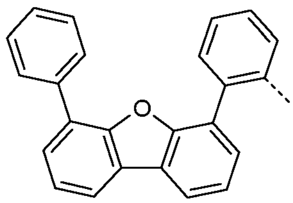 | 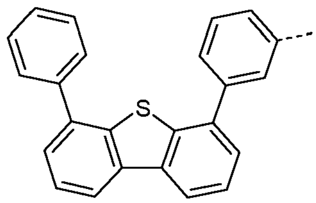 |
| R2-102 | R2-103 | R2-104 |
| 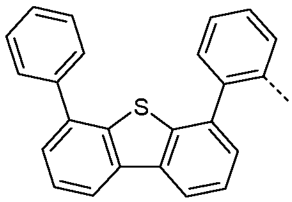 | | |
| R2-105 | | |
| 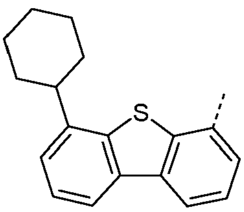 | 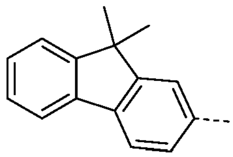 | 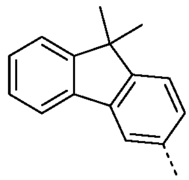 |
| R2-106 | R2-107 | R2-108 |
| 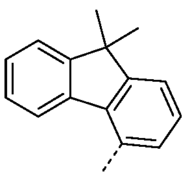 | 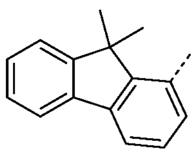 | 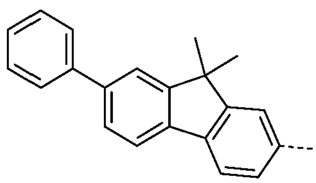 |
| R2-109 | R2-110 | R2-111 |

(fortgesetzt)

| | | |
|---|---|---|
| 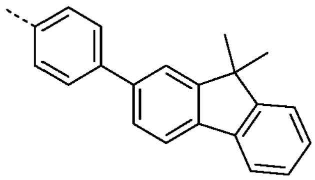 | 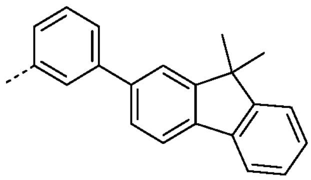 | |
| R2-112 | R2-113 | |
| 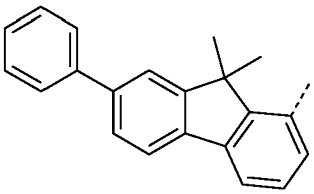 | 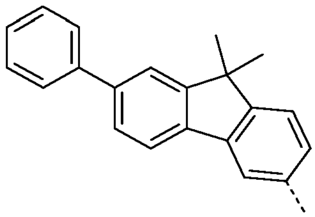 | 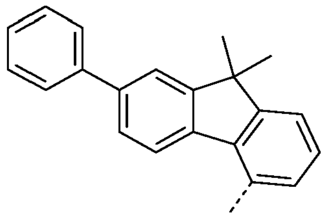 |
| R2-114 | R2-115 | R2-116 |
| 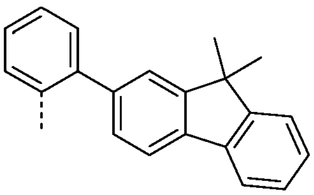 | 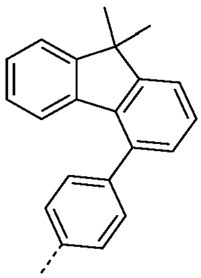 | 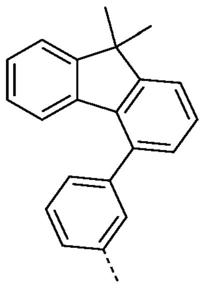 |
| R2-117 | R2-118 | R2-119 |
| 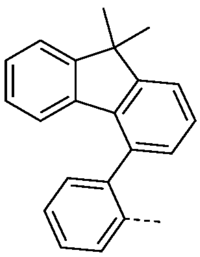 | 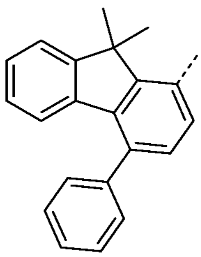 | 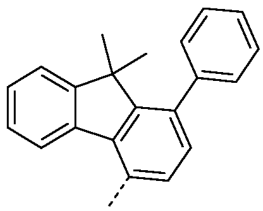 |
| R2-120 | R2-121 | R2-122 |
| 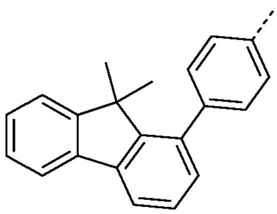 | 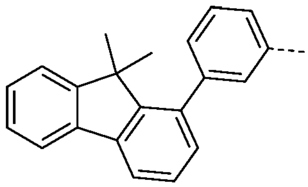 | 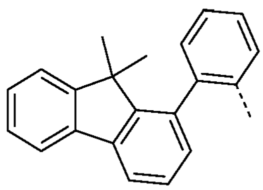 |
| R2-123 | R2-124 | R2-125 |
| 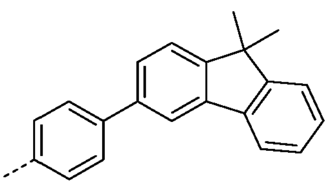 | 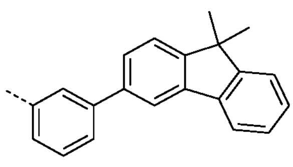 | 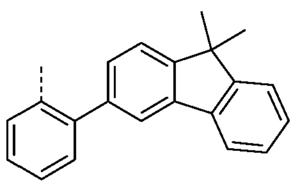 |
| R2-126 | R2-127 | R2-128 |

(fortgesetzt)

| | | |
|---|---|---|
| 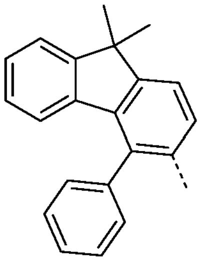 | 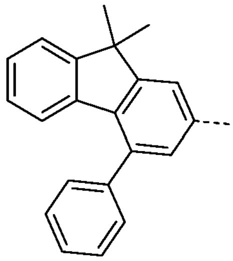 | 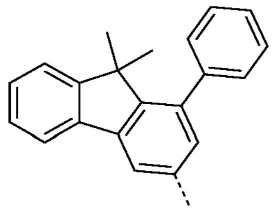 |
| R2-129 | R2-130 | R2-131 |
| 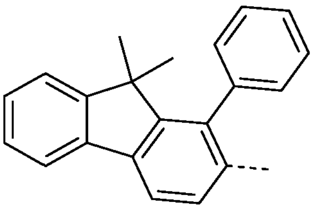 | 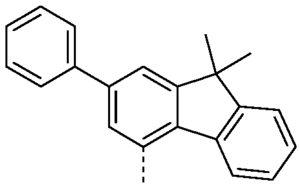 | |
| R2-132 | R2-133 | |
| 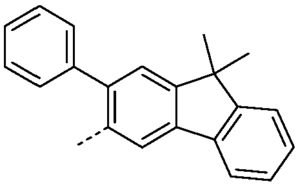 | 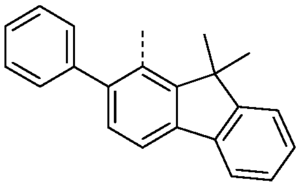 | 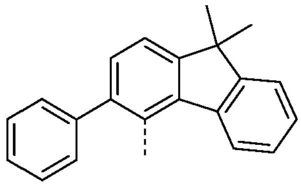 |
| R2-134 | R2-135 | R2-136 |
| 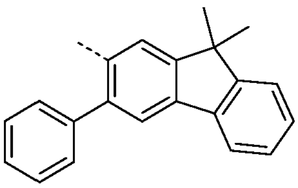 | 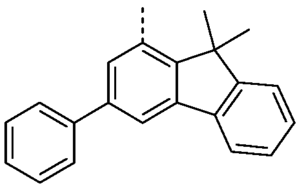 | 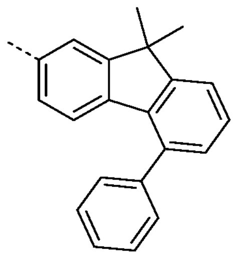 |
| R2-137 | R2-138 | R2-139 |
| 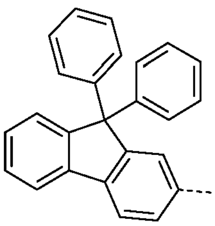 | 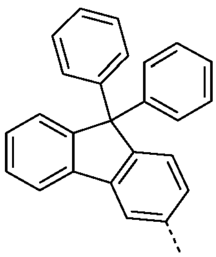 | 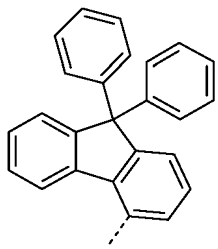 |
| R2-140 | R2-141 | R2-142 |
| 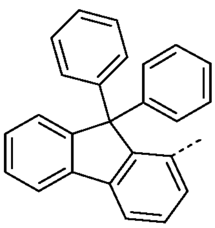 | 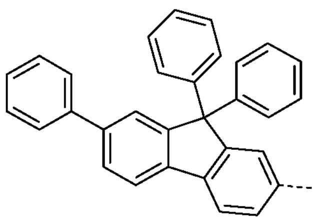 | 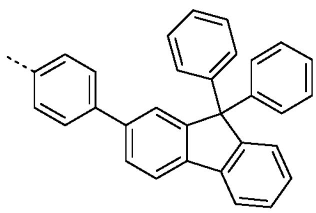 |
| R2-143 | R2-144 | R2-145 |

(fortgesetzt)

| | | |
|---|---|---|
| 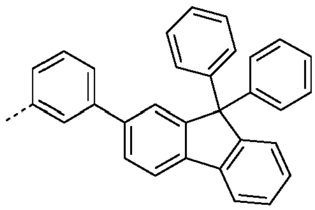 | 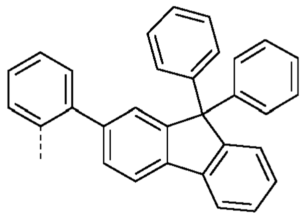 | 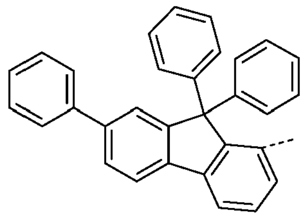 |
| R2-146 | R2-147 | R2-148 |
| 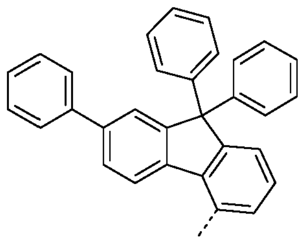 | 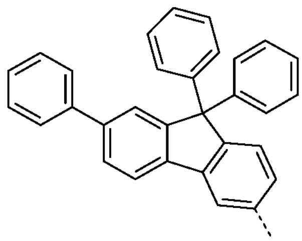 | 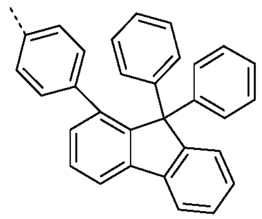 |
| R2-149 | R2-150 | R2-151 |
| 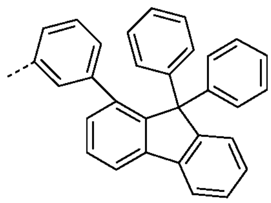 | 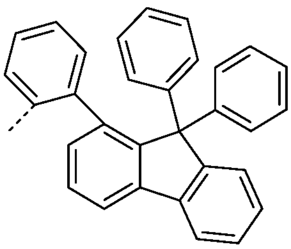 | 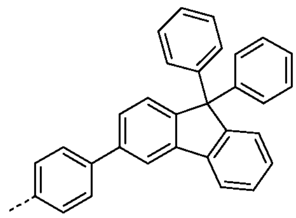 |
| R2-152 | R2-153 | R2-154 |
| 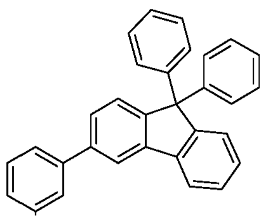 | 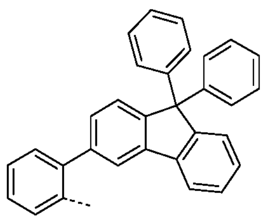 | 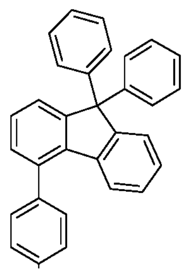 |
| R2-155 | R2-156 | R2-157 |
| 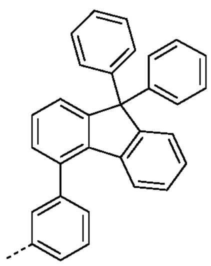 | 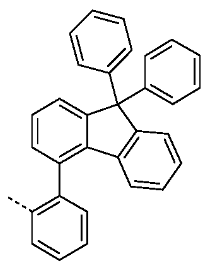 | 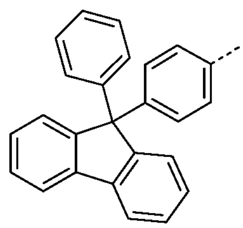 |
| R2-158 | R2-159 | R2-160 |

(fortgesetzt)

| | | |
|---|---|---|
| 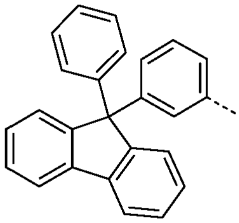 | 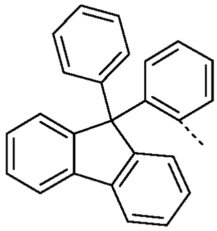 | 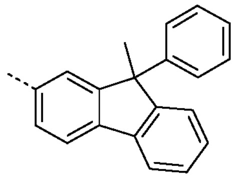 |
| R2-161 | R2-162 | R2-163 |
| 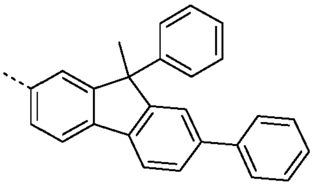 | 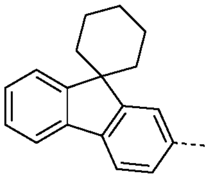 | 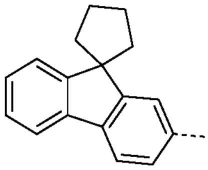 |
| R2-164 | R2-165 | R2-166 |
| 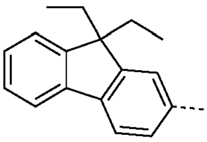 | 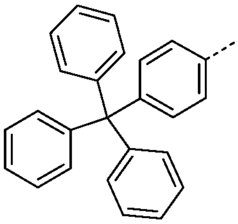 | 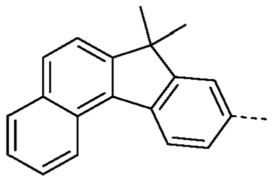 |
| R2-167 | R2-168 | R2-169 |
| 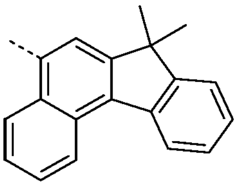 | 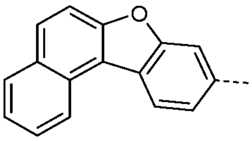 | 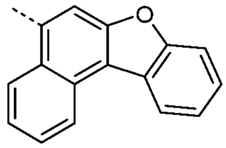 |
| R2-170 | R2-171 | R2-172 |
| 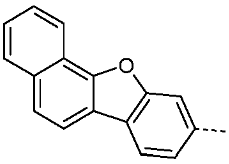 | 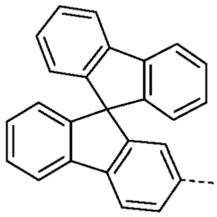 | 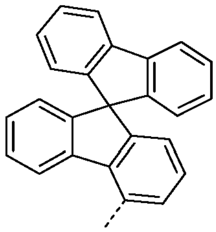 |
| R2-173 | R2-174 | R2-175 |
| 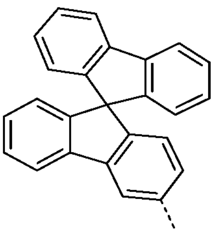 | 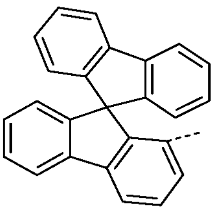 | 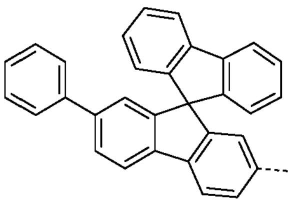 |
| R2-176 | R2-177 | R2-178 |

(fortgesetzt)

| | | |
|---|---|---|
| 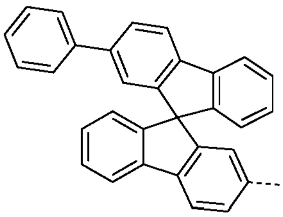 | 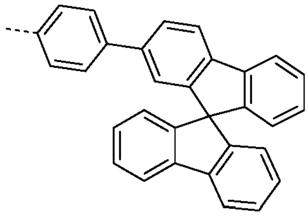 | 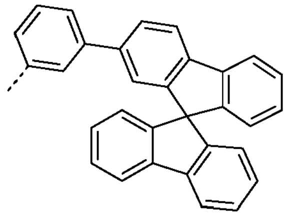 |
| R2-179 | R2-180 | R2-181 |
| 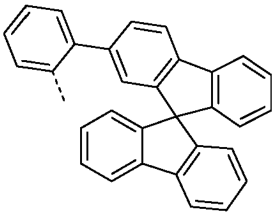 | 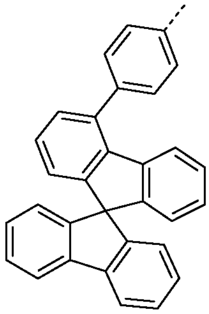 | 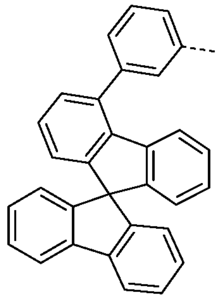 |
| R2-182 | R2-183 | R2-184 |
| 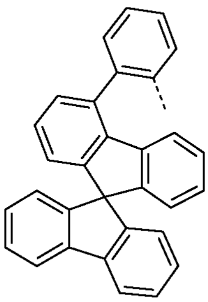 | 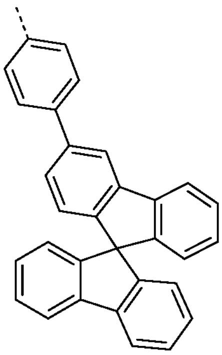 | 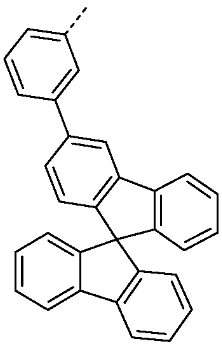 |
| R2-185 | R2-186 | R2-187 |
| 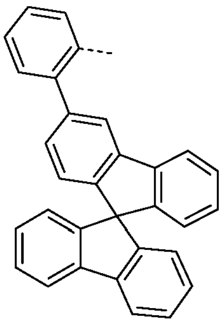 | 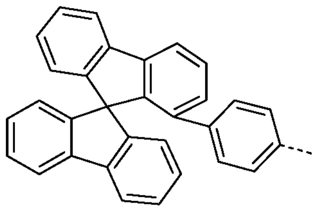 | 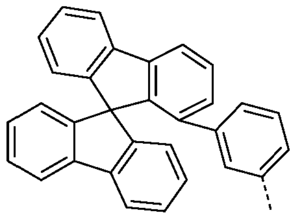 |
| R2-188 | R2-189 | R2-190 |
| 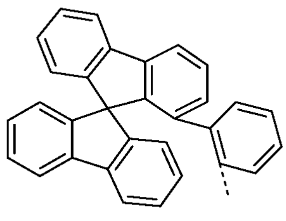 | | |
| R2-191 | | |

(fortgesetzt)

| | | |
|---|---|---|
| 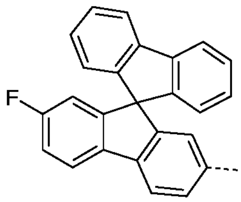 | 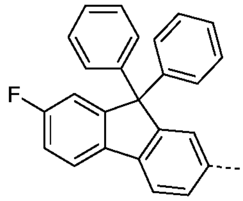 | 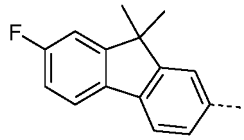 |
| R2-192 | R2-193 | R2-194 |
| 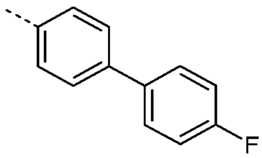 | 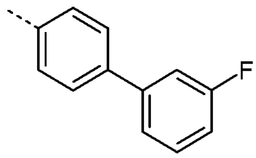 | 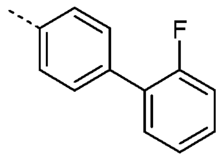 |
| R2-195 | R2-196 | R2-197 |
| 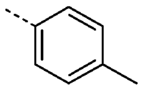 | 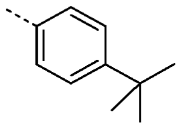 | 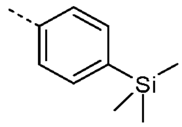 |
| R2-198 | R2-199 | R2-200 |
| 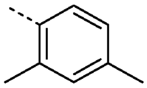 | 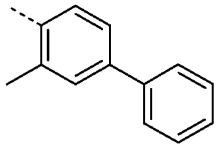 | 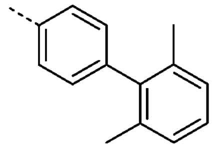 |
| R2-201 | R2-202 | R2-203 |
| 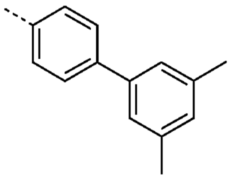 | 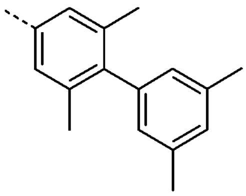 | 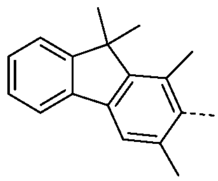 |
| R2-204 | R2-205 | R2-206 |
| 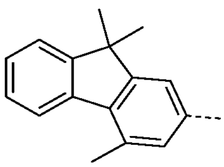 | 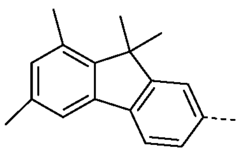 | 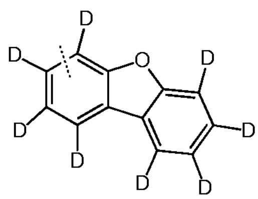 |
| R2-207 | R2-208 | R2-209 |
| 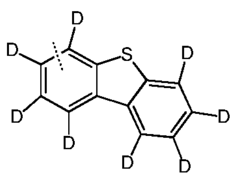 | 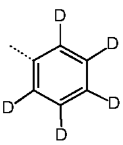 | 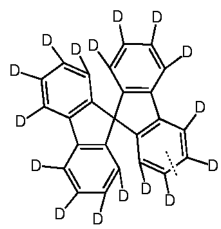 |
| R2-210 | R2-211 | R2-212 |

(fortgesetzt)

| | | |
|---|---|---|
| 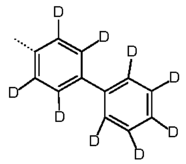 | 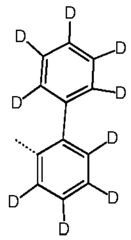 | 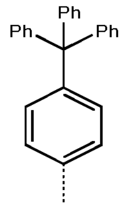 |
| R2-213 | R2-214 | R2-215 |
| 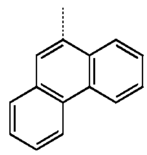 | 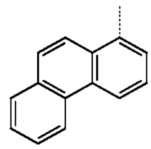 | 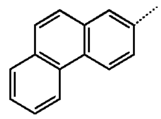 |
| R2-216 | R2-217 | R2-218 |
| 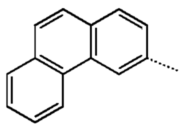 | 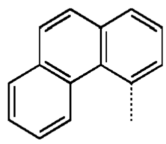 | 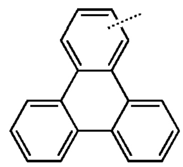 |
| R2-219 | R2-220 | R2-221, |

wobei die gestrichelte Linie die Bindung an den Rest der Formel (2) darstellt. Bevorzugt sind die Substituenten R2-1 bis R2-221 teilweise deuteriert oder vollständig deuteriert.

Steht in Verbindungen der Formel (2) x für 2 und $a_1$ für 1, 2 oder 3, so bilden die beiden Substituenten $R^2$ in einer bevorzugten Ausführungsform ein monocyclisches oder polycyclisches, aliphatisches, aromatisches oder heteroaromatisches Ringsystem, das mit einem oder mehreren Resten $R^3$ substituiert sein kann, mit der Bedingung, dass das Ringsystem und daran gebundene Substituenten keine Carbazolgruppe enthalten.

In einer bevorzugten Ausführungsform steht das Hostmaterial 2 der Formel (2) für mindestens eine Verbindung der Formel (3),

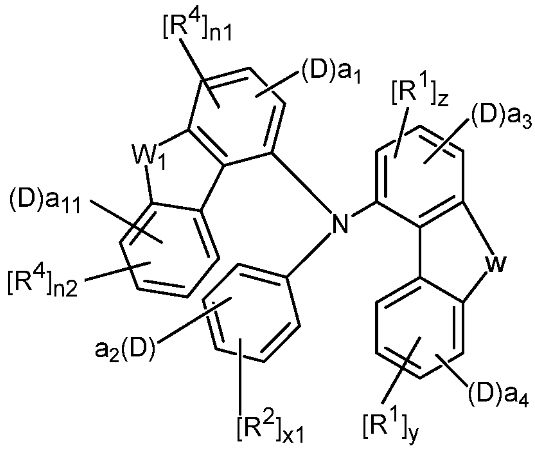

Formel (3),

wobei W, $R^1$, $R^2$, $a_1$, $a_2$, $a_3$, $a_4$, x, x1, y und z eine zuvor angegebene oder nachfolgend angegebene Bedeutung haben und für die verwendeten Symbole und Indizes gilt:

$W_1$ ist O, S oder $C(R)_2$, wobei R eine zuvor angegebene Bedeutung hat;
$R^4$ ist bei jedem Auftreten gleich oder verschieden ausgewählt aus der Gruppe bestehend aus F, Cl, Br, I, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder

einer verzweigten oder cyclischen Alkyl-, Alkoxy- oder Thioalkylgruppe mit 3 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br oder I ersetzt sein können, einem aromatischen oder heteroaromatischen Ringsystem mit 5 bis 60 Ringatomen, das jeweils mit einem oder mehreren Resten $R^3$ substituiert sein kann, wobei optional zwei oder mehr benachbarte Substituenten $R^4$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^4$ und daran gebundene Substituenten keine Carbazolgruppe enthalten;

$a_{11}$ ist 0, 1, 2, 3 oder 4;
n1 ist 0, 1 oder 2; und
n2 ist 0, 1, 2, 3 oder 4.

In Verbindungen der Formel (3) ist $a_{11}$ bevorzugt 1, 2, 3 oder 4.
In Verbindungen der Formel (3) ist $a_1+a_2+a_3+a_4+a_{11}$ bevorzugt ausgewählt aus 3, 4, 5, 6, 7, 8, 9, 10, 11, 12, 13, 14, 15, 16, 17, 18 oder 19.
In Verbindungen der Formel (3) ist n1 bevorzugt 0 oder 1.
In Verbindungen der Formel (3) ist n2 bevorzugt 0 oder 1.
In Verbindungen der Formel (3) ist n1+n2 bevorzugt 0 oder 1.
In Verbindungen der Formel (3) ist n1+n2 bevorzugt 0.
Bei Auftreten des Substituenten $R^4$ in Verbindungen der Formel (3), wie zuvor beschrieben, oder in Verbindungen der Formeln (3a), (3b), (3c), (3d) und (3e), wie nachfolgend beschrieben, wird dieser bevorzugt ausgewählt aus der Gruppe F, einer geradkettigen oder verzweigten Alkylgruppe mit 1 bis 20 C-Atomen, die jeweils mit einem oder mehreren Resten $R^3$ substituiert sein kann, den Substituenten R2-1 bis R2-221, wie zuvor beschrieben, wobei die Substituenten R2-1 bis R-221 auch teilweise deuteriert oder vollständig deuteriert sein können, sofern nicht schon als Solches beschrieben und wobei die gestrichelte Linie die Bindung an den Rest der Formeln (3), (3a), (3b), (3c), (3d) oder (3e) darstellt oder zwei oder mehr benachbarte Substituenten $R^4$ bilden ein monocyclisches oder polycyclisches, aromatisches oder heteroaromatisches Ringsystem, das mit einem oder mehreren Resten $R^3$ substituiert sein kann, mit der Bedingung, dass $R^3$ und daran gebundene Substituenten keine Carbazolgruppe enthalten.
Bei Auftreten des Substituenten $R^4$ in Verbindungen der Formeln (3), (3a), (3b), (3c), (3d), (3e), wie zuvor oder nachfolgend beschrieben, wird dieser besonders bevorzugt ausgewählt aus der Gruppe F, einer geradkettigen oder verzweigten Alkylgruppe mit 1 bis 10 C-Atomen, die jeweils mit einem oder mehreren Resten $R^3$ substituiert sein kann oder den Substituenten R2-1 bis R2-3, R2-63 bis R2-70, R2-107 bis R2-111, R2-114 bis R2-116, R2-122, R2-129 bis R2-139 und R2-206 bis R2-215 und R2-221, wie zuvor beschrieben, die teilweise deuteriert oder vollständig deuteriert sind.
Ein weiterer Gegenstand der Erfindung ist demzufolge eine organische lumineszierende Vorrichtung, wie zuvor beschrieben oder bevorzugt beschrieben, wobei das Hostmaterial 2 mindestens einer Verbindung der Formel (3) entspricht, wie zuvor beschrieben.
In Verbindungen der Formeln (2) oder (3), wie zuvor beschrieben oder als bevorzugt beschrieben, steht W für O, S oder $C(R)_2$, wobei R jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten. Bevorzugt steht W für O oder $C(R)_2$. Besonders bevorzugt steht W für $C(R)_2$, wobei R eine zuvor genannte oder nachfolgend bevorzugt genannte Bedeutung hat.
In Verbindungen der Formeln (2) oder (3), wie zuvor beschrieben oder als bevorzugt beschrieben, steht R bevorzugt für eine Methyl oder Phenylgruppe, die teilweise oder vollständig deuteriert sein können, oder zwei Substituenten R bilden mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten.
Bevorzugte Verbindungen der Formeln (2) oder (3) werden durch die Formeln (2a) bis (2e) und (3a) bis (3e) dargestellt,

| | |
|---|---|
| 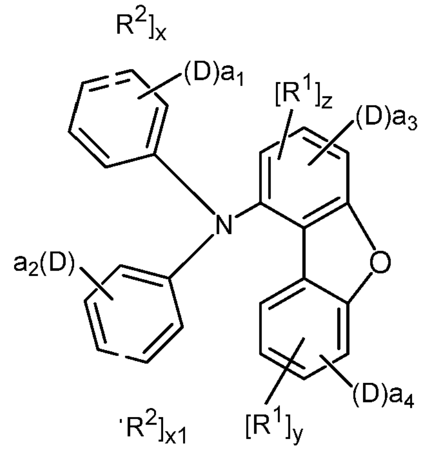 | 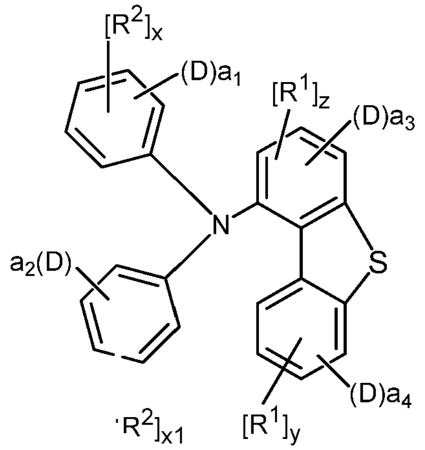 |
| Formel (2a) | Formel (2b) |
| 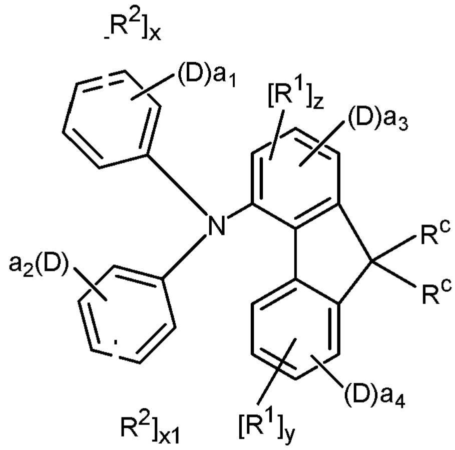 | 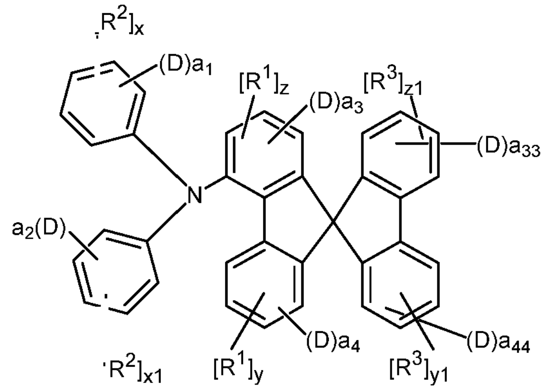 |
| Formel (2c) | Formel (2d) |
| 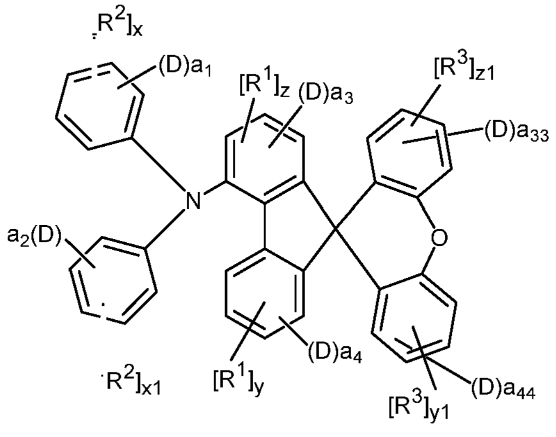 | 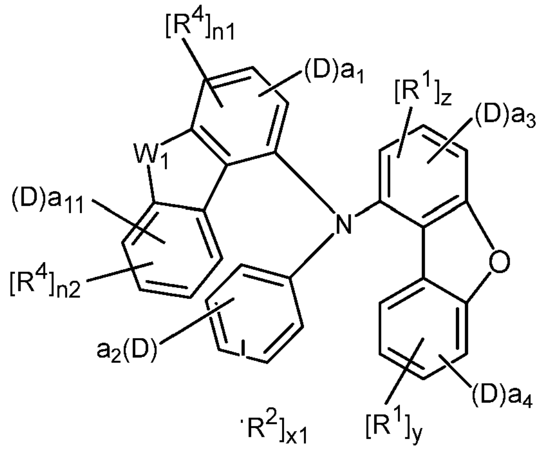 |
| Formel (2e) | Formel (3a) |

(fortgesetzt)

| | |
|---|---|
| 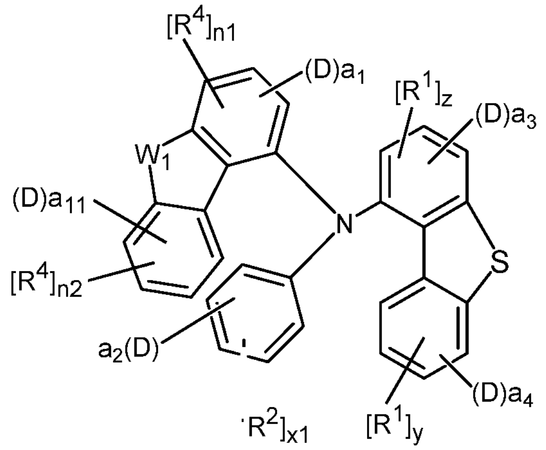 | 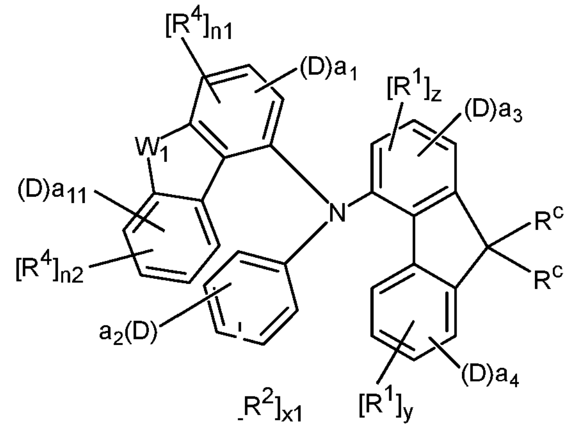 |
| Formel (3b) | Formel (3c) |
| 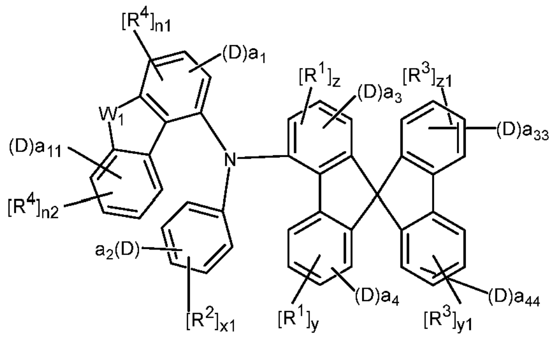 | 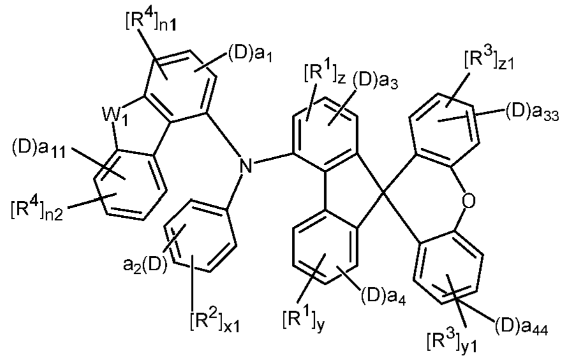 |
| Formel (3d) | Formel (3e), |

wobei $a_1$, $a_2$, $a_3$, $a_4$, $a_{11}$, $R^2$, x, x1, y, z, $R^1$, $R^3$, $R^4$ und $W_1$ eine zuvor genannte oder zuvor oder nachfolgend bevorzugt genannte Bedeutung haben und $R^c$ jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist;

y1, z1 sind jeweils unabhängig voneinander 0, 1 oder 2; und
$a_{33}$, $a_{44}$ sind jeweils unabhängig voneinander 0, 1, 2, 3 oder 4, mit der Bedingung,
dass $R^3$ und daran gebundene Substituenten keine Carbazolgruppe enthalten.

In Verbindungen der Formeln (2c) und (3c), wie zuvor beschrieben, oder in Verbindungen der Formeln (3h), (3l), (3n), (3o), (4) und (5), wie nachfolgend beschrieben, ist $R^c$ bevorzugt gleich und eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes Phenyl. In Verbindungen der Formeln (2c) und (3c), wie zuvor beschrieben, oder in Verbindungen der Formeln (3h), (3l), (3n), (3o), (4) und (5), wie nachfolgend beschrieben, ist $R^c$ bevorzugt gleich und jeweils $CD_3$.

In Verbindungen der Formeln (2d) und (2e) ist $a_{33}$ bevorzugt 1, 2, 3 oder 4. In Verbindungen der Formeln (2d) und (2e) ist $a_{44}$ bevorzugt 1, 2, 3 oder 4. In Verbindungen der Formeln (2d) und (2e) sind y1 und z1 bevorzugt 0.

In Verbindungen der Formel (2d) und (2e) ist $a_1+a_2+a_3+a_4+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24 oder 25.

In Verbindungen der Formeln (3a), (3b), (3c), (3d) und (3e) und den nachfolgend genannten Verbindungen der Formeln ((3f), (3g), (3h), (3i), (3j), (3k), (3l), (3m), (3n), (3o), (4), (5), (6), (7), (8) und (9), ist $a_{11}$ bevorzugt 1, 2, 3 oder 4.

In Verbindungen der Formel (3d) und (3e) und den nachfolgend genannten Verbindungen der Formeln (6), (7), (8) und (9) ist $a_{33}$ bevorzugt 1, 2, 3 oder 4. In Verbindungen der Formel (3d) und (3e) und den nachfolgend genannten Verbindungen der Formeln (6), (7), (8) und (9) ist $a_{44}$ bevorzugt 1, 2, 3 oder 4. In Verbindungen der Formel (3d) und (3f) sind y1 und z1 bevorzugt 0.

In Verbindungen der Formeln (3a), (3b) und (3c) ist $a_1+a_2+a_3+a_4+a_{11}$ bevorzugt ausgewählt aus 3, 4, 5, 6, 7, 8, 9, 10, 11, 12, 13, 14, 15, 16, 17, 18 oder 19. In Verbindungen der Formel (3d) und (3e) ist $a_1+a_2+a_3+a_4+a_{11}+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

Bei Auftreten des Substituenten $R^3$ in Verbindungen der Formeln (2d), (2e), (3d) und (3e), wie zuvor beschrieben, oder in Verbindungen der Formeln (3i), (3m), (5), (6), (7), (8) und (9), wie nachfolgend beschrieben, wird dieser bevorzugt ausgewählt aus der Gruppe F, einer geradkettigen oder verzweigten Alkylgruppe mit 1 bis 20 C-Atomen, in dem ein oder mehrere H-Atome durch D, F, Cl, Br, I oder CN ersetzt sein kann/können oder den Substituenten R2-1 bis R2-221, wie zuvor beschrieben, wobei die Substituenten R2-1 bis R-221 auch teilweise deuteriert oder vollständig deuteriert sein können, sofern nicht schon als Solches beschrieben und wobei die gestrichelte Linie die Bindung an den Rest der Formeln (2d), (2e), (3d), (3e), (3i), (3m), (5), (6), (7), (8) und (9) darstellt.

Bei Auftreten des Substituenten $R^3$ in Verbindungen der Formeln (2d), (2e), (3d) und (3e), wie zuvor beschrieben, oder in Verbindungen der Formeln (3i), (3m), (5), (6), (7), (8) und (9), wie nachfolgend beschrieben wird dieser besonders bevorzugt ausgewählt aus der Gruppe F, einer geradkettigen oder verzweigten Alkylgruppe mit 1 bis 10 C-Atomen, in dem ein oder mehrere H-Atome durch D ersetzt ist/sind oder den Substituenten R2-1 bis R2-3, R2-63 bis R2-70, R2-107 bis R2-111, R2-114 bis R2-116, R2-122, R2-129 bis R2-139 und R2-206 bis R2-215 und R2-221, wie zuvor beschrieben, die teilweise deuteriert oder vollständig deuteriert sind, sofern nicht schon als Solches beschrieben.

In einer bevorzugten Ausführungsform der Verbindungen der Formeln (3), (3a), (3b), (3c), (3d) und (3e), wie zuvor beschrieben oder als bevorzugt beschrieben, steht $W_1$ für O, S oder $C(R)_2$, wobei R jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten. Bevorzugt steht $W_1$ für O oder $C(R)_2$. Besonders bevorzugt steht $W_1$ für $C(R)_2$, wobei R eine zuvor genannte oder zuvor bevorzugt genannte Bedeutung hat.

Bevorzugte Verbindungen der Formeln (3), (3a), (3b), (3c) und (3d), werden durch die Formeln (3f), (3g), (3h), (3i), (3j), (3k), (3l), (3m), (3n), (3o), (4), (5), (6), (7), (8) und (9) dargestellt,

| | |
|---|---|
| 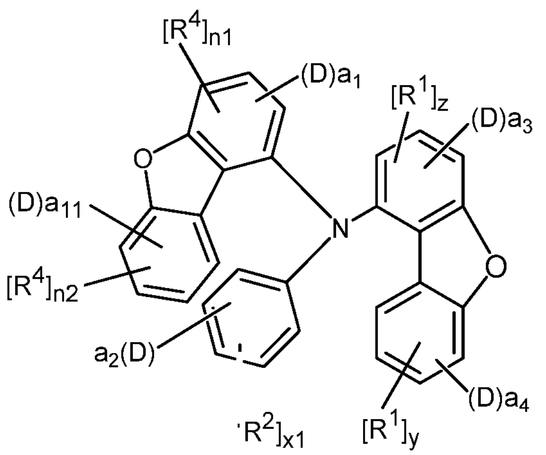 | 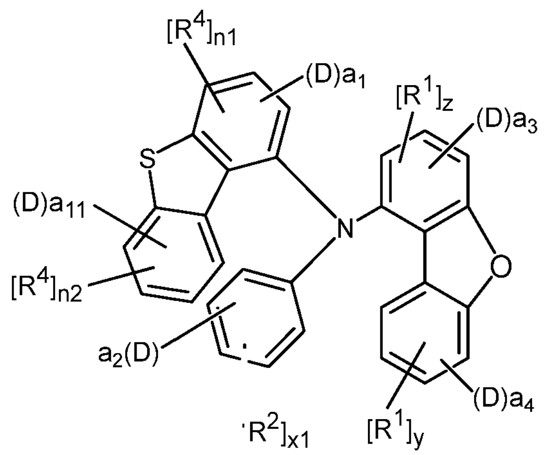 |
| Formel (3f) | Formel (3g) |

(fortgesetzt)

| | |
|---|---|
| 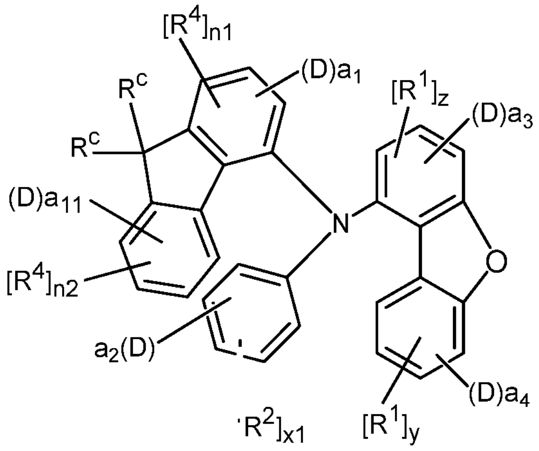 | 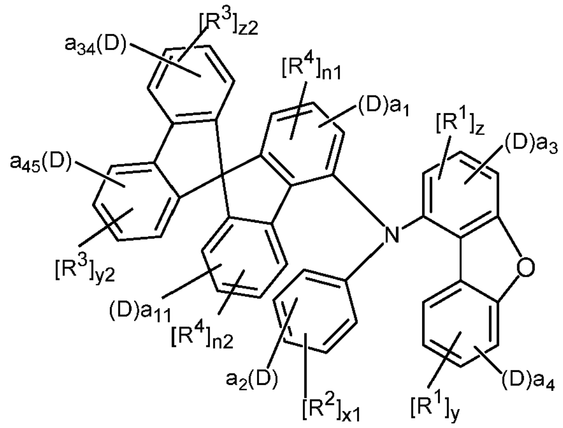 |
| Formel (3h) | Formel (3i) |
| 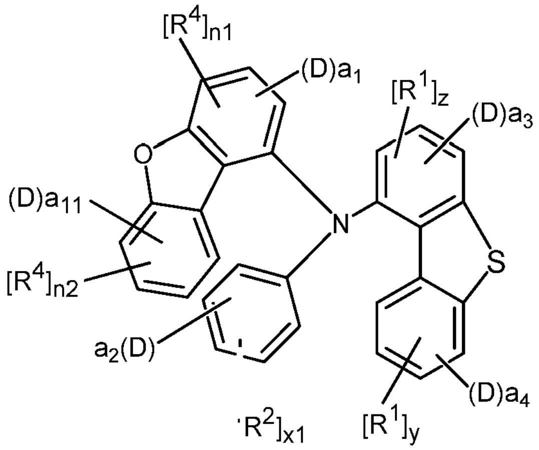 | 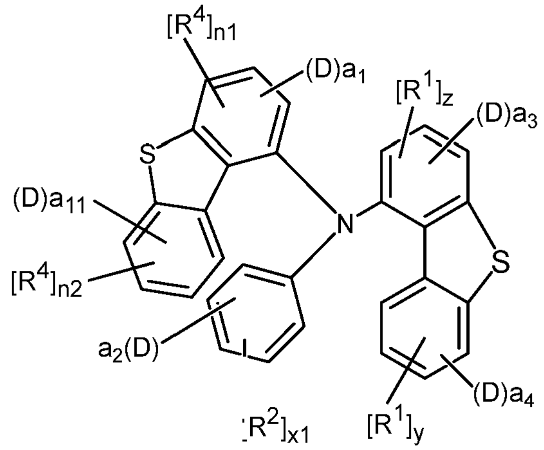 |
| Formel (3j) | Formel (3k) |
| 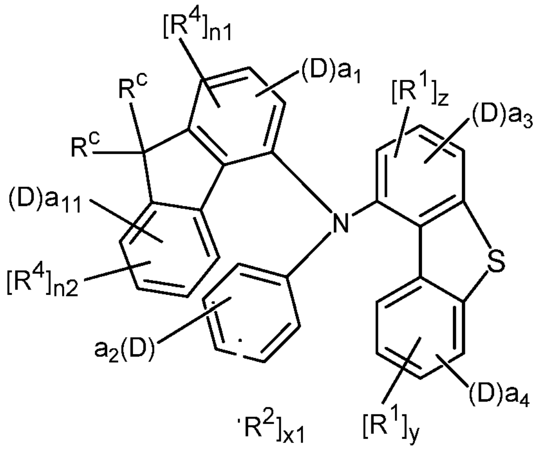 | 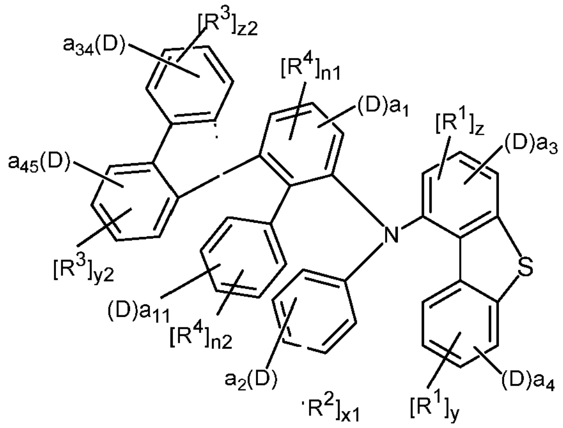 |
| Formel (3l) | Formel (3m) |

(fortgesetzt)

| | |
|---|---|
| 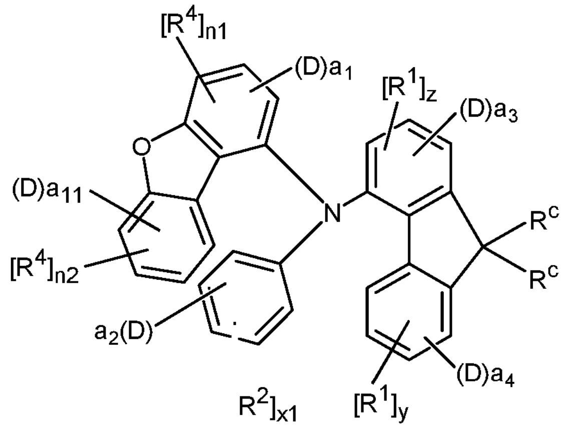 | 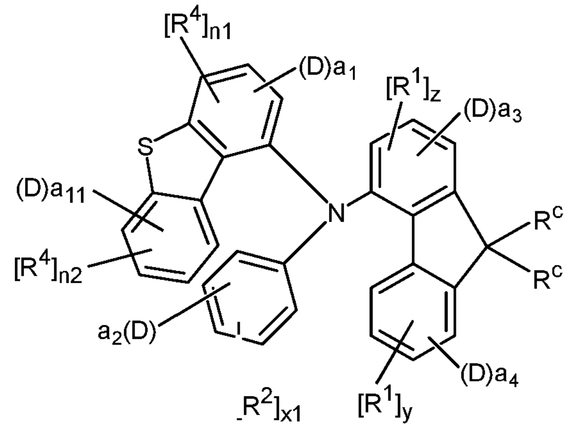 |
| Formel (3n) | Formel (3o) |
| 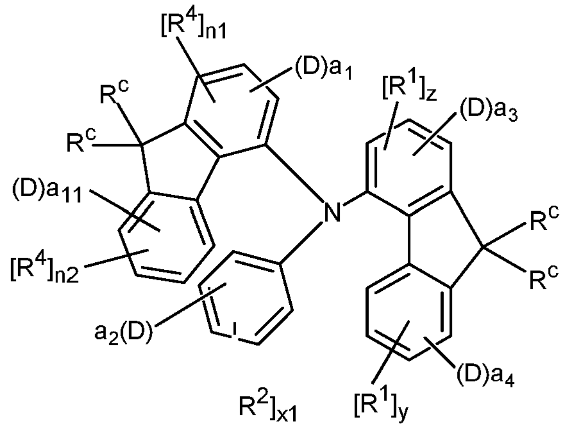 | 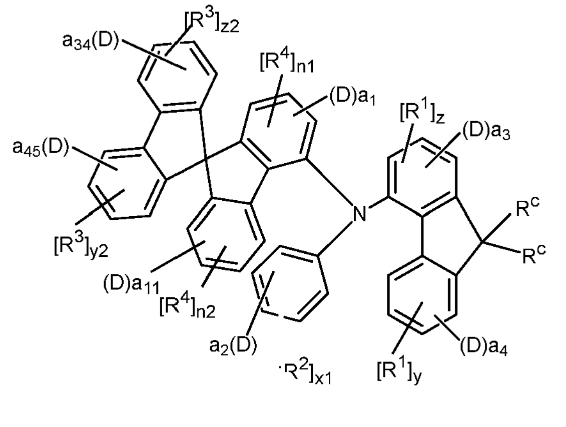 |
| Formel (4) | Formel (5) |
| 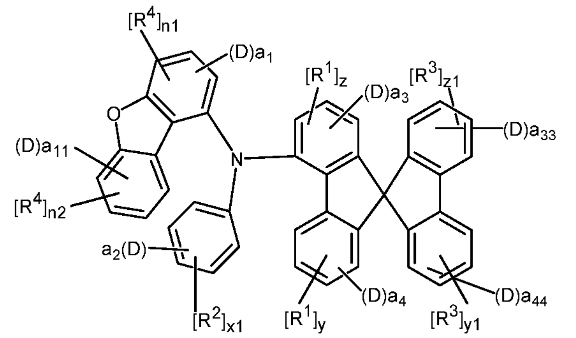 | 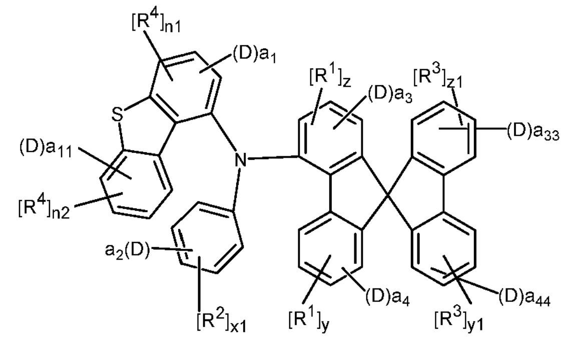 |
| Formel (6) | Formel (7) |
| 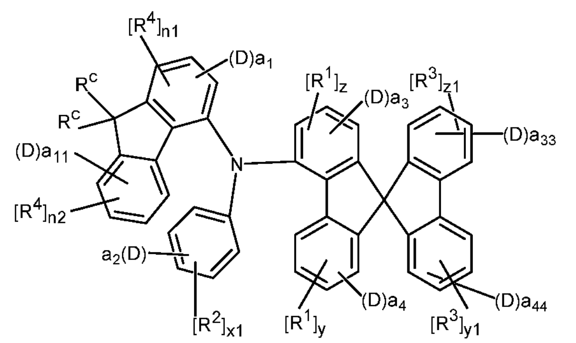 | 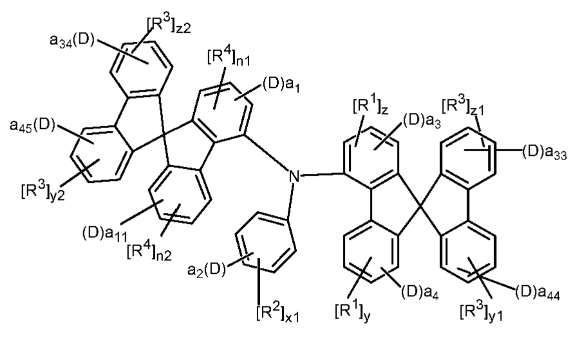 |

(fortgesetzt)

| | |
|---|---|
| Formel (8) | Formel (9), |

wobei $a_1$, $a_2$, $a_3$, $a_4$, $a_{11}$, $a_{33}$, $a_{44}$, $R^2$, x, x1, y, y1, z, z1, $R^1$, $R^3$, $R^c$ und $R^4$ eine zuvor genannte oder zuvor oder nachfolgend bevorzugt genannte Bedeutung haben und

y2, z2 sind jeweils unabhängig voneinander 0, 1 oder 2; und
$a_{34}$, $a_{45}$ sind jeweils unabhängig voneinander 0, 1, 2, 3 oder 4.

In Verbindungen der Formeln (3f), (3g), (3h), (3j), (3k), (3l), (3n), (3o) und (4) ist $a_1+a_2+a_3+a_4+a_{11}$ bevorzugt ausgewählt aus 3, 4, 5, 6, 7, 8, 9, 10, 11, 12, 13, 14, 15, 16, 17, 18 oder 19. In Verbindungen der Formeln (6), (7) und (8) ist $a_1+a_2+a_3+a_4+a_{11}+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

In Verbindungen der Formeln (3i), (3m) und (5) ist $a_1+a_2+a_3+a_4+a_{11}+a_{34}+a_{45}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

In Verbindungen der Formeln (9) ist $a_1+a_2+a_3+a_4+a_{11}+ a_{33}+a_{44}+a_{34}+a_{45}$ bevorzugt ausgewählt aus 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34 oder 35.

In Verbindungen der Formeln (3i), (3m), (5) und (9) sind y2 und z2 bevorzugt 0.

In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y bevorzugt 0 oder 1. In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist z bevorzugt 0 oder 1. In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y+z bevorzugt 0 oder 1. In einer bevorzugten Ausführungsform der Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y+z bevorzugt 0.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser bevorzugt ausgewählt aus der Gruppe F, einer geradkettigen, verzweigten oder cyclischen Alkylgruppe mit 1 bis 20 C-Atomen, in dem ein oder mehrere H-Atome durch D, F, Cl, Br, I oder CN ersetzt sein kann/können.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser besonders bevorzugt ausgewählt aus der Gruppe F, einer geradkettigen oder verzweigten Alkylgruppe mit 1 bis 10 C-Atomen, in dem ein oder mehrere H-Atome durch D ersetzt sein kann/können.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser ganz besonders bevorzugt ausgewählt aus der Gruppe einer geradkettigen oder verzweigten Alkylgruppe mit 1 bis 10 C-Atomen, in dem ein oder mehrere H-Atome durch D ersetzt ist/sind.

Besonders bevorzugt werden Verbindungen der Formeln (4), (5), (6), (7), (8) oder (9) als Hostmaterial 2 in der erfindungsgemäßen Vorrichtung verwendet, wobei die genannten Symbole und Indizes eine zuvor genannte oder jeweils zuvor bevorzugt genannte oder eine jeweils nachfolgend bevorzugt genannte Bedeutung haben.

Ganz besonders bevorzugt werden Verbindungen der Formeln (5), (8) oder (9) als Hostmaterial 2 in der erfindungsgemäßen Vorrichtung verwendet, wobei die genannten Symbole und Indizes eine zuvor genannte oder jeweils zuvor bevorzugt genannte oder eine jeweils nachfolgend bevorzugt genannte Bedeutung haben.

Ein weiterer Gegenstand der Erfindung ist demzufolge eine organische elektrolumineszierende Vorrichtung, wie zuvor beschrieben oder bevorzugt beschrieben, wobei die mindestens eine Verbindung der Formel (2) einer Verbindung der Formeln (5), (8) oder (9) entspricht.

In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) steht x1 bevorzugt für 1 oder 2, wobei $R^2$ bei jedem Auftreten gleich oder verschieden bevorzugt ausgewählt wird aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein

kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten.

Steht in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) x1 für 1 und $a_1$ für 1, 2, 3 oder 4, so wird der Substituent $R^2$ bevorzugt aus der Gruppe der Substituenten R2-1 bis R2-221 ausgewählt, wobei die Substituenten R2-1 bis R-221 in diesem Fall mit einem oder mehreren Resten $R^5$ substituiert sein kann/können, in dem ein oder mehrere H-Atome oder D-Atome durch $R^5$ ersetzt würde(n), wobei $R^5$ bei jedem Auftreten gleich oder verschieden ausgewählt ist aus der Gruppe bestehend aus F, CN, $N(Ar_1)_2$, einem aliphatischen Kohlenwasserstoffrest mit 1 bis 20 C-Atomen oder einem aromatischen oder heteroaromatischen Ringsystem mit 5 bis 30 Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^5$ miteinander ein mono- oder polycyclisches, aliphatisches, aromatisches oder heteroaromatisches Ringsystem bilden, mit der Bedingung, dass das Ringsystem und daran gebundene Substituenten keine Carbazolgruppe enthalten.

Bei Auftreten des Substituenten $R^5$ in Substituenten R2-1 bis R2-221 von Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser bevorzugt ausgewählt aus der Gruppe F, $N(Ar_1)_2$, einer geradkettigen oder verzweigten Alkylgruppe mit 1 bis 10 C-Atomen, in dem ein oder mehrere H-Atome durch D ersetzt sein kann/können oder einem aromatischen oder heteroaromatischen Ringsystem mit 5 bis 18 Ringatomen, in dem ein oder mehrere H-Atome durch D ersetzt sein können, wobei $Ar_1$ eine zuvor angegebene Bedeutung hat, mit der Bedingung, dass das Ringsystem und daran gebundene Substituenten keine Carbazolgruppe enthalten oder zwei oder mehr benachbarte Substituenten $R^5$ bilden miteinander ein mono- oder polycyclisches, aliphatisches, aromatisches oder heteroaromatisches Ringsystem, mit der Bedingung, dass das Ringsystem und daran gebundene Substituenten keine Carbazolgruppe enthalten.

Bei Auftreten des Substituenten $N(Ar_1)_2$ wird $Ar_1$ jeweils unabhängig voneinander bevorzugt ausgewählt aus der Gruppe R2-1 bis R2-221, wie zuvor beschrieben, die teilweise deuteriert oder vollständig deuteriert sein können und mit der Bedingung, dass das Ringsystem und daran gebundene Substituenten keine Carbazolgruppe enthalten, wobei die gestrichelte Linie an das N-Atom bindet.

In einer bevorzugten Ausführungsform des Hostmaterials 2, repräsentiert durch die Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird der N-gebundene Substituent der Teilformel (2-0),

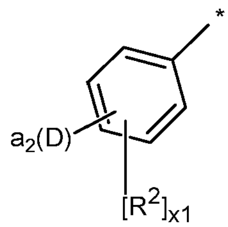

Formel (2-0)

,

aus der Gruppe der Substituenten R2-1 bis R2-221 ausgewählt, wobei mindestens ein H-Atom der Substituenten R2-1 bis R2-221 durch D ersetzt ist, wobei die Substituenten R2-1 bis R-221 in diesem Fall mit einem oder mehreren Resten $R^5$ substituiert sein kann/können, in dem ein oder mehrere H-Atome oder D-Atome, jedoch nicht das mindestens eine D-Atom, durch $R^5$ ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und * die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet.

In dieser Ausführungsform ist es bevorzugt, wenn der N-gebundene Substituent der Teilformel (2-0) aus der Gruppe der Substituenten R2-2 bis R2-47, R2-63 bis R2-98, R2-107 bis R2-139, R2-174 bis R2-197, R2-206 bis R2-214 und R2-221 ausgewählt wird, wobei mindestens ein H-Atom durch D ersetzt ist, d.h. die Substituenten teilweise deuteriert oder vollständig deuteriert sind, wobei die genannten Substituenten in diesem Fall mit einem oder mehreren Resten $R^5$ substituiert sein kann/können, in dem ein oder mehrere H-Atome oder D-Atome, jedoch nicht das mindestens eine D-Atom, durch $R^5$

ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und die gestrichelte Linie die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet.

In dieser Ausführungsform ist es besonders bevorzugt, wenn der N-gebundene Substituent der Teilformel (2-0) aus der Gruppe der Substituenten R2-174 bis R2-197 und R2-212 ausgewählt wird, wobei mindestens ein H-Atom durch D ersetzt ist, d.h. die Substituenten teilweise deuteriert oder vollständig deuteriert sind, wobei die Substituenten R2-174 bis R-297 und R2-212 in diesem Fall mit einem oder mehreren Resten $R^5$ substituiert sein kann/können, in dem ein oder mehrere H-Atome oder D-Atome, jedoch nicht das mindestens eine D-Atom, durch $R^5$ ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und die gestrichelte Linie die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet. Bevorzugt sind die Substituenten R2-1 bis R2-221 als Teilformel (2-0) teilweise deuteriert oder vollständig deuteriert.

Beispiele für geeignete Hostmaterialien der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9), die erfindungsgemäß ausgewählt werden, und bevorzugt in Kombination mit mindestens einer Verbindung der Formel (1) in der erfindungsgemäßen elektrolumineszierenden Vorrichtung verwendet werden, sind die nachstehend genannten Strukturen der Tabelle 3:

Tabelle 3:

| | | |
|---|---|---|
| 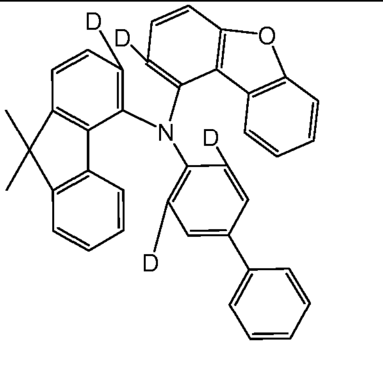 | 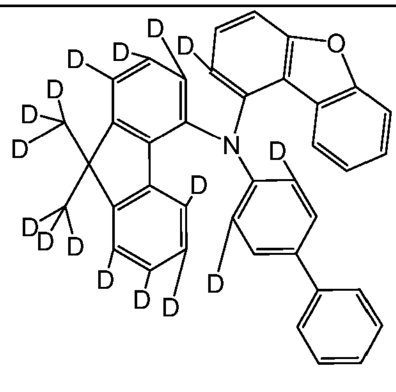 | 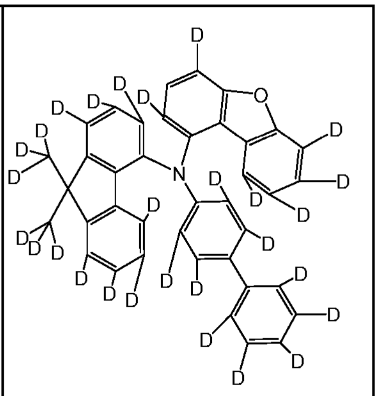 |
| 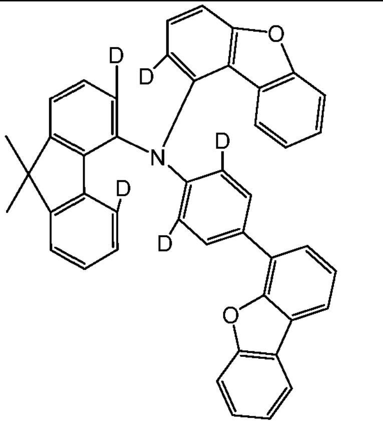 | 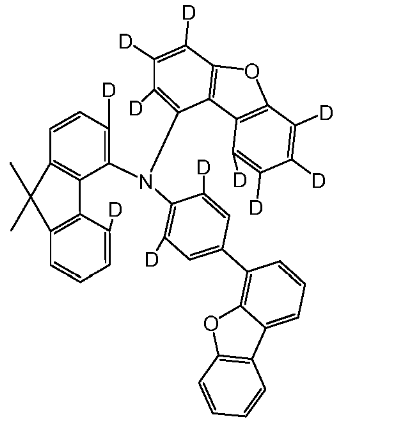 | 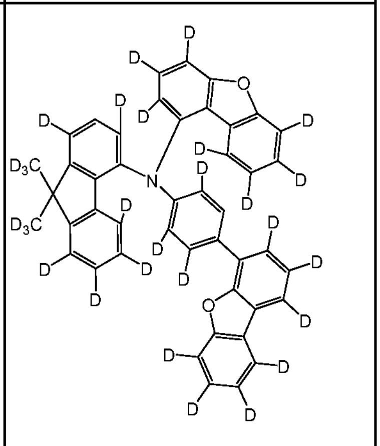 |
| 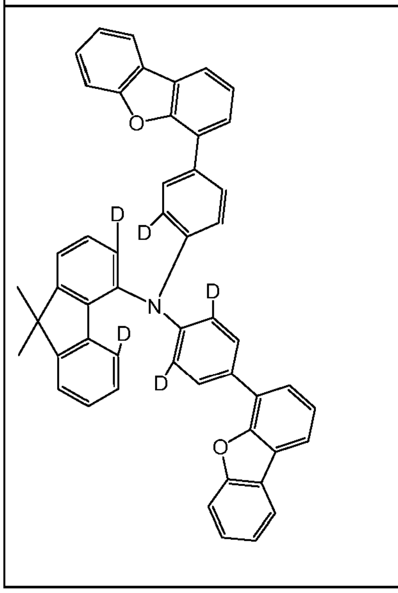 | 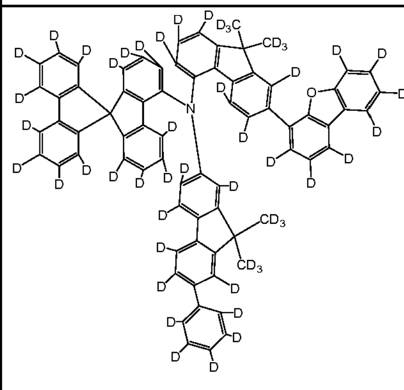 | 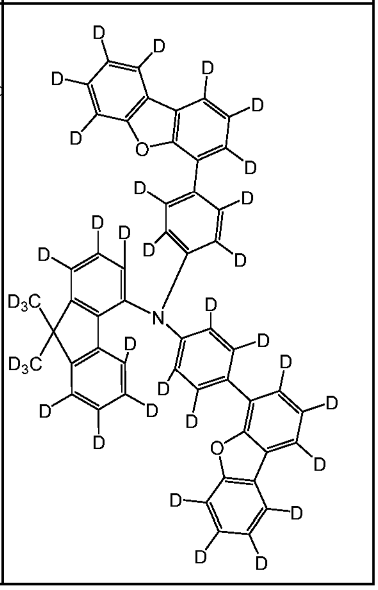 |

| | | |
|---|---|---|
| 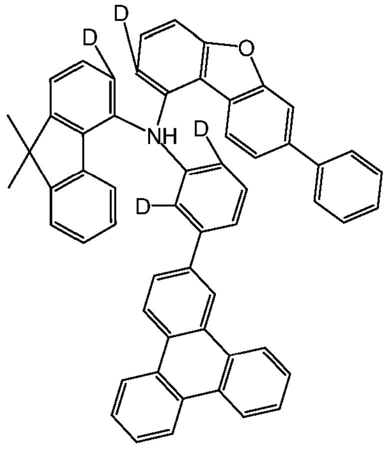 | 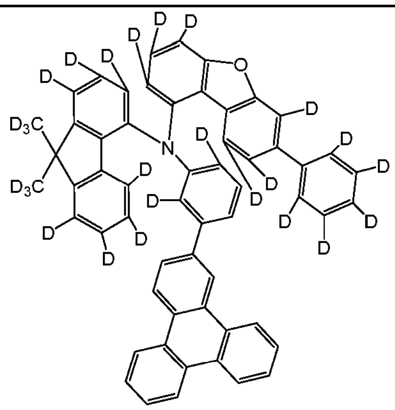 | 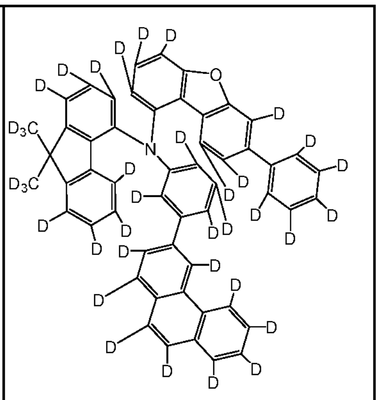 |
| 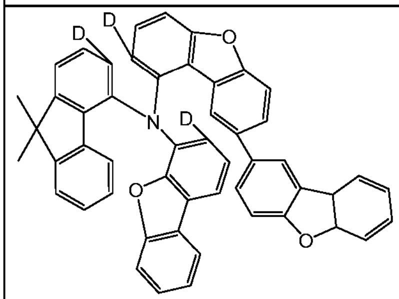 | 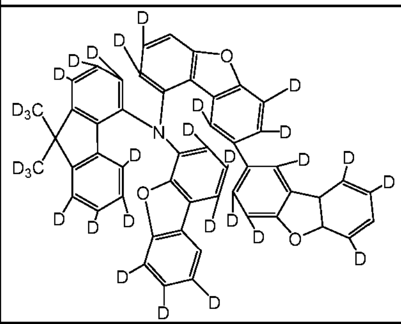 | 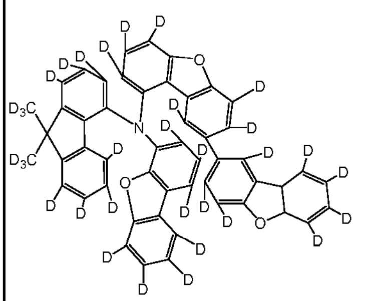 |
| 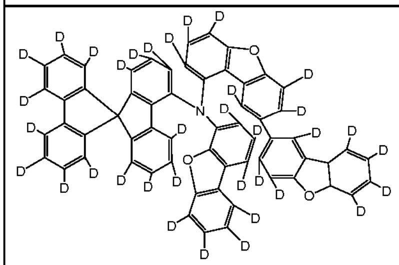 | 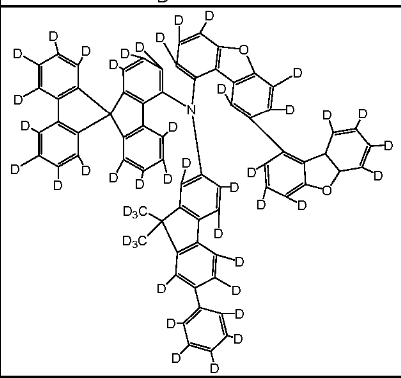 | 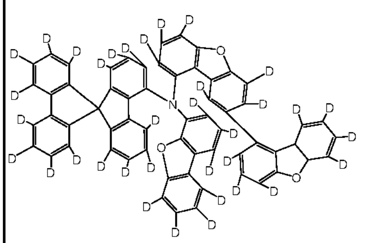 |
| 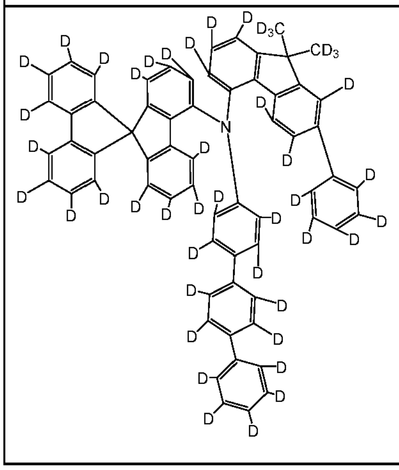 | 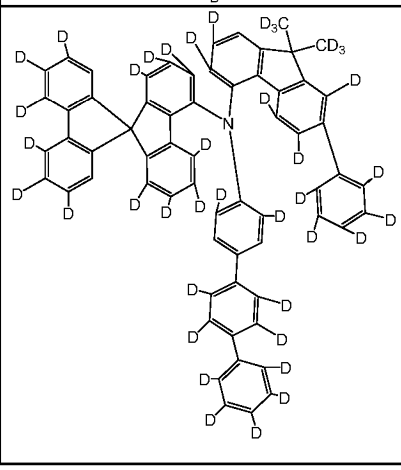 | 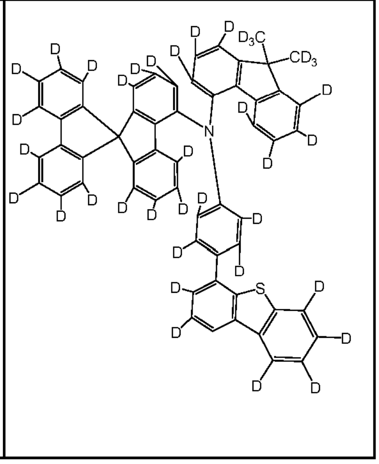 |

| | | |
|---|---|---|
| 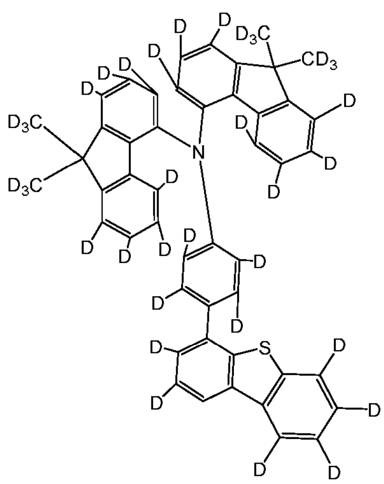 | 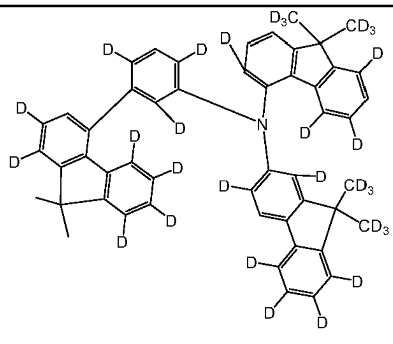 | 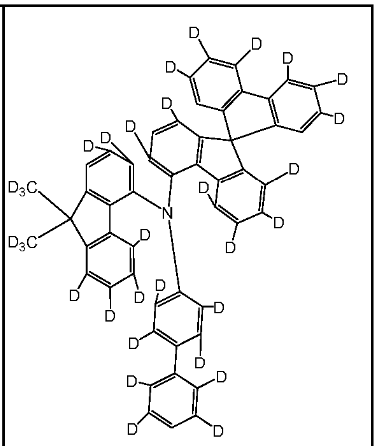 |
| 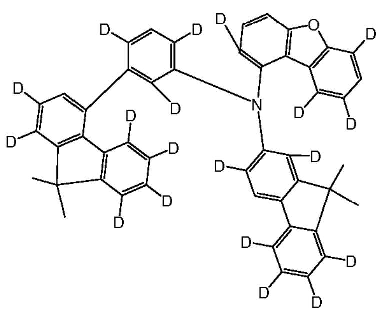 | 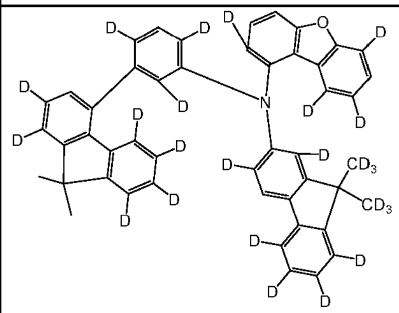 | 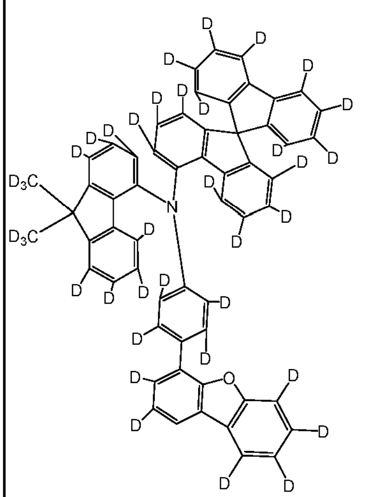 |
| 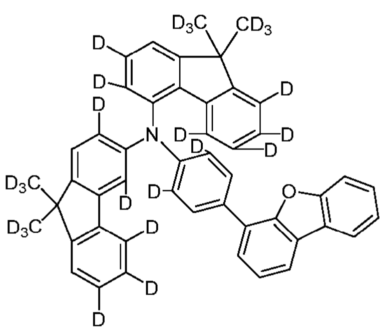 | 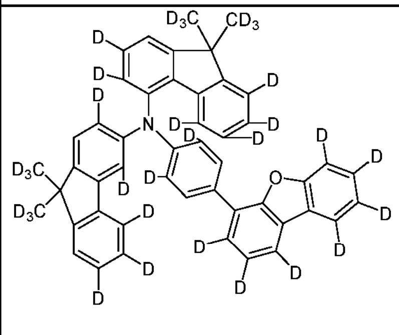 | 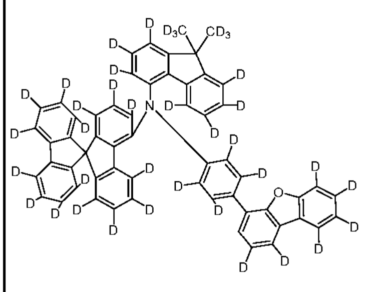 |
| 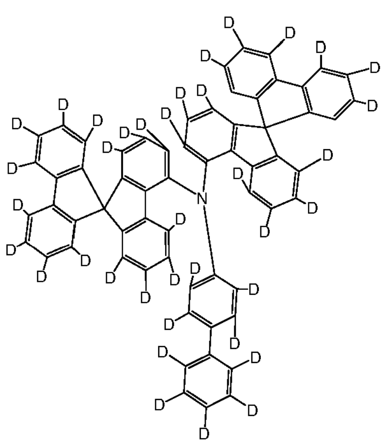 | 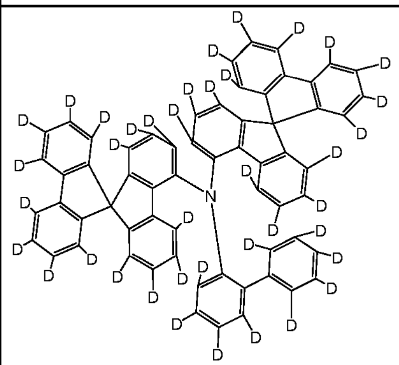 | 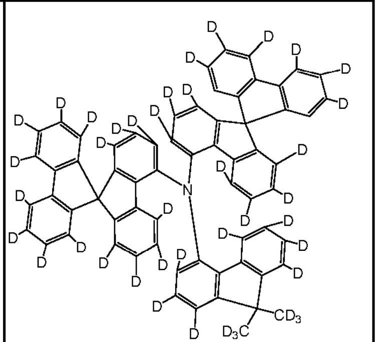 |

| | | |
|---|---|---|
| 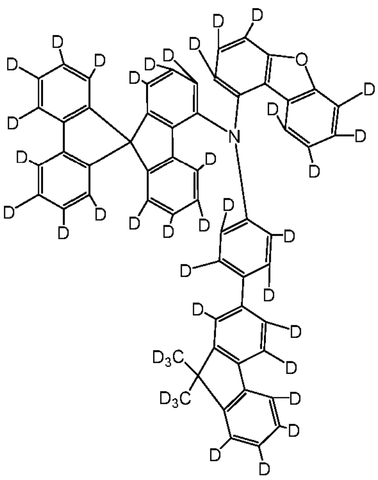 | 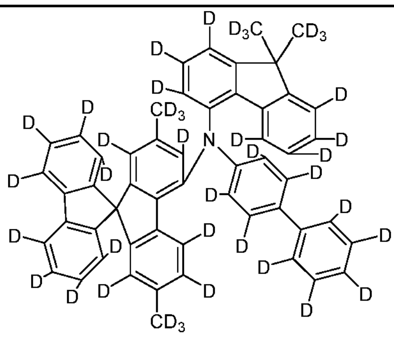 | 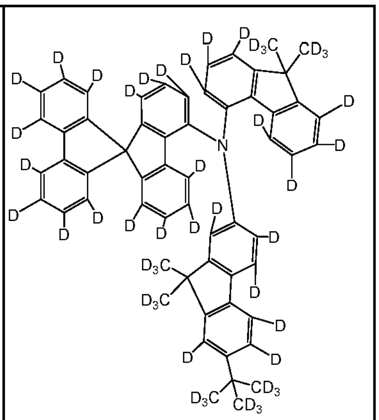 |
| 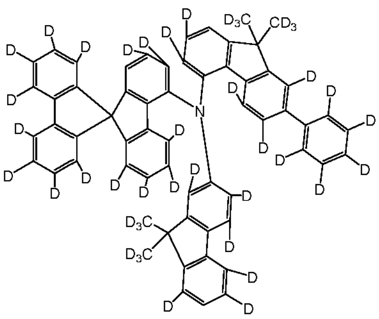 | 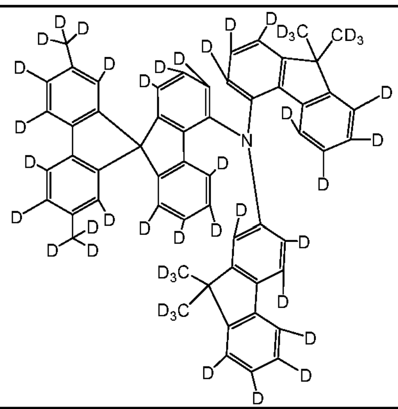 | 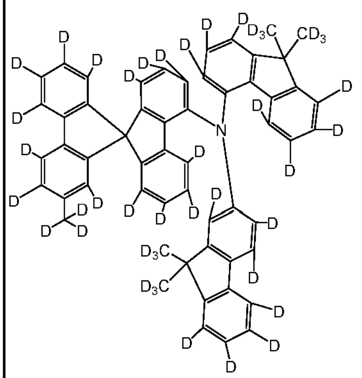 |
| 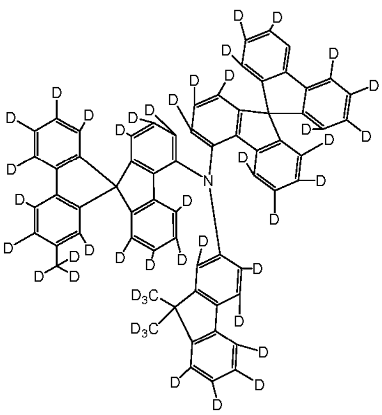 | 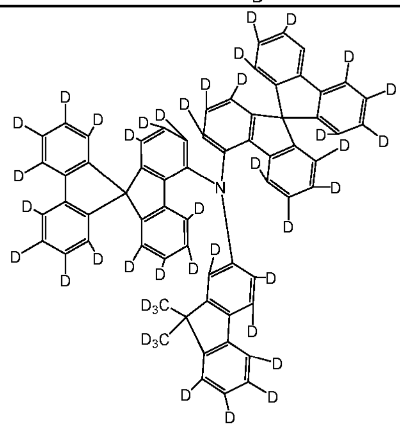 | 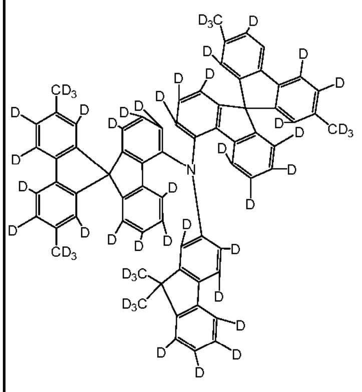 |
| 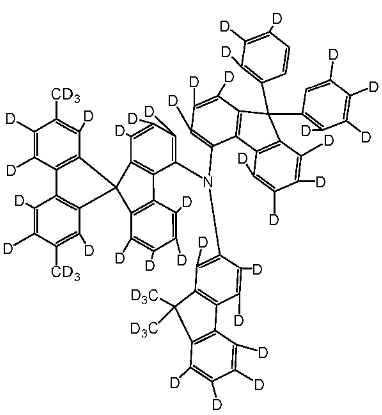 | 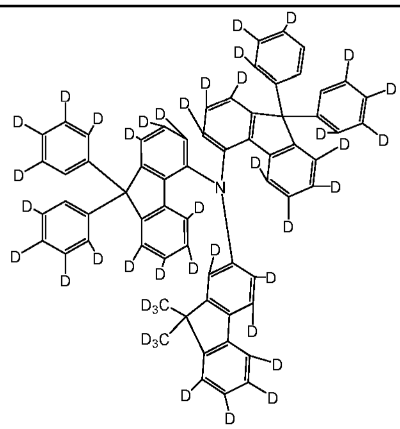 | 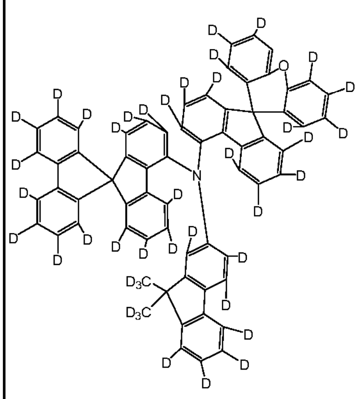 |

| | | |
|---|---|---|
| 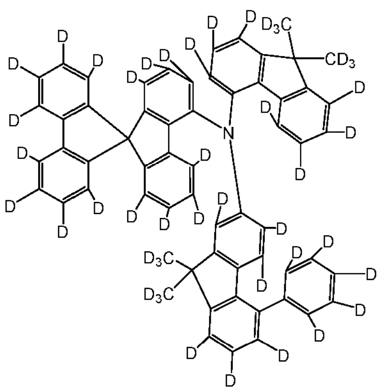 | 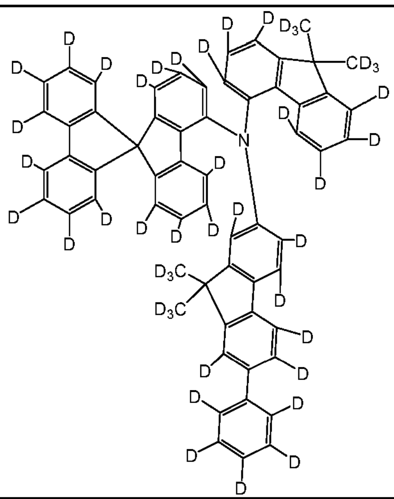 | 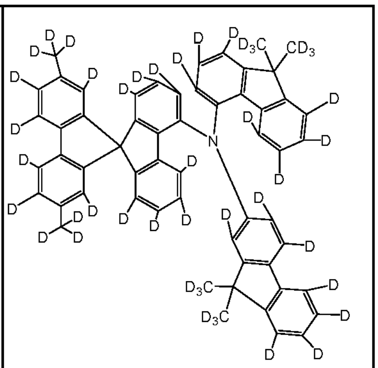 |
| 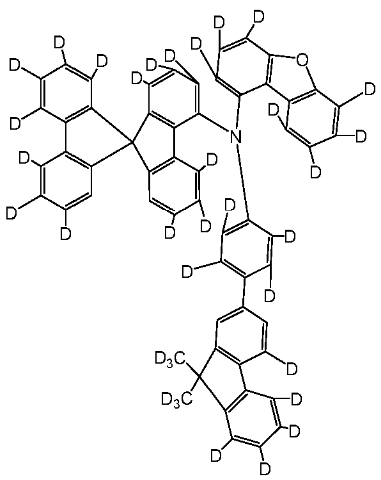 | 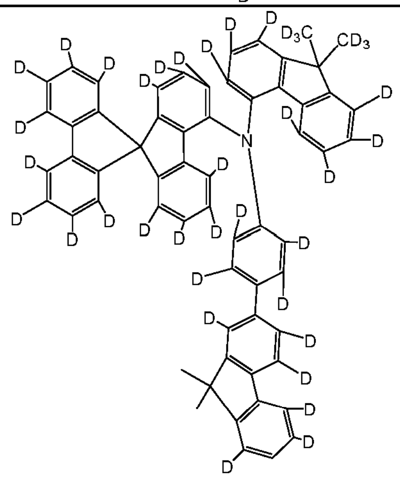 | 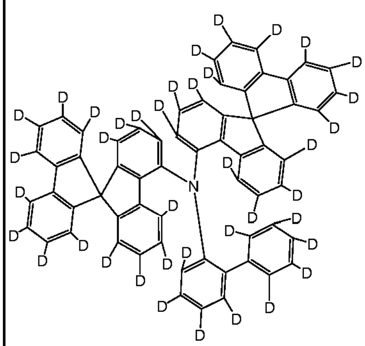 |
| 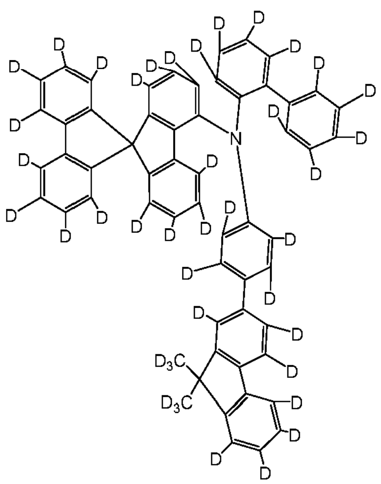 | 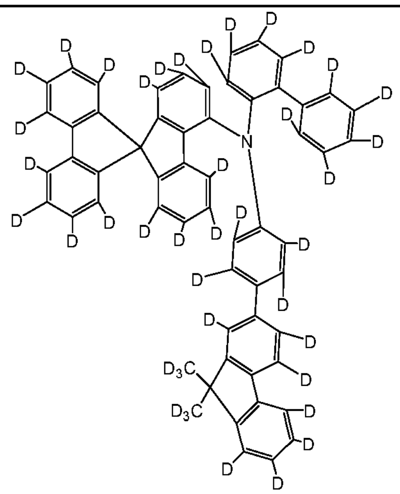 | 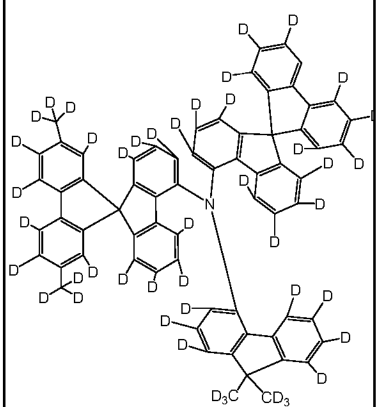 |

| | | |
|---|---|---|
| 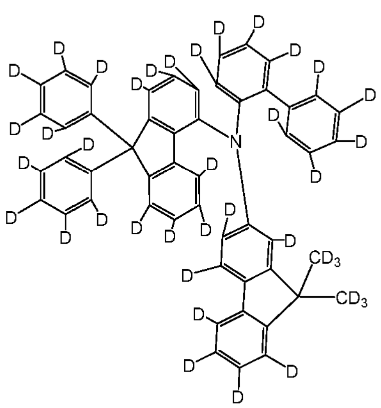 | 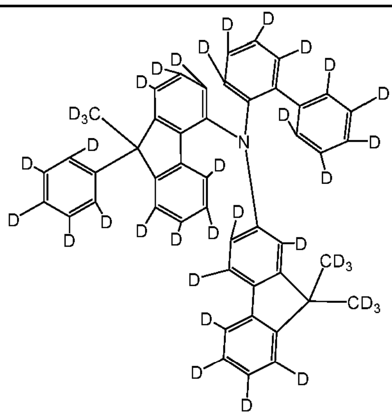 | 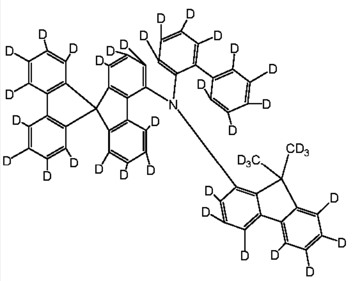 |
| 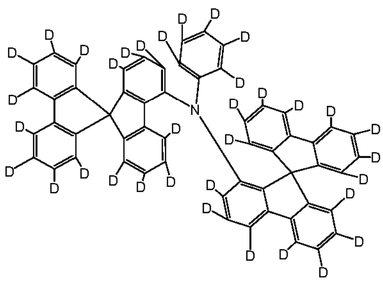 | 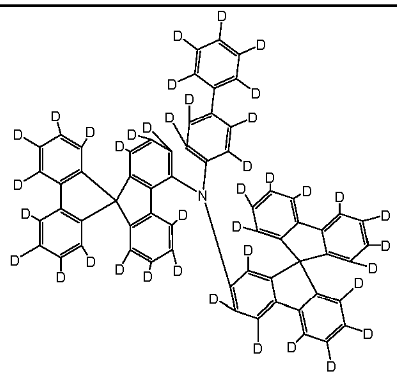 | 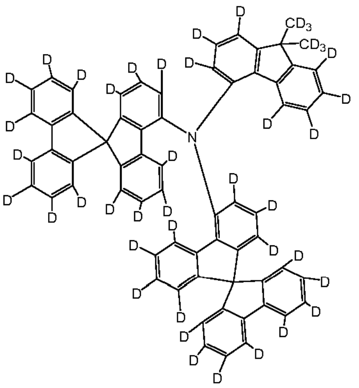 |
| 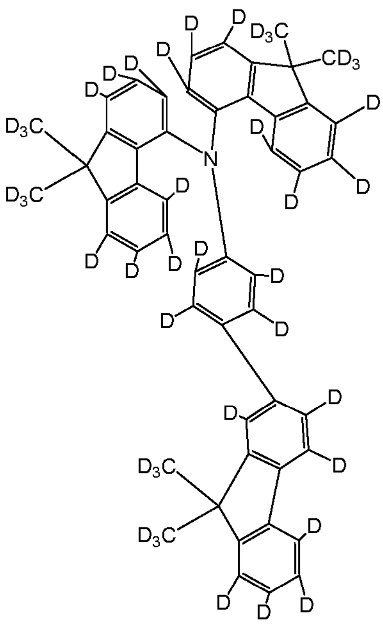 | 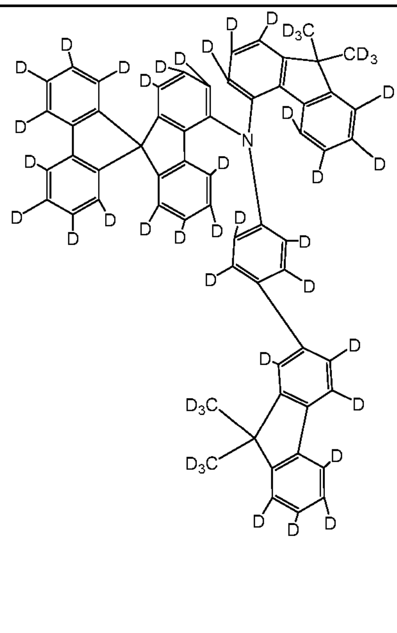 | 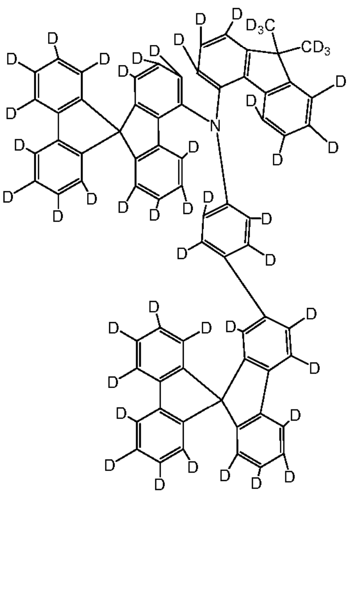 |

| | | |
|---|---|---|
| 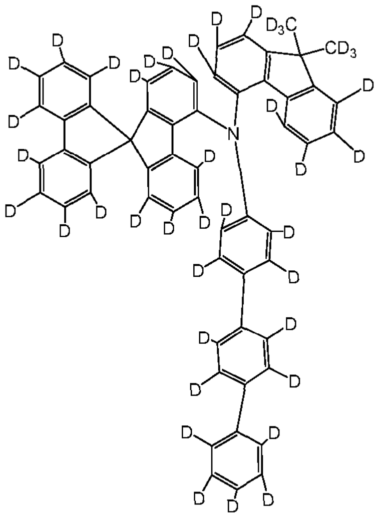 | 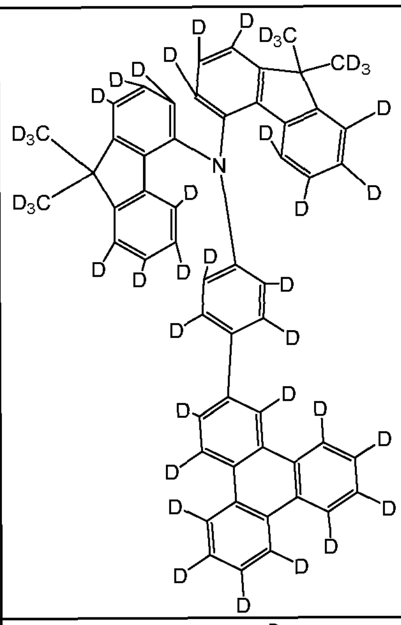 | 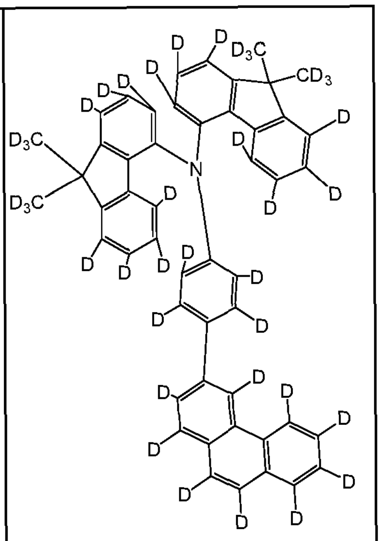 |
| 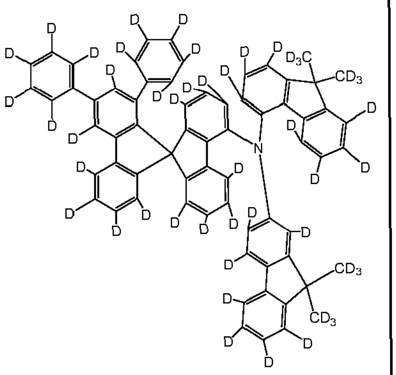 | 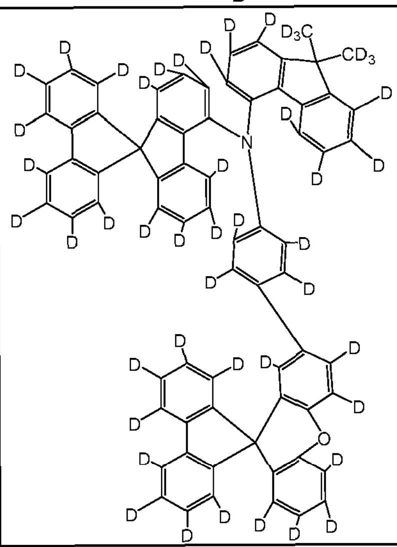 | 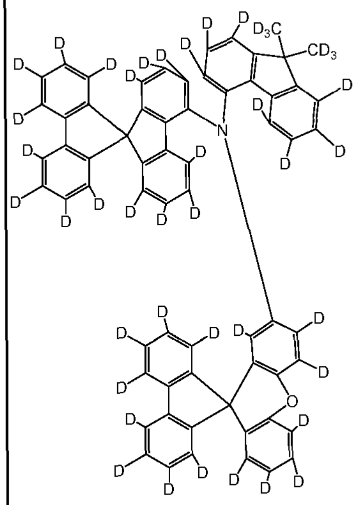 |
| 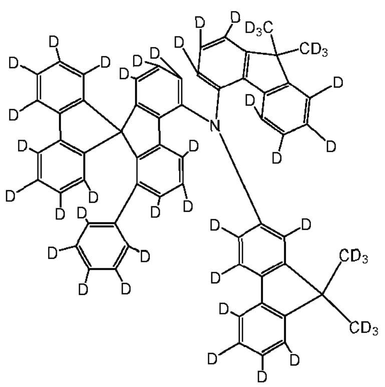 | 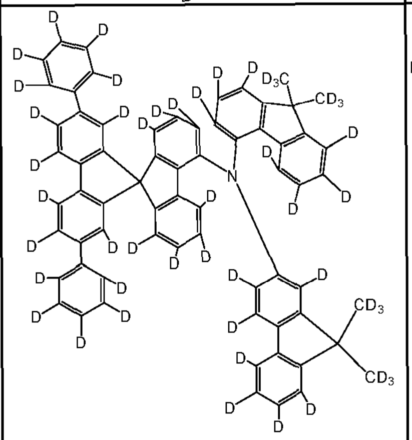 | 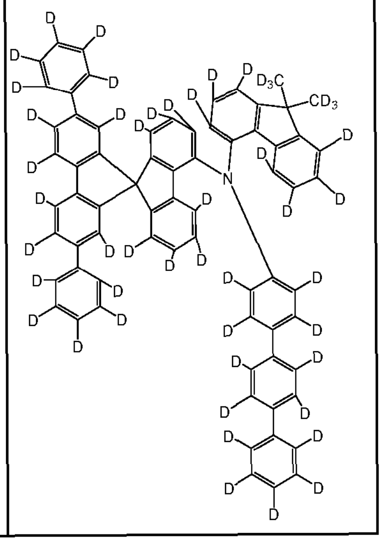 |

| | | |
|---|---|---|
| 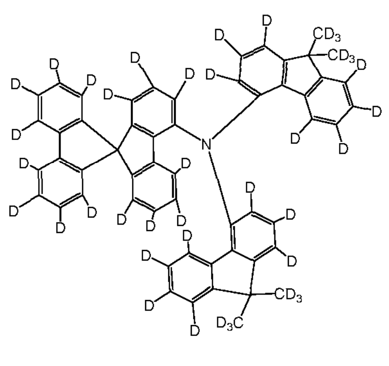 | 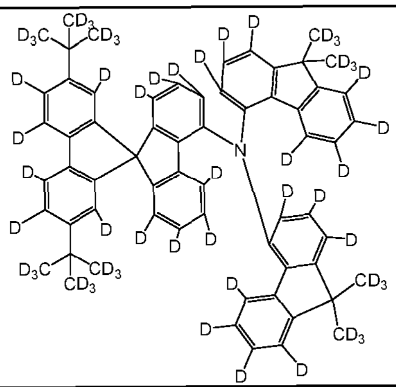 | 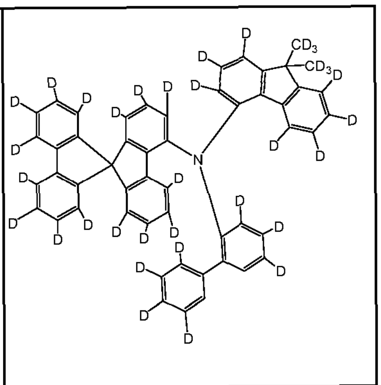 |
| 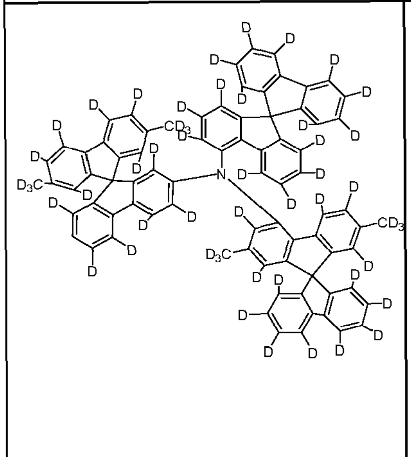 | 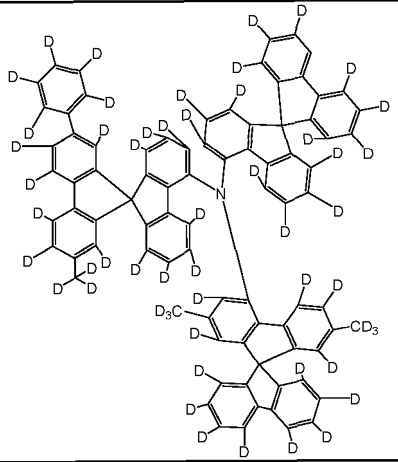 | 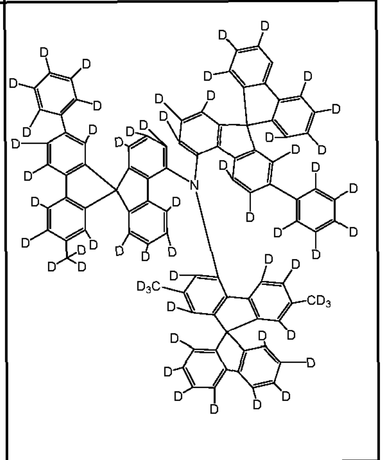 |
| 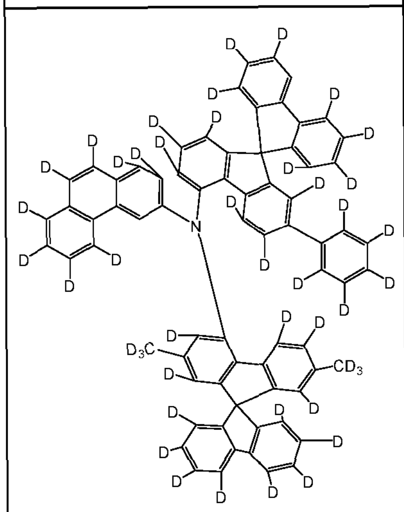 | 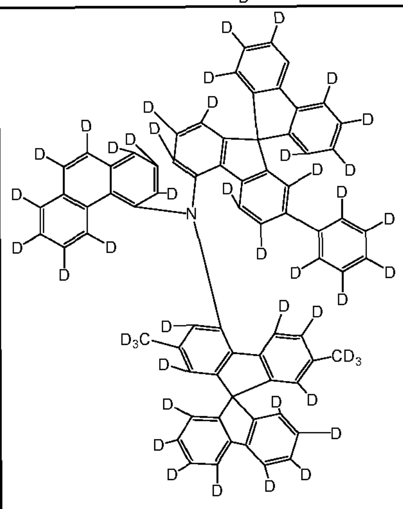 | 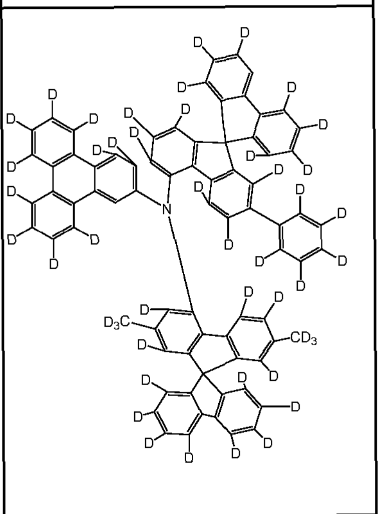 |
| 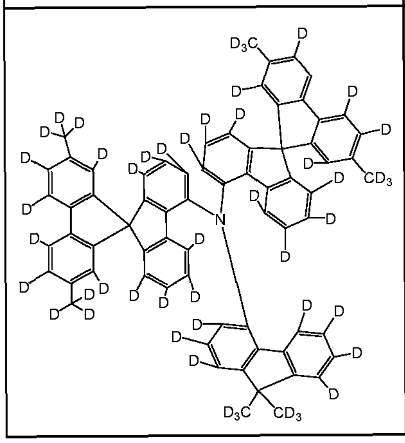 | 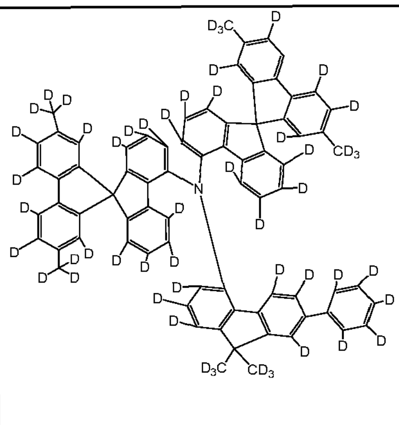 | 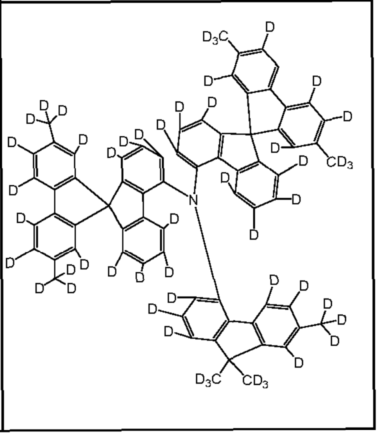 |

| | | |
|---|---|---|
| 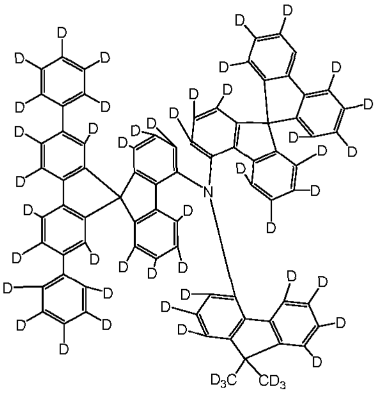 | 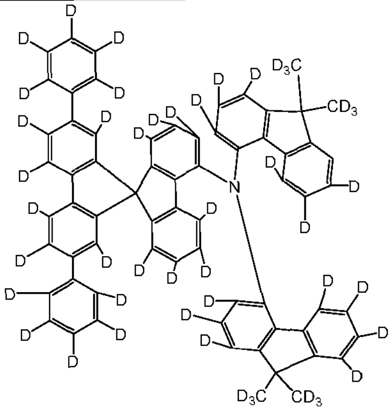 | 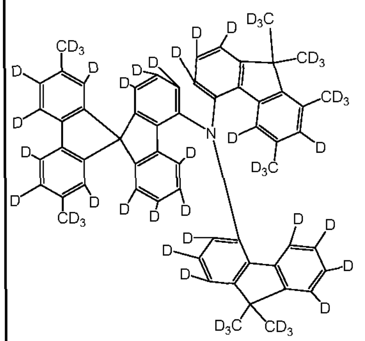 |
| 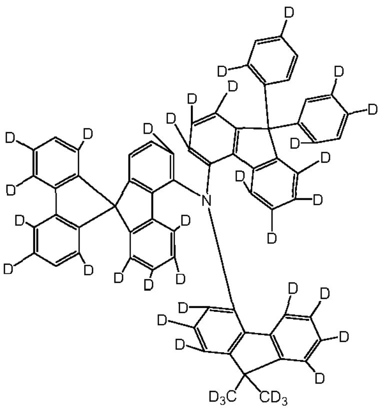 | 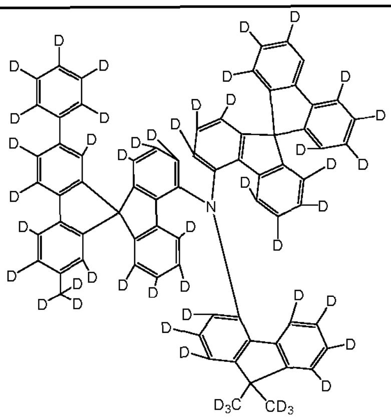 | 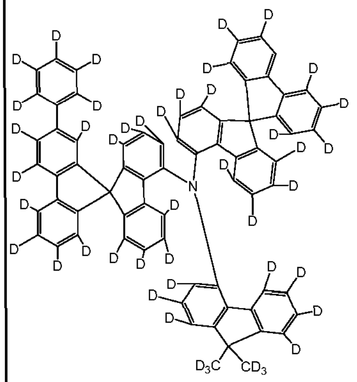 |
| 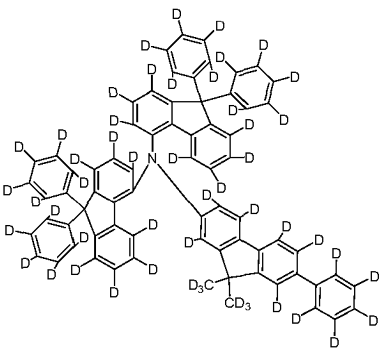 | 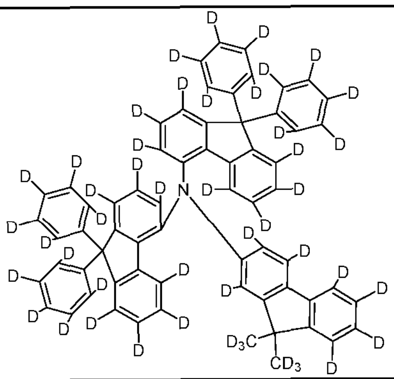 | 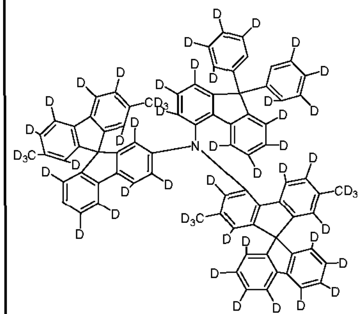 |
| 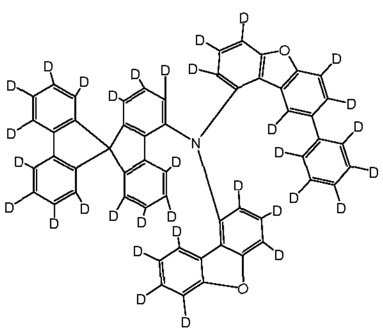 | 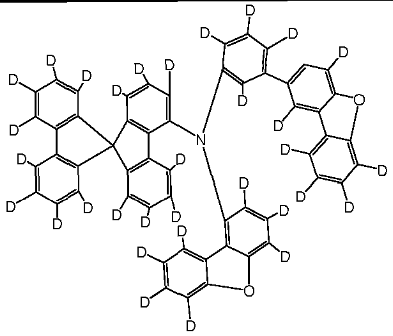 | 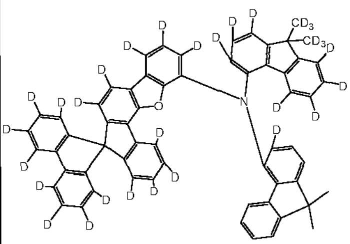 |

| | | |
|---|---|---|
| 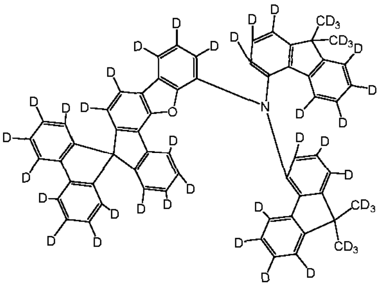 | 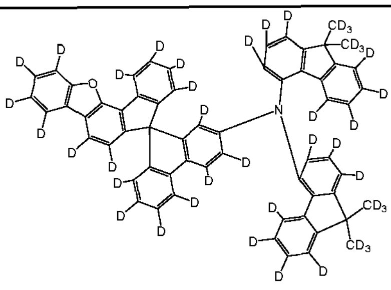 | 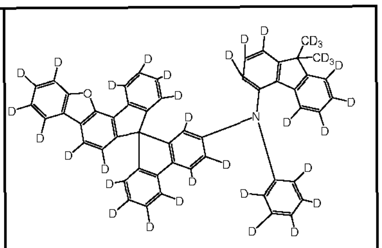 |
| 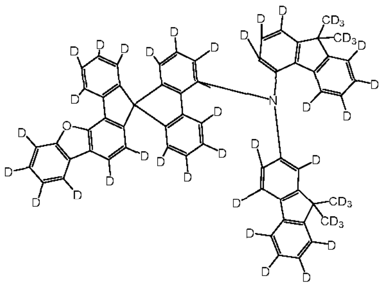 | 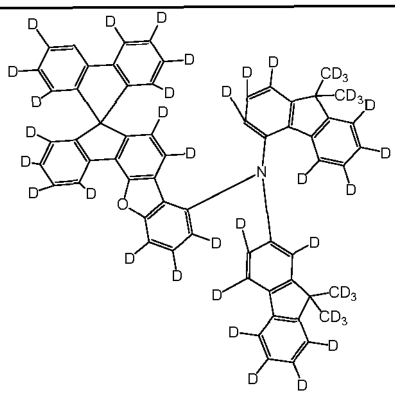 | 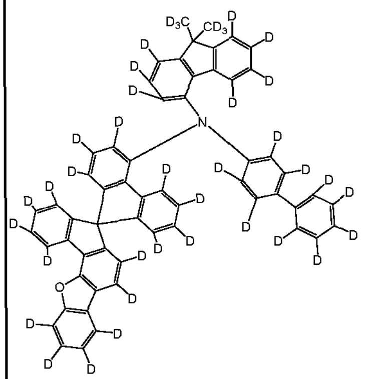 |
| 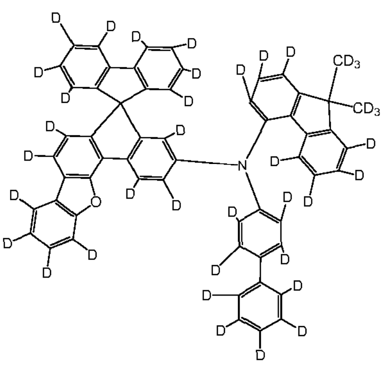 | 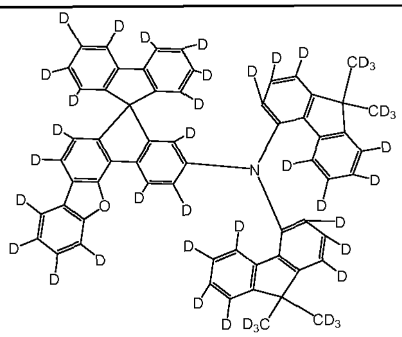 | 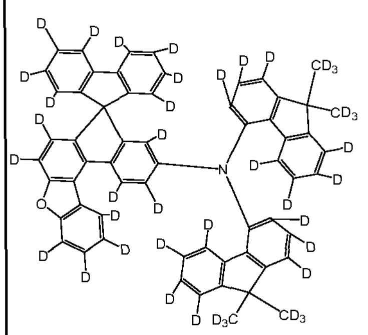 |
| 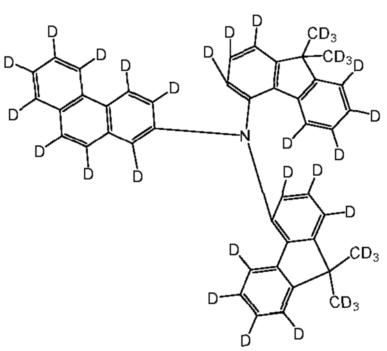 | 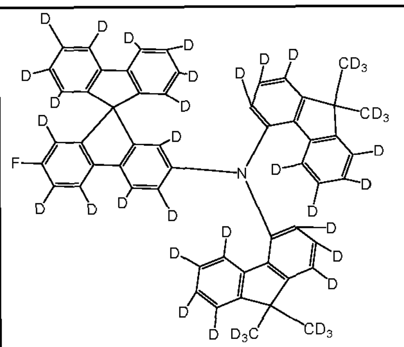 | 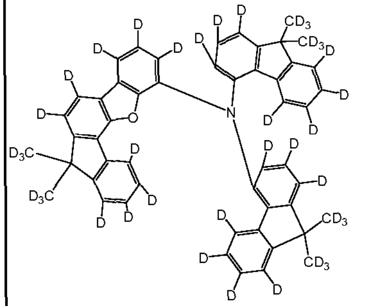 |
| 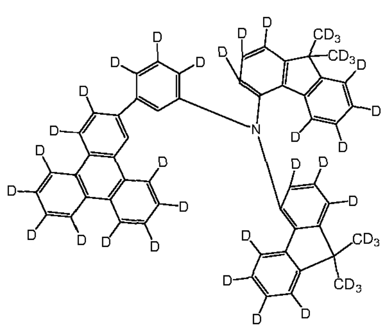 | 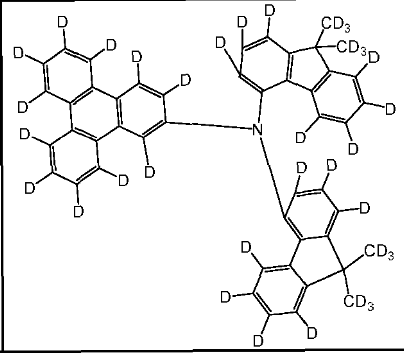 | 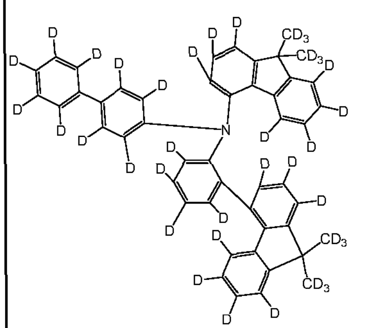 |

| | | |
|---|---|---|
| 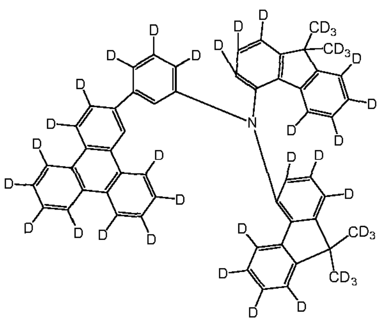 | 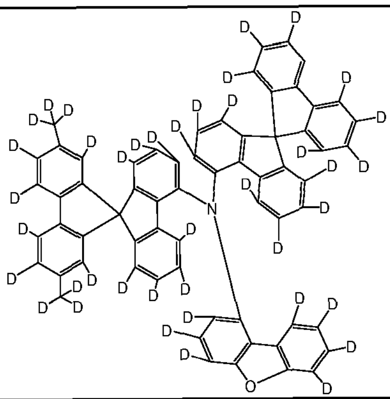 | 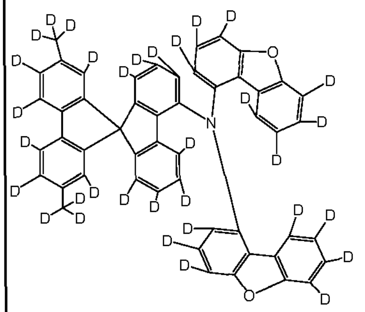 |
| 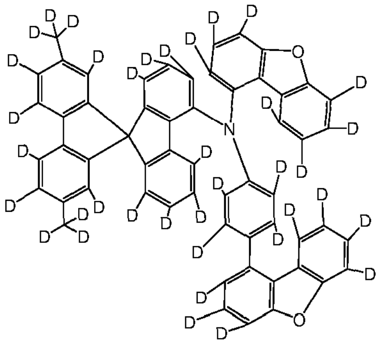 | 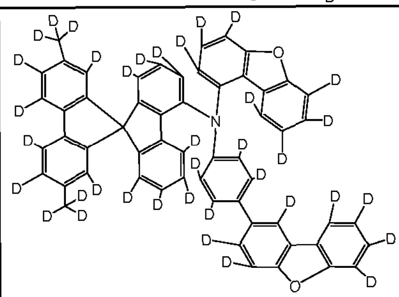 | 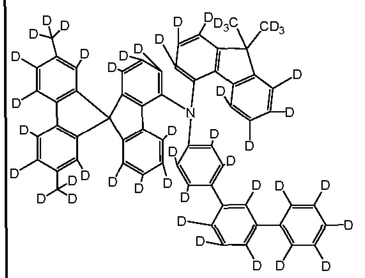 |
| 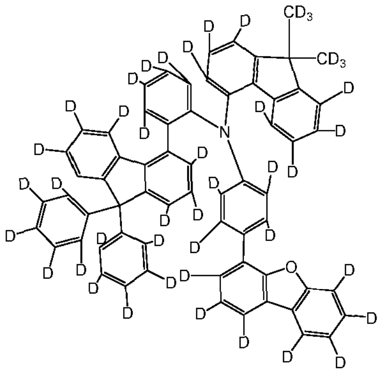 | 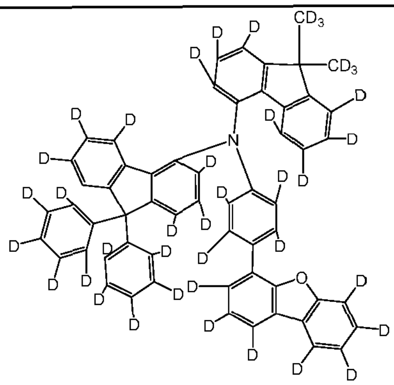 | 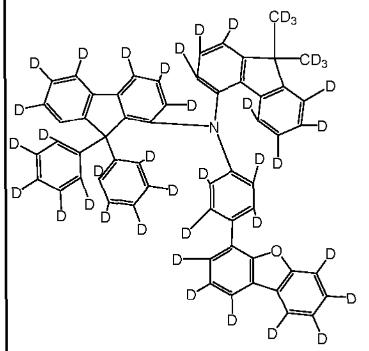 |
| 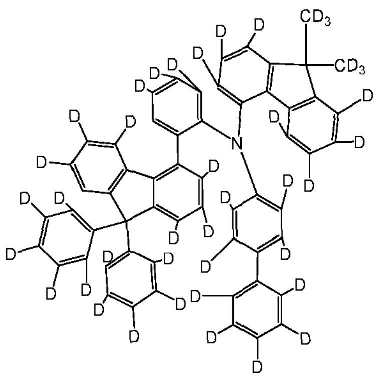 | 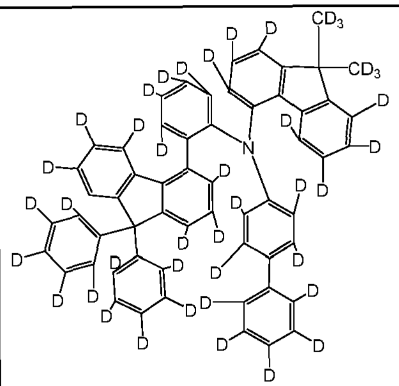 | 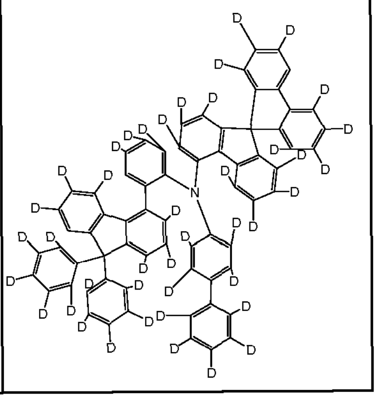 |

| | | |
|---|---|---|
| 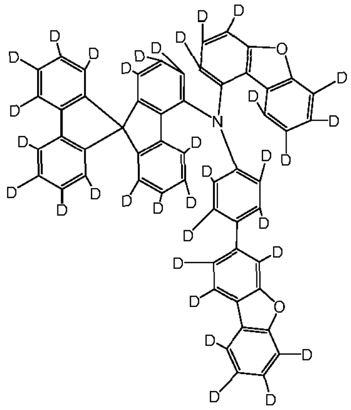 | 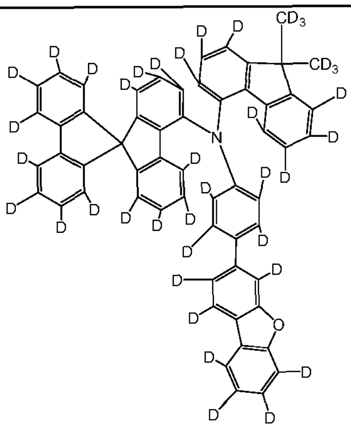 | 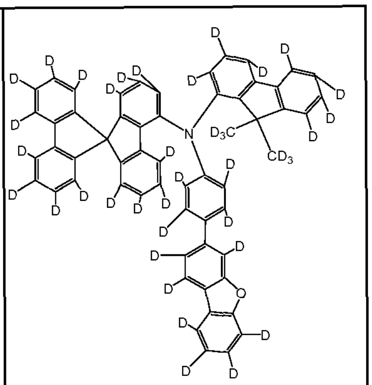 |
| 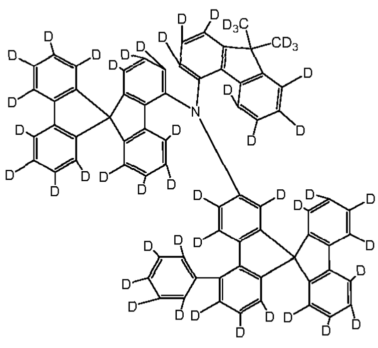 | 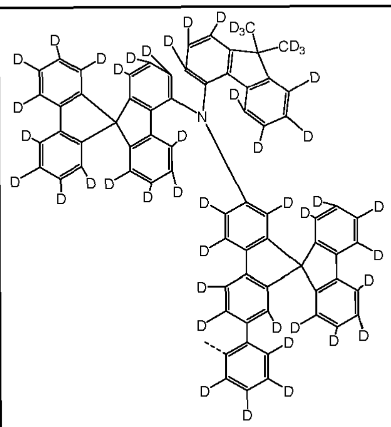 | 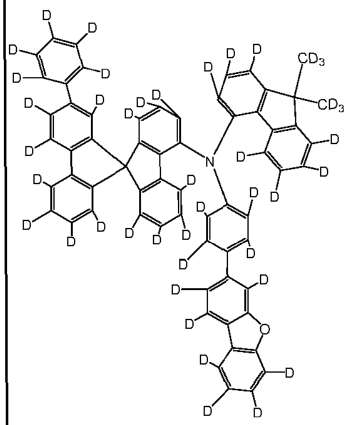 |
| 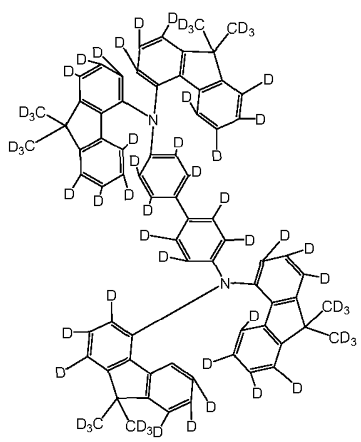 | 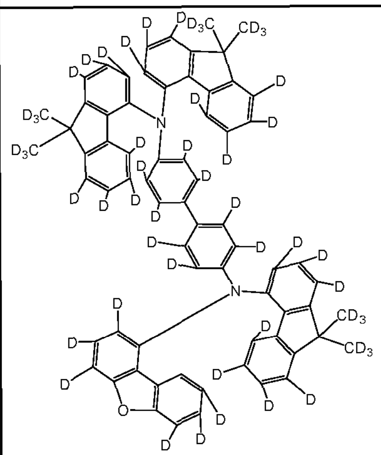 | 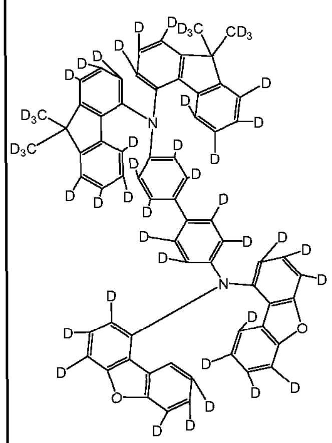 |
| 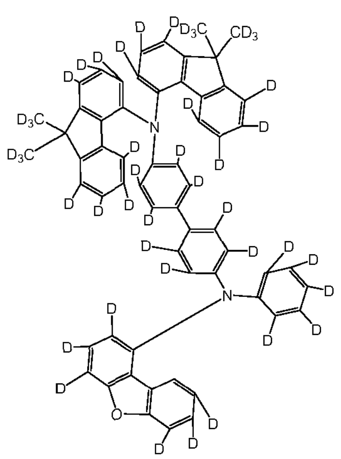 | 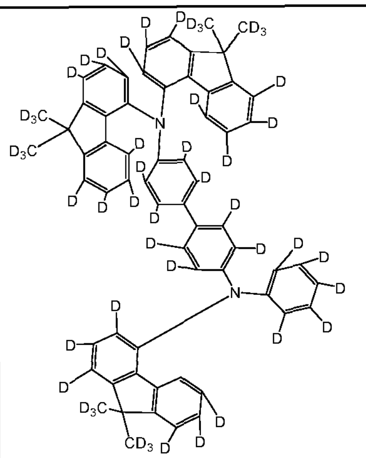 | 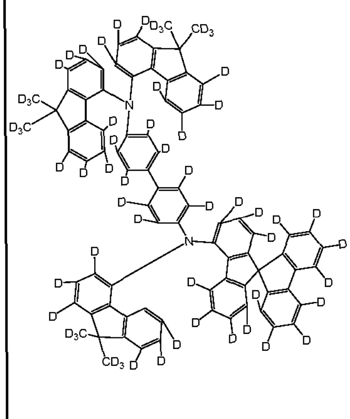 |

| | | |
|---|---|---|
| 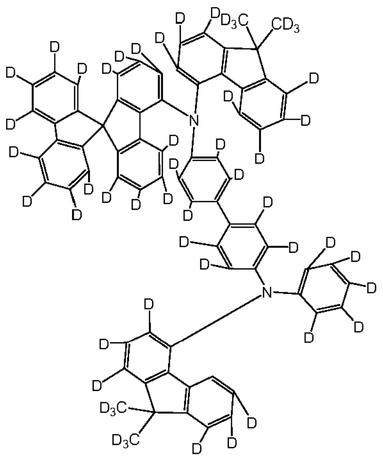 | 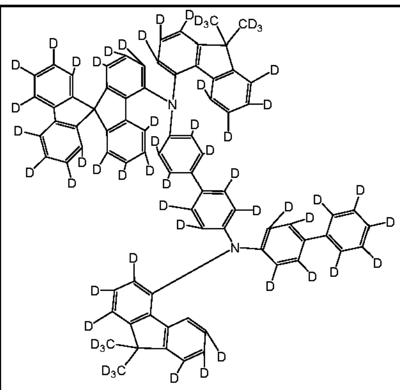 | 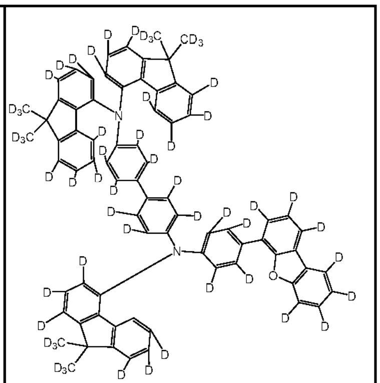 |
| 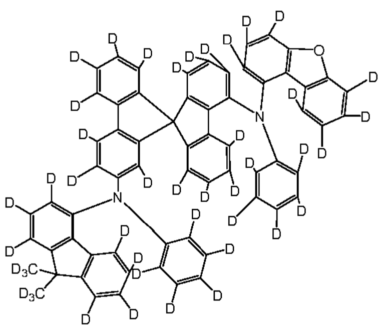 | 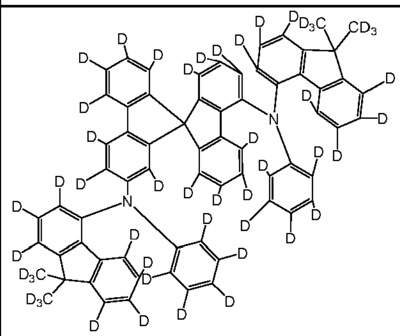 | 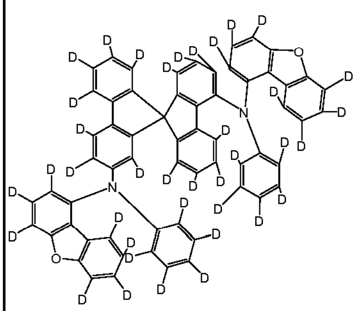 |
| 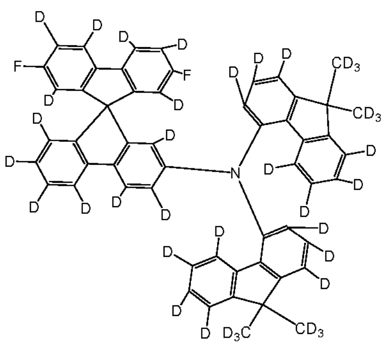 | 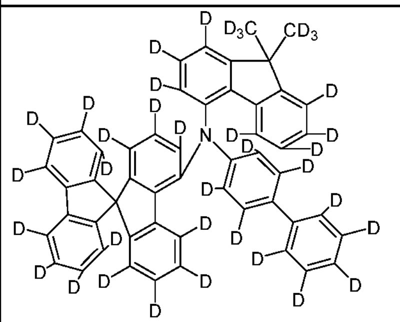 | |

Besonders geeignete Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9), die erfindungsgemäß ausgewählt werden, und bevorzugt in Kombination mit mindestens einer Verbindung der Formel (1) in der erfindungsgemäßen elektrolumineszierenden Vorrichtung verwendet werden, sind die Verbindungen H1 bis H15 der Tabelle 4.

Tabelle 4:

| | |
|---|---|
| 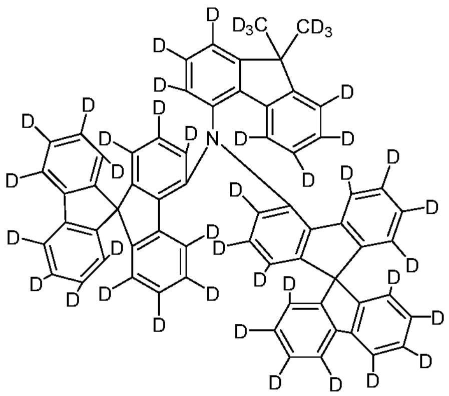 | 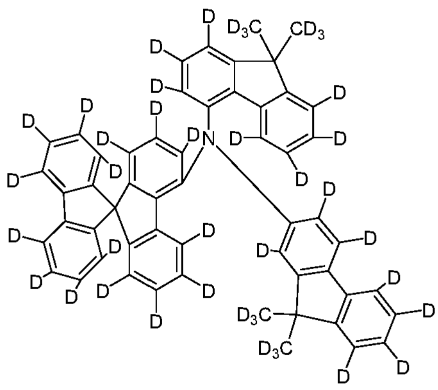 |
| H1 | H2 |
| 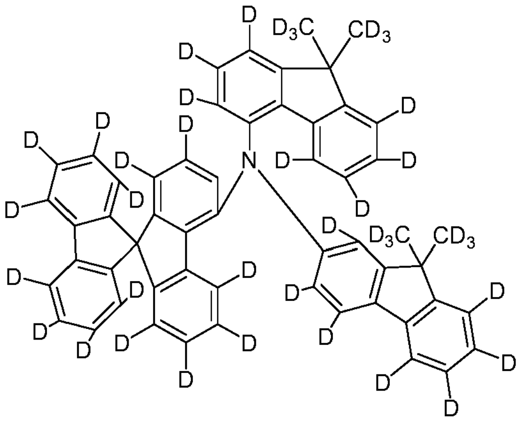 | 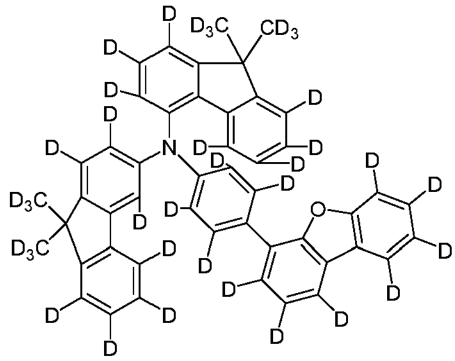 |
| H3 | H4 |
| 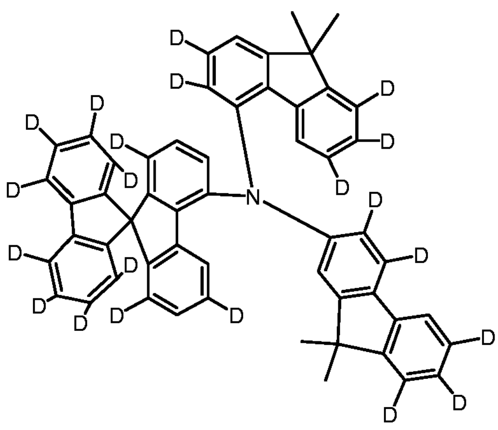 | 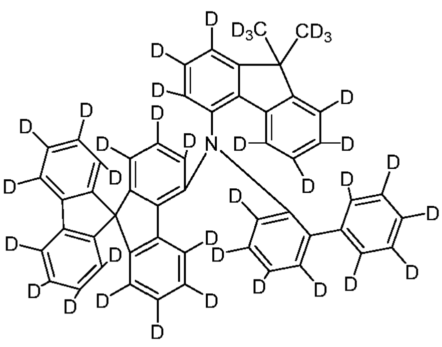 |
| H5 | H6 |

(fortgesetzt)

| | |
|---|---|
| 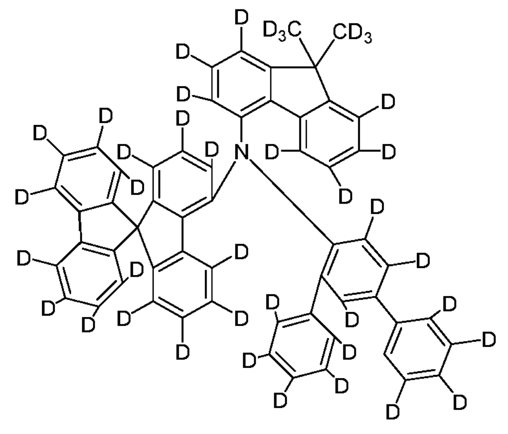 | 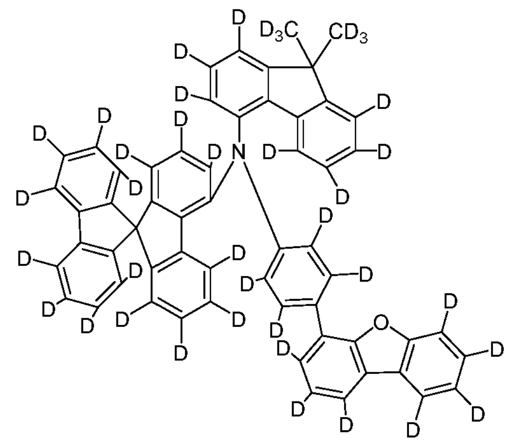 |
| H7 | H8 |
| 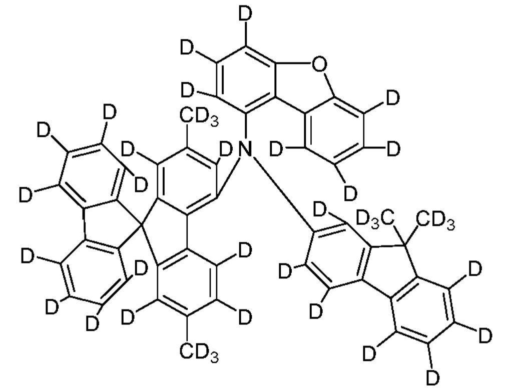 | 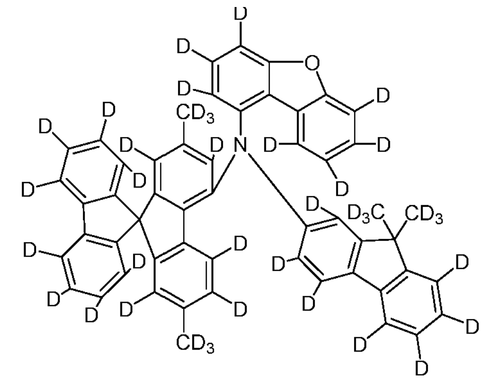 |
| H9 | H10 |
| 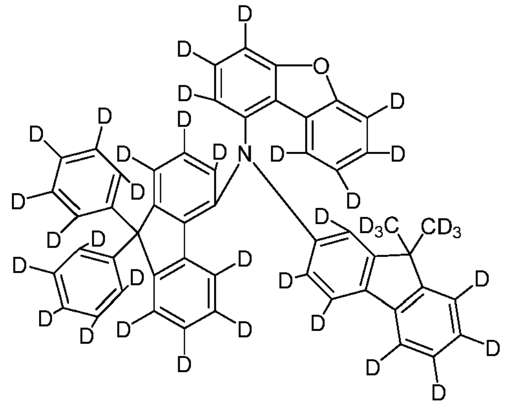 | 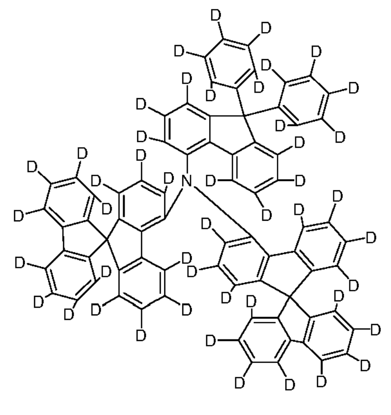 |
| H11 | H12 |

(fortgesetzt)

| | |
|---|---|
| 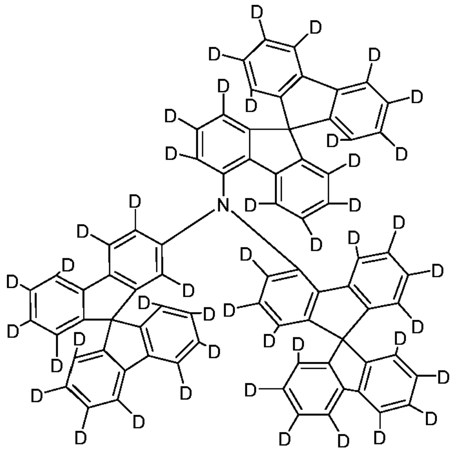 | 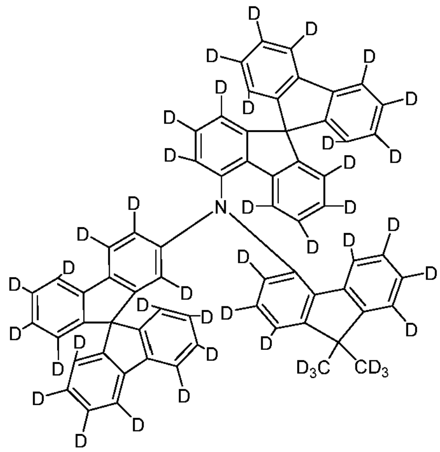 |
| H13 | H14 |
| 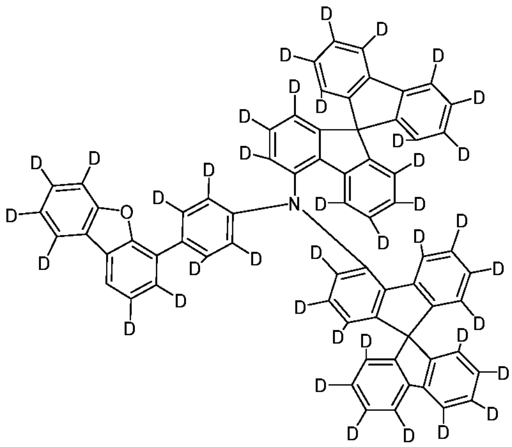 | |
| H15. | |

Die Herstellung der Verbindungen der Formel (2) oder der bevorzugten Verbindungen der Formeln (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9), sowie der Verbindungen der Tabelle 3 und Verbindungen **H1** bis **H15** ist dem Fachmann bekannt. Die Verbindungen können nach dem Fachmann bekannten Syntheseschritten, wie z. B. Bromierung, Suzuki-Kupplung, Additions- und Cyclisierungsreaktionen etc., dargestellt werden. Die Einführung der teilweise deuterierten oder vollständig deuterierten Substituenten kann nacheinander währen der Synthese der Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9) erfolgen oder alternativ kann zunächst die nicht deuterierte Verbindung hergestellt werden und anschließend eine Deuterierung durchgeführt werden, die zu teilweise deuterierten oder vollständig deuterierten Verbindungen führt.

Reaktionsbedingungen sind dem Fachmann hinlänglich bekannt. Ein geeignetes Syntheseverfahren zur Herstellung von Spirobifluorenyl-Verbindungen als Hostmaterial 2 ist in Schema 5 dargestellt, wobei die verwendeten Symbole und Indizes stellevertretend für die Synthese des Grundgerüsts gewählt sind. Der Fachmann ist in der Lage, dieses Schema 5 auf die Synthese des Hostmaterials 2, wie zuvor beschrieben, entsprechend anzupassen.

Für die Synthese dieser Hostmaterialien 2 in Schema 5, wird von Biphenyl-Derivaten ausgegangen, die in den beiden Positionen ortho zur Bindung zwischen den Phenylgruppen Halogengruppen aufweisen (X). Diese können durch Suzuki-Reaktion hergestellt werden. Die Biphenyl-Derivate sind stellvertretend mit mindestens einem organischen Rest R substituiert, der entsprechend der Beschreibung angepasst werden kann. In einem folgenden Schritt werden sie in einer Additions- und folgenden Cyclisierungsreaktion mit einem Fluorenon-Derivat zu einem Spirobifluoren umgesetzt, das ein Halogenatom in der Position 4 aufweist. X in Schema 5 ist ein Halogenatom, bevorzugt Cl, Br oder I, besonders bevorzugt Cl oder Br, und Y in Schema 5 ist I.

Schema 5:

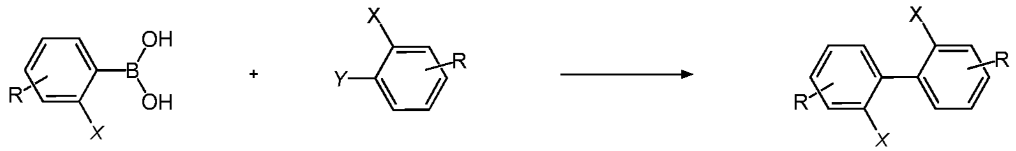

Fortführung Schema 5:

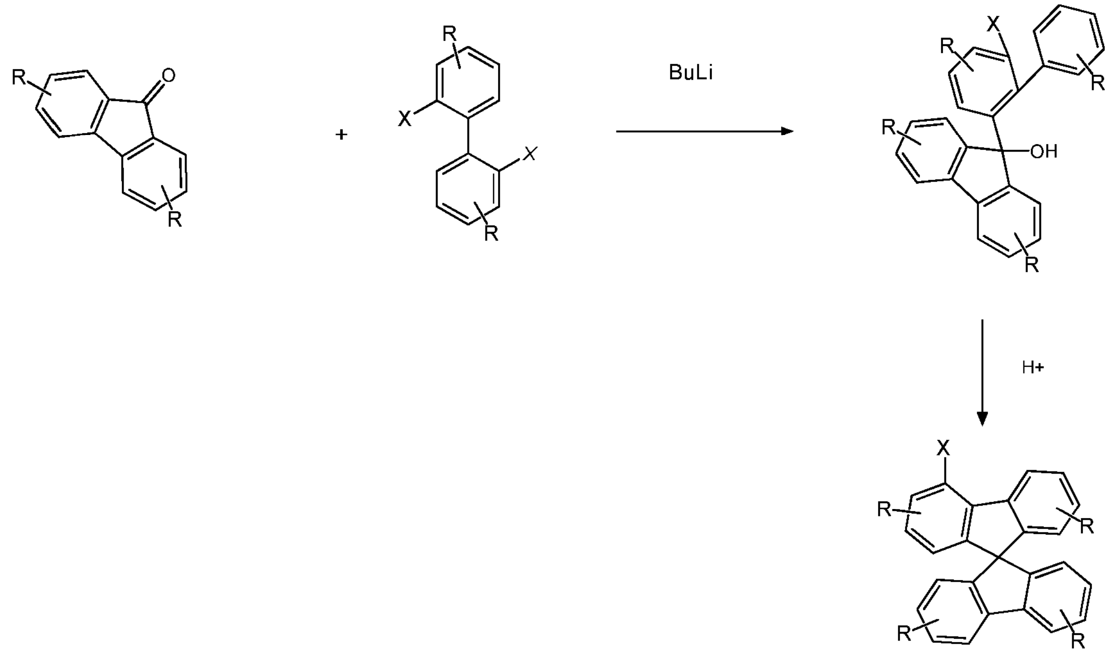


In einem folgenden Schritt können die in Schema 5 erhaltenen Intermediate a) in einer Buchwald-Kupplung mit einem sekundären Amin umgesetzt werden, oder b) in einer Suzuki-Kupplung mit einem Triarylamin umgesetzt werden, oder c) in einem zweischrittigen Verfahren zunächst in einer Suzuki-Kupplung mit einem Aromaten oder Heteroaromaten umgesetzt werden und anschließend in einer Buchwald-Kupplung mit einem sekundären Amin umgesetzt werden.

Geeignete Reaktionsbedingungen für Deuterierungen sind in den folgenden Schemata 6 bis 12 angegeben, wobei jeweils die Literatur oder Patentliteratur angegeben ist, in der Details beschrieben sind. Die angegebene Literatur bzw. Patentliteratur wird dadurch per Referenz in die Beschreibung aufgenommen. Weitere Details zur Deuterierung werden im Ausführungsteil beschrieben.

Ein geeignetes Verfahren zur Deuterierung eines Arylamins oder eines Heteroarylamins durch Austausch eines oder mehrerer H-Atome gegen D-Atome, ist eine Behandlung des zu deuterierenden Arylamins oder Hetroarylamins in Gegenwart eines Platinkatalysators oder Palladiumkatalysators und einer Deuteriumquelle. Der Begriff "Deuteriumquelle" bedeutet jede Verbindung, die ein oder mehrere D-Atome enthält und diese unter geeigneten Bedingungen freisetzen kann.

Der Platinkatalysator ist vorzugsweise trockenes Platin auf Kohle, vorzugsweise 5% trockenes Platin auf Kohle. Der Palladiumkatalysator ist vorzugsweise trockenes Palladium auf Kohle, vorzugsweise 5% trockenes Palladium auf Kohle. Eine geeignete Deuteriumquelle ist $D_2O$, Benzol-d6, Chloroform-d, Acetonitril-d3, Aceton-d6, Essigsäured4, Methanol-d4, Toluol-d8. Eine bevorzugte Deuteriumquelle ist $D_2O$ oder eine Kombination aus $D_2O$ und einem vollständig deuterierten organischen Lösungsmittel. Eine besonders bevorzugte Deuteriumquelle ist die Kombination aus $D_2O$ mit einem vollständig deuterierten organischen Lösungsmittel, wobei das vollständig deuterierte Lösungsmittel hier nicht eingeschränkt ist. Besonders geeignete vollständig deuterierte Lösungsmittel sind Benzen-d6 und Toluol-d8. Eine besonders bevorzugte Deuteriumquelle ist eine Kombination von $D_2O$ und Toluol-d8. Die Reaktion wird vorzugsweise unter Erhitzen durchgeführt, stärker bevorzugt unter Erhitzen auf Temperaturen zwischen 100 °C und 200 °C. Weiterhin wird die Reaktion vorzugsweise unter Druck durchgeführt.

Schema 6: X bedeutet einen beliebigen Substituenten

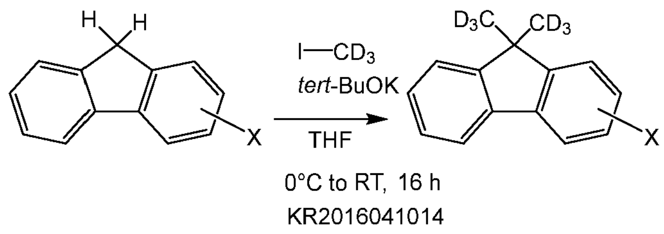


Schema 7:

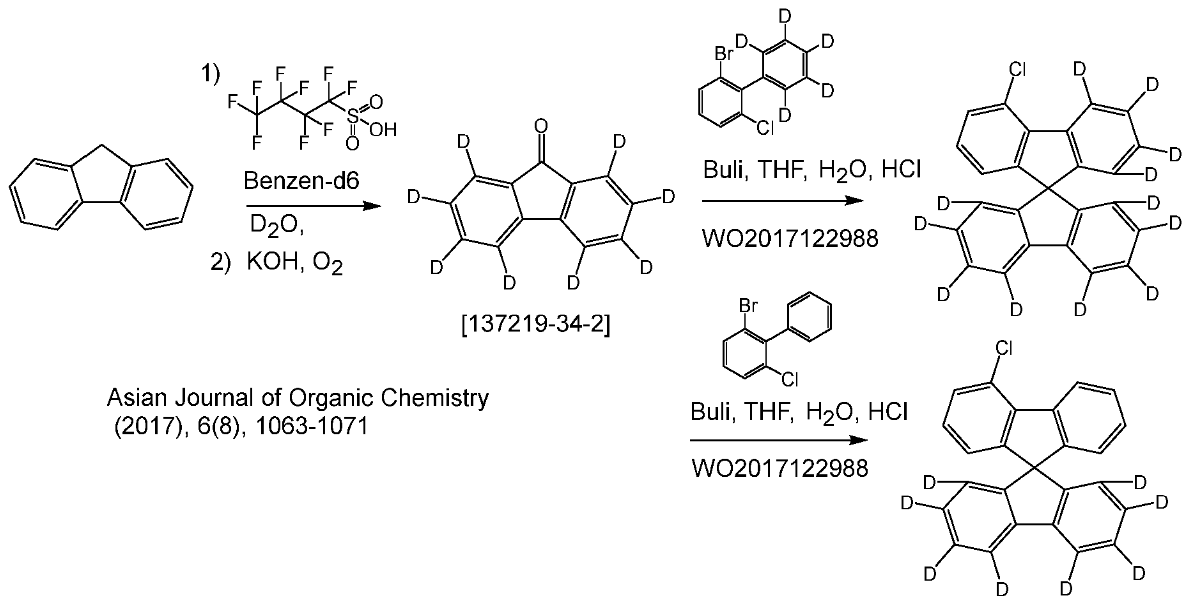


Schema 8:

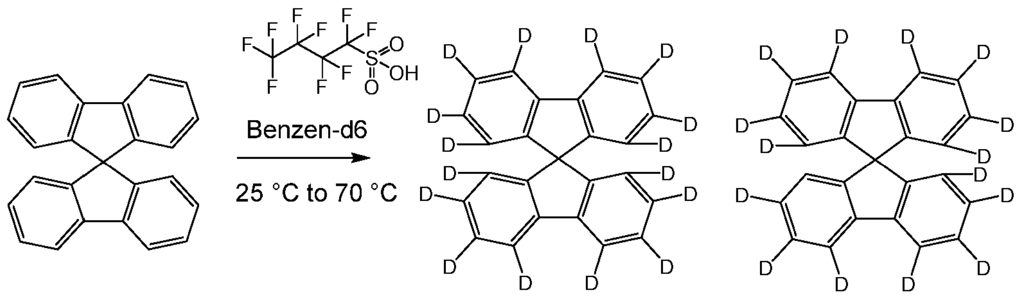


Asian Journal of Organic Chemistry
(2017), 6(8), 1063-1071

Schema 9:

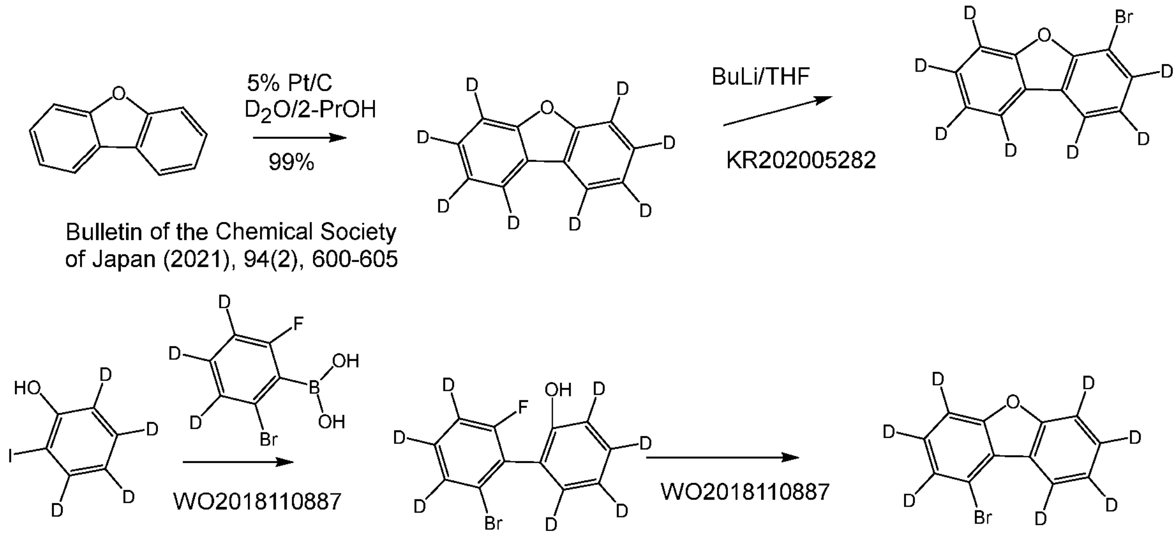


Schema 10: Deuterierung eines Monoamins:

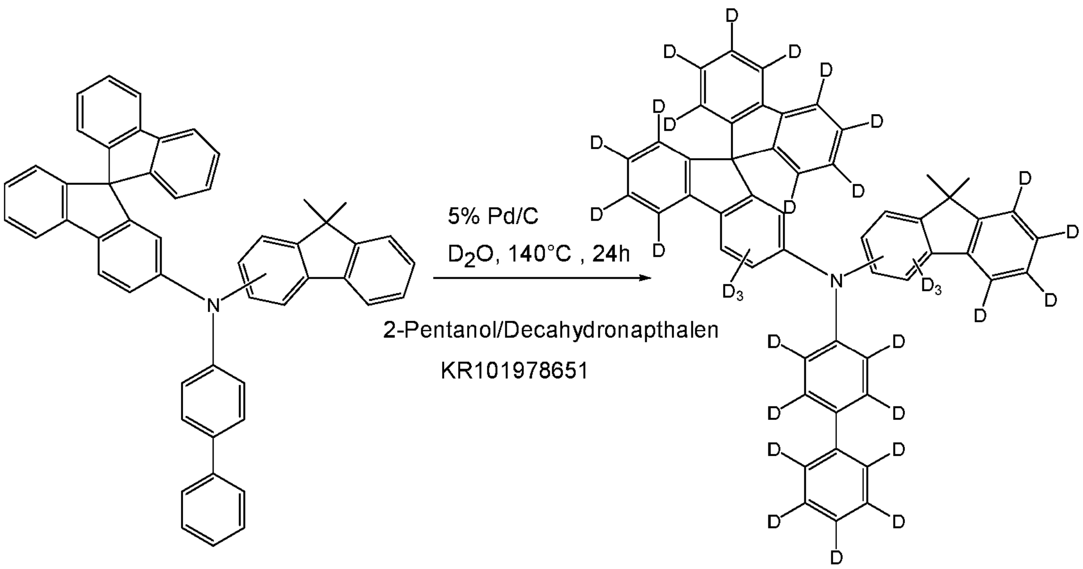

Schema 11:

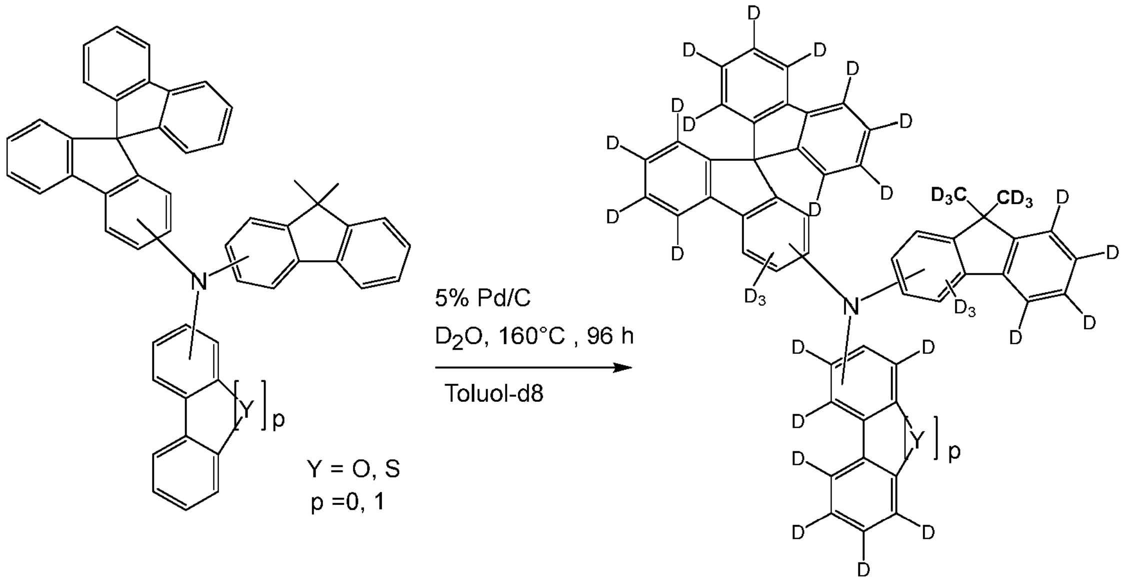


Schema 12: n und m kennzeichnet den Grad der Deuterierung, wobei pro N-gebundener Substituent mindestens ein D enthalten ist

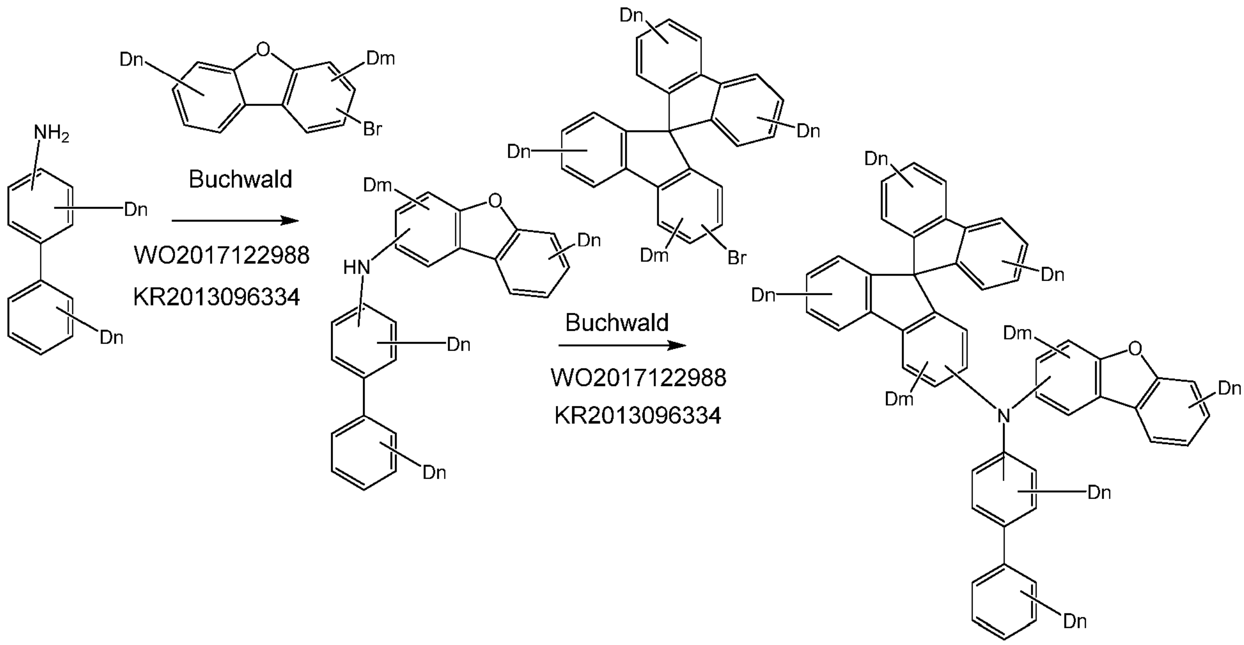


Die vorstehend genannten Hostmaterialien der Formel (1) sowie deren bevorzugt beschriebene Ausführungsformen oder die Verbindungen der Tabelle 1 und der Verbindungen **E1** bis **E39** können in der erfindungsgemäßen Vorrichtung beliebig mit den genannten Hostmaterialien der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9) sowie deren bevorzugt beschriebene Ausführungsformen oder den Verbindungen der Tabelle 3 oder den Verbindungen **H1** bis **H15** kombiniert werden.

Ein weiterer Gegenstand der Erfindung sind ebenfalls Mischungen enthaltend mindestens eine Verbindung der Formel (1) als Hostmaterial 1 und mindestens eine Verbindung der Formel (2) als Hostmaterial 2,

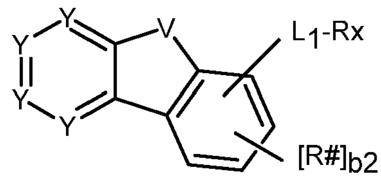

Formel (1),

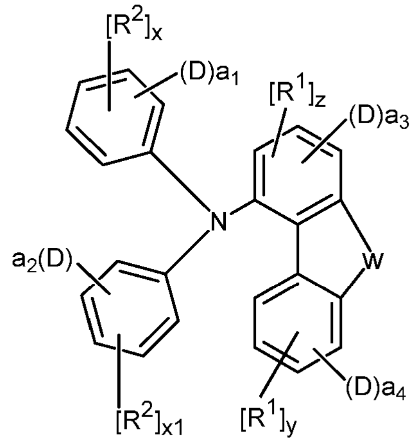

Formel (2),

wobei für die verwendeten Symbole und Indizes gilt:

| | |
|---|---|
| Y | ist bei jedem Auftreten unabhängig voneinander N, $[L]_b$-$Ar_2$ oder $[L]_{b1}$-$Ar_3$, wobei genau zwei Y für N stehen, die durch mindestens eine Gruppe $[L]_b$-$Ar_2$ oder $[L]_{b1}$-$Ar_3$ getrennt sind; |
| V | ist O oder S; |
| $L_1$ | ist eine Einfachbindung oder ein aromatisches oder heteroaromatisches Ringsystem mit 5 bis 30 Ringatomen; |
| Rx | ist F, Cl, Br, I, CN, $NO_2$, eine geradkettigen Alkyl-, Alkoxy- oder Thioalkylgruppe mit 1 bis 40 C-Atomen oder eine verzweigte oder cyclische Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei ein oder mehrere H-Atome durch D, F, Cl, Br, I, CN oder $NO_2$ ersetzt sein können, ein aromatisches oder heteroaromatisches Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme; |
| b, b1 | sind jeweils unabhängig voneinander 0 oder 1; |
| b2 | ist 0, 1, 2 oder 3; |
| L | ist bei jedem Auftreten gleich oder verschieden ein aromatisches oder heteroaromatisches Ringsystem mit 5 bis 30 Ringatomen; |
| R# | ist D, F oder eine Arylgruppe mit 6 bis 20 C-Atomen, die mit einem oder mehreren Resten $R^3$ substituiert sein kann; |
| $Ar_2$, $Ar_3$ | sind bei jedem Auftreten gleich oder verschieden ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann; |
| W | ist O, S, $C(R)_2$; |
| R | ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten; |
| $Ar_1$ | ist bei jedem Auftreten gleich oder verschieden ein aromatisches oder heteroaromatisches Ringsys- |

tem mit 5 bis 30 Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$R^1$ ist bei jedem Auftreten gleich oder verschieden ausgewählt aus der Gruppe bestehend aus F, Cl, Br, I, CN, $NO_2$, $P(=O)(Ar_1)_2$, $P(Ar_1)_2$, $B(Ar_1)_2$, $Si(Ar_1)_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, wobei eine oder mehrere nicht-benachbarte $CH_2$-Gruppen durch C=O, C=S, SO, $SO_2$, O oder S ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einer geradkettigen Alkylgruppe mit 1 bis 20 C-Atomen oder einer verzweigten oder cyclischen Alkylgruppe mit 3 bis 20 C-Atomen, wobei eine oder mehrere nicht-benachbarte $CH_2$-Gruppen durch O oder S ersetzt sein können und wobei ein oder mehrere H-Atome durch D, F, oder CN ersetzt sein können oder einem aromatischen oder heteroaromatischen Ringsystem mit 5 bis 30 Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;

a3 ist 0, 1, 2 oder 3;

a4 ist 0, 1, 2, 3 oder 4; und

a1+a2+a3+a4 ist 3, 4, 5, 6, 7, 8, 9, 10, 11, 12, 13, 14, 15, 16 oder 17.

Die Ausführungen hinsichtlich der Hostmaterialien der Formeln (1) und (2) sowie deren bevorzugten Ausführungsformen gilt entsprechend auch für die erfindungsgemäße Mischung.

Besonders bevorzugte Mischungen der Hostmaterialien der Formel (1) mit den Hostmaterialien der Formel (2) für die erfindungsgemäße Vorrichtung erhält man durch Kombination der Verbindungen **E1** bis **E39** mit den Verbindungen der Tabelle 3.

Ganz besonders bevorzugte Mischungen der Hostmaterialien der Formel (1) mit den Hostmaterialien der Formel (2) für die erfindungsgemäße Vorrichtung erhält man durch Kombination der Verbindungen **E1** bis **E39** mit den Verbindungen **H1** bis **H15** wie im Folgenden in Tabelle 5 gezeigt.

Tabelle 5:

| | | | | | | | | |
|---|---|---|---|---|---|---|---|---|
| M1 | **E1** | **H1** | M2 | **E2** | **H1** | M3 | **E3** | **H1** |
| M4 | **E4** | **H1** | M5 | **E5** | **H1** | M6 | **E6** | **H1** |
| M7 | **E7** | **H1** | M8 | **E8** | **H1** | M9 | **E9** | **H1** |
| M10 | **E10** | **H1** | M11 | **E11** | **H1** | M12 | **E12** | **H1** |
| M13 | **E13** | **H1** | M14 | **E14** | **H1** | M15 | **E15** | **H1** |

(fortgesetzt)

| | | | | | | | | |
|---|---|---|---|---|---|---|---|---|
| M16 | **E16** | **H1** | M17 | **E17** | **H1** | M18 | **E18** | **H1** |
| M19 | **E19** | **H1** | M20 | **E20** | **H1** | M21 | **E21** | **H1** |
| M22 | **E22** | **H1** | M23 | **E23** | **H1** | M24 | **E24** | **H1** |
| M25 | **E25** | **H1** | M26 | **E26** | **H1** | M27 | **E27** | **H1** |
| M28 | **E28** | **H1** | M29 | **E29** | **H1** | M30 | **E30** | **H1** |
| M31 | **E31** | **H1** | M32 | **E32** | **H1** | M33 | **E33** | **H1** |
| M34 | **E34** | **H1** | M35 | **E35** | **H1** | M36 | **E36** | **H1** |
| M37 | **E37** | **H1** | M38 | **E38** | **H1** | M39 | **E39** | **H1** |
| M40 | **E1** | **H2** | M41 | **E2** | **H2** | M42 | **E3** | **H2** |
| M43 | **E4** | **H2** | M44 | **E5** | **H2** | M45 | **E6** | **H2** |
| M46 | **E7** | **H2** | M47 | **E8** | **H2** | M48 | **E9** | **H2** |
| M49 | **E10** | **H2** | M50 | **E11** | **H2** | M51 | **E12** | **H2** |
| M52 | **E13** | **H2** | M53 | **E14** | **H2** | M54 | **E15** | **H2** |
| M55 | **E16** | **H2** | M56 | **E17** | **H2** | M57 | **E18** | **H2** |
| M58 | **E19** | **H2** | M59 | **E20** | **H2** | M60 | **E21** | **H2** |
| M61 | **E22** | **H2** | M62 | **E23** | **H2** | M63 | **E24** | **H2** |
| M64 | **E25** | **H2** | M65 | **E26** | **H2** | M66 | **E27** | **H2** |
| M67 | **E28** | **H2** | M68 | **E29** | **H2** | M69 | **E30** | **H2** |
| M70 | **E31** | **H2** | M71 | **E32** | **H2** | M72 | **E33** | **H2** |
| M73 | **E34** | **H2** | M74 | **E35** | **H2** | M75 | **E36** | **H2** |
| M76 | **E37** | **H2** | M77 | **E38** | **H2** | M78 | **E39** | **H2** |
| M79 | **E1** | **H3** | M80 | **E2** | **H3** | M81 | **E3** | **H3** |
| M82 | **E4** | **H3** | M83 | **E5** | **H3** | M84 | **E6** | **H3** |
| M85 | **E7** | **H3** | M86 | **E8** | **H3** | M87 | **E9** | **H3** |
| M88 | **E10** | **H3** | M89 | **E11** | **H3** | M90 | **E12** | **H3** |
| M91 | **E13** | **H3** | M92 | **E14** | **H3** | M93 | **E15** | **H3** |
| M94 | **E16** | **H3** | M95 | **E17** | **H3** | M96 | **E18** | **H3** |
| M97 | **E19** | **H3** | M98 | **E20** | **H3** | M99 | **E21** | **H3** |
| M100 | **E22** | **H3** | M101 | **E23** | **H3** | M102 | **E24** | **H3** |
| M103 | **E25** | **H3** | M104 | **E26** | **H3** | M105 | **E27** | **H3** |
| M106 | **E28** | **H3** | M107 | **E29** | **H3** | M108 | **E30** | **H3** |
| M109 | **E31** | **H3** | M110 | **E32** | **H3** | M111 | **E33** | **H3** |
| M112 | **E34** | **H3** | M113 | **E35** | **H3** | M114 | **E36** | **H3** |
| M115 | **E37** | **H3** | M116 | **E38** | **H3** | M117 | **E39** | **H3** |
| M118 | **E1** | **H4** | M119 | **E2** | **H4** | M120 | **E3** | **H4** |
| M121 | **E4** | **H4** | M122 | **E5** | **H4** | M123 | **E6** | **H4** |
| M124 | **E7** | **H4** | M125 | **E8** | **H4** | M126 | **E9** | **H4** |
| M127 | **E10** | **H4** | M128 | **E11** | **H4** | M129 | **E12** | **H4** |
| M130 | **E13** | **H4** | M131 | **E14** | **H4** | M132 | **E15** | **H4** |
| M133 | **E16** | **H4** | M134 | **E17** | **H4** | M135 | **E18** | **H4** |

(fortgesetzt)

| | | | | | | | | |
|---|---|---|---|---|---|---|---|---|
| M136 | **E19** | **H4** | M137 | **E20** | **H4** | M138 | **E21** | **H4** |
| M139 | **E22** | **H4** | M140 | **E23** | **H4** | M141 | **E24** | **H4** |
| M142 | **E25** | **H4** | M143 | **E26** | **H4** | M144 | **E27** | **H4** |
| M145 | **E28** | **H4** | M146 | **E29** | **H4** | M147 | **E30** | **H4** |
| M148 | **E31** | **H4** | M149 | **E32** | **H4** | M150 | **E33** | **H4** |
| M151 | **E34** | **H4** | M152 | **E35** | **H4** | M153 | **E36** | **H4** |
| M154 | **E37** | **H4** | M155 | **E38** | **H4** | M156 | **E39** | **H4** |
| M157 | **E1** | **H5** | M158 | **E2** | **H5** | M159 | **E3** | **H5** |
| M160 | **E4** | **H5** | M161 | **E5** | **H5** | M162 | **E6** | **H5** |
| M163 | **E7** | **H5** | M164 | **E8** | **H5** | M165 | **E9** | **H5** |
| M166 | **E10** | **H5** | M167 | **E11** | **H5** | M168 | **E12** | **H5** |
| M169 | **E13** | **H5** | M170 | **E14** | **H5** | M171 | **E15** | **H5** |
| M172 | **E16** | **H5** | M173 | **E17** | **H5** | M174 | **E18** | **H5** |
| M175 | **E19** | **H5** | M176 | **E20** | **H5** | M177 | **E21** | **H5** |
| M178 | **E22** | **H5** | M179 | **E23** | **H5** | M180 | **E24** | **H5** |
| M181 | **E25** | **H5** | M182 | **E26** | **H5** | M183 | **E27** | **H5** |
| M184 | **E28** | **H5** | M185 | **E29** | **H5** | M186 | **E30** | **H5** |
| M187 | **E31** | **H5** | M188 | **E32** | **H5** | M189 | **E33** | **H5** |
| M190 | **E34** | **H5** | M191 | **E35** | **H5** | M192 | **E36** | **H5** |
| M193 | **E37** | **H5** | M194 | **E38** | **H5** | M195 | **E39** | **H5** |
| M196 | **E1** | **H6** | M197 | **E2** | **H6** | M198 | **E3** | **H6** |
| M199 | **E4** | **H6** | M200 | **E5** | **H6** | M201 | **E6** | **H6** |
| M202 | **E7** | **H6** | M203 | **E8** | **H6** | M204 | **E9** | **H6** |
| M205 | **E10** | **H6** | M206 | **E11** | **H6** | M207 | **E12** | **H6** |
| M208 | **E13** | **H6** | M209 | **E14** | **H6** | M210 | **E15** | **H6** |
| M211 | **E16** | **H6** | M212 | **E17** | **H6** | M213 | **E18** | **H6** |
| M214 | **E19** | **H6** | M215 | **E20** | **H6** | M216 | **E21** | **H6** |
| M217 | **E22** | **H6** | M218 | **E23** | **H6** | M219 | **E24** | **H6** |
| M220 | **E25** | **H6** | M221 | **E26** | **H6** | M222 | **E27** | **H6** |
| M223 | **E28** | **H6** | M224 | **E29** | **H6** | M225 | **E30** | **H6** |
| M226 | **E31** | **H6** | M227 | **E32** | **H6** | M228 | **E33** | **H6** |
| M229 | **E34** | **H6** | M230 | **E35** | **H6** | M231 | **E36** | **H6** |
| M232 | **E37** | **H6** | M233 | **E38** | **H6** | M234 | **E39** | **H6** |
| M235 | **E1** | **H7** | M236 | **E2** | **H7** | M237 | **E3** | **H7** |
| M238 | **E4** | **H7** | M239 | **E5** | **H7** | M240 | **E6** | **H7** |
| M241 | **E7** | **H7** | M242 | **E8** | **H7** | M243 | **E9** | **H7** |
| M244 | **E10** | **H7** | M245 | **E11** | **H7** | M246 | **E12** | **H7** |
| M247 | **E13** | **H7** | M248 | **E14** | **H7** | M249 | **E15** | **H7** |
| M250 | **E16** | **H7** | M251 | **E17** | **H7** | M252 | **E18** | **H7** |
| M253 | **E19** | **H7** | M254 | **E20** | **H7** | M255 | **E21** | **H7** |

(fortgesetzt)

| | | | | | | | | |
|---|---|---|---|---|---|---|---|---|
| M256 | **E22** | **H7** | M257 | **E23** | **H7** | M258 | **E24** | **H7** |
| M259 | **E25** | **H7** | M260 | **E26** | **H7** | M261 | **E27** | **H7** |
| M262 | **E28** | **H7** | M263 | **E29** | **H7** | M264 | **E30** | **H7** |
| M265 | **E31** | **H7** | M266 | **E32** | **H7** | M267 | **E33** | **H7** |
| M268 | **E34** | **H7** | M269 | **E35** | **H7** | M270 | **E36** | **H7** |
| M271 | **E37** | **H7** | M272 | **E38** | **H7** | M273 | **E39** | **H7** |
| M274 | **E1** | **H8** | M275 | **E2** | **H8** | M276 | **E3** | **H8** |
| M277 | **E4** | **H8** | M278 | **E5** | **H8** | M279 | **E6** | **H8** |
| M280 | **E7** | **H8** | M281 | **E8** | **H8** | M282 | **E9** | **H8** |
| M283 | **E10** | **H8** | M284 | **E11** | **H8** | M285 | **E12** | **H8** |
| M286 | **E13** | **H8** | M287 | **E14** | **H8** | M288 | **E15** | **H8** |
| M289 | **E16** | **H8** | M290 | **E17** | **H8** | M291 | **E18** | **H8** |
| M292 | **E19** | **H8** | M293 | **E20** | **H8** | M294 | **E21** | **H8** |
| M295 | **E22** | **H8** | M296 | **E23** | **H8** | M297 | **E24** | **H8** |
| M298 | **E25** | **H8** | M299 | **E26** | **H8** | M300 | **E27** | **H8** |
| M301 | **E28** | **H8** | M302 | **E29** | **H8** | M303 | **E30** | **H8** |
| M304 | **E31** | **H8** | M305 | **E32** | **H8** | M306 | **E33** | **H8** |
| M307 | **E34** | **H8** | M308 | **E35** | **H8** | M309 | **E36** | **H8** |
| M310 | **E37** | **H8** | M311 | **E38** | **H8** | M312 | **E39** | **H8** |
| M313 | **E1** | **H9** | M314 | **E2** | **H9** | M315 | **E3** | **H9** |
| M316 | **E4** | **H9** | M317 | **E5** | **H9** | M318 | **E6** | **H9** |
| M319 | **E7** | **H9** | M320 | **E8** | **H9** | M321 | **E9** | **H9** |
| M322 | **E10** | **H9** | M323 | **E11** | **H9** | M324 | **E12** | **H9** |
| M325 | **E13** | **H9** | M326 | **E14** | **H9** | M327 | **E15** | **H9** |
| M328 | **E16** | **H9** | M329 | **E17** | **H9** | M330 | **E18** | **H9** |
| M331 | **E19** | **H9** | M332 | **E20** | **H9** | M333 | **E21** | **H9** |
| M334 | **E22** | **H9** | M335 | **E23** | **H9** | M336 | **E24** | **H9** |
| M337 | **E25** | **H9** | M338 | **E26** | **H9** | M339 | **E27** | **H9** |
| M340 | **E28** | **H9** | M341 | **E29** | **H9** | M342 | **E30** | **H9** |
| M343 | **E31** | **H9** | M344 | **E32** | **H9** | M345 | **E33** | **H9** |
| M346 | **E34** | **H9** | M347 | **E35** | **H9** | M348 | **E36** | **H9** |
| M349 | **E37** | **H9** | M350 | **E38** | **H9** | M351 | **E39** | **H9** |
| M352 | **E1** | **H10** | M353 | **E2** | **H10** | M354 | **E3** | **H10** |
| M355 | **E4** | **H10** | M356 | **E5** | **H10** | M357 | **E6** | **H10** |
| M358 | **E7** | **H10** | M359 | **E8** | **H10** | M360 | **E9** | **H10** |
| M361 | **E10** | **H10** | M362 | **E11** | **H10** | M363 | **E12** | **H10** |
| M364 | **E13** | **H10** | M365 | **E14** | **H10** | M366 | **E15** | **H10** |
| M367 | **E16** | **H10** | M368 | **E17** | **H10** | M369 | **E18** | **H10** |
| M370 | **E19** | **H10** | M371 | **E20** | **H10** | M372 | **E21** | **H10** |
| M373 | **E22** | **H10** | M374 | **E23** | **H10** | M375 | **E24** | **H10** |

(fortgesetzt)

| | | | | | | | | |
|---|---|---|---|---|---|---|---|---|
| M376 | **E25** | **H10** | M377 | **E26** | **H10** | M378 | **E27** | **H10** |
| M379 | **E28** | **H10** | M380 | **E29** | **H10** | M381 | **E30** | **H10** |
| M382 | **E31** | **H10** | M383 | **E32** | **H10** | M384 | **E33** | **H10** |
| M385 | **E34** | **H10** | M386 | **E35** | **H10** | M387 | **E36** | **H10** |
| M388 | **E37** | **H10** | M389 | **E38** | **H10** | M390 | **E39** | **H10** |
| M391 | **E1** | **H11** | M392 | **E2** | **H11** | M393 | **E3** | **H11** |
| M394 | **E4** | **H11** | M395 | **E5** | **H11** | M396 | **E6** | **H11** |
| M397 | **E7** | **H11** | M398 | **E8** | **H11** | M399 | **E9** | **H11** |
| M400 | **E10** | **H11** | M401 | **E11** | **H11** | M402 | **E12** | **H11** |
| M403 | **E13** | **H11** | M404 | **E14** | **H11** | M405 | **E15** | **H11** |
| M406 | **E16** | **H11** | M407 | **E17** | **H11** | M408 | **E18** | **H11** |
| M409 | **E19** | **H11** | M410 | **E20** | **H11** | M411 | **E21** | **H11** |
| M412 | **E22** | **H11** | M413 | **E23** | **H11** | M414 | **E24** | **H11** |
| M415 | **E25** | **H11** | M416 | **E26** | **H11** | M417 | **E27** | **H11** |
| M418 | **E28** | **H11** | M419 | **E29** | **H11** | M420 | **E30** | **H11** |
| M421 | **E31** | **H11** | M422 | **E32** | **H11** | M423 | **E33** | **H11** |
| M424 | **E34** | **H11** | M425 | **E35** | **H11** | M426 | **E36** | **H11** |
| M427 | **E37** | **H11** | M428 | **E38** | **H11** | M429 | **E39** | **H11** |
| M430 | **E1** | **H12** | M431 | **E2** | **H12** | M432 | **E3** | **H12** |
| M433 | **E4** | **H12** | M434 | **E5** | **H12** | M435 | **E6** | **H12** |
| M436 | **E7** | **H12** | M437 | **E8** | **H12** | M438 | **E9** | **H12** |
| M439 | **E10** | **H12** | M440 | **E11** | **H12** | M441 | **E12** | **H12** |
| M442 | **E13** | **H12** | M443 | **E14** | **H12** | M444 | **E15** | **H12** |
| M445 | **E16** | **H12** | M446 | **E17** | **H12** | M447 | **E18** | **H12** |
| M448 | **E19** | **H12** | M449 | **E20** | **H12** | M450 | **E21** | **H12** |
| M451 | **E22** | **H12** | M452 | **E23** | **H12** | M453 | **E24** | **H12** |
| M454 | **E25** | **H12** | M455 | **E26** | **H12** | M456 | **E27** | **H12** |
| M457 | **E28** | **H12** | M458 | **E29** | **H12** | M459 | **E30** | **H12** |
| M460 | **E31** | **H12** | M461 | **E32** | **H12** | M462 | **E33** | **H12** |
| M463 | **E34** | **H12** | M464 | **E35** | **H12** | M465 | **E36** | **H12** |
| M466 | **E37** | **H12** | M467 | **E38** | **H12** | M468 | **E39** | **H12** |
| M469 | **E1** | **H13** | M470 | **E2** | **H13** | M471 | **E3** | **H13** |
| M472 | **E4** | **H13** | M473 | **E5** | **H13** | M474 | **E6** | **H13** |
| M475 | **E7** | **H13** | M476 | **E8** | **H13** | M477 | **E9** | **H13** |
| M478 | **E10** | **H13** | M479 | **E11** | **H13** | M480 | **E12** | **H13** |
| M481 | **E13** | **H13** | M482 | **E14** | **H13** | M483 | **E15** | **H13** |
| M484 | **E16** | **H13** | M485 | **E17** | **H13** | M486 | **E18** | **H13** |
| M487 | **E19** | **H13** | M488 | **E20** | **H13** | M489 | **E21** | **H13** |
| M490 | **E22** | **H13** | M491 | **E23** | **H13** | M492 | **E24** | **H13** |
| M493 | **E25** | **H13** | M494 | **E26** | **H13** | M495 | **E27** | **H13** |

(fortgesetzt)

| | | | | | | | | |
|---|---|---|---|---|---|---|---|---|
| M496 | **E28** | **H13** | M497 | **E29** | **H13** | M498 | **E30** | **H13** |
| M499 | **E31** | **H13** | M500 | **E32** | **H13** | M501 | **E33** | **H13** |
| M502 | **E34** | **H13** | M503 | **E35** | **H13** | M504 | **E36** | **H13** |
| M505 | **E37** | **H13** | M506 | **E38** | **H13** | M507 | **E39** | **H13** |
| M508 | **E1** | **H14** | M509 | **E2** | **H14** | M510 | **E3** | **H14** |
| M511 | **E4** | **H14** | M512 | **E5** | **H14** | M513 | **E6** | **H14** |
| M514 | **E7** | **H14** | M515 | **E8** | **H14** | M516 | **E9** | **H14** |
| M517 | **E10** | **H14** | M518 | **E11** | **H14** | M519 | **E12** | **H14** |
| M520 | **E13** | **H14** | M521 | **E14** | **H14** | M522 | **E15** | **H14** |
| M523 | **E16** | **H14** | M524 | **E17** | **H14** | M525 | **E18** | **H14** |
| M526 | **E19** | **H14** | M527 | **E20** | **H14** | M528 | **E21** | **H14** |
| M529 | **E22** | **H14** | M530 | **E23** | **H14** | M531 | **E24** | **H14** |
| M532 | **E25** | **H14** | M533 | **E26** | **H14** | M534 | **E27** | **H14** |
| M535 | **E28** | **H14** | M536 | **E29** | **H14** | M537 | **E30** | **H14** |
| M538 | **E31** | **H14** | M539 | **E32** | **H14** | M540 | **E33** | **H14** |
| M541 | **E34** | **H14** | M542 | **E35** | **H14** | M543 | **E36** | **H14** |
| M544 | **E37** | **H14** | M545 | **E38** | **H14** | M546 | **E39** | **H14** |
| M547 | **E1** | **H15** | M548 | **E2** | **H15** | M549 | **E3** | **H15** |
| M550 | **E4** | **H15** | M551 | **E5** | **H15** | M552 | **E6** | **H15** |
| M553 | **E7** | **H15** | M554 | **E8** | **H15** | M555 | **E9** | **H15** |
| M556 | **E10** | **H15** | M557 | **E11** | **H15** | M558 | **E12** | **H15** |
| M559 | **E13** | **H15** | M560 | **E14** | **H15** | M561 | **E15** | **H15** |
| M562 | **E16** | **H15** | M563 | **E17** | **H15** | M564 | **E18** | **H15** |
| M565 | **E19** | **H15** | M566 | **E20** | **H15** | M567 | **E21** | **H15** |
| M568 | **E22** | **H15** | M569 | **E23** | **H15** | M570 | **E24** | **H15** |
| M571 | **E25** | **H15** | M572 | **E26** | **H15** | M573 | **E27** | **H15** |
| M574 | **E28** | **H15** | M575 | **E29** | **H15** | M576 | **E30** | **H15** |
| M577 | **E31** | **H15** | M578 | **E32** | **H15** | M579 | **E33** | **H15** |
| M580 | **E34** | **H15** | M581 | **E35** | **H15** | M582 | **E36** | **H15** |
| M583 | **E37** | **H15** | M584 | **E38** | **H15** | M585 | **E39** | **H15** |

Die Konzentration des elektronentransportierenden Hostmaterials der Formel (1), wie zuvor beschrieben oder bevorzugt beschrieben, in der erfindungsgemäßen Mischung oder in der lichtemittierenden Schicht der erfindungsgemäßen Vorrichtung liegt im Bereich von 5 Gew.-% bis 90 Gew.-%, bevorzugt im Bereich von 10 Gew.-% bis 85 Gew.-%, mehr bevorzugt im Bereich von 20 Gew.-% bis 85 Gew.-%, noch mehr bevorzugt im Bereich von 30 Gew.-% bis 80 Gew.-%, ganz besonders bevorzugt im Bereich von 20 Gew.-% bis 60 Gew.-% und am meisten bevorzugt im Bereich von 30 Gew.-% bis 50 Gew.-%, bezogen auf die gesamte Mischung oder bezogen auf die gesamte Zusammensetzung der lichtemittierenden Schicht.

Die Konzentration des lochtransportierenden Hostmaterials der Formel (2), wie zuvor beschrieben oder als bevorzugt beschrieben, in der erfindungsgemäßen Mischung oder in der lichtemittierenden Schicht der erfindungsgemäßen Vorrichtung liegt im Bereich von 10 Gew.-% bis 95 Gew.-%, bevorzugt im Bereich von 15 Gew.-% bis 90 Gew.-%, mehr bevorzugt im Bereich von 15 Gew.-% bis 80 Gew.-%, noch mehr bevorzugt im Bereich von 20 Gew.-% bis 70 Gew.-%, ganz besonders bevorzugt im Bereich von 40 Gew.-% bis 80 Gew.-% und am meisten bevorzugt im Bereich von 50 Gew.-% bis 70 Gew.-%, bezogen auf die gesamte Mischung oder bezogen auf die gesamte Zusammensetzung der

lichtemittierenden Schicht.

Die vorliegende Erfindung betrifft auch eine Mischung, die neben den vorstehend genannten Hostmaterialien 1 und 2, wie zuvor beschrieben oder bevorzugt beschrieben, insbesondere Mischungen M1 bis M585, mindestens noch einen phosphoreszierenden Emitter enthält.

Die vorliegende Erfindung betrifft auch eine organische elektrolumineszierende Vorrichtung, wie zuvor beschrieben oder bevorzugt beschrieben, wobei die lichtemittierende Schicht neben den vorstehend genannten Hostmaterialien 1 und 2, wie zuvor beschrieben oder bevorzugt beschrieben, insbesondere den Materialkombinationen M1 bis M585, mindestens noch einen phosphoreszierenden Emitter enthält.

Vom Begriff phosphoreszierende Emitter sind typischerweise Verbindungen umfasst, bei denen die Lichtemission durch einen spin-verbotenen Übergang aus einem angeregten Zustand mit höherer Spinmultiplizität, also einem Spinzustand > 1, erfolgt, beispielsweise durch einen Übergang aus einem Triplett-Zustand oder einem Zustand mit einer noch höheren Spinquantenzahl, beispielsweise einem Quintett-Zustand. Bevorzugt wird hierbei ein Übergang aus einem Triplett-Zustand verstanden.

Als phosphoreszierende Emitter (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten. Im Sinne der vorliegenden Erfindung werden alle lumineszierenden Verbindungen, die die oben genannten Metalle enthalten, als phosphoreszierende Emitter angesehen.

Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind.

Bevorzugte phosphoreszierende Emitter gemäß der vorliegenden Erfindung entsprechen der Formel (IIIa),

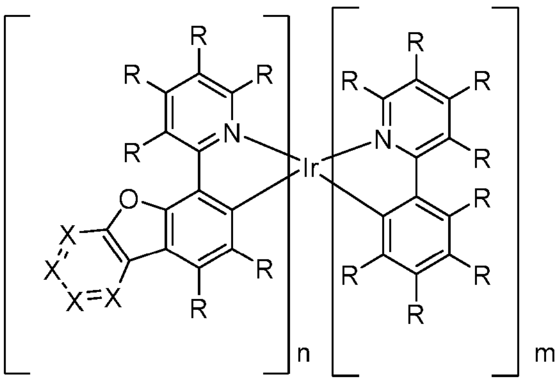

Formel (IIIa),

wobei die Symbole und Indizes für diese Formel (IIIa) die Bedeutung haben:

n+m ist 3, n ist 1 oder 2, m ist 2 oder 1,
X ist N oder CR,
R ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 7 C-Atomen, die teilweise oder vollständig mit Deuterium substituiert sein kann.

Ein weiterer Gegenstand der Erfindung ist demzufolge eine organische elektrolumineszierende Vorrichtung, wie zuvor beschrieben oder bevorzugt beschrieben, dadurch gekennzeichnet, dass die lichtemittierende Schicht neben den Hostmaterialien 1 und 2 mindestens einen phosphoreszierenden Emitter enthält, der der Formel (IIIa) entspricht, wie zuvor beschrieben.

In Emittern der Formel (IIIa) ist n bevorzugt 1 und m ist bevorzugt 2.

In Emittern der Formel (IIIa) ist bevorzugt ein X ausgewählt aus N und die anderen X bedeuten CR.

In Emittern der Formel (IIIa) ist mindestens ein R bevorzugt unterschiedlich von H. In Emittern der Formel (IIIa) sind bevorzugt zwei R unterschiedlich von H und haben eine der sonst zuvor für die Emitter der Formel (IIIa) angegebenen Bedeutungen.

Bevorzugte phosphoreszierende Emitter gemäß der vorliegenden Erfindung entsprechen den Formeln (I), (II),

(III), (IV) oder (V),

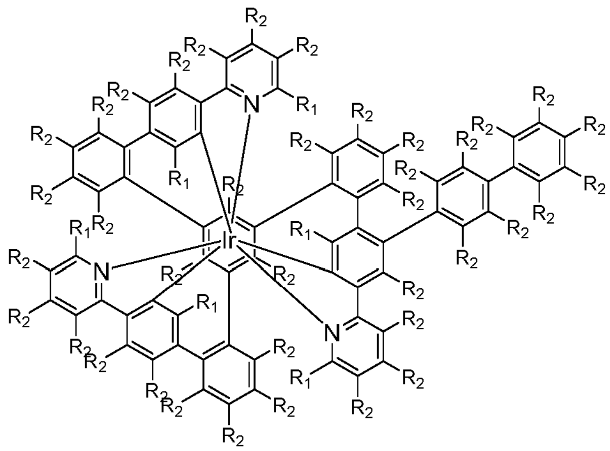

Formel (I) ,

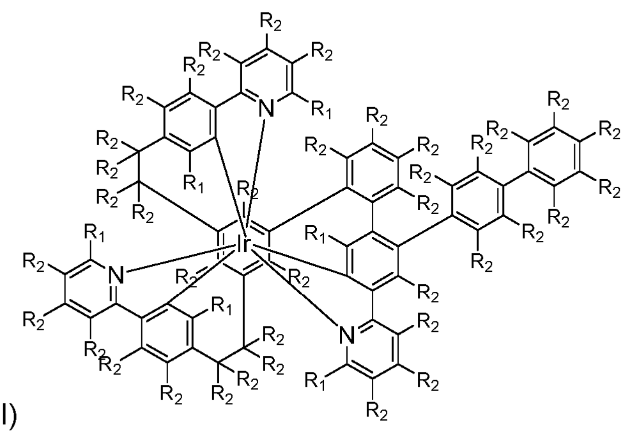

Formel (II) ,

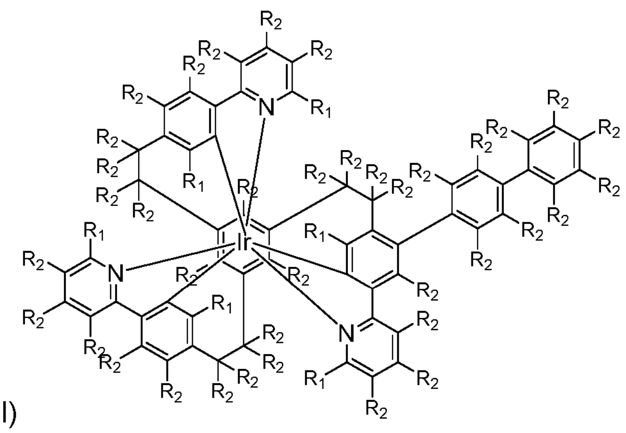

Formel (III) ,

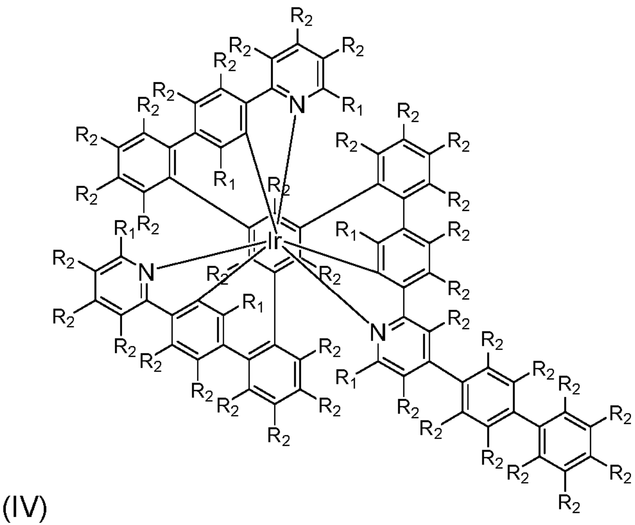

Formel (IV) ,

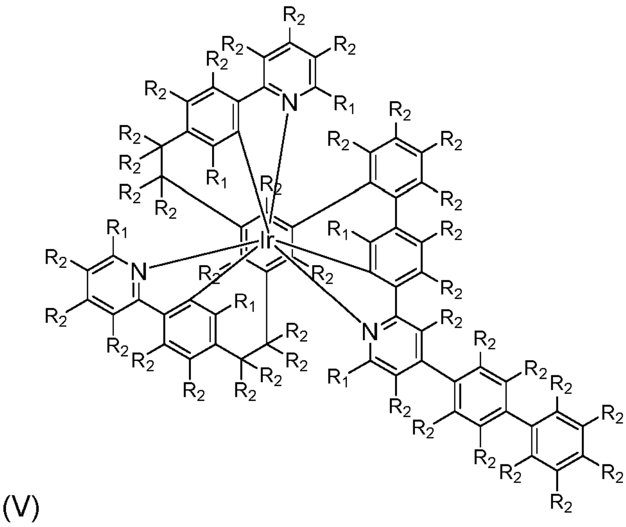

Formel (V) ,

wobei die Symbole und Indizes für diese Formeln (I), (II), (III), (IV) und (V) die Bedeutung haben:
$R_1$ ist H oder D, $R_2$ ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 10 C-Atomen, die teilweise oder vollständig mit Deuterium substituiert sein kann.

Bevorzugte phosphoreszierende Emitter gemäß der vorliegenden Erfindung entsprechen den Formeln (VI), (VII) oder (VIII),

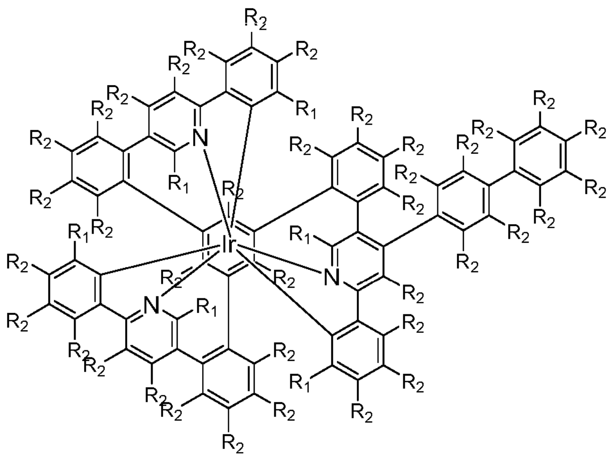

Formel (VI) ,

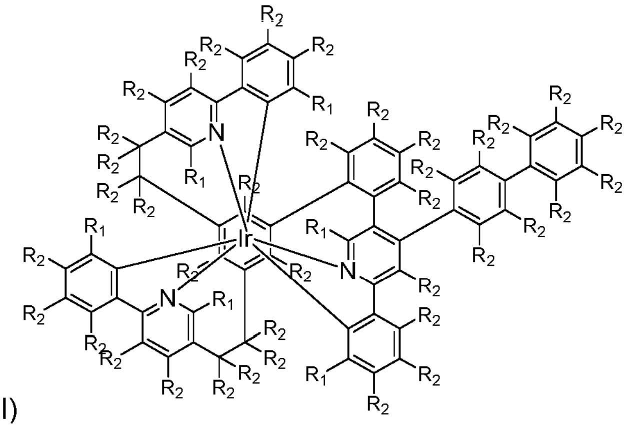

Formel (VII) ,

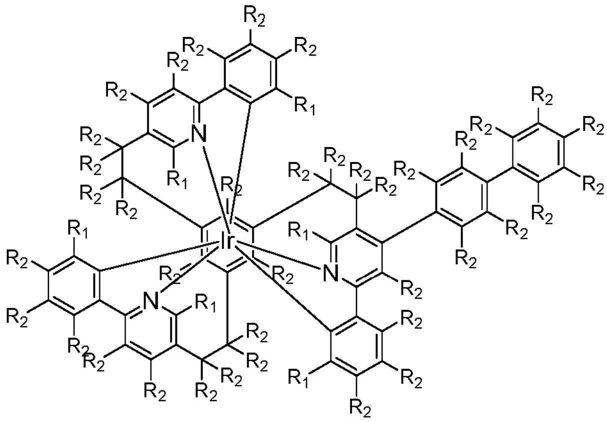

Formel (VIII) .

wobei die Symbole und Indizes für diese Formeln (VI), (VII) und (VIII) die Bedeutung haben:
$R_1$ ist H oder D, $R_2$ ist H, D, F oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 10 C-Atomen, die teilweise oder vollständig mit Deuterium substituiert sein kann.

Bevorzugte Beispiele von phosphoreszierenden Emittern sind in WO2019007867 auf den Seiten 120 bis 126 in Tabelle 5 und auf den Seiten 127 bis 129 in Tabelle 6 beschrieben. Besonders bevorzugte Beispiele von phosphoreszierenden Emittern sind in der folgenden Tabelle 6 aufgeführt.

Tabelle 6:

| | | |
|---|---|---|
| 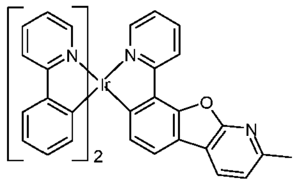 | 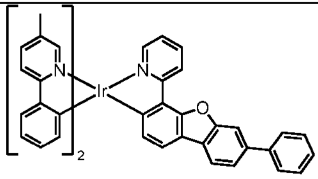 | 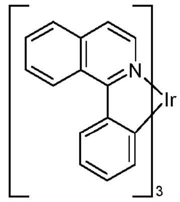 |
| 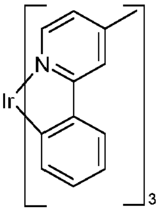 | 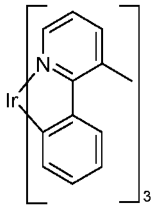 | 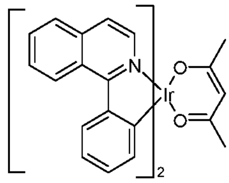 |
| 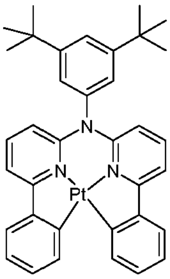 | 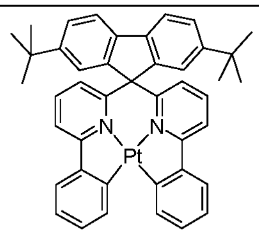 | 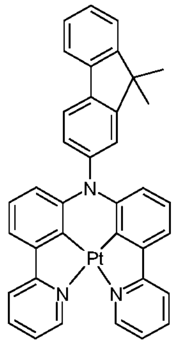 |
| 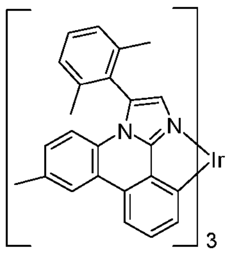 | 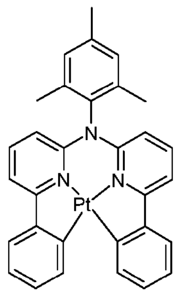 | 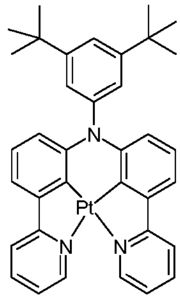 |
| 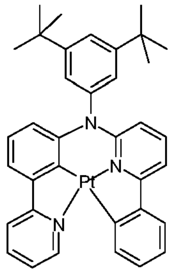 | 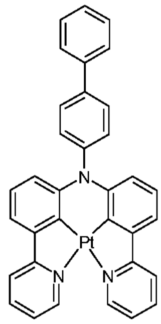 | 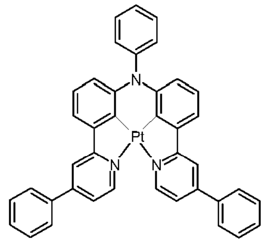 |

| | | |
|---|---|---|
| 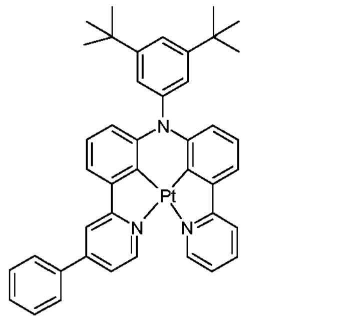 | 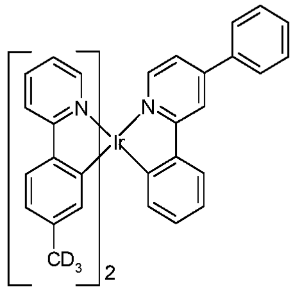 | 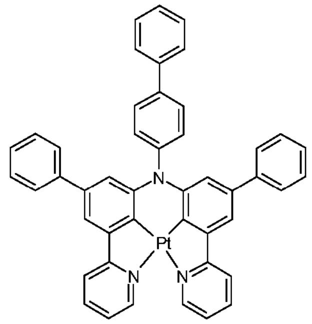 |
| 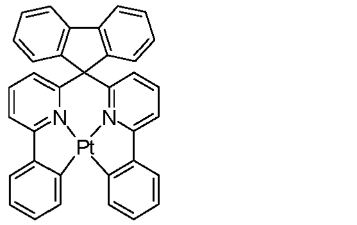 | 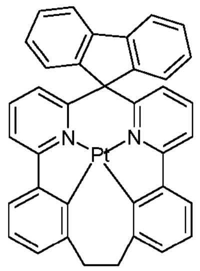 | 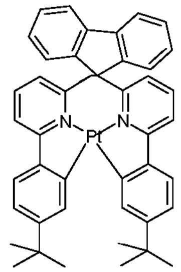 |
| 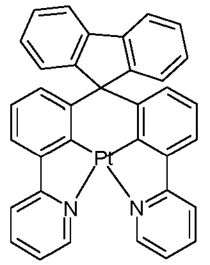 | 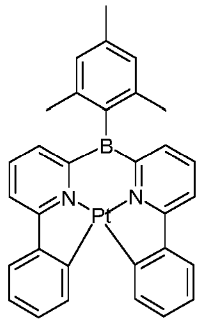 | 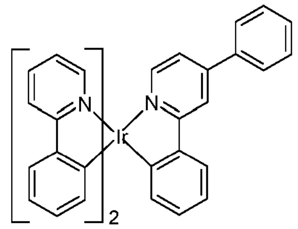 |
| 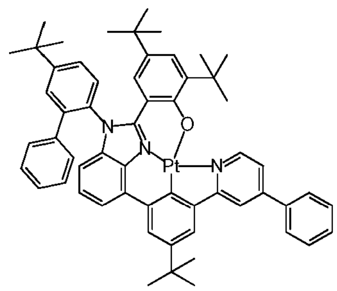 | 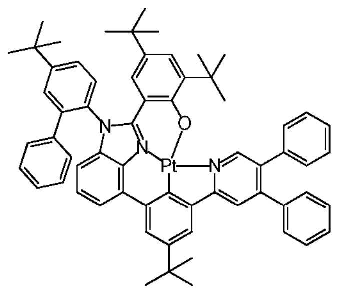 | 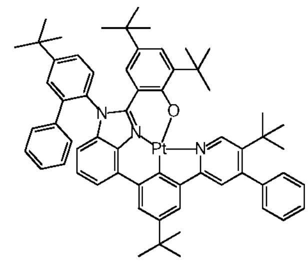 |
| 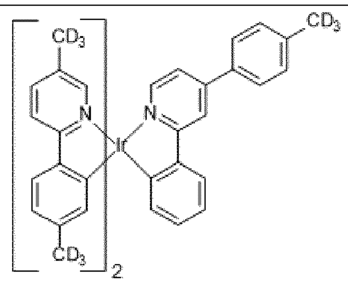 | 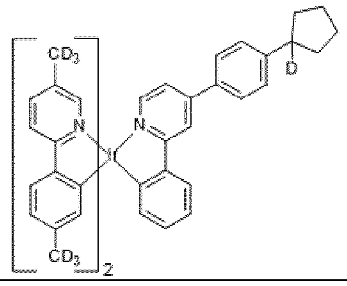 | 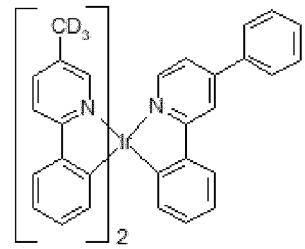 |

| | | |
|---|---|---|
| 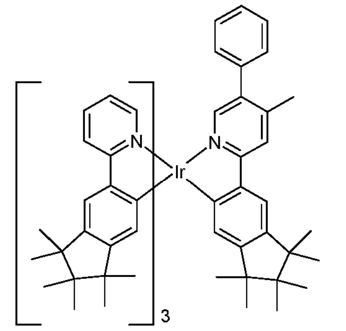 | 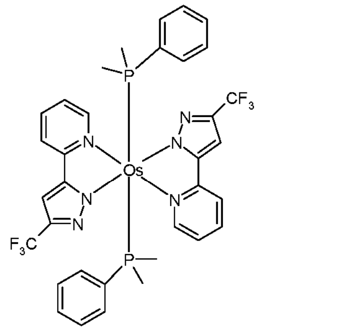 | 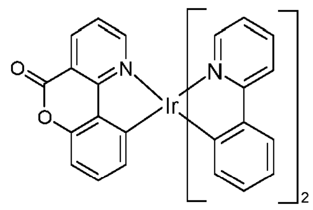 |
| 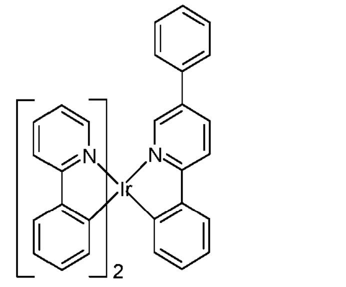 | 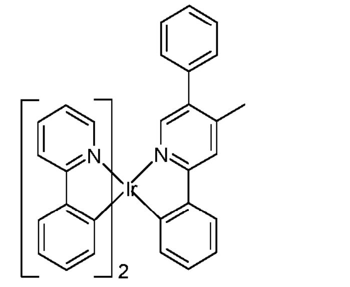 | 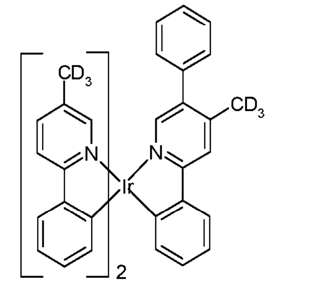 |
| 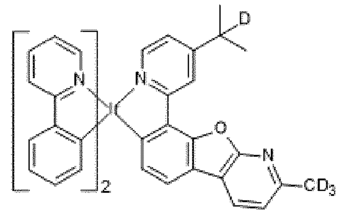 | 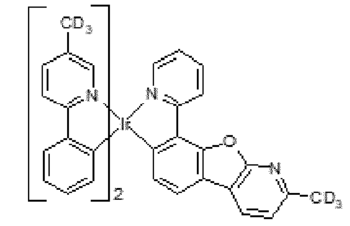 | 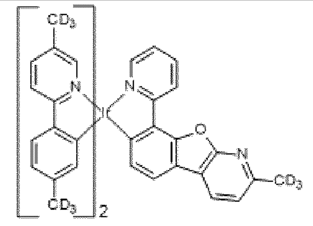 |
| 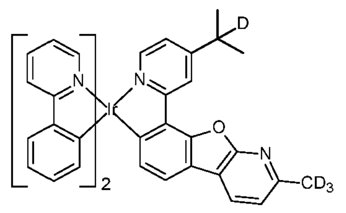 | 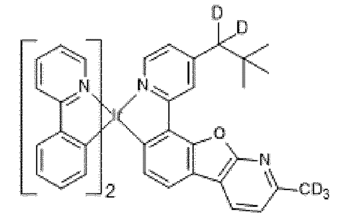 | 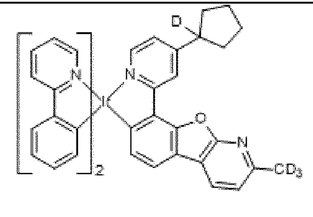 |
| 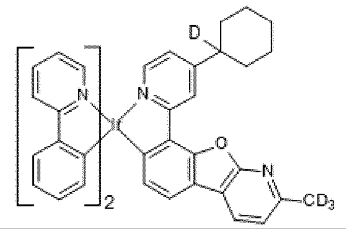 | 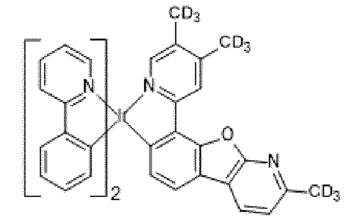 | 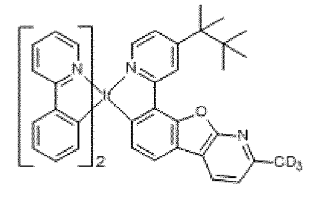 |
| 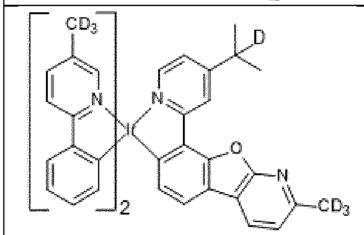 | 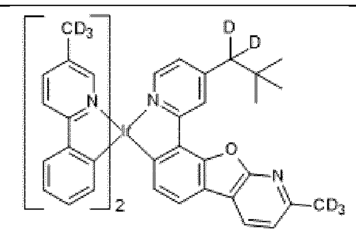 | 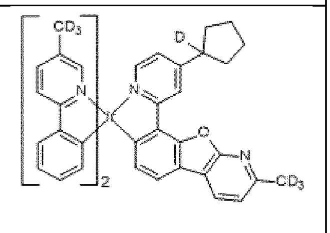 |
| 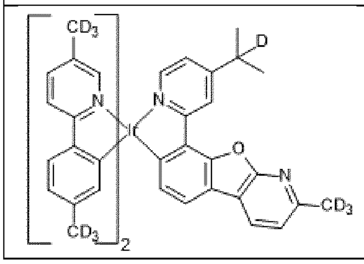 | 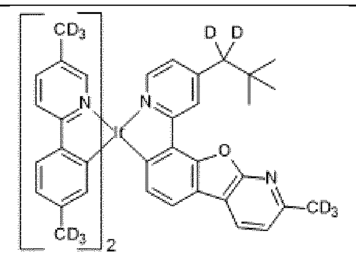 | 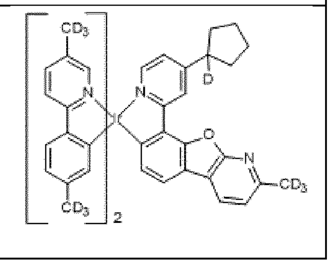 |

| | | |
|---|---|---|
| 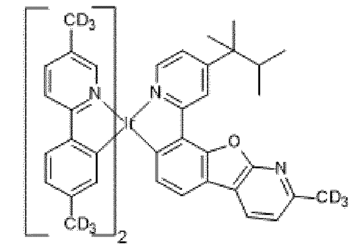 | 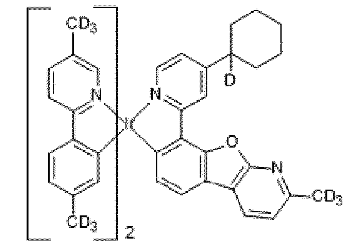 | 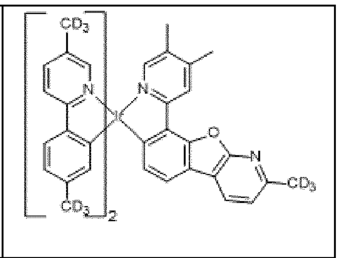 |
| 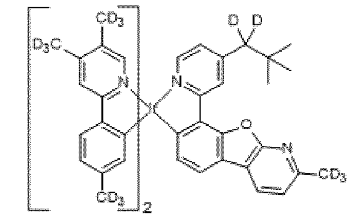 | 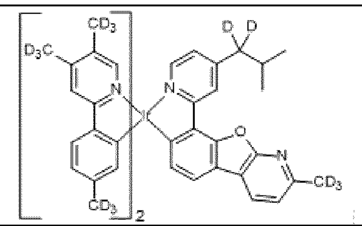 | 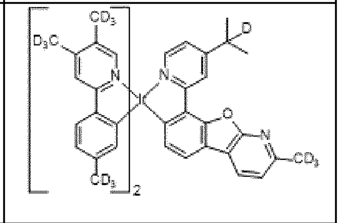 |
| 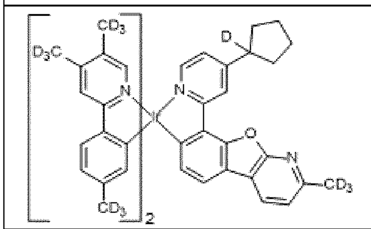 | 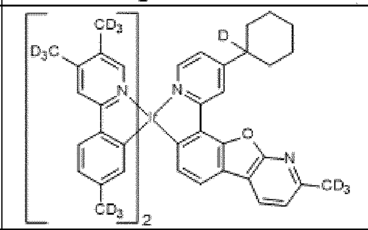 | 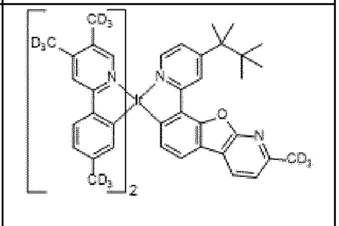 |
| 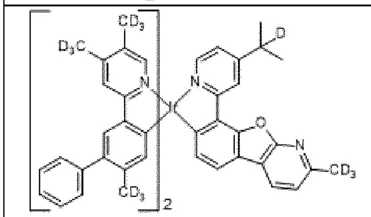 | 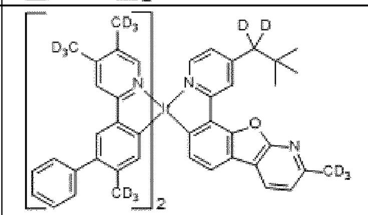 | 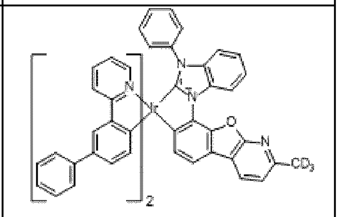 |
| 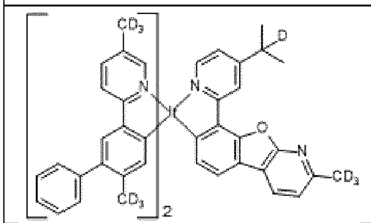 | 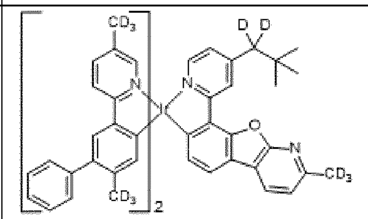 | 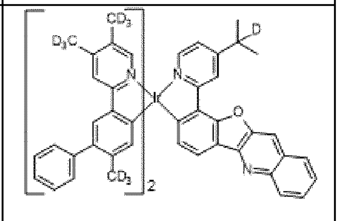 |
| 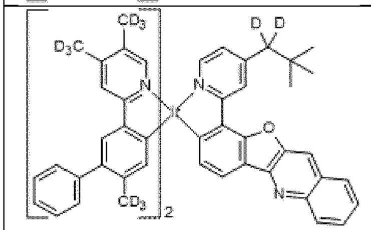 | 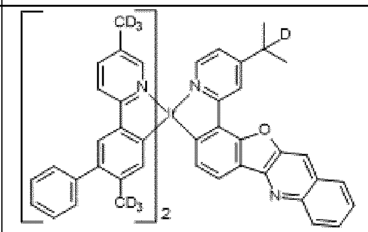 | 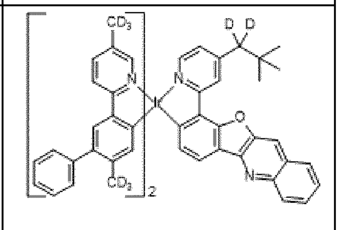 |
| 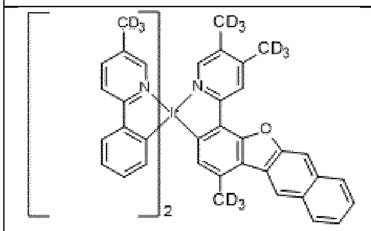 | 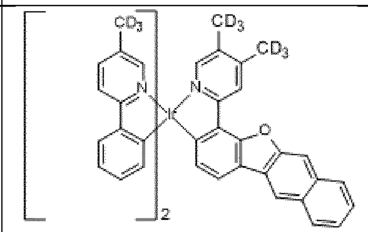 | 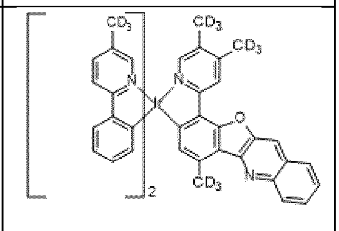 |
| 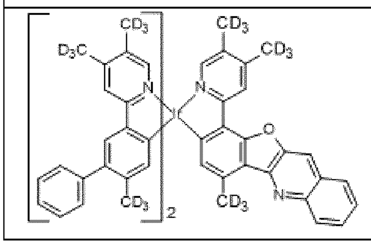 | 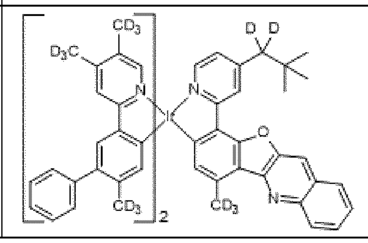 | 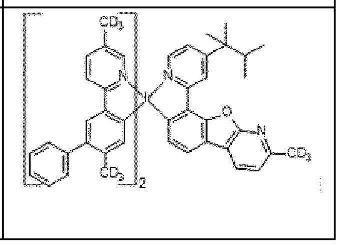 |

| | | |
|---|---|---|
| 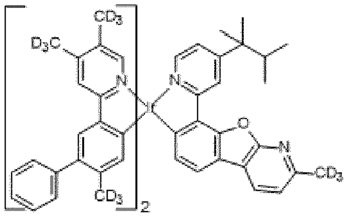 | 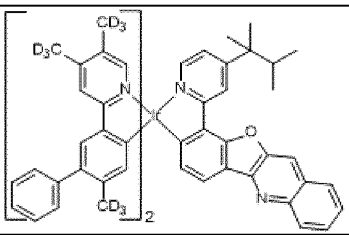 | 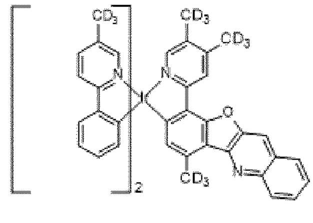 |
| 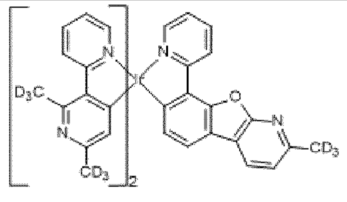 | 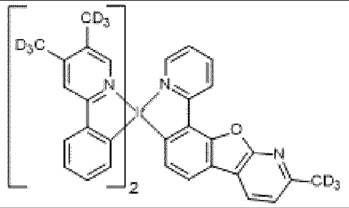 | 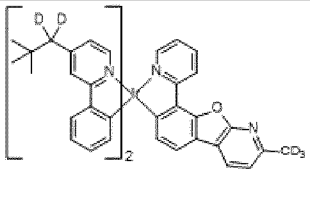 |
| 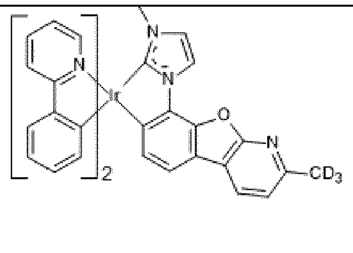 | 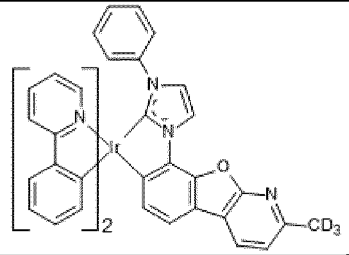 | 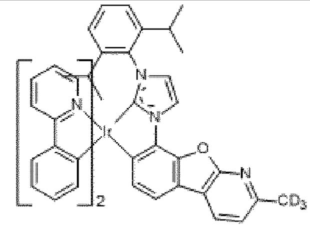 |
| 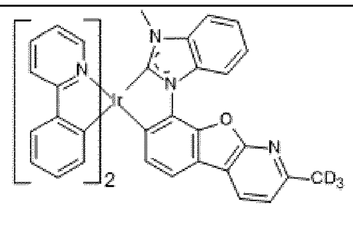 | 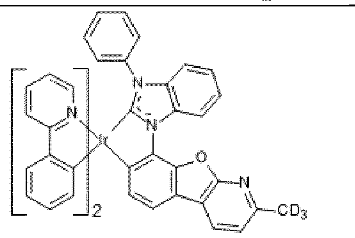 | 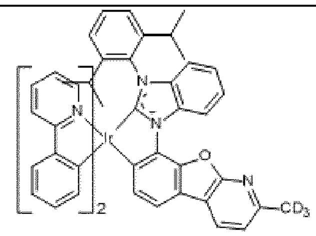 |
| 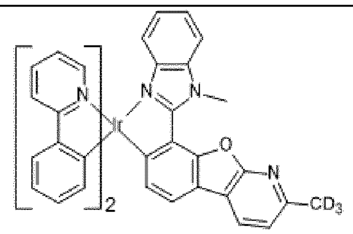 | 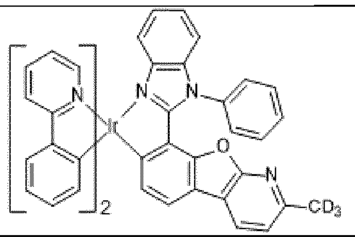 | 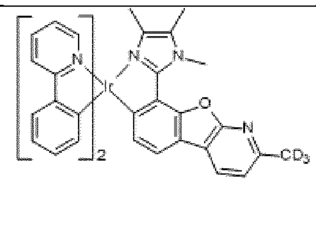 |
| 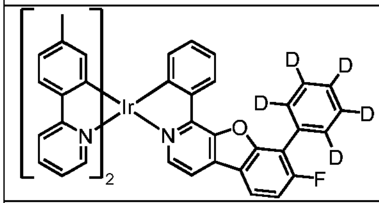 | 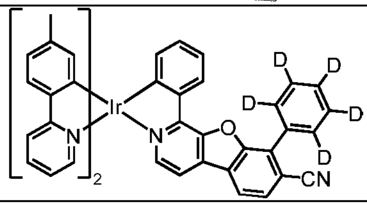 | 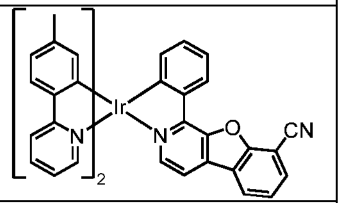 |
| 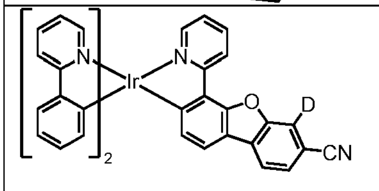 | 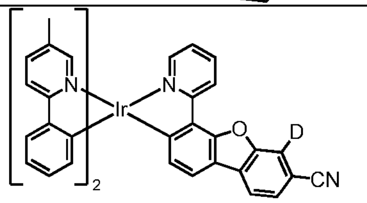 | 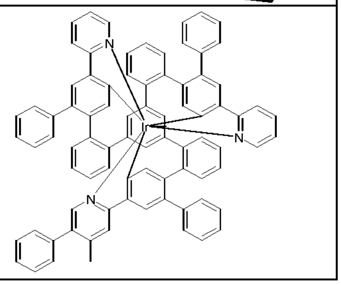 |

| | | |
|---|---|---|
| 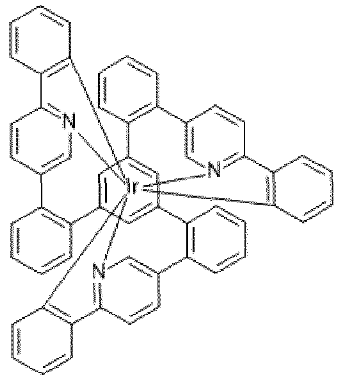 | 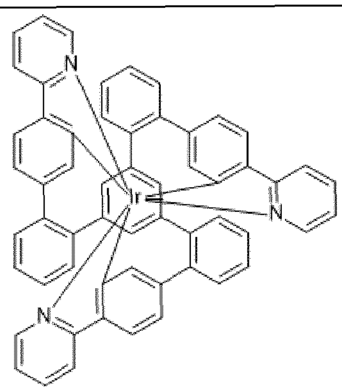 | 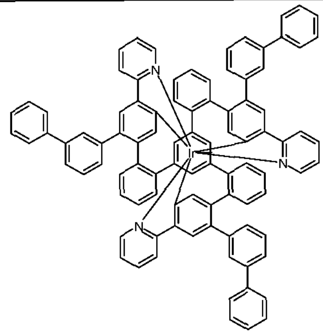 |
| 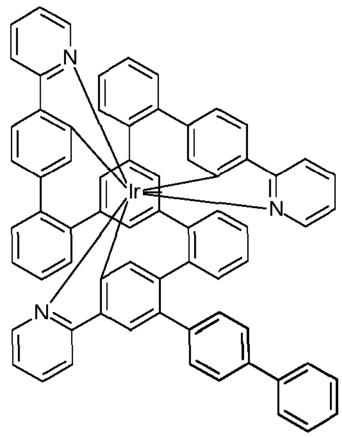 | 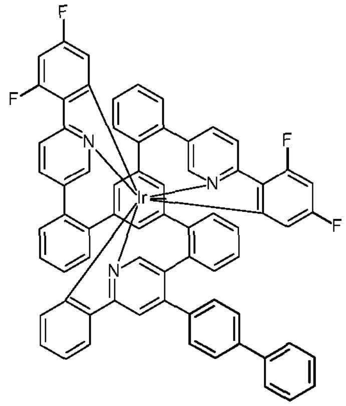 | 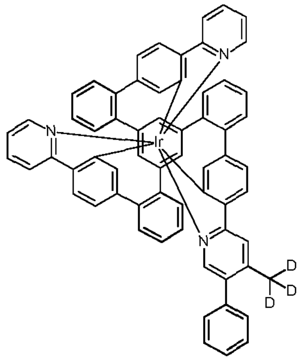 |
| 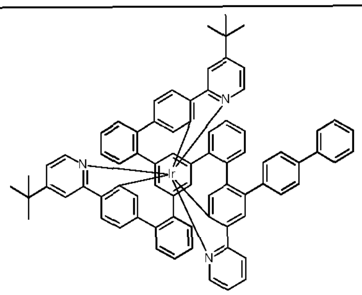 | 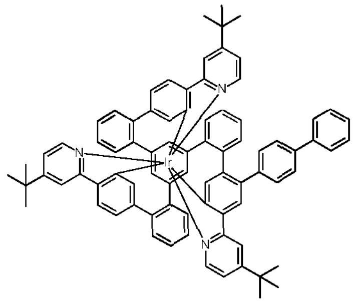 | 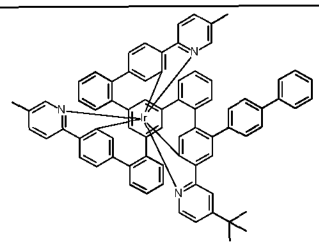 |
| 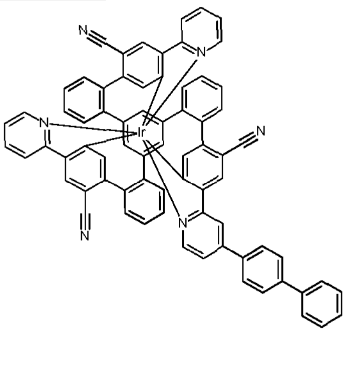 | 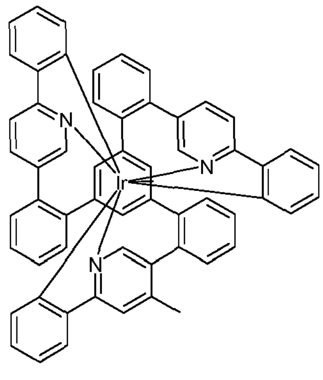 | 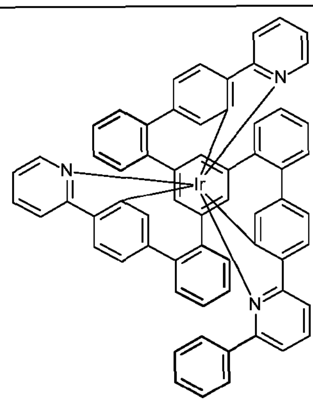 |

| | | |
|---|---|---|
| 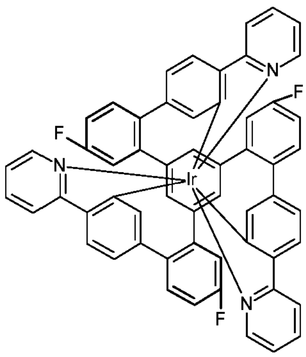 | 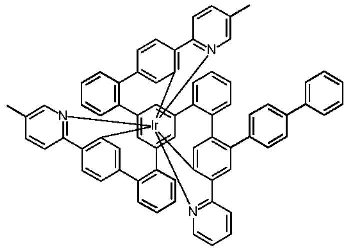 | 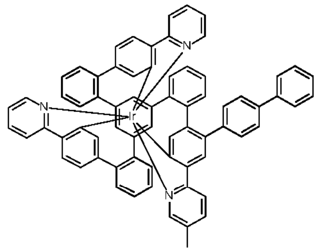 |
| 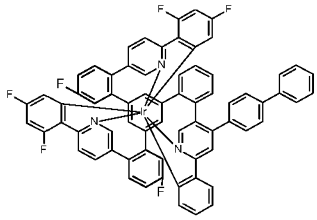 | 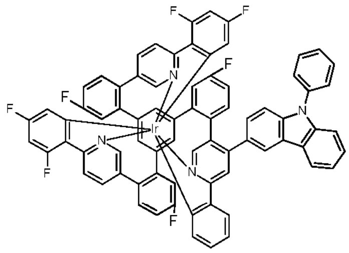 | 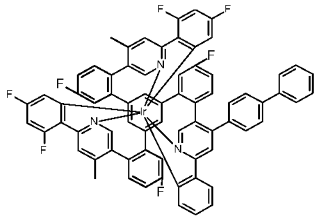 |
| 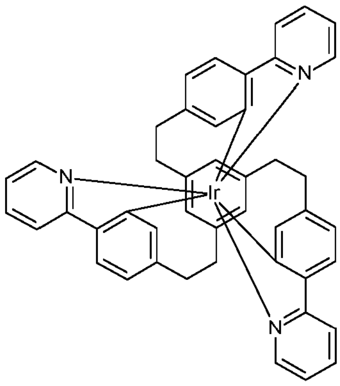 | 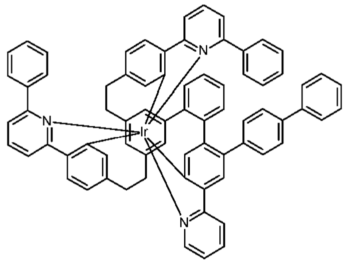 | 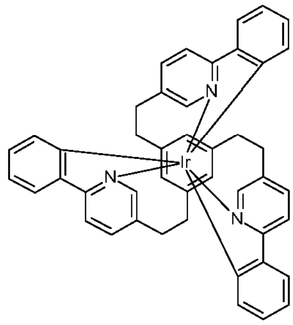 |
| 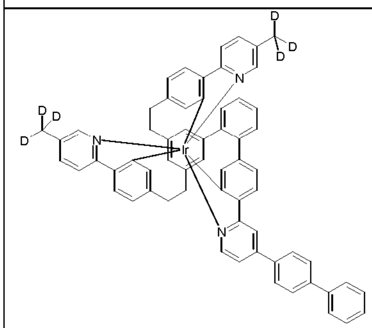 | 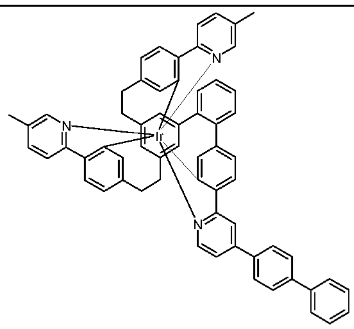 | 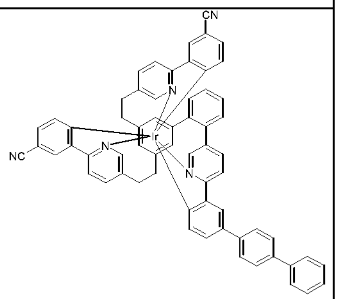 |
| 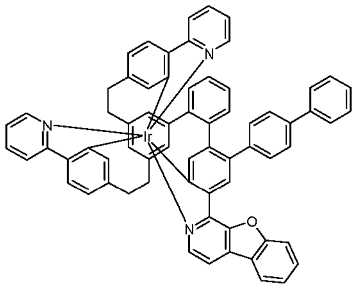 | 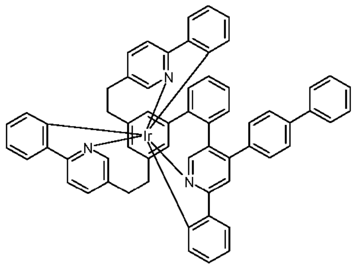 | 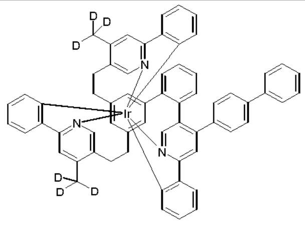 |

| | | |
|---|---|---|
| 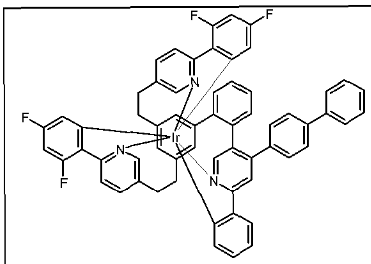 | 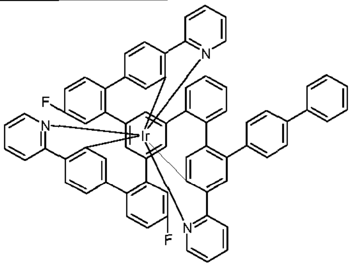 | 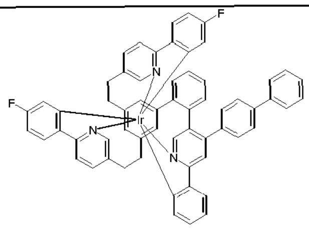 |
| 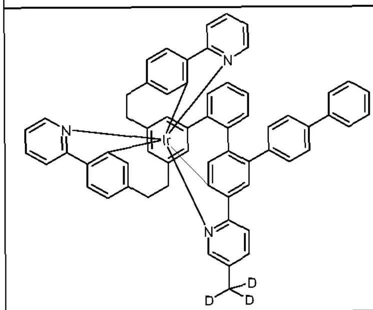 | 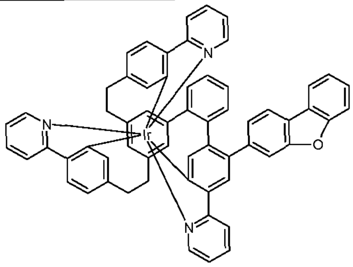 | 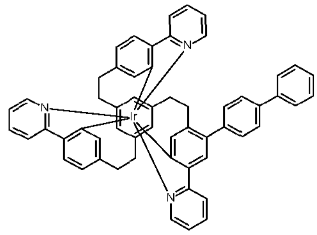 |
| 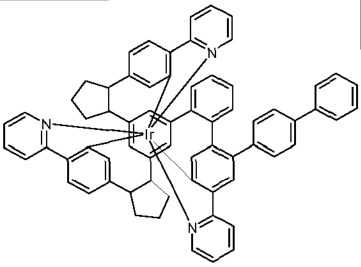 | 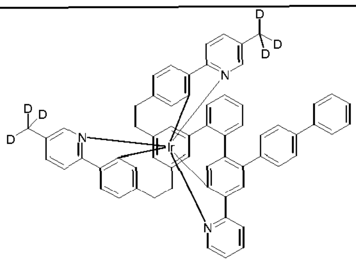 | 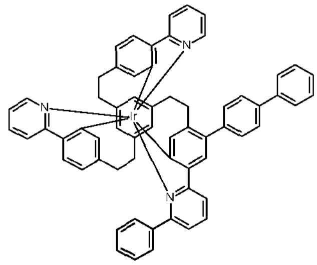 |
| 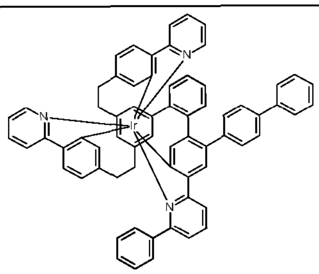 | 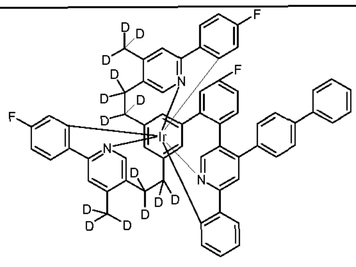 | 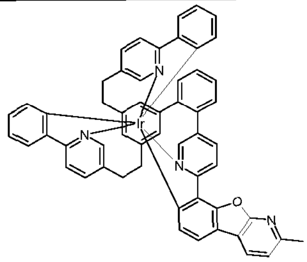 |
| 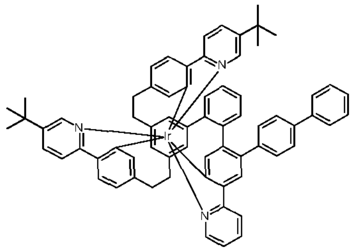 | 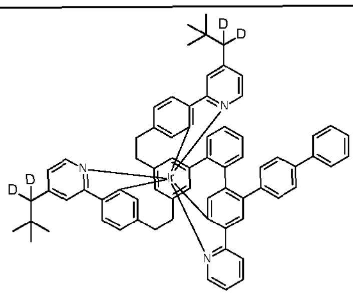 | 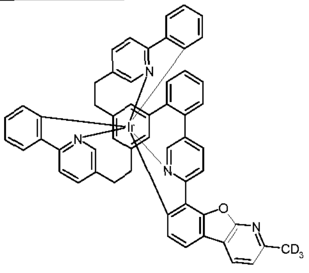 |
| 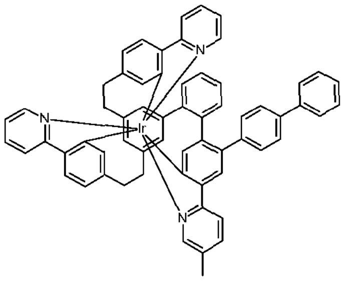 | 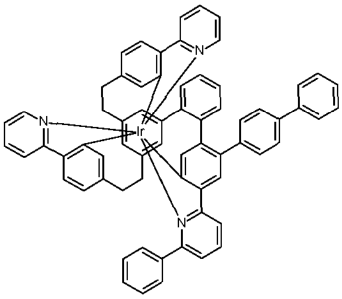 | 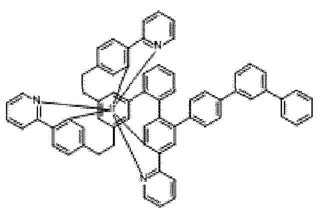 |

| | | |
|---|---|---|
| 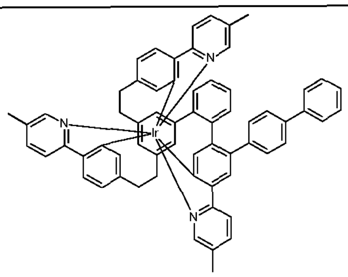 | 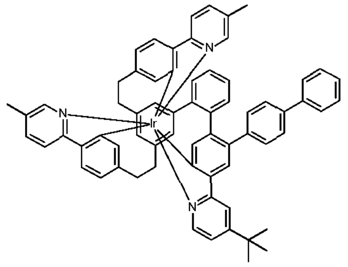 | 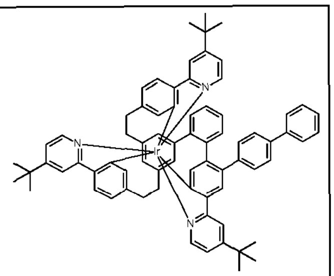 |
| 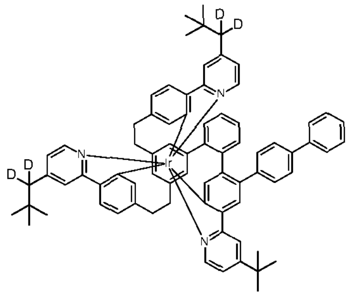 | 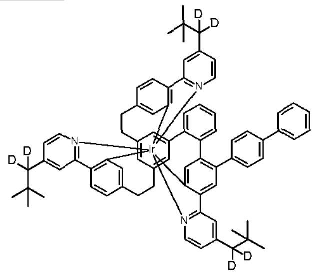 | 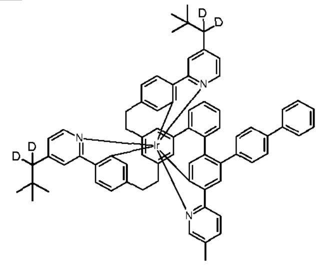 |
| 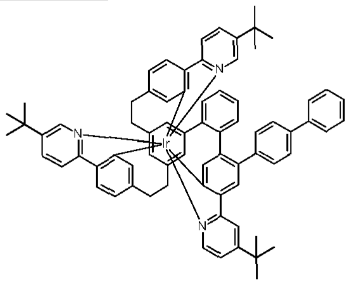 | 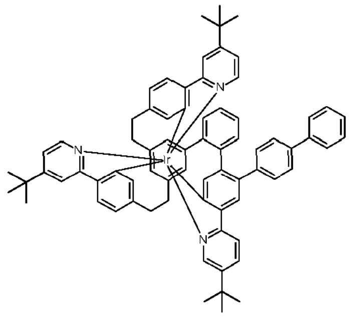 | 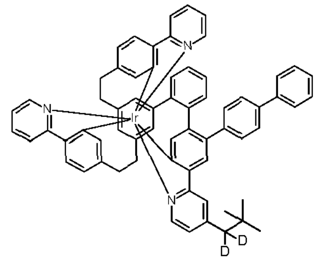 |
| 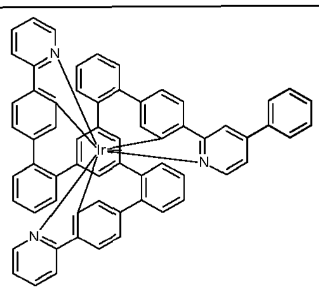 | 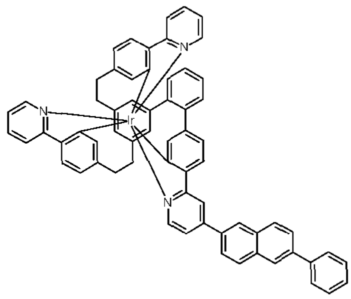 | 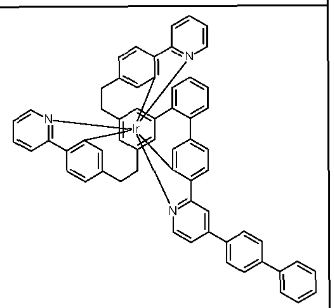 |
| 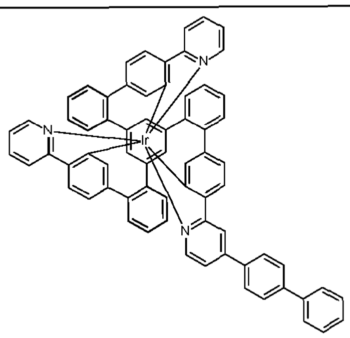 | 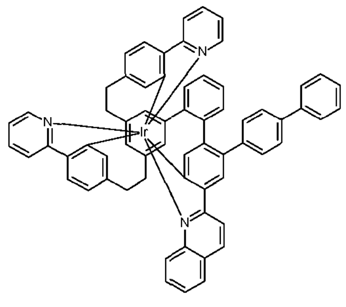 | 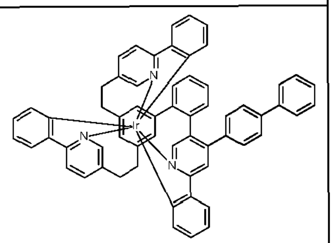 |
| 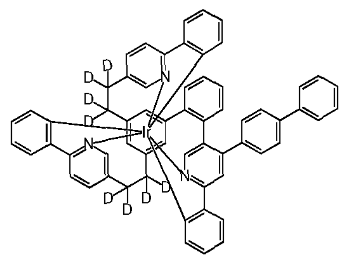 | 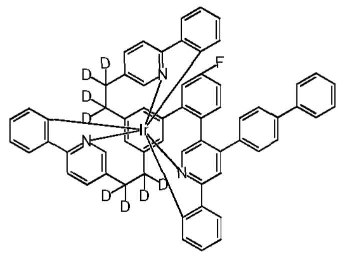 | 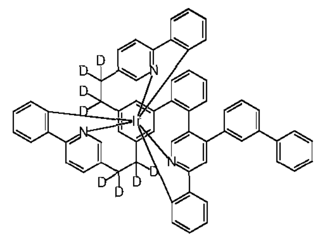 |

| | | |
|---|---|---|
| 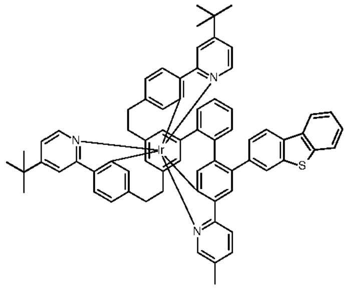 | 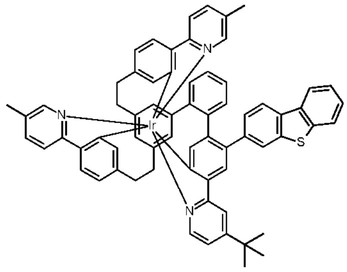 | 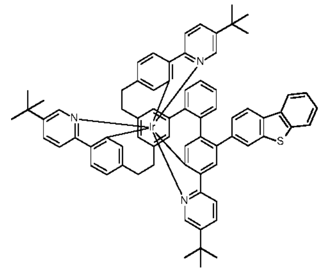 |

In den erfindungsgemäßen Mischungen oder in der lichtemittierenden Schicht der erfindungsgemäßen Vorrichtung wird bevorzugt jede Mischung ausgewählt aus der Summe der Mischungen M1 bis M585 mit einer Verbindung der Formel (IIIa) oder einer Verbindung der Formeln (I) bis (VIII) oder einer Verbindung aus Tabelle 6 kombiniert.

Die lichtemittierende Schicht in der erfindungsgemäßen organischen elektrolumineszierenden Vorrichtung enthaltend mindestens einen phosphoreszierenden Emitter ist bevorzugt eine infra-rot emittierende, gelb, orange, rot, grün, blau oder ultraviolett emittierende Schicht, besonders bevorzugt eine gelb oder grün emittierende Schicht und ganz besonders bevorzugt eine grün emittierende Schicht.

Dabei wird unter einer gelb emittierenden Schicht eine Schicht verstanden, deren Photolumineszenzmaximum im Bereich von 540 bis 570 nm liegt. Unter einer orange emittierenden Schicht wird eine Schicht verstanden, deren Photolumineszenzmaximum im Bereich von 570 bis 600 nm liegt. Unter einer rot emittierenden Schicht wird eine Schicht verstanden, deren Photolumineszenzmaximum im Bereich von 600 bis 750 nm liegt. Unter einer grün emittierenden Schicht wird eine Schicht verstanden, deren Photolumineszenzmaximum im Bereich von 490 bis 540 nm liegt. Unter einer blau emittierenden Schicht wird eine Schicht verstanden, deren Photolumineszenzmaximum im Bereich von 440 bis 490 nm liegt. Dabei wird das Photolumineszenzmaximum der Schicht durch Messung des Photolumineszenzspektrums der Schicht mit einer Schichtdicke von 50 nm bei Raumtemperatur bestimmt, wobei die Schicht die erfindungsgemäße Kombination der Hostmaterialien der Formeln (1) und (2) und den entsprechenden Emitter enthält.

Die Aufnahme des Photolumineszenzspektrums der Schicht erfolgt beispielsweise mit einem handelsüblichen Photolumineszenzspektrometer.

Das Photolumineszenzspektrum des gewählten Emitters wird in der Regel in Sauerstofffreier Lösung, 10-5 molar, gemessen, wobei die Messung bei Raumtemperatur erfolgt und jedes Lösemittel geeignet ist, in dem sich der gewählte Emitter in der genannten Konzentration löst. Besonders geeignete Lösemittel sind üblicherweise Toluol oder 2-Methyl-THF, aber auch Dichlormethan. Gemessen wird mit einem handelsüblichen Photolumineszenzspektrometer. Die Triplettenergie T1 in eV wird aus den Photolumineszenzspektren der Emitter bestimmt. Es wird zunächst das Peakmaximum Plmax. (in nm) des Photolumineszenzspektrums bestimmt. Das Peakmaximum Plmax. (in nm) wird dann in eV umgerechnet gemäß: E(T1 in eV) = 1240/E(T1 in nm) = 1240/PLmax. (in nm).

Bevorzugte phosphoreszierende Emitter sind demzufolge gelbe Emitter, vorzugsweise der Formel (IIIa), der Formeln (I) bis (VIII) oder aus Tabelle 6, deren Triplettenergie $T_1$ bevorzugt bei -2.3 eV bis ~2.1 eV liegt.

Bevorzugte phosphoreszierende Emitter sind demzufolge grüne Emitter, vorzugsweise der Formel (IIIa), der Formeln (I) bis (VIII) oder aus Tabelle 6, deren Triplettenergie $T_1$ bevorzugt bei -2.5 eV bis -2.3 eV liegt.

Besonders bevorzugte phosphoreszierende Emitter sind demzufolge grüne Emitter, vorzugsweise der Formel (IIIa), der Formeln (I) bis (VIII) oder aus Tabelle 6, wie zuvor beschrieben, deren Triplettenergie $T_1$ bevorzugt bei -2.5 eV bis -2.3 eV liegt.

Ganz besonders bevorzugt werden grüne Emitter, vorzugsweise der Formel (IIIa), der Formeln (I) bis (VIII) oder aus Tabelle 6, wie zuvor beschrieben, für die erfindungsgemäße Mischung bzw. erfindungsgemäße emittierende Schicht ausgewählt.

In der lichtemittierenden Schicht der erfindungsgemäßen Vorrichtung können auch fluoreszierende Emitter enthalten sein.

Bevorzugte fluoreszierende emittierende Verbindungen sind ausgewählt aus der Klasse der Arylamine, wobei bevorzugt mindestens eines der aromatischen oder heteroaromatischen Ringsysteme des Arylamins ein kondensiertes Ringsystem, besonders bevorzugt mit mindestens 14 Ringatomen ist. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte emittierende Verbindungen sind Indenofluorenamine

bzw. - diamine, Benzoindenofluorenamine bzw. -diamine, und Dibenzoindenofluorenamine bzw. -diamine, sowie Indenofluorenderivate mit kondensierten Arylgruppen. Ebenfalls bevorzugt sind Pyren-Arylamine. Ebenfalls bevorzugt sind Benzoindenofluoren-Amine, Benzofluoren-Amine, erweiterte Benzoindenofluorene, Phenoxazine, und Fluoren-Derivate, die mit Furan-Einheiten oder mit Thiophen-Einheiten verbunden sind.

In einer weiteren bevorzugten Ausführungsform der Erfindung kann die mindestens eine lichtemittierende Schicht der organischen elektrolumineszierenden Vorrichtung neben den Hostmaterialien 1 und 2, wie zuvor beschrieben oder als bevorzugt beschrieben, weitere Hostmaterialien oder Matrixmaterialien umfassen, sogenannte Mixed-Matrix-Systeme. Die Mixed-Matrix-Systeme umfassen bevorzugt drei oder vier verschiedene Matrixmaterialien, besonders bevorzugt drei verschiedene Matrixmaterialien (das heißt, eine weitere Matrixkomponente zusätzlich zu den Hostmaterialien 1 und 2, wie zuvor beschrieben). Besonders geeignete Matrixmaterialien, welche in Kombination als Matrixkomponente eines Mixed-Matrix-Systems verwendet werden können, sind ausgewählt aus *wide-band*-gap-Materialien, bipolaren Hostmaterialien, Elektronentransportmaterialien (ETM) und Lochtransportmaterialien (HTM).

Unter *wide-band-gap*-Material wird hierin ein Material im Sinne der Offenbarung von US 7,294,849 verstanden, das durch eine Bandlücke von mindestens 3.5 eV charakterisiert ist, wobei unter Bandlücke der Abstand zwischen HOMO und LUMO-Energie eines Materials verstanden wird.

Bevorzugt wird das Mixed-Matrix-System auf einen Emitter der Formel (IIIa), der Formeln (I) bis (VIII) oder aus Tabelle 6 optimiert.

Gemäß einer Ausführungsform der vorliegenden Erfindung enthält die Mischung neben den Bestandteilen elektronentransportierendes Hostmaterial der Formel (1) und lochtransportierendes Hostmaterial der Formel (2) keine weiteren Bestandteile, das heißt, funktionellen Materialien. Es handelt sich um Materialmischungen, die als solche zur Herstellung der lichtemittierenden Schicht, verwendet werden. Man bezeichnet diese Mischungen auch als Premix-Systeme, die als einzige Materialquelle bei der Aufdampfung der Hostmaterialien für die lichtemittierende Schicht verwendet wird und die ein konstantes Mischungsverhältnis bei der Aufdampfung haben. Dadurch lässt sich auf einfache und schnelle Art und Weise das Aufdampfen einer Schicht mit gleichmäßiger Verteilung der Komponenten erreichen, ohne dass eine präzise Ansteuerung einer Vielzahl an Materialquellen notwendig ist.

Gemäß einer alternativen Ausführungsform der vorliegenden Erfindung enthält die Mischung neben den Bestandteilen elektronentransportierendes Hostmaterial der Formel (1) und lochtransportierendes Hostmaterial der Formel (2) noch den phosphoreszierenden Emitter, wie zuvor beschrieben. Bei geeignetem Mischungsverhältnis bei der Aufdampfung kann auch diese Mischung als einzige Materialquelle verwendet werden, wie zuvor beschrieben.

Die Komponenten bzw. Bestandteile der lichtemittierenden Schicht der erfindungsgemäßen Vorrichtung können somit durch Aufdampfen oder aus Lösung prozessiert werden. Die Materialkombination der Hostmaterialien 1 und 2, wie zuvor beschrieben oder bevorzugt beschrieben, gegebenenfalls mit dem phosphoreszierenden Emitter, wie zuvor beschrieben oder bevorzugt beschrieben, werden dazu in einer Formulierung bereitgestellt, die mindestens ein Lösemittel enthält. Diese Formulierungen können beispielsweise Lösungen, Dispersionen oder Emulsionen sein. Es kann bevorzugt sein, hierfür Mischungen aus zwei oder mehr Lösemitteln zu verwenden.

Ein weiterer Gegenstand der vorliegenden Erfindung ist daher eine Formulierung enthaltend eine erfindungsgemäße Mischung an Hostmaterialien 1 und 2, wie zuvor beschrieben, gegebenenfalls in Kombination mit einem phosphoreszierenden Emitter, wie zuvor beschrieben oder bevorzugt beschrieben, und mindestens ein Lösemittel.

Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Die Formulierung kann dabei auch mindestens eine weitere organische oder anorganische Verbindung enthalten, die ebenfalls in der lichtemittierenden Schicht der erfindungsgemäßen Vorrichtung eingesetzt wird, insbesondere eine weitere emittierende Verbindung und/oder ein weiteres Matrixmaterial. Geeignete emittierende Verbindungen und weitere Matrixmaterialien wurden vorstehend bereits aufgeführt.

Die lichtemittierende Schicht in der erfindungsgemäßen Vorrichtung gemäß den bevorzugten Ausführungsformen und der emittierenden Verbindung enthält vorzugsweise zwischen 99,9 und 1 Vol.-%, weiter vorzugsweise zwischen 99 und 10 Vol.-%, besonders bevorzugt zwischen 98 und 60 Vol.-%, ganz besonders bevorzugt zwischen 97 und 80 Vol.-% an Matrixmaterial aus mindestens einer Verbindung der Formel (1) und mindestens einer Verbindung der Formel (2) gemäß den bevorzugten Ausführungsformen, bezogen auf die gesamte Zusammensetzung aus Emitter und Matrixmaterial. Entsprechend enthält die lichtemittierende Schicht in der erfindungsgemäßen Vorrichtung vorzugsweise

zwischen 0,1 und 99 Vol.-%, weiter vorzugsweise zwischen 1 und 90 Vol.-%, besonders bevorzugt zwischen 2 und 40 Vol.-%, ganz besonders bevorzugt zwischen 3 und 20 Vol.-% des Emitters bezogen auf die gesamte Zusammensetzung der aus Emitter und Matrixmaterial bestehenden lichtemittierenden Schicht. Werden die Verbindungen aus Lösung verarbeitet, so werden statt der oben angegebenen Mengen in Vol.-% bevorzugt die entsprechenden Mengen in Gew.-% verwendet.

Die lichtemittierende Schicht in der erfindungsgemäßen Vorrichtung gemäß den bevorzugten Ausführungsformen und der emittierenden Verbindung enthält vorzugsweise das Matrixmaterial der Formel (1) und das Matrixmaterial der Formel (2) in einem Volumenprozentverhältnis zwischen 3:1 und 1:3, bevorzugt zwischen 1:2.5 und 1:1, besonders bevorzugt zwischen 1:2 und 1:1. Werden die Verbindungen aus Lösung verarbeitet, so werden statt des oben angegebenen Verhältnisses in Vol.-% bevorzugt das entsprechende Verhältnis in Gew.-% verwendet.

Die vorliegende Erfindung betrifft auch eine organische elektrolumineszierende Vorrichtung, wie zuvor beschrieben oder bevorzugt beschrieben, wobei die organische Schicht eine Lochinjektionsschicht (HIL) und/oder eine Lochtransportschicht (HTL) enthält, deren lochinjizierendes Material und lochtransportierendes Material zur Klasse der Arylamine gehört. Bevorzugte Verbindungen mit Lochtransportfunktion, die nicht einer der Formeln für das Hostmaterial 2 entsprechen, vorzugsweise zur Verwendung in einer Lochinjektionsschicht, einer Lochtransportschicht, einer Elektronenblockierschicht und/oder als zusätzliches Matrixmaterial in der erfindungsgemäßen emittierenden Schicht, sind in der folgenden Tabelle 7 gezeigt. Die Verbindungen der Tabelle 7 sind, wie die Strukturen zeigen, nicht deuterierte Verbindungen.

Tabelle 7:

| | |
|---|---|
| 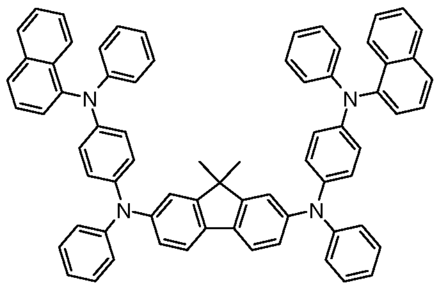 | 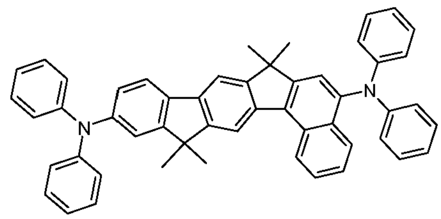 |
| HT-1 | HT-2 |
| 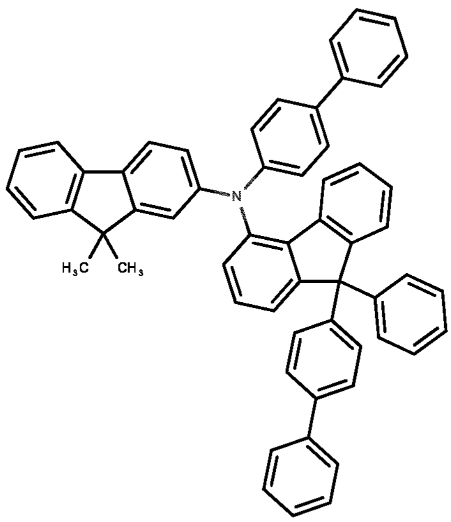 | 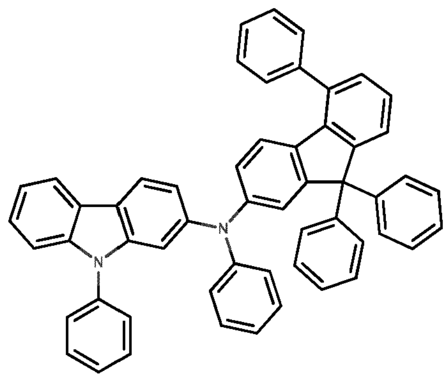 |
| HT-3 | HT-4 |

(fortgesetzt)

| | |
|---|---|
| 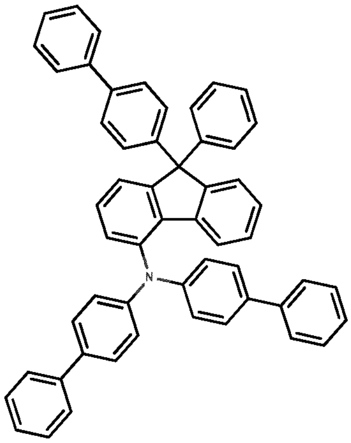 | 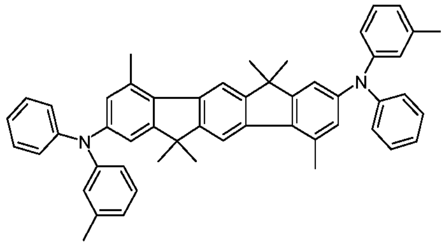 |
| HT-5 | HT-6 |
| 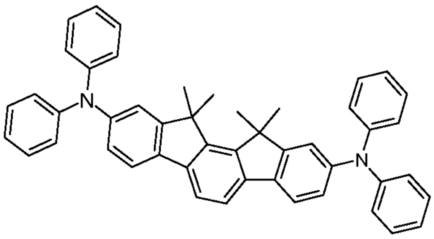 | 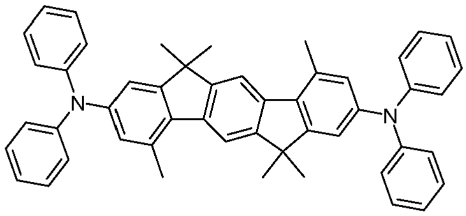 |
| HT-7 | HT-8 |
| 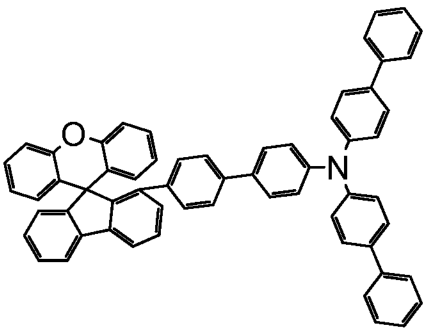 | 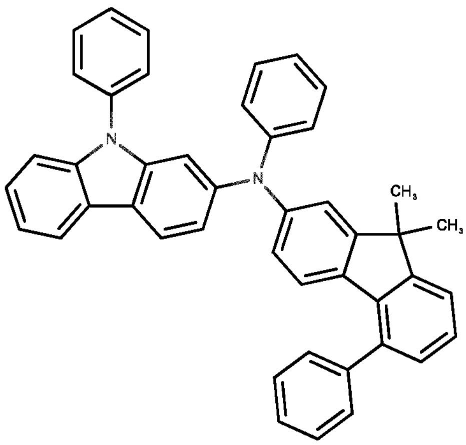 |
| HT-9 | HT-10 |

(fortgesetzt)

| | |
|---|---|
| 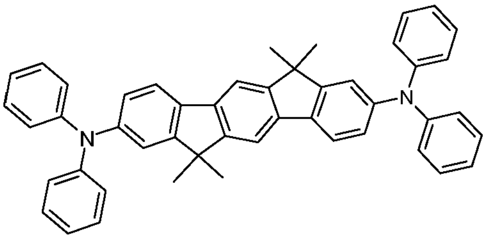 | 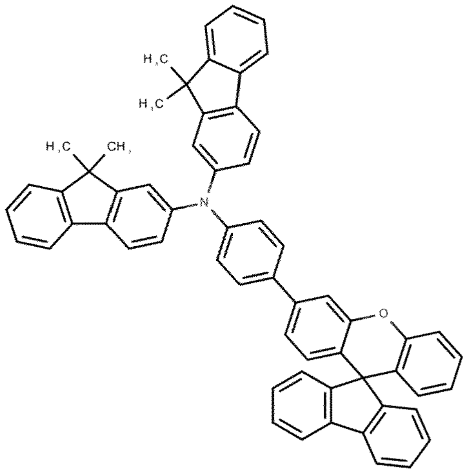 |
| HT-11 | HT-12 |
| 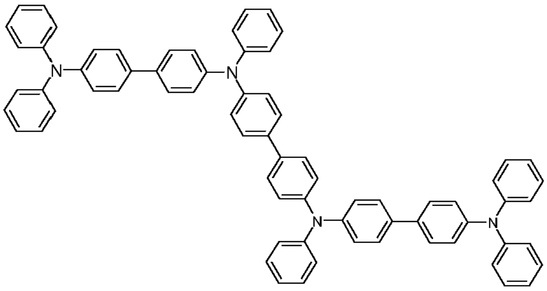 | 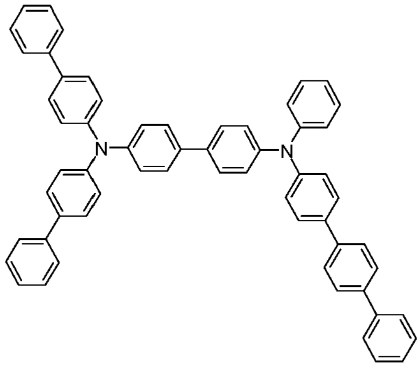 |
| HT-13 | HT-14 |
| 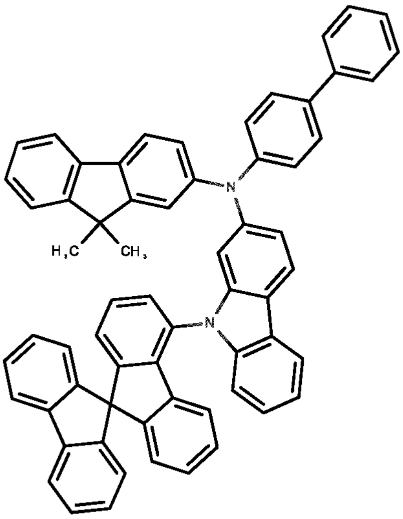 | 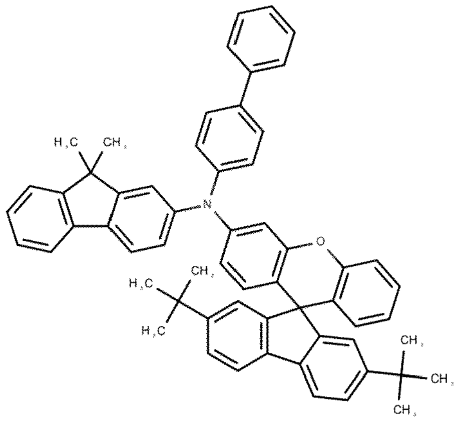 |
| HT-15 | HT-16 |

(fortgesetzt)

| | |
|---|---|
| 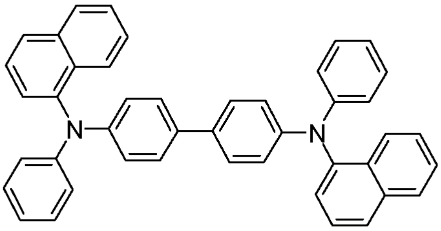 | 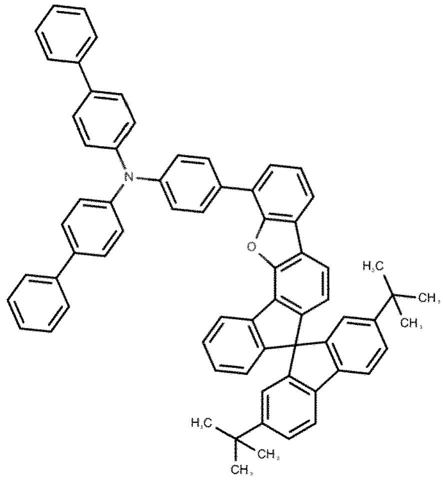 |
| HT-17 | HT-18 |
| 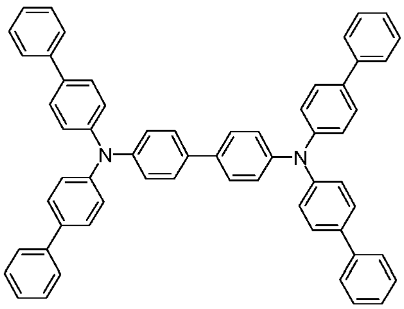 | 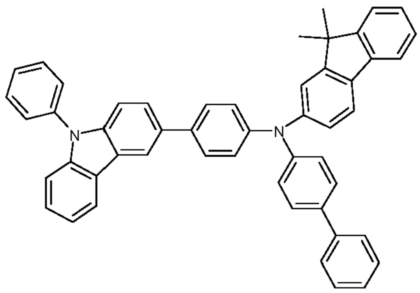 |
| HT-19 | HT-20 |
| 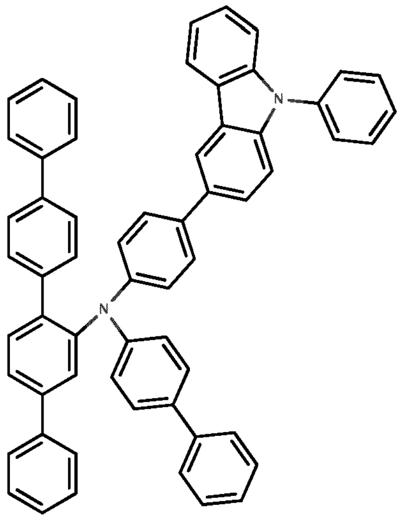 | 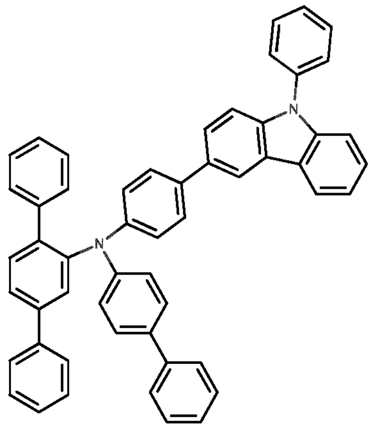 |
| HT-21 | HT-22 |

(fortgesetzt)

| | |
|---|---|
| 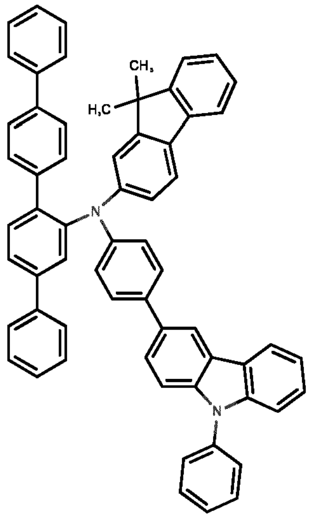 | 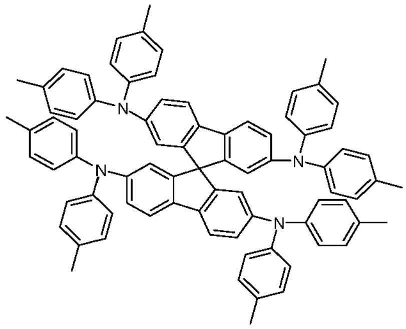 |
| HT-23 | HT-24 |
| 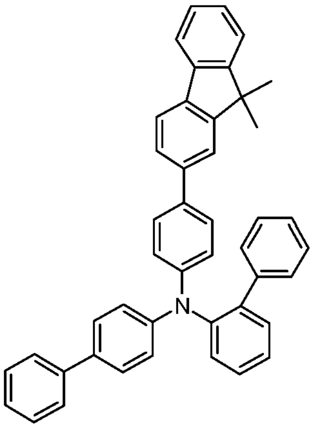 | 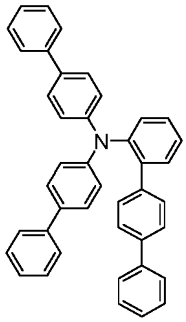 |
| HT-25 | HT-26 |
| 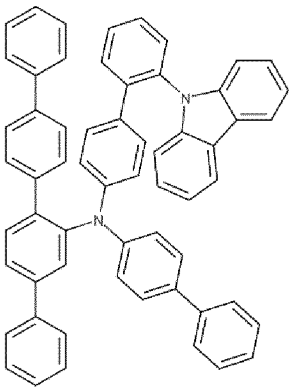 | 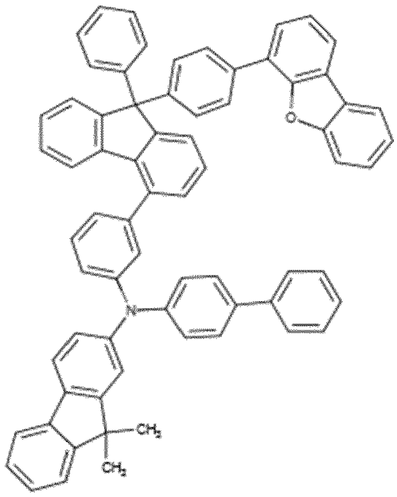 |
| HT-27 | HT-28 |

(fortgesetzt)

| | |
|---|---|
| 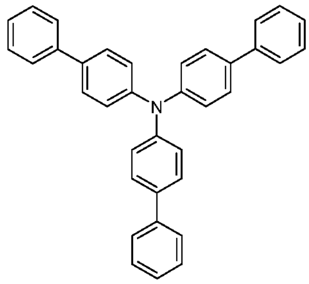 | 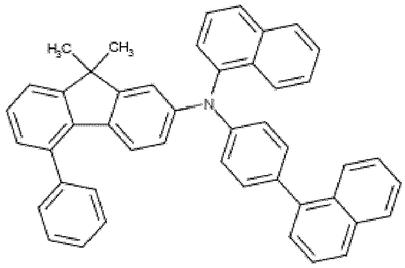 |
| HT-29 | HT-30 |
| 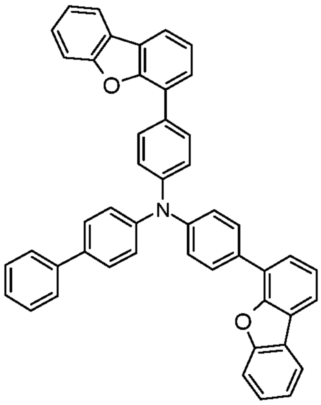 | 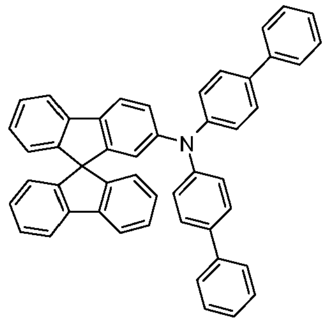 |
| HT-31 | HT-32 |
| 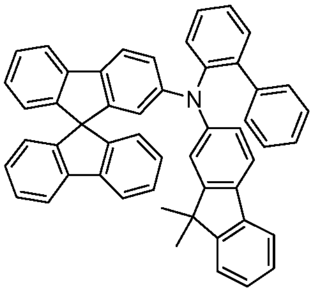 | 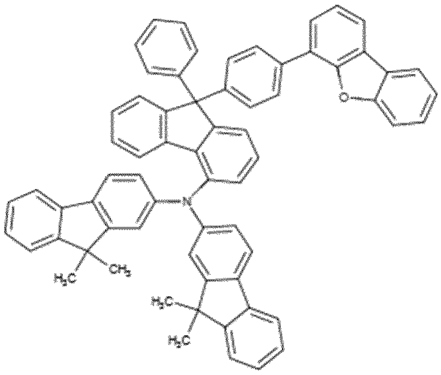 |
| HT-33 | HT-34 |
| 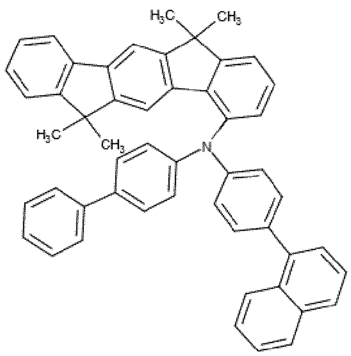 | 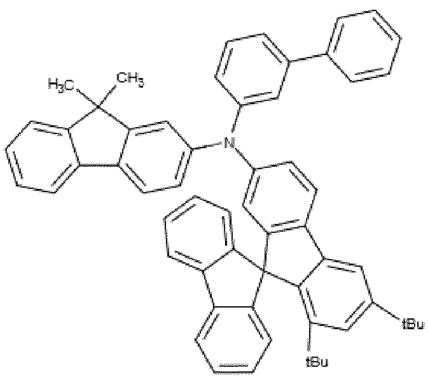 |
| HT-35 | HT-36 |

(fortgesetzt)

| | |
|---|---|
| 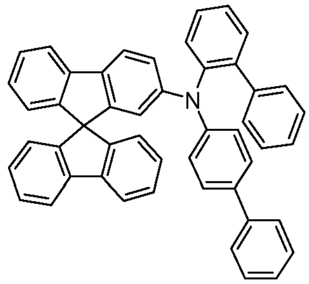 | 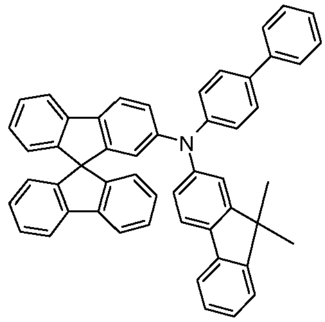 |
| HT-37 | HT-38 |
| 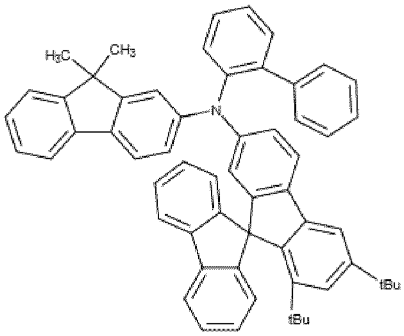 | 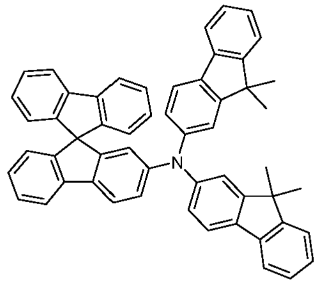 |
| HT-39 | HT-40 |
| 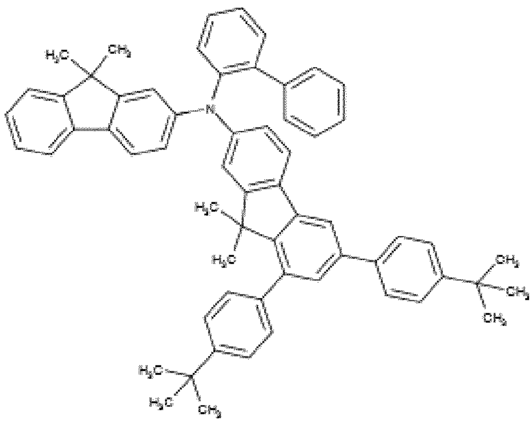 | 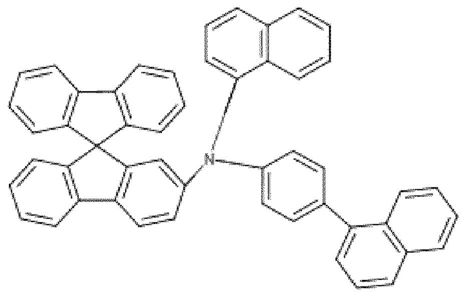 |
| HT-41 | HT-42 |
| 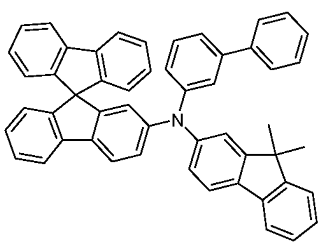 | 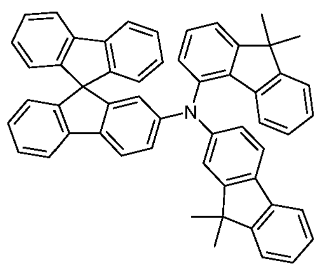 |
| HT-43 | HT-44 |

(fortgesetzt)

| | |
|---|---|
| 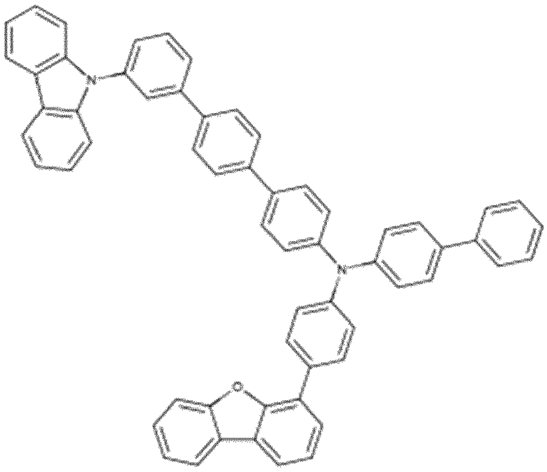 | 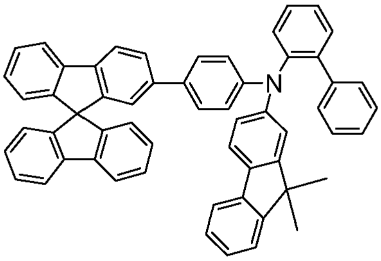 |
| HT-45 | HT-46 |
| 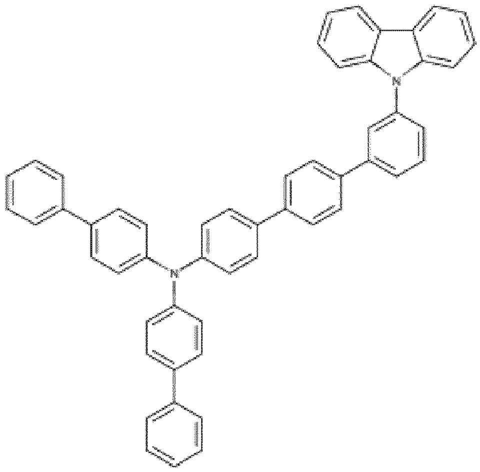 | 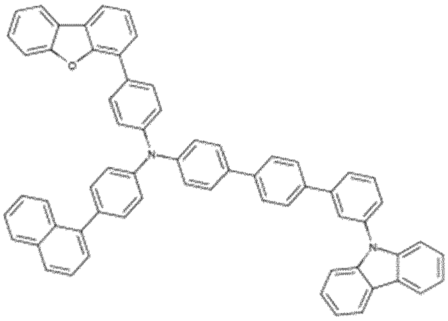 |
| HT-47 | HT-48 |
| 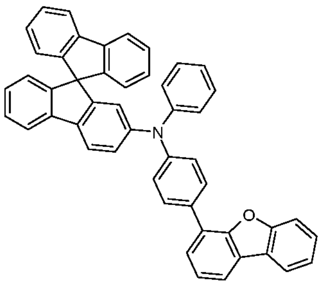 | 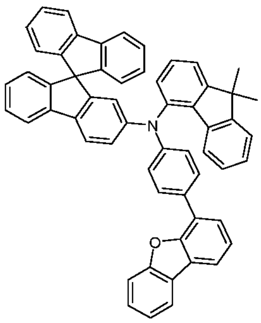 |
| HT-49 | HT-50 |

(fortgesetzt)

| | |
|---|---|
| 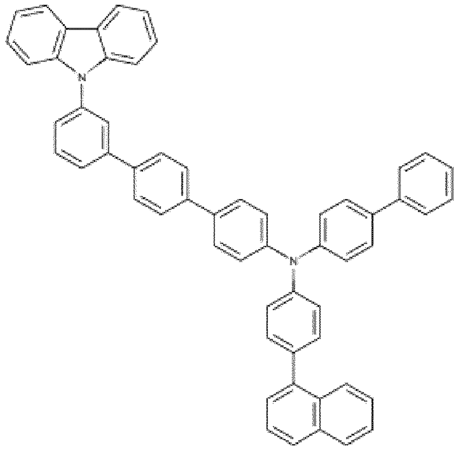 | 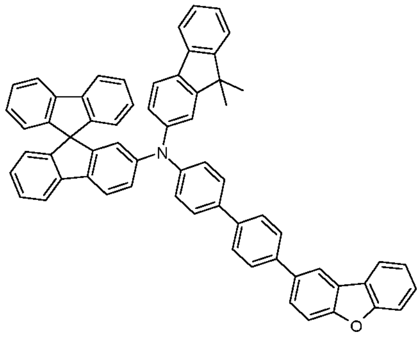 |
| HT-51 | HT-52 |
| 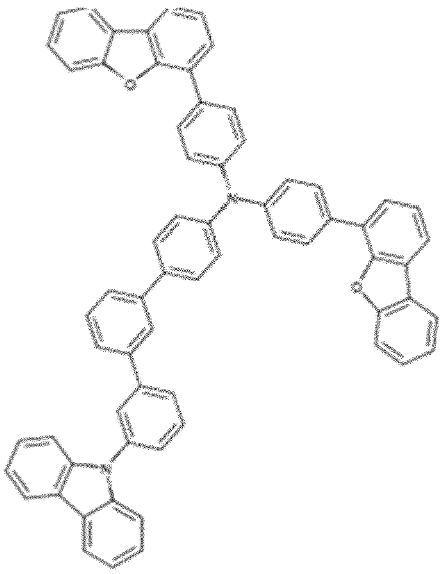 | 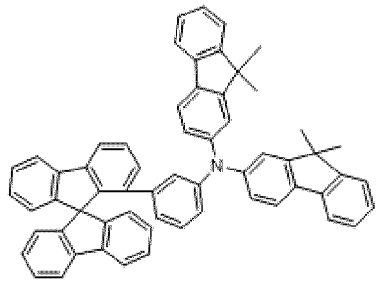 |
| HT-53 | HT-54 |
| 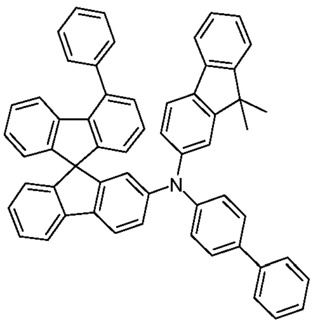 | 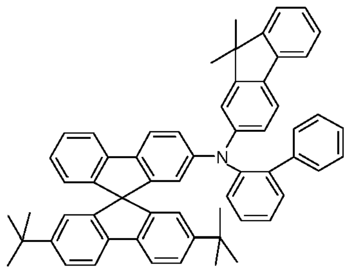 |
| HT-55 | HT-56 |

(fortgesetzt)

| | |
|---|---|
| 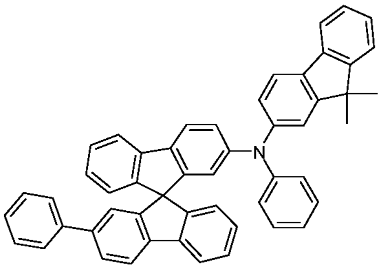 | 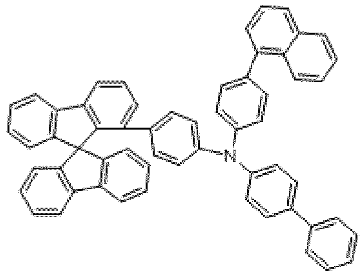 |
| HT-57 | HT-58 |
| 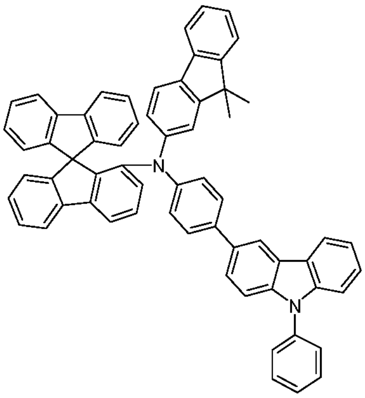 | 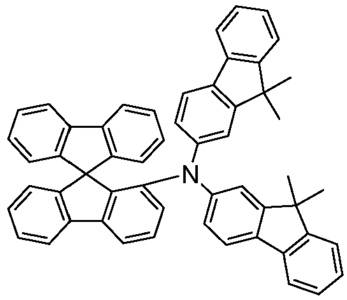 |
| HT-59 | HT-60 |
| 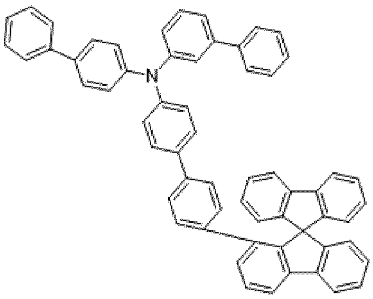 | 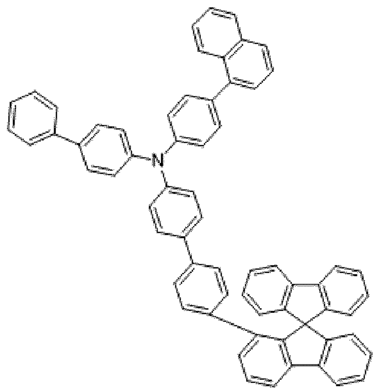 |
| HT-61 | HT-62 |
| 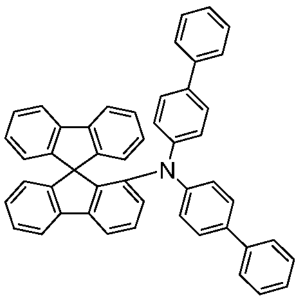 | 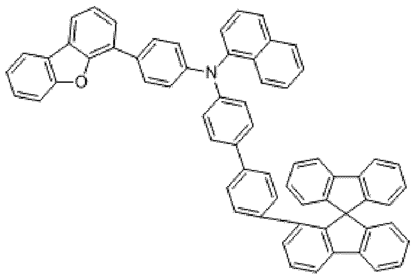 |
| HT-63 | HT-64 |

(fortgesetzt)

| | |
|---|---|
| 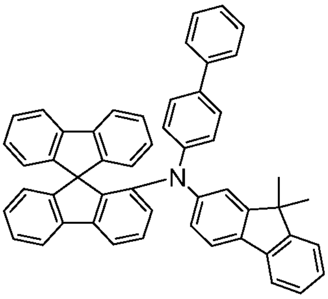 | 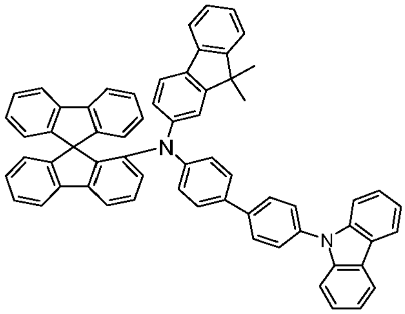 |
| HT-65 | HT-66 |
| 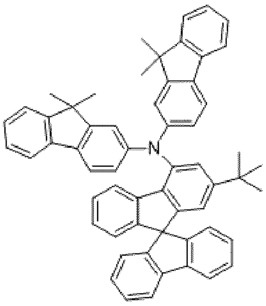 | 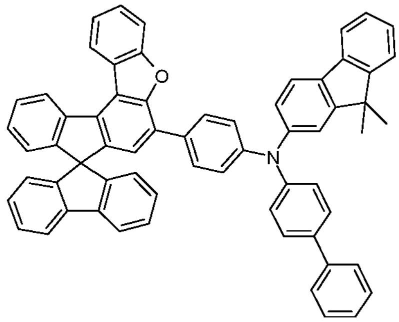 |
| HT-67 | HT-68 |
| 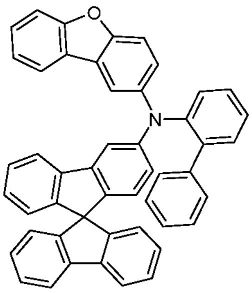 | 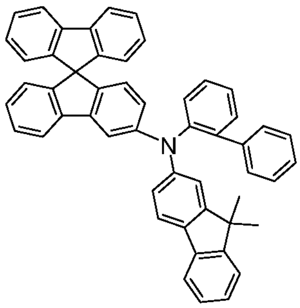 |
| HT-69 | HT-70 |
| 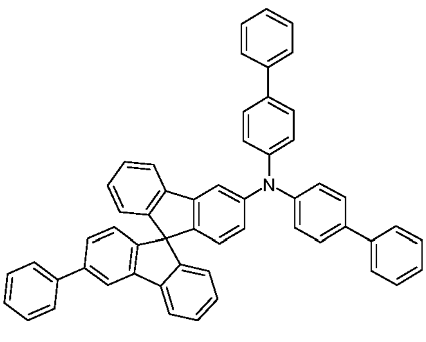 | 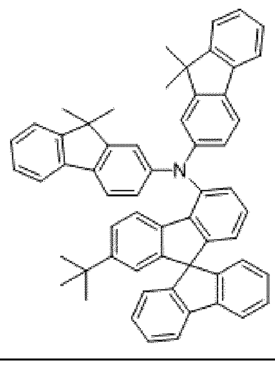 |
| HT-71 | HT-72 |

(fortgesetzt)

| | |
|---|---|
| 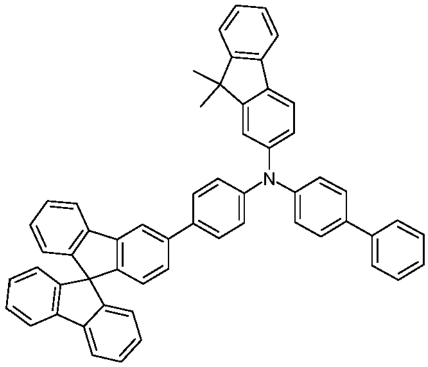 | 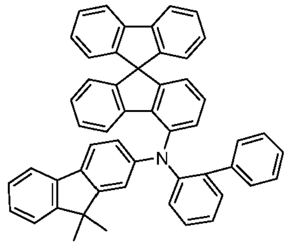 |
| HT-73 | HT-74 |
| 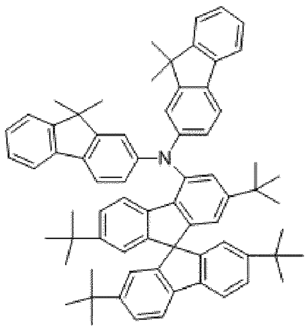 | 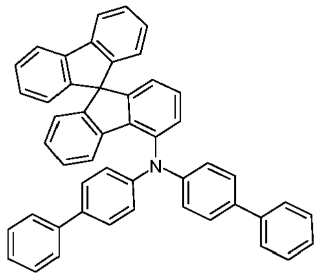 |
| HT-75 | HT-76 |
| 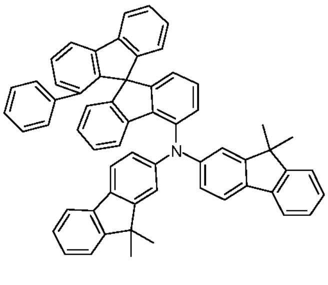 | 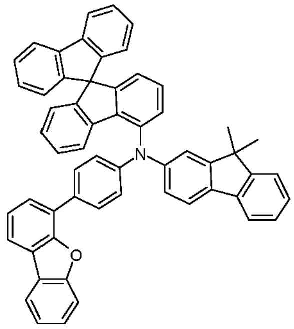 |
| HT-77 | HT-78 |
| 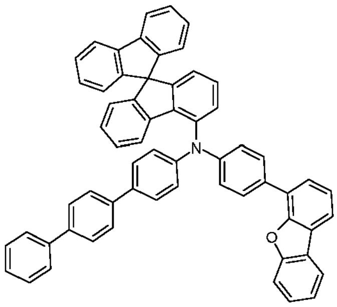 | 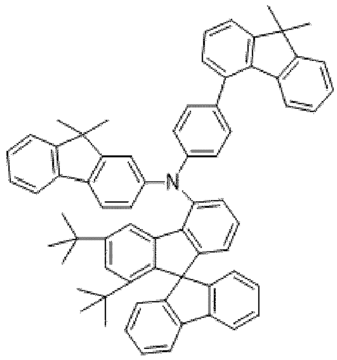 |
| HT-79 | HT-80 |

(fortgesetzt)

| | |
|---|---|
| 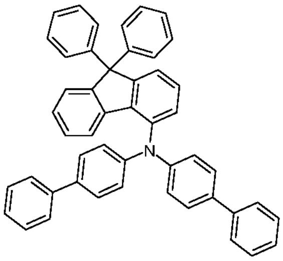 | 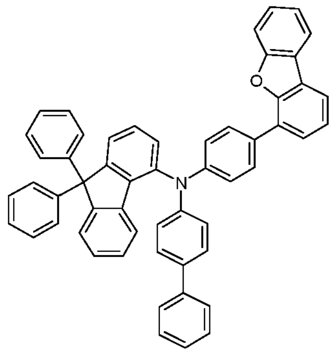 |
| HT-81 | HT-82 |
| 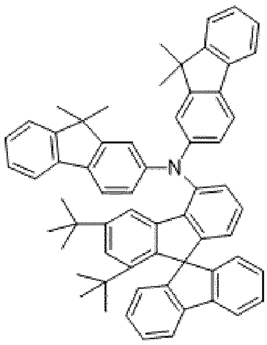 | 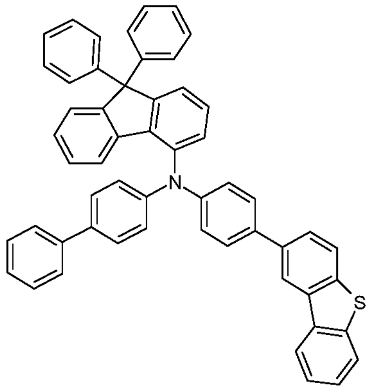 |
| HT-83 | HT-84 |
| 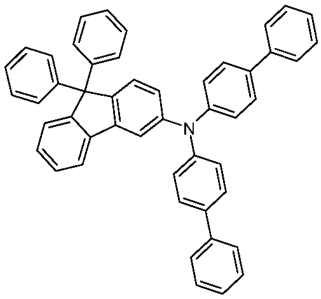 | 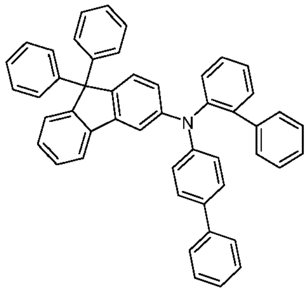 |
| HT-85 | HT-86 |
| 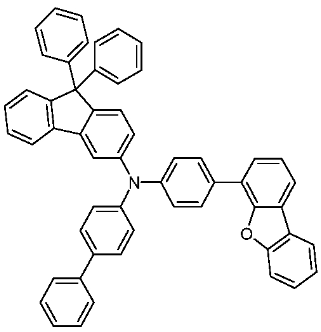 | 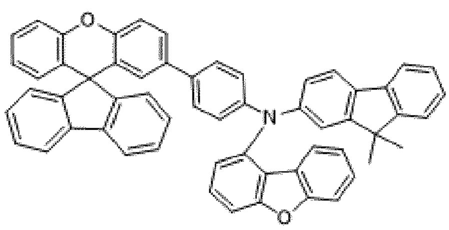 |
| HT-87 | HT-88 |

(fortgesetzt)

| | |
|---|---|
| 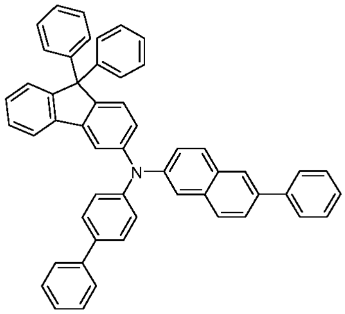 | 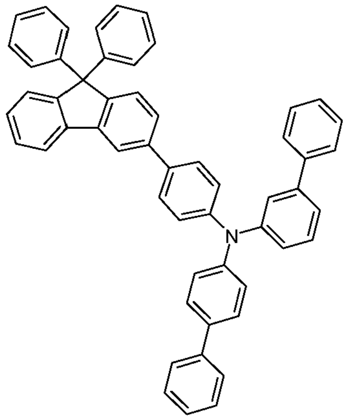 |
| HT-89 | HT-90 |
| 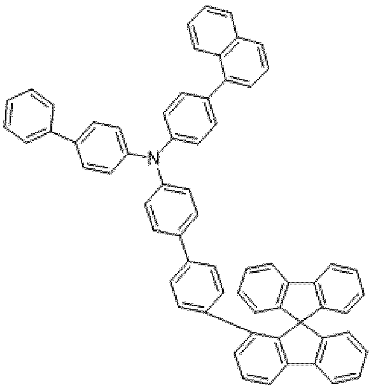 | 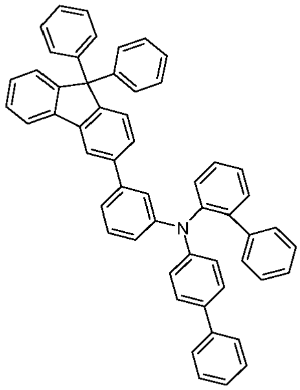 |
| HT-91 | HT-92 |
| 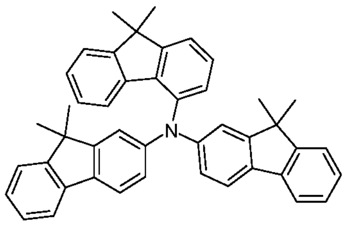 | 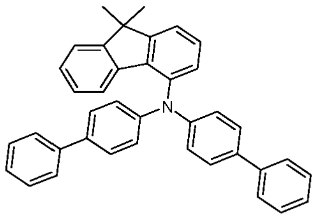 |
| HT-93 | HT-94 |
| 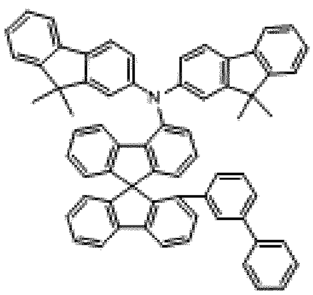 | 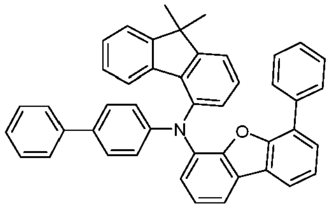 |
| HT-95 | HT-96 |

(fortgesetzt)

| | |
|---|---|
| 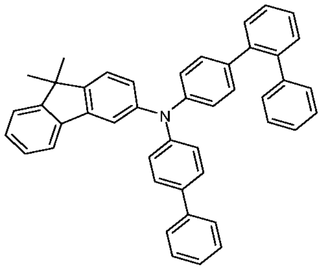 | 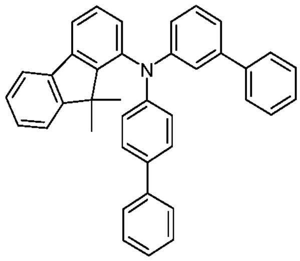 |
| HT-97 | HT-98 |
| 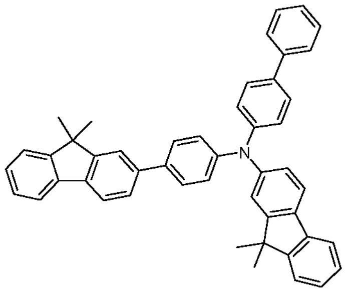 | 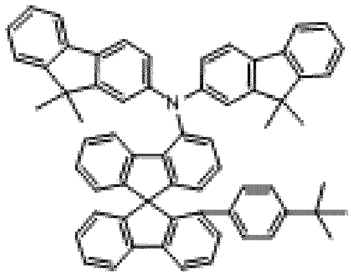 |
| HT-99 | HT-100 |
| 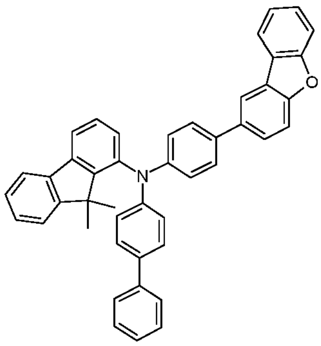 | 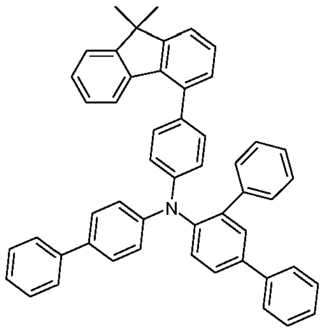 |
| HT-101 | HT-102 |
| 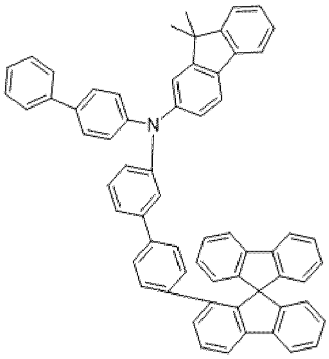 | 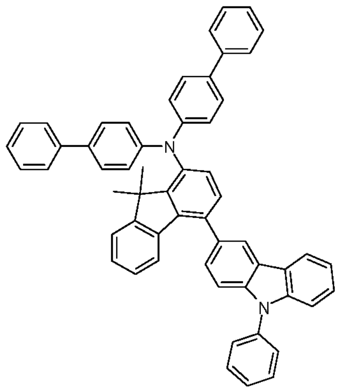 |
| HT-103 | HT-104 |

(fortgesetzt)

| | |
|---|---|
| 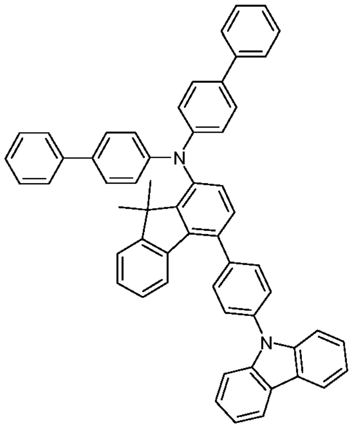 | 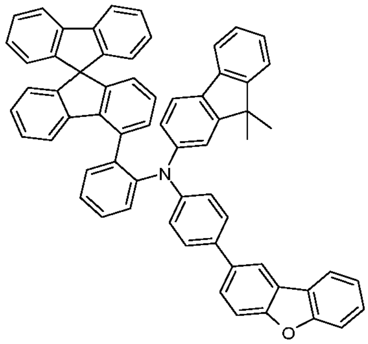 |
| HT-105 | HT-106 |
| 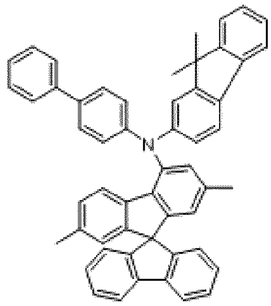 | 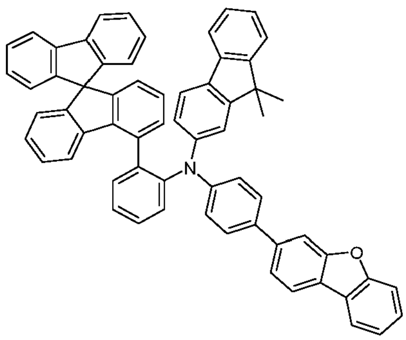 |
| HT-107 | HT-108 |
| 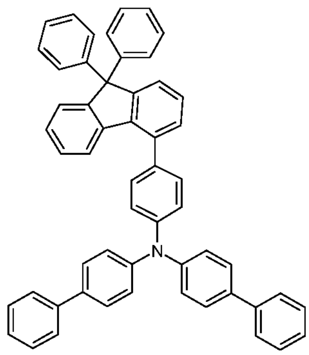 | 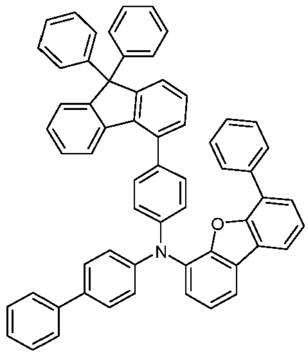 |
| HT-109 | HT-110 |

Die Abfolge der Schichten in der erfindungsgemäßen organischen Elektrolumineszenzvorrichtung ist bevorzugt die folgende:
Anode / Lochinjektionsschicht / Lochtransportschicht / emittierende Schicht / Elektronentransportschicht / Elektroneninjektionsschicht / Kathode.

Diese Abfolge der Schichten ist eine bevorzugte Abfolge.

Dabei soll erneut darauf hingewiesen werden, dass nicht alle der genannten Schichten vorhanden sein müssen, und/oder dass zusätzlich weitere Schichten vorhanden sein können.

Die erfindungsgemäße organische Elektrolumineszenzvorrichtung kann mehrere emittierende Schichten enthalten. Mindestens eine der emittierenden Schichten ist die erfindungsgemäße lichtemittierende Schicht enthaltend mindestens eine Verbindung der Formel (1) als Hostmaterial 1 und mindestens eine Verbindung der Formel (2) als Hostmaterial 2, wie zuvor beschrieben oder bevorzugt beschrieben. Besonders bevorzugt weisen diese Emissionsschichten in diesem Fall insgesamt mehrere Emissionsmaxima zwischen 380 nm und 750 nm auf, so dass insgesamt weiße Emission resultiert.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise $Alq_3$, Zirkoniumkomplexe, beispielsweise $Zrq_4$, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate.

Als Kathode der erfindungsgemäßen Vorrichtung eignen sich Metalle mit geringer Austrittsarbeit, Metalllegierungen oder mehrlagige Strukturen aus verschiedenen Metallen, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. $Al/Ni/NiO_X$, $Al/PtO_X$) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die erfindungsgemäße organische elektrolumineszierende Vorrichtung wird bei der Herstellung entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

Die Herstellung der erfindungsgemäßen Vorrichtung ist hierbei nicht eingeschränkt. Es ist möglich, dass eine oder mehrere organische Schichten, auch die lichtemittierende Schicht, mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Bevorzugt ist die erfindungsgemäße organische Elektrolumineszenzvorrichtung dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist die erfindungsgemäße organische Elektrolumineszenzvorrichtung dadurch gekennzeichnet, dass eine oder mehrere organische Schichten enthaltend die erfindungsgemäße Zusammensetzung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Hostmaterialien 1 und 2 und phosphoreszierende Emitter nötig. Das Verarbeiten aus Lösung hat den Vorteil, dass beispielsweise die lichtemittierende Schicht sehr einfach und kostengünstig aufgebracht werden kann. Diese Technik eignet sich insbesondere für die Massenproduktion organischer elektrolumineszierender Vorrichtungen.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können auf organische Elektrolumineszenzvorrichtungen angewandt werden.

Ein weiterer Gegenstand der Erfindung ist daher ein Verfahren zur Herstellung der erfindungsgemäßen organischen elektrolumineszierenden Vorrichtung, wie zuvor beschrieben oder bevorzugt beschrieben, dadurch gekennzeichnet, dass die organische Schicht, vorzugsweise die lichtemittierende Schicht, die Lochinjektionsschicht und/oder Lochtransportschicht, durch Gasphasenabscheidung, insbesondere mit einem Sublimationsverfahren und/oder mit einem OVPD (Organic Vapour Phase Deposition) Verfahren und/oder mit Hilfe einer Trägergassublimation, oder aus Lösung, insbesondere durch Spincoating oder mit einem Druckverfahren, aufgebracht wird.

Bei der Herstellung mittels Gasphasenabscheidung bestehen grundsätzlich zwei Möglichkeiten, wie die erfindungsgemäße organische Schicht, bevorzugt die lichtemittierende Schicht, auf ein beliebiges Substrat bzw. die vorherige Schicht aufgebracht bzw. aufgedampft werden kann. Zum einen können die verwendeten Materialien jeweils in einer Materialquelle vorgelegt und schließlich aus den verschiedenen Materialquellen verdampft werden ("co-evaporation"). Zum anderen können die verschiedenen Materialien vorgemischt ("premixed", Premix-Systeme) und das Gemisch in einer einzigen Materialquelle vorgelegt werden, aus der es schließlich verdampft wird ("premix-evaporation"). Dadurch lässt sich auf einfache und schnelle Art und Weise das Aufdampfen der lichtemittierenden Schicht mit gleichmäßiger Verteilung der Komponenten erreichen, ohne dass eine präzise Ansteuerung einer Vielzahl an Materialquellen notwendig ist.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1), wie zuvor beschrieben oder als bevorzugt beschrieben, und die mindestens eine Verbindung der Formel (2), wie zuvor beschrieben oder als bevorzugt beschrieben, nacheinander oder gleichzeitig aus mindestens zwei Materialquellen, gegebenenfalls mit dem mindestens einen phosphoreszierenden Emitter, wie zuvor beschrieben oder bevorzugt beschrieben, aus der Gasphase abgeschieden werden und die lichtemittierende Schicht bilden.

In einer bevorzugten Ausführungsform der vorliegenden Erfindung wird die lichtemittierende Schicht mittels Gasphasenabscheidung aufgebracht, wobei die Bestandeile der Zusammensetzung vorgemischt und aus einer einzigen Materialquelle verdampft werden.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1) und die mindestens eine Verbindung der Formel (2) als Mischung, nacheinander oder gleichzeitig mit dem mindestens einen phosphoreszierenden Emitter, aus der Gasphase abgeschieden werden und die lichtemittierende Schicht bilden.

Ein weiterer Gegenstand der Erfindung ist ein Verfahren zur Herstellung der erfindungsgemäßen Vorrichtung, wie zuvor beschrieben oder bevorzugt beschrieben, dadurch gekennzeichnet, dass die mindestens eine Verbindung der Formel (1) und die mindestens eine Verbindung der Formel (2), wie zuvor beschrieben oder bevorzugt beschrieben, zusammen mit dem mindestens einen phosphoreszierenden Emitter, aus Lösung aufgebracht werden, um die lichtemittierende Schicht zu bilden.

Die erfindungsgemäßen Vorrichtungen zeichnen sich durch folgende überraschende Vorteile gegenüber dem Stand der Technik aus:

Die Verwendung der beschriebenen Materialkombination der Hostmaterialien 1 und 2, wie zuvor beschrieben, führt insbesondere zu einer Steigerung der Lebensdauer der Vorrichtungen.

Es ist bekannt, dass die C-D-Bindung kürzer ist als die C-H-Bindung als Ergebnis der Anharmonizität des Bindungsdehnungspotentials ( M. L. Allinger und H. L. Flanagan, J. Computa nationale Chem. 1983, 4(3), 399). Das bedeutet, dass die chemische Bindung von Kohlenstoff mit Deuterium stärker, stabiler ist und langsamer reagiert als die chemische Kohlenstoff-Wasserstoff-Bindung. Bei Verwendung eines deuterierte organischen Systems im Vergleich zu dem nicht-deuterierten organischen System wird in der Regel eine bessere thermische Stabilität und eine längere Lebensdauer für die optoelektronische Vorrichtung erwartet. Der Ersatz labiler C-H-Bindungen durch C-D-Bindungen in einem organischen funktionalen Material erhöht die Lebensdauer der entsprechenden Vorrichtung in der Regel um den Faktor 1,5-3 ohne Verlust von Effizienz.

Wie im nachfolgend angegebenen Beispiel ersichtlich, lässt sich durch Vergleich der Daten für OLEDs mit Kombinationen aus dem Stand der Technik feststellen, dass die erfindungsgemäßen Kombinationen an Matrixmaterialien in der EML zu Vorrichtungen führen, deren Lebensdauer und/oder Leuchtkraft signifikant erhöht sind, unabhängig von der Emitterkonzentration, wobei der Fachmann eine solche Erhöhung der Lebensdauer nicht erwartet. Gleichzeitig sind die erfindungsgemäßen Vorrichtungen thermisch stabiler und die nicht erwünschte Nebenreaktion einer Carbazolbildung des Hostmaterials 2 durch Cyclisierungsreaktion in der lichtemittierenden Schicht während des Betriebs der Vorrichtung wird deutlich verringert.

Die Vorteile der Kombination der Hostmaterialien 1 und 2, wie zuvor beschrieben, begründen sich auch durch die spezielle strukturelle Auswahl dieser Hostmaterialien 1 und 2 aus dem Stand der Technik.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbarte Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte sich gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

## Beispiele

Allgemeine Methoden:

In allen quantenchemischen Berechnungen wird das Programmpaket Gaussian16 (Rev. B.01) verwendet. Der neutrale Singulettgrundzustand wird auf dem B3LYP/6-31G(d)-Niveau optimiert. HOMO- und LUMO-Werte werden auf dem B3LYP/6-31G(d)-Niveau für die mit B3LYP/6-31G(d) optimierte Grundzustandsenergie bestimmt. Daraufhin werden TD-DFT-Singulett- und Triplettanregungen (vertikale Anregungen) mit der gleichen Methode (B3LYP/6-31G(d)) und der optimierten Grundzustandsgeometrie berechnet. Die Standardeinstellungen für SCF- und Gradientenkonvergenz werden verwendet.

Aus der Energierechnung erhält man das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Daraus wird der anhand von Cyclovoltammetriemessungen kalibrierte HOMO- und LUMO-Wert in Elektronenvolt wie folgt bestimmt:

$$\text{HOMOcorr} = 0.90603 * \text{HOMO} - 0.84836$$

$$\text{LUMOcorr} = 0.99687 * \text{LUMO} - 0.72445$$

Das Triplett-Niveau T1 eines Materials ist definiert als die relative Anregungsenergie (in eV) des Triplettzustands mit der niedrigsten Energie, der sich aus der quantenchemischen Energierechnung ergibt.

Das Singulett-Niveau S1 eines Materials ist definiert als die relative Anregungsenergie (in eV) des Singulettzustands mit der zweitniedrigsten Energie, der sich aus der quantenchemischen Energierechnung ergibt.

Der energetisch niedrigste Singulettzustand wird als S0 bezeichnet.

Die hierin beschriebene Methode ist unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend wird zur Berechnung der Energien das Programmpaket "Gaussian16 (Rev. B.01)" verwendet.

## Synthesebeispiele

Die nachfolgenden Synthesen werden, sofern nicht anders angegeben, unter einer Schutzgasatmosphäre in getrockneten Lösungsmitteln durchgeführt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

Synthesebeispiel 1:

a) 2-Chloro-4,8-diphenyl-benzofuro[3,2-d]pyrimidin

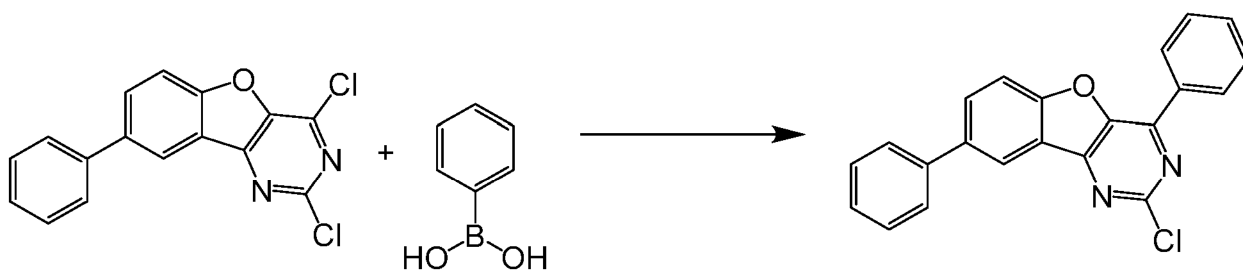

[1835207-37-8]

31,4 (100 mmol) 2,4-Dichloro-8-phenyl-benzofuro[3,2-d]pyrimidin,12,2 g (100 mmol) Phenyboronsäure und 11,8 g (111mmol) Natriumcarbonat werden in 800ml 1,4-Dioxan, 800 ml Wasser und 250ml Toluol gelöst und unter Argonatmosphaere gerührt. 1,2 g (1mmol) Tetrakis- (Triphenylphosphin)-Palladium wird dazugegeben. Das Reaktionsgemisch wird unter Rückfluss über Nacht gerührt. Nach dem Abkühlen wird das Gemisch gequenscht. Die organische Phase wird getrennt, mit 300 ml Wasser drei Mal gewaschen, über MgSO4 getrocknet, filtriert und das Lösungsmittel im Vakuum entfernt. Der Rückstand wird durch Säulenchromatographie über Kieselgel (Eluent: DCM/ Heptan (1:10) gereinigt. Die Ausbeute beträgt 28 g (80 mmol), entsprechend 80 % der Theorie.

Analog dazu werden die folgenden Verbindungen hergestellt:

| | Edukt 1 | Edukt 1 | Produkt | Ausbeute |
|---|---|---|---|---|
| 1a | 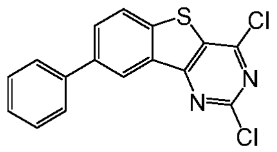 [2201127-92-4] | 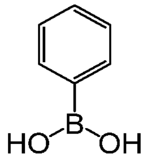 | 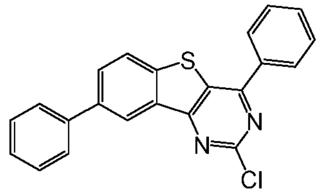 | 75% |
| 2a | 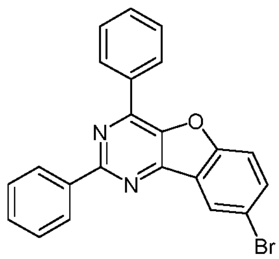 [2144459-61-8] | 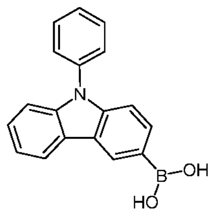 [854952-58-2] | 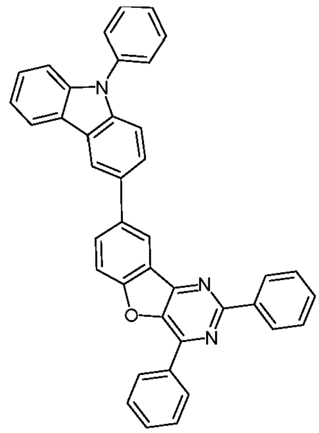 E6 | 73% |
| 3a | 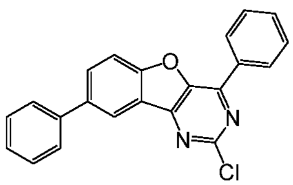 | 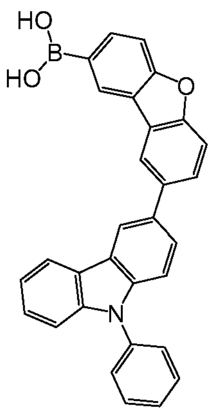 [1307793-69-6] | 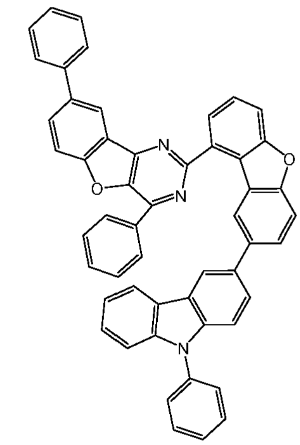 E8 | 77% |
| 4a | 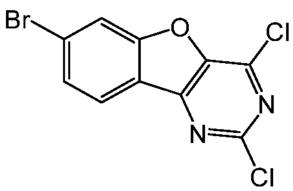 [2201128-38-1 ] | 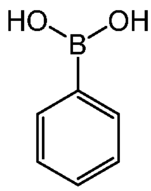 | 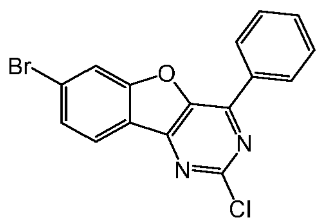 | 56% |

(fortgesetzt)

| | Edukt 1 | Edukt 1 | Produkt | Ausbeute |
|---|---|---|---|---|
| 5a | 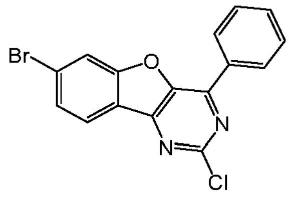 | 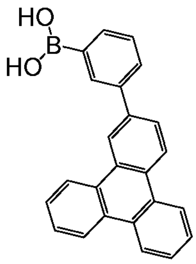<br>[1235876-72-8] | 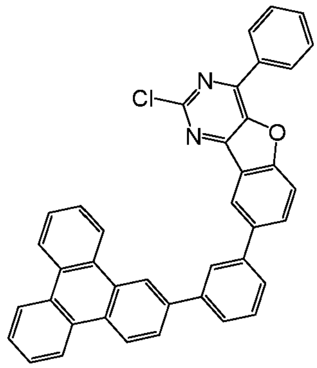 | 53% |
| **6a** | 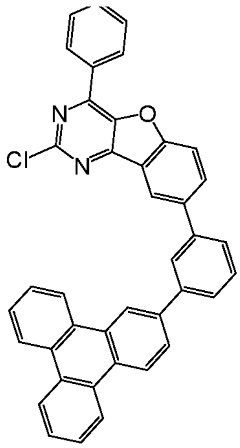 | 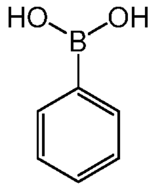 | 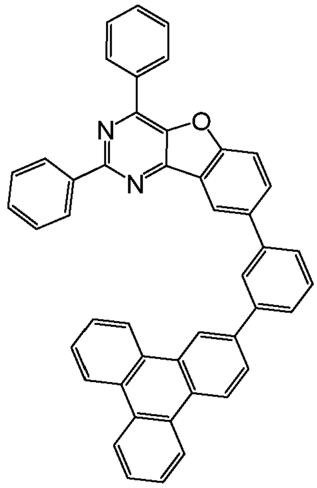<br>E14 | 74% |
| **7a** | 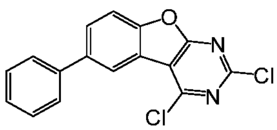<br>[2201128-33-6] | 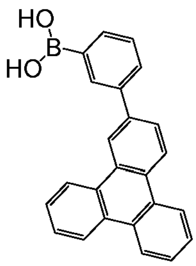<br>[1235876-72-8] | 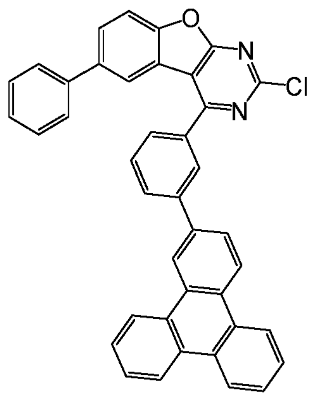 | 52% |
| **8a** | 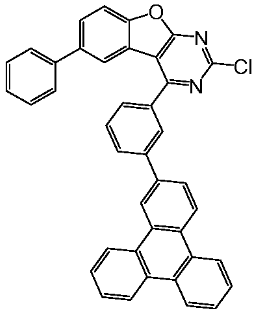 | 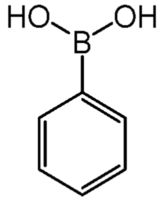 | 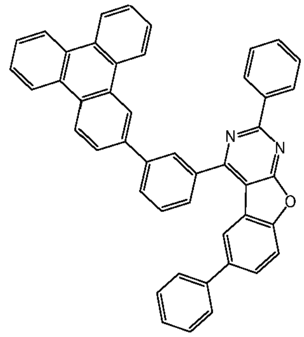<br>E18 | 68% |

(fortgesetzt)

| | Edukt 1 | Edukt 1 | Produkt | Ausbeute |
|---|---|---|---|---|
| 9a | 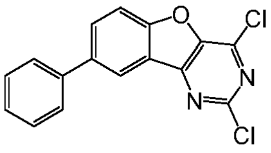 [1835207-37-8] | 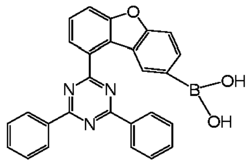 [2653325-65-4] | 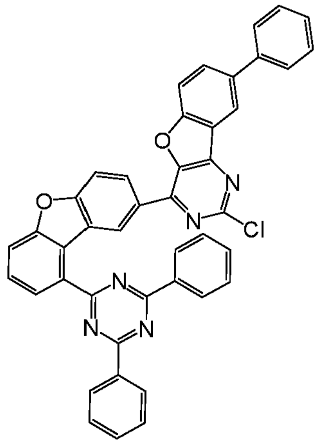 | 61% |
| 10a | 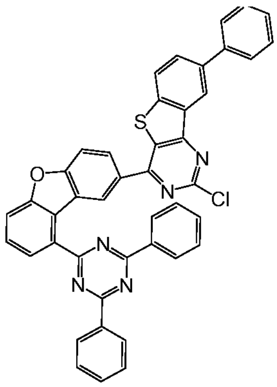 | 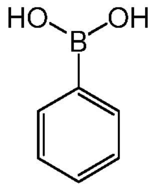 | 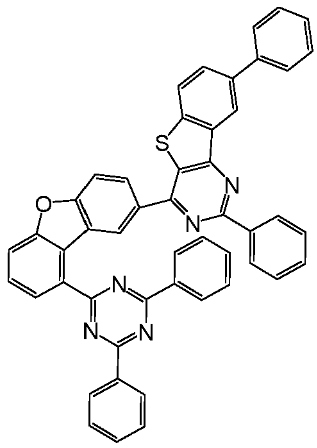 E37 | 65% |

**b) 2,4-Diphenyl-8-(3-phenyl-carbazol-9-yl)-benzo[4,5]furo[3,2-d]pyrimidin**

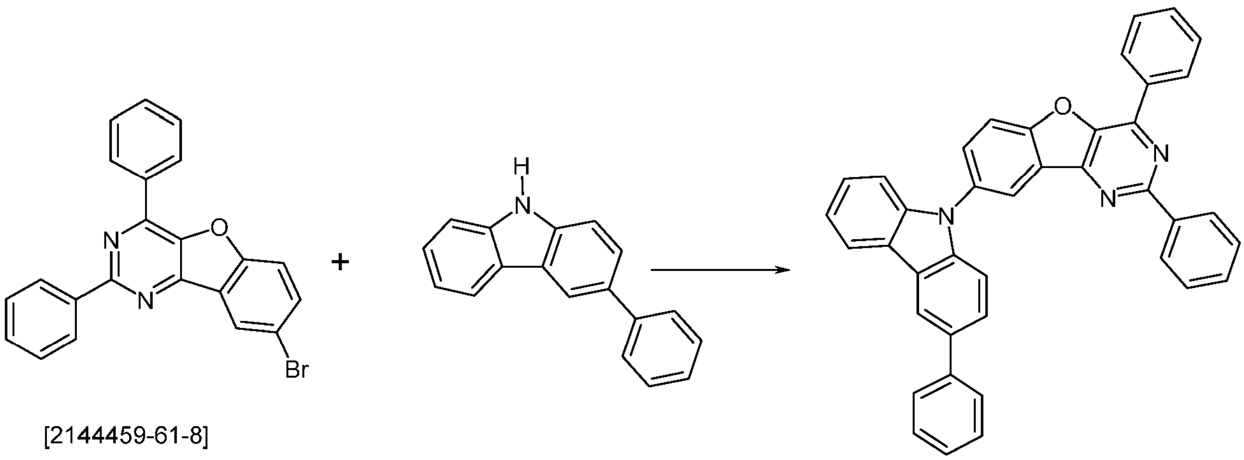

[2144459-61-8]

Eine entgaste Lösung von 59 g (147 mmol) 8-Bromo-2,4-diphenyl-benzo[4,5]furo[3,2-d]pyrimidin und 35,7 g (147 mmol) 3-Phenyl-9H-carbazol in 600 mL Toluol wird 1 h mit $N_2$ gesättigt. Danach wird die Lösung zuerst mit 2.09 mL (8.6 mmol) P(*t*Bu)$_3$, dann mit 1.38 g (6.1 mmol) Palladium(II)acetat versetzt und anschließend werden 17.7 g (185 mmol) NaOtBu im festen Zustand zugegeben. Die Reaktionsmischung wird 1 h unter Rückfluss erhitzt. Nach dem Abkühlen auf

Raumtemperatur werden vorsichtig 500 mL Wasser zugesetzt. Die wässrige Phase wird mit 3 x 50 mL Toluol gewaschen, über $MgSO_4$ getrocknet und das Lösungsmittel im Vakuum entfernt. Danach wird das Rohprodukt über Kieselgel mit Heptan/Essigsäureester (20/1) chromatographisch gereinigt. Der Rückstand wird aus Toluol umkristallisiert und abschließend im Hochvakuum ($p = 5 \times 10^{-6}$ mbar) sublimiert.

Die Ausbeute beträgt 68 g (120 mmol), entsprechend 82% der Theorie.

Analog können folgende Verbindungen erhalten werden:

| | Edukt 1 | Edukt 2 | Produkt | Ausbeute |
|---|---|---|---|---|
| 1b | 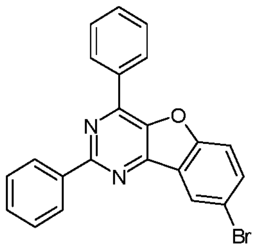 | 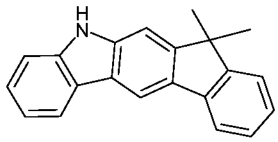 [1257220-47-5] | 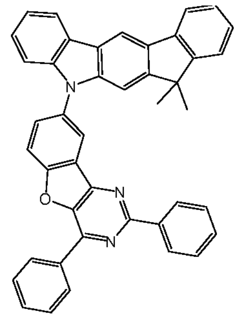 E1 | 87% |
| 2b | 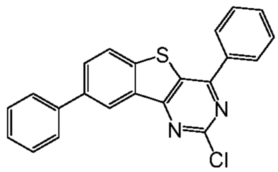 | 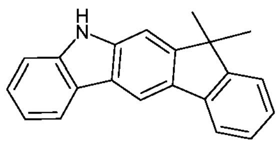 [1257220-47-5] | 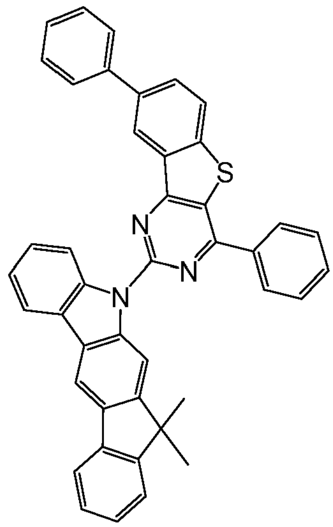 E2 | 81% |
| 3b | 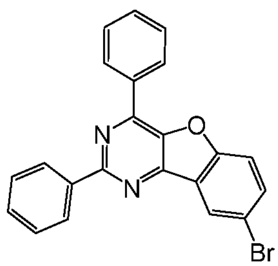 | 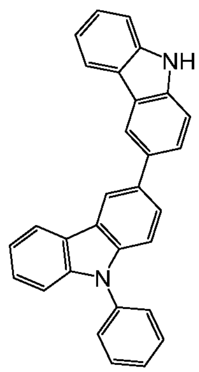 [13045202-03-0] | 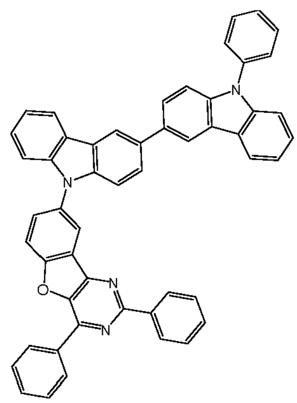 E11 | 72% |

Synthesebeispiel 2:

Allgemeine Deuterierung:

Die Ausgangsverbindung wird in einer Mischung aus deuteriertem Wasser (99% Deuteriumatom) und Toluol-d8 (99% Deuteriumatom) gelöst und 96 Stunden lang unter Druck in Gegenwart von trockenem Platin auf Kohle (5%) als Katalysator auf 160°C erhitzt. Nach dem Abkühlen des Reaktionsgemisches werden die Phasen getrennt und die wässrige Phase zweimal mit dem Tetrahydrofuran-Toluol-Gemisch extrahiert. Die rekombinierten organischen Phasen werden mit einer Natriumchloridlösung gewaschen, über Natriumsulfat getrocknet und filtriert. Das Lösungsmittel wird im Vakuum entfernt, um die rohe deuterierte Verbindung als Feststoff zu liefern. Die Verbindung wird durch Extraktion, Kristallisation und Sublimation weiter gereinigt.

**Beispiel A: 1,1',2',3',4',5',6,6',7',8,8'-Undecadeuterio-N-(2,3,6,7,8-pentadeuterio-9,9-dimethyl-fluoren-4-yl)-N-(3,4,6,7,8-pentadeuterio-9,9-dimethyl-fluoren-2-yl)-9,9'-spirobi[fluoren]-4-amin**

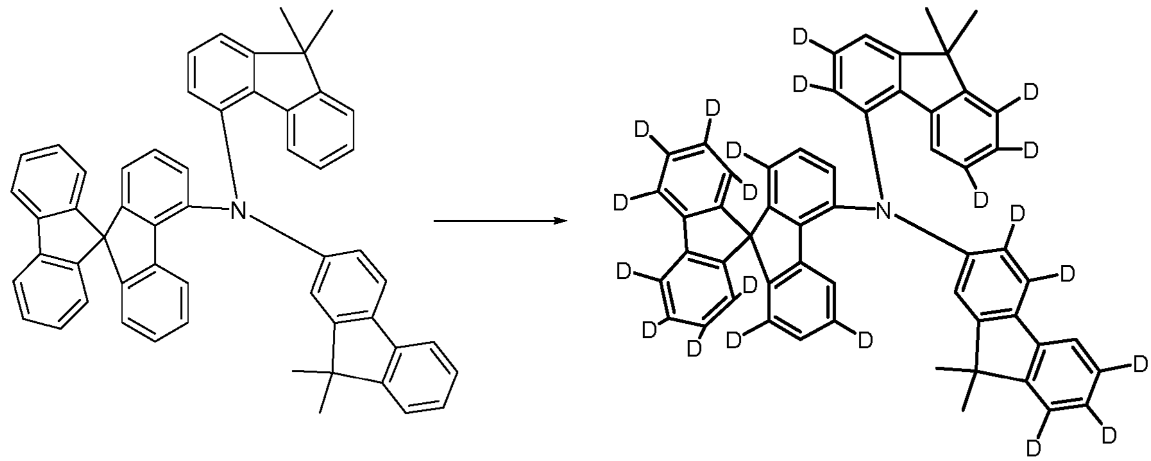

H5

Es wird N-(9,9-Dimethylfluoren-2-yl)-N-(9,9-dimethylfluoren-4-yl)-9,9'-spirobi[fluoren]-4'-amin (22,8 g, 32 mmol), Toluol-d8 (231 g, 2,31 mol) , deuteriertes Wasser (1300 g, 64,9 mol) und trockenes Platin auf Kohle (5%) (30 g) werden 24 h bei 130°C gerührt. Das Rohprodukt wird durch zweimaliges Extrahieren mit einer Mischung aus Heptan und Toluol (4:1) und zweimaliges Sublimieren weiter gereinigt.

Ausbeute: 21,2g (28 mmol, 90 %) mit einer Reinheit von > 99,9 %. Die Identität wird durch HPLC-MS und 1H-NMR bestätigt.

**Beispiel B: 1,2,3,5,6,7,8-Heptadeuterio-N-[1,2,3,5,6,7,8-heptadeuterio-9,9-bis(trideuteriomethyl)fluoren-4-yl]-9,9-bis(trideuteriomethyl)-N-[2,3,5-trideuterio-4-(2,3,4,5,6-pentadeuteriophenyl)phenyl]fluoren-4-amin**

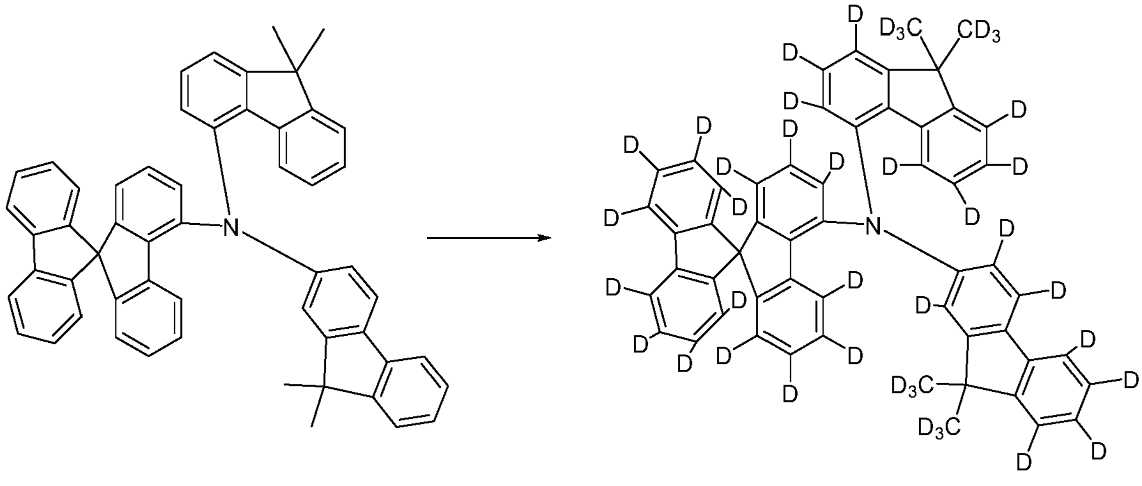

H2

Es wird N-(9,9-Dimethylfluoren-2-yl)-N-(9,9-dimethylfluoren-4-yl)-9,9'-spirobi[fluoren]-4'-amin (22.8 g, 31,8 mmol), Toluol-d8 (231 g, 2,31 mol) , deuteriertes Wasser (1300 g, 64,9 mol) und trockenes Platin auf Kohle (5%) (30 g) 96 h bei 160°C gerührt. Das Rohprodukt wird durch zweimaliges Extrahieren mit einer Mischung aus Heptan und Toluol (4:1) und zweimaliges Sublimieren weiter gereinigt.

Ausbeute: 21,9 g (28,9 mmol, 95 %) mit einer Reinheit von > 99,9 %. Die Identität wird durch HPLC-MS bestätigt.

Analog dazu können die folgenden Verbindungen hergestellt werden: Die Ausbeute liegt in allen Fällen zwischen 40% und 90%.

| | Edukt | Produkt |
|---|---|---|
| 1 | 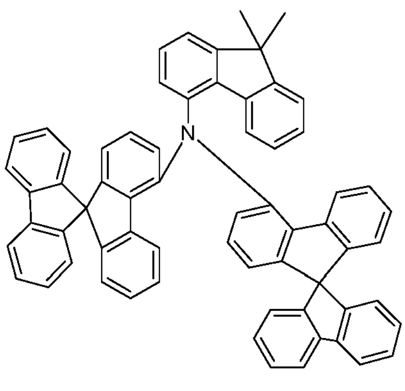 | 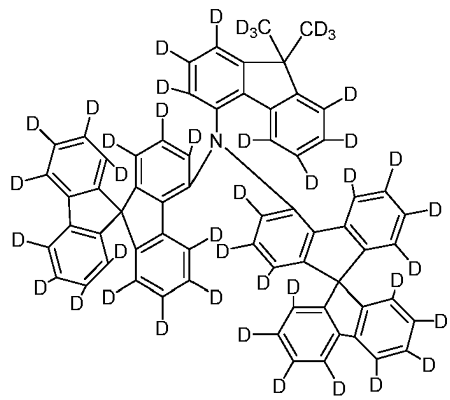 H1 |
| 2 | 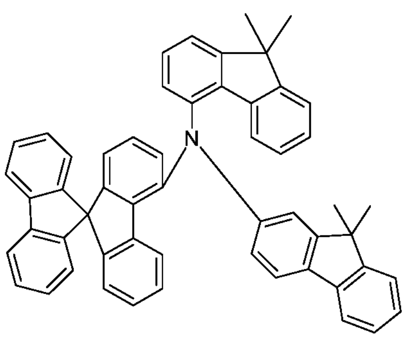 | 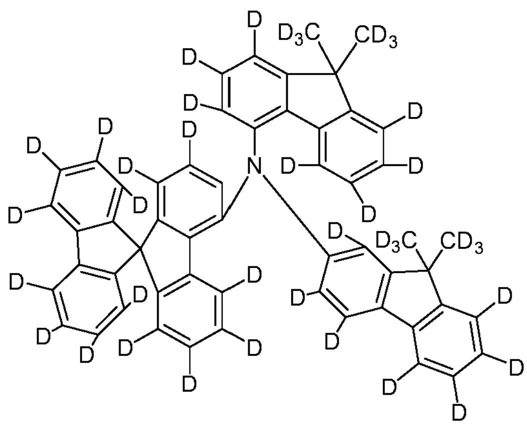 H3 |

(fortgesetzt)

| | Edukt | Produkt |
|---|---|---|
| 3 | 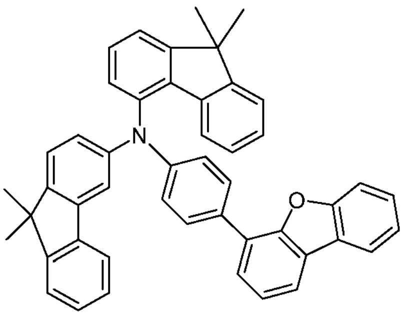 | 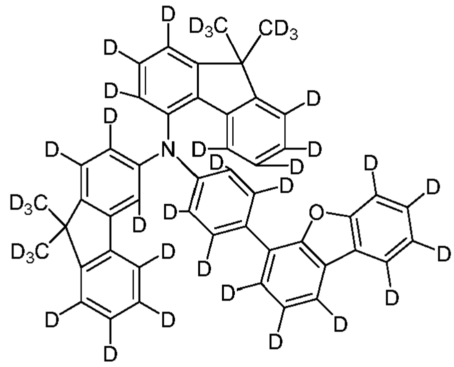 H4 |
| 4 | 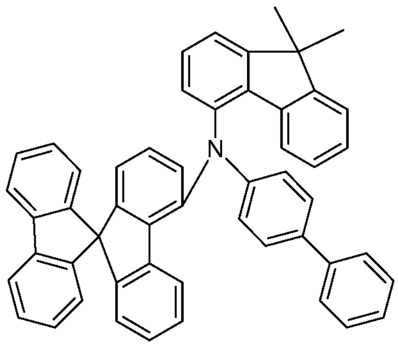 | 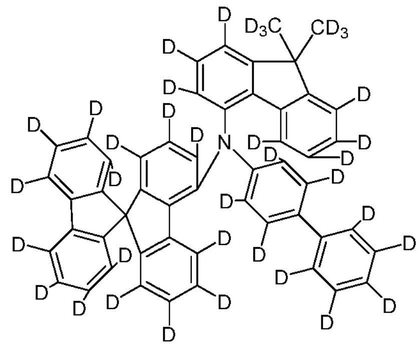 |
| 5 | 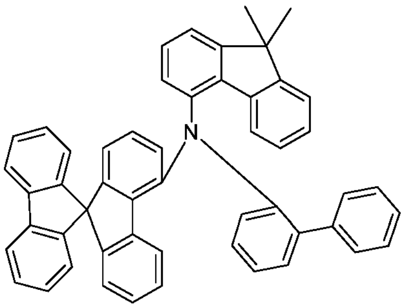 | 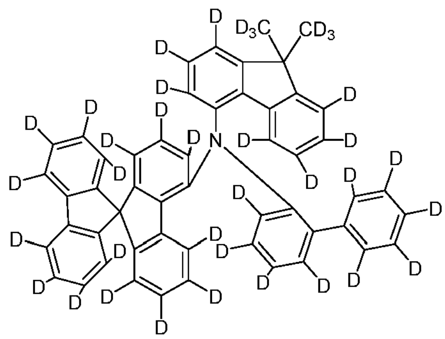 H6 |
| 6 | 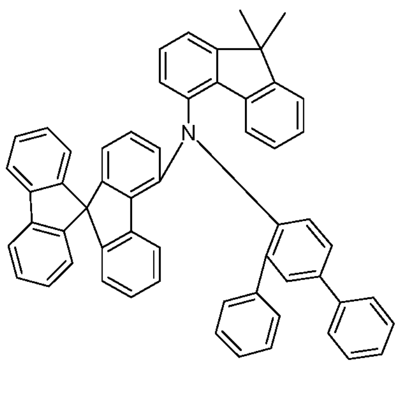 | 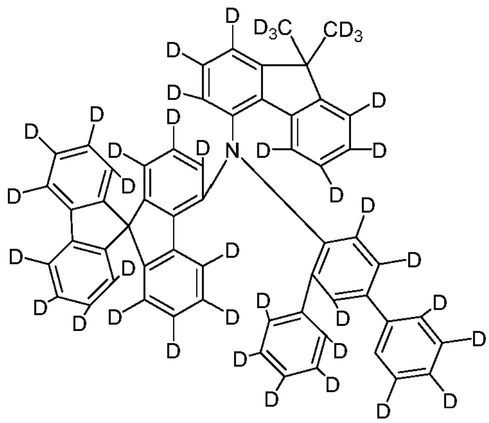 H7 |

(fortgesetzt)

| | Edukt | Produkt |
|---|---|---|
| 7 | 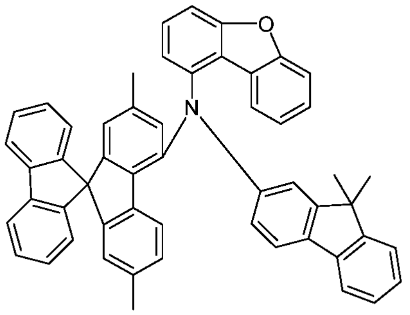 | 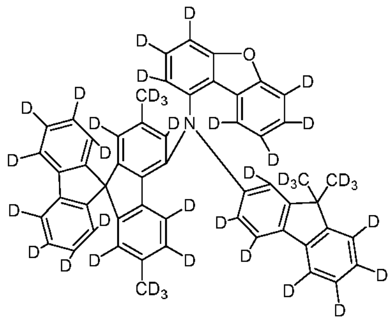 H9 |
| 8 | 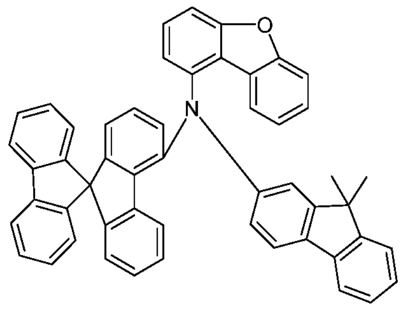 | 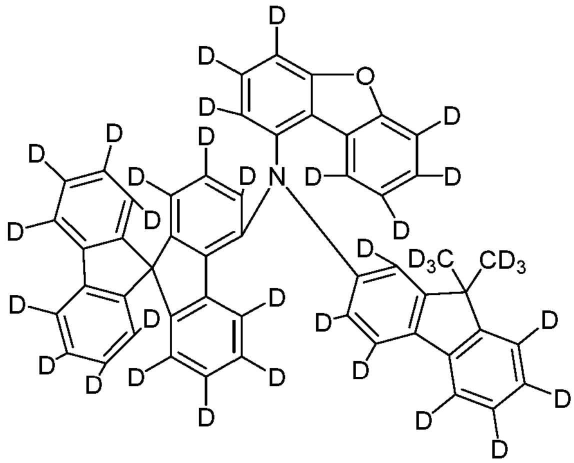 H10 |
| 9 | 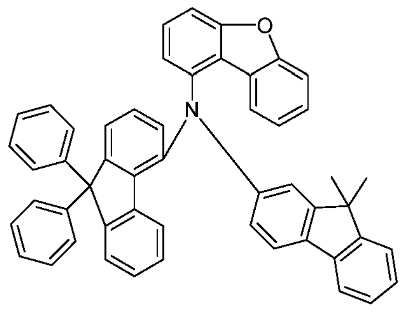 | 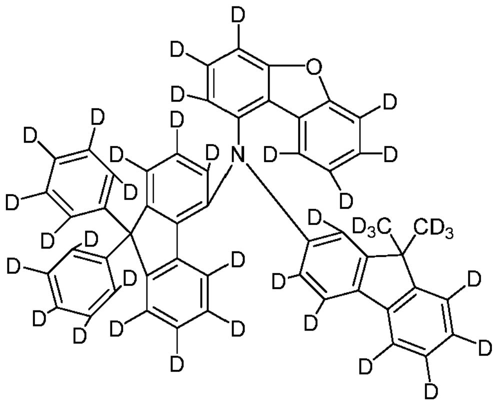 H11 |

(fortgesetzt)

| | Edukt | Produkt |
|---|---|---|
| 10 | 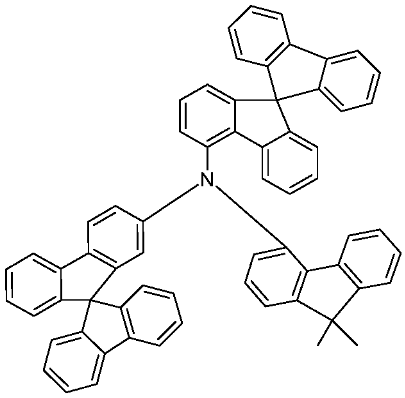 | 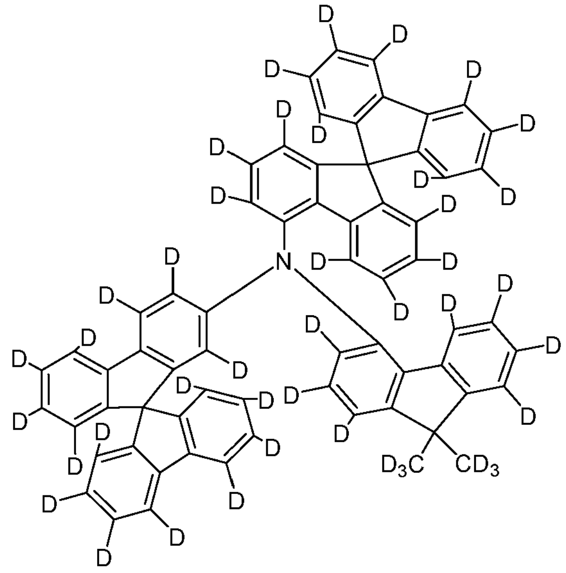<br>H14 |
| 11 | 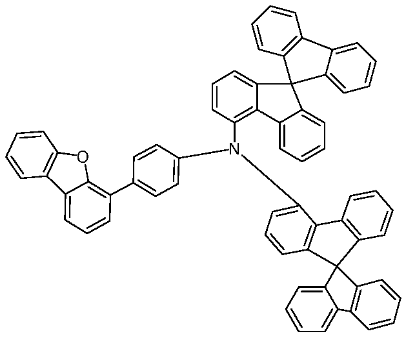 | 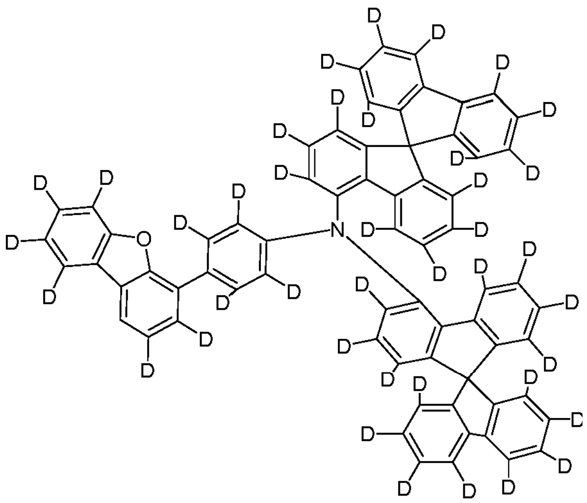<br>H15 |
| 12 | 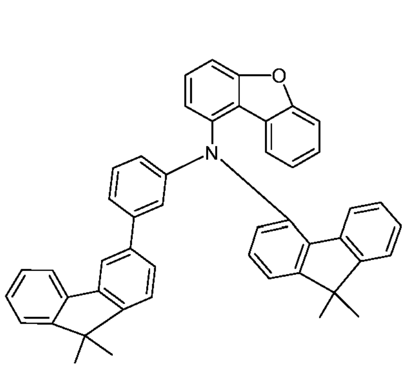 | 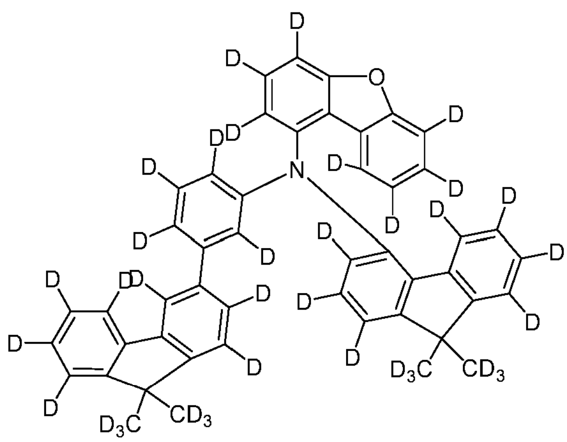 |

## Herstellung der OLEDs

In den folgenden Beispielen V1, V2 und V3 und B1 bis B17 (siehe Tabellen 8 und 9) werden die Daten verschiedener OLEDs vorgestellt.

**Vorbehandlung für die Beispiele V1-V3 und B1-B17:** Glasplättchen, die mit strukturiertem ITO (Indium Zinn Oxid) der Dicke 50 nm beschichtet sind, werden vor der Beschichtung mit einem Sauerstoffplasma, gefolgt von einem Argonplasma, behandelt. Diese mit Plasma behandelten Glasplättchen bilden die Substrate, auf welche die OLEDs aufgebracht werden.

Die OLEDs haben prinzipiell folgenden Schichtaufbau: Substrat / Lochinjektionsschicht (HIL) / Lochtransportschicht (HTL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 8 zu entnehmen. Die zur Herstellung der OLEDs benötigten Materialien sind in Tabelle 10 gezeigt, sofern nicht zuvor beschrieben.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie E14:SdT1:TEG1 (32%:60%:8%) bedeutet hierbei, dass das Material E14 in einem Volumenanteil von 32%, das Material SdT1 in einem Anteil von 60% und der Emitter TEG1 in einem Anteil von 8% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Spannung und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 9 bezeichnet hierbei die Spannung, die für eine Leuchtdichte von 1000 cd/$m^2$ benötigt wird. SE1000 bezeichnet die Stromeffizienz, die bei 1000 cd/$m^2$ erreicht wird. EQE1000 schließlich bezeichnet die externe Quanteneffizienz bei einer Betriebsleuchtdichte von 1000 cd/$m^2$. Als Lebensdauer LD wird die Zeit definiert, nach der die Leuchtdichte bei Betrieb mit konstanter Stromdichte $j_0$ von der Startleuchtdichte auf einen gewissen Anteil L1 absinkt. Eine Angabe L1=80% in Tabelle 9 bedeutet, dass die in Spalte LD angegebene Lebensdauer der Zeit entspricht, nach der die Leuchtdichte auf 80% ihres Anfangswertes absinkt.

Die Daten der verschiedenen OLEDs sind in Tabelle 9 zusammengefasst. Die Beispiele V1 bis V3 sind Vergleichsbeispiele gemäß Stand der Technik, die Beispiele B1-B17 zeigen Daten von erfindungsgemäßen OLEDs.

Im Folgenden werden einige der Beispiele näher erläutert, um die Vorteile der erfindungsgemäßen OLEDs zu verdeutlichen.

## Verwendung von erfindungsgemäßen Mischungen in der Emissionsschicht phosphoreszenter OLEDs

Die erfindungsgemäßen Materialien ergeben beim Einsatz als Matrixmaterial in Kombination mit deuteriertem Monoamin in der Emissionsschicht (EML) in phosphoreszierenden OLEDs wesentliche Verbesserungen gegenüber dem Stand der Technik, vor allem bezüglich der Lebensdauer und der externen Quanteneffizienz der OLEDs. Durch Einsatz der erfindungsgemäßen Materialkombinationen lässt sich eine Verbesserung der EQE um ca. 5-10% gegenüber den Verbindungen aus dem Stand der Technik SdT1, und Steigerung der Lebensdauer um 30-100% beobachten (Vergleich der Beispiele V1 mit Beispiel B1, Vergleich von V2 mit B5 und Vergleich V3 mit B10).

Tabelle 8: Aufbau der OLEDs

| Bsp. | HIL Dicke | HTL Dicke | EBL Dicke | EML Dicke | HBL Dicke | ETL Dicke | EIL Dicke |
|---|---|---|---|---|---|---|---|
| V1 | SpMA1 :PD1 (95%: 5%) 20nm | SpMA1 230nm | SpMA3 20nm | **E14:SdT1:**TEG1 (32%:60%:8%) 40nm | ST2 5nm | ST2:Li Q (50%:5 0%) 40nm | LiQ 1nm |
| B1 | SpMA1 :PD1 (95%: 5%) 20nm | SpMA1 230nm | SpMA3 20nm | **E14:H5:**TEG1 (32%:60%:8%) 40nm | ST2 5nm | ST2:Li Q (50%:5 0%) 40nm | LiQ 1nm |

(fortgesetzt)

| Bsp. | HIL Dicke | HTL Dicke | EBL Dicke | EML Dicke | HBL Dicke | ETL Dicke | EIL Dicke |
|---|---|---|---|---|---|---|---|
| B2 | SpMA1 :PD1 (95%: 5%) 20nm | SpMA1 230nm | SpMA3 20nm | **E14:**H2:TEG1 (32%:60%:8%) 40nm | ST2 5nm | ST2:Li Q (50%:5 0%) 40nm | LiQ 1nm |
| B3 | SpMA1 :PD1 (95%: 5%) 20nm | SpMA1 230nm | SpMA3 20nm | **E14:H1:TEG2** (32%:60%:8%) 40nm | ST2 5nm | ST2:Li Q (50%:5 0%) 40nm | LiQ 1nm |
| B4 | SpMA1 :PD1 (95%: 5%) 20nm | SpMA1 230nm | SpMA3 20nm | **E14:H1:**TEG1 (32%:60%:8%) 40nm | ST2 5nm | ST2:Li Q (50%:5 0%) 40nm | LiQ 1nm |
| V2 | SpMA1 :PD1 (95%: 5%) 20nm | SpMA1 230nm | SpMA3 20nm | **E37:SdT1:**TEG1 (32%:60%:8%) 40nm | ST2 5nm | ST2:Li Q (50%:5 0%) 40nm | LiQ 1nm |
| B5 | SpMA1 :PD1 (95%: 5%) 20nm | SpMA1 230nm | SpMA3 20nm | **E37**:H5:TEG1 (32%:60%:8%) 40nm | ST2 5nm | ST2:Li Q (50%:5 0%) 40nm | LiQ 1nm |
| B6 | SpMA1 :PD1 (95%: 5%) 20nm | SpMA1 230nm | SpMA3 20nm | **E37**:H2:TEG1 (32%:60%:8%) 40nm | ST2 5nm | ST2:Li Q (50%:5 0%) 40nm | LiQ 1nm |
| B7 | SpMA1 :PD1 (95%: 5%) 20nm | SpMA1 230nm | SpMA3 20nm | **E37**:H2:**TEG2** (32%:60%:8%) 40nm | ST2 5nm | ST2:Li Q (50%:5 0%) 40nm | LiQ 1nm |
| B8 | SpMA1 :PD1 (95%: 5%) 20nm | SpMA1 230nm | SpMA3 20nm | **E37:H1**:TEG1 (32%:60%:8%) 40nm | ST2 5nm | ST2:Li Q (50%:5 0%) 40nm | LiQ 1nm |
| B9 | SpMA1 :PD1 (95%: 5%) 20nm | SpMA1 230nm | SpMA3 20nm | **E1:** H2:TEG1 (32%:60%:8%) 40nm | ST2 5nm | ST2: Li Q (50%:5 0%) 40nm | LiQ 1nm |
| V3 | SpMA1 :PD1 (95%: 5%) 20nm | SpMA1 230nm | SpMA3 20nm | **E2:SdT2:** TEG1 (32%:60%:8%) 40nm | ST2 5nm | ST2: Li Q (50%:5 0%) 40nm | LiQ 1nm |
| B10 | SpMA1 :PD1 (95%: 5%) 20nm | SpMA1 230nm | SpMA3 20nm | **E2: H4:**TEG1 (32%:60%:8%) 40nm | ST2 5nm | ST2: Li Q (50%:5 0%) 40nm | LiQ 1nm |
| B11 | SpMA1 :PD1 (95%: 5%) 20nm | SpMA1 240nm | SpMA3 20nm | **E3: H10:**TEG1 (32%:60%:8%) 40nm | ST2 5nm | ST2: Li Q (50%:50%) 40nm | LiQ 1nm |
| B12 | SpMA1 :PD1 (95%: 5%) 20nm | SpMA1 230nm | SpMA3 20nm | **E8: H11**:TEG1 (32%:60%:8%) 40nm | ST2 5nm | ST2: Li Q (50%:5 0%) 40nm | LiQ 1nm |
| B13 | SpMA1 :PD1 (95%: 5%) 20nm | SpMA1 230nm | SpMA3 20nm | **E15:** H2:TEG1 (32%:60%:8%) 40nm | ST2 5nm | ST2: Li Q (50%:5 0%) 40nm | LiQ 1nm |
| B14 | SpMA1 :PD1 (95%: 5%) 20nm | SpMA1 240nm | SpMA3 20nm | **E16:** H2:TEG1 (32%:60%:8%) 40nm | ST2 5nm | ST2: Li Q (50%:5 0%) 40nm | LiQ 1nm |
| B15 | SpMA1 :PD1 (95%: 5%) 20nm | SpMA1 240nm | SpMA3 20nm | **E25:** H2:TEG1 (32%:60%:8%) 40nm | ST2 5nm | ST2: Li Q (50%:5 0%) 40nm | LiQ 1nm |

(fortgesetzt)

| Bsp. | HIL Dicke | HTL Dicke | EBL Dicke | EML Dicke | HBL Dicke | ETL Dicke | EIL Dicke |
|---|---|---|---|---|---|---|---|
| B16 | SpMA1 :PD1 (95%: 5%) 20nm | SpMA1 240nm | SpMA3 20nm | **E34:** H2:TEG1 (32%:60%:8%) 40nm | ST2 5nm | ST2: Li Q (50%:5 0%) 40nm | LiQ 1nm |
| B17 | SpMA1 :PD1 (95%: 5%) 20nm | SpMA1 240nm | SpMA3 20nm | **E38:** H2:TEG1 (32%:60%:8%) 40nm | ST2 5nm | ST2: Li Q (50%:5 0%) 40nm | LiQ 1nm |

Tabelle 9: Daten der OLEDs

| Bsp. | U1000 (V) | EQE1000 (%) | CIE x/y bei 1000 cd/m$^2$ | $j_0$ (mA/cm$^2$) | L1 (%) | LD (h) |
|---|---|---|---|---|---|---|
| | | | | | | |
| V1 | 4.2 | 19.4 | 0.33/0.63 | 40 | 80 | 510 |
| B1 | 4.1 | 21.7 | 0.34/0.62 | 40 | 80 | 765 |
| B2 | 4.0 | 22.3 | 0.35/0.63 | 40 | 80 | 1021 |
| B3 | 4.0 | 18.9 | 0.34/0.63 | 40 | 80 | 980 |
| B4 | 4.1 | 22.7 | 0.35/0.63 | 40 | 80 | 997 |
| V2 | 4.2 | 19.9 | 0.34/0.63 | 40 | 80 | 443 |
| B5 | 4.3 | 24.1 | 0.35/0.63 | 40 | 80 | 769 |
| B6 | 4.1 | 25.3 | 0.34/0.63 | 40 | 80 | 980 |
| B7 | 4.0 | 20.6 | 0.33/0.63 | 40 | 80 | 992 |
| B8 | 4.0 | 23.5 | 0.34/0.63 | 40 | 80 | 879 |
| B9 | 4.2 | 23.4 | 0.35/0.63 | 40 | 80 | 917 |
| V3 | 4.8 | 19.4 | 0.33/0.62 | 40 | 80 | 430 |
| B10 | 4.1 | 22.1 | 0.34/0.63 | 40 | 80 | 887 |
| B11 | 4.2 | 22.3 | 0.34/0.62 | 40 | 80 | 921 |
| B12 | 4.2 | 23.0 | 0.34/0.62 | 40 | 80 | 977 |
| B13 | 4.0 | 23.3 | 0.34/0.63 | 40 | 80 | 968 |
| B14 | 4.1 | 22.1 | 0.35/0.62 | 40 | 80 | 895 |
| B15 | 4.1 | 23.2 | 0.33/0.63 | 40 | 80 | 947 |
| B16 | 4.1 | 23.2 | 0.33/0.63 | 40 | 80 | 929 |
| B17 | 4.1 | 23.2 | 0.33/0.63 | 40 | 80 | 938 |

Tabelle 10: Strukturformeln der Materialien für die OLEDs, die noch nicht zuvor erwähnt wurden

| | |
|---|---|
| 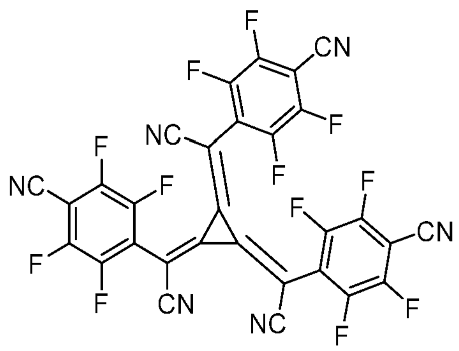 | 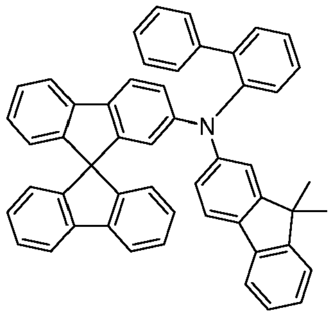 |

(fortgesetzt)

| PD1 | SpMA1 |
|---|---|
| 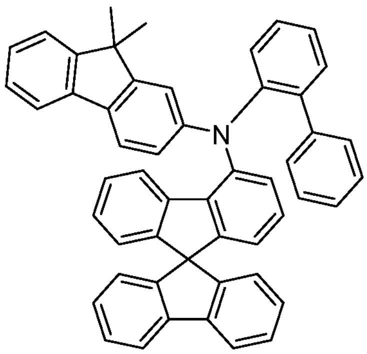 | 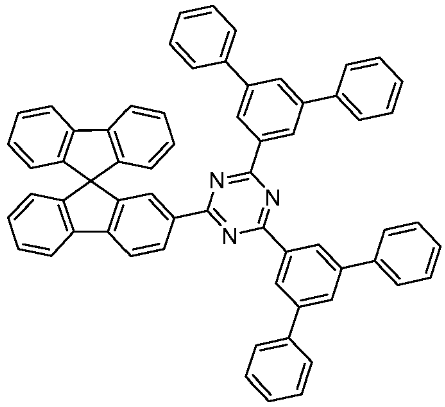 |
| SpMA3 | ST2 |
| 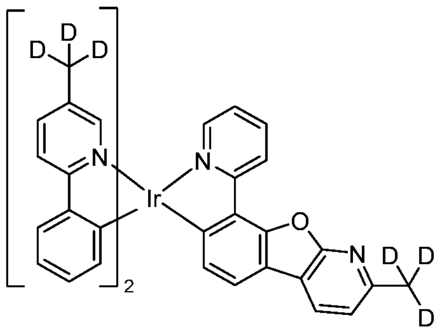 | 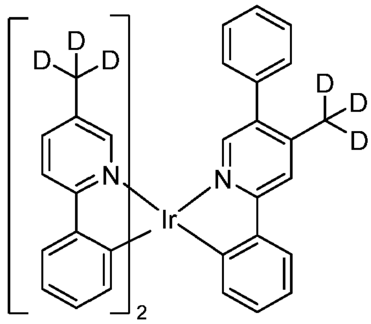 |
| TEG1 | TEG2 |
| 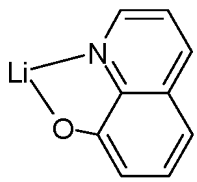 | 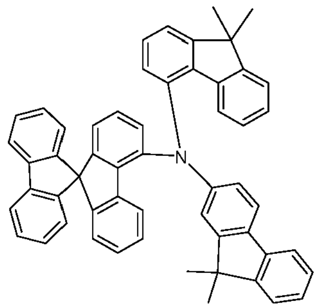 2647462-04-0 |
| LiQ | SdT1 (WO2021107728 ) |
| 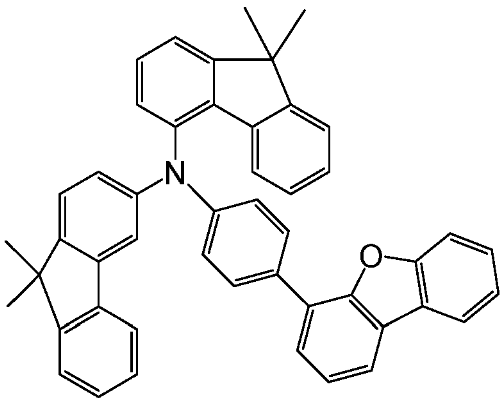 2378358-05-3 | |

(fortgesetzt)

| SdT2 (WO2019192954) | |
|---|---|

## Patentansprüche

**1.** Organische elektrolumineszierende Vorrichtung umfassend eine Anode, eine Kathode und mindestens eine organische Schicht, enthaltend mindestens eine lichtemittierende Schicht, wobei die mindestens eine lichtemittierende Schicht mindestens eine Verbindung der Formel (1) als Hostmaterial 1 und mindestens eine Verbindung der Formel (2) als Hostmaterial 2 enthält,

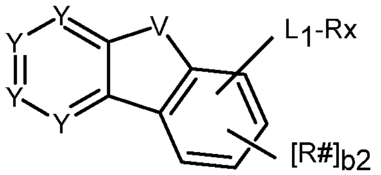

Formel (1),

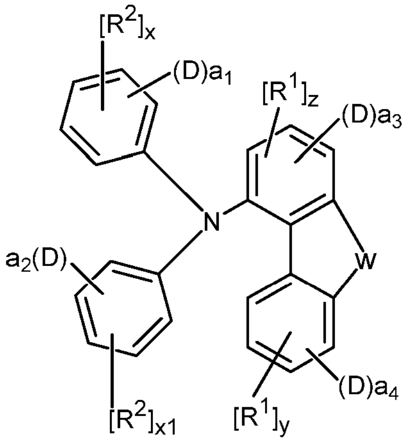

Formel (2),

wobei für die verwendeten Symbole und Indizes gilt:

Y ist bei jedem Auftreten unabhängig voneinander N, $[L]_b$-$Ar_2$ oder $[L]_{b1}$-$Ar_3$, wobei genau zwei Y für N stehen, die durch mindestens eine Gruppe $[L]_b$-$Ar_2$ oder $[L]_{b1}$-$Ar_3$ getrennt sind;
V ist O oder S;
$L_1$ ist eine Einfachbindung oder ein aromatisches oder heteroaromatisches Ringsystem mit 5 bis 30 Ringatomen, das teilweise oder vollständig deuteriert sein kann;
Rx ist F, Cl, Br, I, CN, $NO_2$, eine geradkettigen Alkyl-, Alkoxy- oder Thioalkylgruppe mit 1 bis 40 C-Atomen oder eine verzweigte oder cyclische Alkyl-, Alkoxy- oder Thioalkylgruppe mit 3 bis 40 C-Atomen oder einer Alkenyloder Alkinylgruppe mit 2 bis 40 C-Atomen, die jeweils mit einem oder mehreren Resten $R^3$ substituiert sein kann, wobei ein oder mehrere H-Atome durch D, F, Cl, Br, I, CN oder $NO_2$ ersetzt sein können, ein aromatisches oder heteroaromatisches Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme;
b, b1 sind jeweils unabhängig voneinander 0 oder 1;
b2 ist 0, 1, 2 oder 3;
L ist bei jedem Auftreten gleich oder verschieden ein aromatisches oder heteroaromatisches Ringsystem mit 5 bis 30 Ringatomen, das teilweise oder vollständig deuteriert sein kann;
R# ist D, F oder eine Arylgruppe mit 6 bis 20 C-Atomen, die mit einem oder mehreren Resten $R^3$ substituiert sein kann;
$Ar_2$, $Ar_3$ sind bei jedem Auftreten gleich oder verschieden ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann;

W ist O, S, $C(R)_2$;

R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Rinasvstem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;

$Ar_1$ ist bei jedem Auftreten gleich oder verschieden ein aromatisches oder heteroaromatisches Ringsystem mit 5 bis 30 Ringatomen, das mit einem oder mehreren Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$R^1$ ist bei jedem Auftreten gleich oder verschieden ausgewählt aus der Gruppe bestehend aus F, Cl, Br, I, CN, $NO_2$, $P(=O)(Ar_1)_2$, $P(Ar_1)_2$, $B(Ar_1)_2$ $Si(Ar_1)_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, wobei eine oder mehrere nicht-benachbarte $CH_2$-Gruppen durch C=S, SO, $SO_2$, O oder S ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann. wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einer geradkettigen Alkylgruppe mit 1 bis 20 C-Atomen oder einer verzweigten oder cyclischen Alkylgruppe mit 3 bis 20 C-Atomen, wobei eine oder mehrere nicht-benachbarte $CH_2$-Gruppen durch O oder S ersetzt sein können und wobei ein oder mehrere H-Atome durch D, F, oder CN ersetzt sein können oder einem aromatischen oder heteroaromatischen Ringsystem mit 5 bis 30 Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;

a3 ist 0, 1, 2 oder 3;

a4 ist 0, 1, 2, 3 oder 4; und

a1+a2+a3+a4 ist 3, 4, 5, 6, 7, 8, 9, 10, 11, 12, 13, 14, 15, 16 oder 17.

2. Organische elektrolumineszierende Vorrichtung nach Anspruch 1, **dadurch gekennzeichnet, dass** das Hostmaterial 1 einer der Formeln (1a), (1b) oder (1c) entspricht,

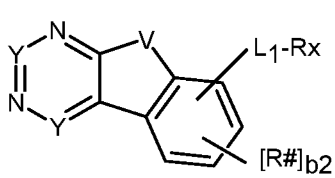

Formel (1a) ,

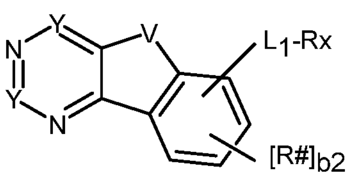

Formel (1b) ,

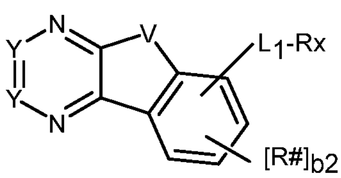

Formel (1c) ,

wobei die verwendeten Symbole Y, V und $L_1$-Rx eine Bedeutung wie in Anspruch 1 haben.

3. Organische elektrolumineszierende Vorrichtung nach Anspruch 1 oder 2, **dadurch gekennzeichnet, dass** das Hostmaterial 2 der Formel (3) entspricht,

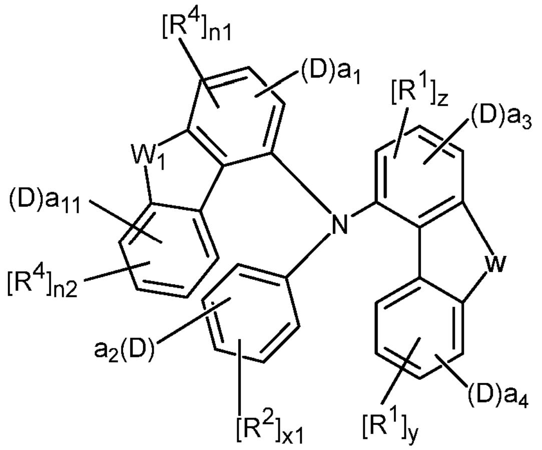

Formel (3),

wobei W, R1, R2, a1, a2, a3, a4, x, y und z eine in Anspruch 1 angegebene Bedeutung haben und für die verwendeten Symbole und Indizes gilt:

$W_1$ ist O, S oder $C(R)_2$, wobei R eine in Anspruch 1 angegebene Bedeutung hat;
$R^4$ ist bei jedem Auftreten gleich oder verschieden ausgewählt aus der Gruppe bestehend aus F, Cl, Br, I, C(=O)$Ar_1$, C(=O)H, C(=O)$R^3$, P(=O)$(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, die jeweils mit einem oder mehreren Resten $R^3$ substituiert sein kann,
wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, C=$NR^3$, P(=O)($R^3$), SO, $SO_2$, NH, $NR^3$, O, S, CONH oder $CONR^3$ ersetzt sein können und wobei ein oder mehrere H-Atome durch D, F, Cl, Br oder I ersetzt sein können, einem aromatischen oder heteroaromatischen Ringsystem mit 5 bis 60 Ringatomen, das jeweils mit einem oder mehreren Resten $R^3$ substituiert sein kann, wobei optional zwei oder mehr benachbarte Substituenten $R^4$ ein monocyclisches oder polycyclisches, aliphatisches, aromatisches oder heteroaromatisches Ringsystem bilden können,
das mit einem oder mehreren Resten $R^3$ substituiert sein kann, mit der Bedingung,
dass $R^4$ und daran gebundene Substituenten keine Carbazolgruppe enthalten;
$a_{11}$ ist 0, 1, 2, 3 oder 4;
n1 ist 0, 1 oder 2; und
n2 ist 0, 1, 2, 3 oder 4.

4. Organische elektrolumineszierende Vorrichtung nach einem oder mehreren der Ansprüche 1 bis 3, **dadurch gekennzeichnet, dass** im Hostmaterial 1, Rx ein aromatisches oder heteroaromatisches Ringsystem mit 5 bis 60 Ringatomen bedeutet, das jeweils mit einem oder mehreren Resten $R^3$ substituiert sein kann.

5. Organische elektrolumineszierende Vorrichtung nach einem oder mehreren der Ansprüche 1 bis 4, **dadurch gekennzeichnet, dass** das Hostmaterial 2 vollständig deuteriert ist.

6. Organische elektrolumineszierende Vorrichtung nach einem oder mehreren der Ansprüche 1 bis 5, **dadurch gekennzeichnet, dass** es sich um eine Elektrolumineszenzvorrichtung handelt, die ausgewählt ist aus den organischen lichtemittierenden Transistoren (OLETs), organischen Feld-Quench-Devices (OFQDs), organischen lichtemittierenden elektrochemischen Zellen (OLECs, LECs, LEECs), organischen Laserdioden (O-Laser) und den organischen lichtemittierenden Dioden (OLEDs).

7. Organische elektrolumineszierende Vorrichtung nach einem oder mehreren der Ansprüche 1 bis 6, **dadurch gekennzeichnet, dass** diese neben der Lichtemittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL) enthält.

**8.** Organische elektrolumineszierende Vorrichtung nach einem oder mehreren der Ansprüche 1 bis 7, **dadurch gekennzeichnet, dass** die lichtemittierende Schicht neben dem mindestens einen Hostmaterial 1 und dem mindestens einen Hostmaterial 2 mindestens einen phosphoreszierenden Emitter enthält.

**9.** Verfahren zur Herstellung einer Vorrichtung nach einem oder mehreren der Ansprüche 1 bis 8, **dadurch gekennzeichnet, dass** die lichtemittierende Schicht durch Gasphasenabscheidung oder aus Lösung aufgebracht wird.

**10.** Verfahren nach Anspruch 9, **dadurch gekennzeichnet, dass** die mindestens eine Verbindung der Formel (1) und die mindestens eine Verbindung der Formel (2), nacheinander oder gleichzeitig aus mindestens zwei Materialquellen, gegebenenfalls mit dem mindestens einen phosphoreszierenden Emitter, aus der Gasphase abgeschieden werden und die lichtemittierende Schicht bilden.

**11.** Verfahren nach Anspruch 9, **dadurch gekennzeichnet, dass** die mindestens eine Verbindung der Formel (1) und die mindestens eine Verbindung der Formel (2) als Mischung, nacheinander oder gleichzeitig mit dem mindestens einen phosphoreszierenden Emitter, aus der Gasphase abgeschieden werden und die lichtemittierende Schicht bilden.

**12.** Verfahren nach Anspruch 9, **dadurch gekennzeichnet, dass** die mindestens eine Verbindung der Formel (1) und die mindestens eine Verbindung der Formel (2) zusammen mit dem mindestens einen phosphoreszierenden Emitter, aus einer Lösung aufgebracht werden, um die lichtemittierende Schicht zu bilden.

**13.** Mischung enthaltend mindestens eine Verbindung der Formel (1) als Hostmaterial 1 und mindestens eine Verbindung der Formel (2) als Hostmaterial 2,

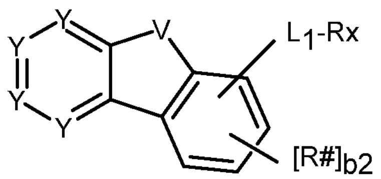

Formel (1),

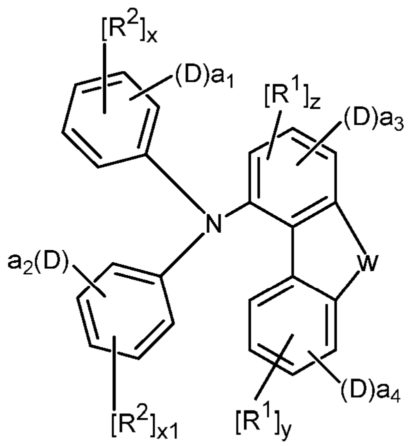

Formel (2),

wobei für die verwendeten Symbole und Indizes gilt:

Y ist bei jedem Auftreten unabhängig voneinander N, $[L]_b$-$Ar_2$ oder $[L]_{b1}$-$Ar_3$, wobei genau zwei Y für N stehen, die durch mindestens eine Gruppe $[L]_b$-$Ar_2$ oder $[L]_{b1}$-$Ar_3$ getrennt sind;
V ist O oder S;
$L_1$ ist eine Einfachbindung oder ein aromatisches oder heteroaromatisches Ringsystem mit 5 bis 30 Ringatomen, das teilweise oder vollständig deuteriert sein kann;
Rx ist F, Cl, Br, I, CN, $NO_2$, eine geradkettigen Alkyl-, Alkoxy- oder Thioalkylgruppe mit 1 bis 40 C-Atomen oder eine verzweigte oder cyclische Alkyl-, Alkoxy- oder Thioalkylgruppe mit 3 bis 40 C-Atomen oder einer Alkenyloder Alkinylgruppe mit 2 bis 40 C-Atomen, die jeweils mit einem oder mehreren Resten $R^3$ substituiert sein kann, wobei ein oder mehrere H-Atome durch D, F, Cl, Br, I, CN oder $NO_2$ ersetzt sein können, ein aromatisches oder heteroaromatisches Ringsystem mit 5 bis 60 Ringatomen, das jeweils mit einem oder mehreren Resten $R^3$

substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme;
b, b1 sind jeweils unabhängig voneinander 0 oder 1;
b2 ist 0, 1, 2 oder 3;
L ist bei jedem Auftreten gleich oder verschieden ein aromatisches oder heteroaromatisches Ringsystem mit 5 bis 30 Ringatomen, das teilweise oder vollständig deuteriert sein kann;
R# ist D, F oder eine Arylgruppe mit 6 bis 20 C-Atomen, die mit einem oder mehreren Resten $R^3$ substituiert sein kann;
$Ar_2$, $Ar_3$ sind bei jedem Auftreten gleich oder verschieden ein aromatisches Ringsystem mit 6 bis 30 Ringatomen, das mit einem oder mehreren Resten $R^3$ substituiert sein kann oder ein heteroaromatisches Ringsystem mit 5 bis 30 Ringatomen, das mit einem oder mehreren Resten $R^3$ substituiert sein kann;
W ist O, S, $C(R)_2$;
R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Rinasvstem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;
$Ar_1$ ist bei jedem Auftreten gleich oder verschieden ein aromatisches oder heteroaromatisches Ringsystem mit 5 bis 30 Ringatomen, das mit einem oder mehreren Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;
$R^1$ ist bei jedem Auftreten gleich oder verschieden ausgewählt aus der Gruppe bestehend aus F, Cl, Br, I, CN, $NO_2$, $P(=O)(Ar_1)_2$, $P(Ar_1)_2$, $B(Ar_1)_2$, $Si(Ar_1)_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, wobei eine oder mehrere nicht-benachbarte $CH_2$-Gruppen durch C=S,SO, O oder S ersetzt sein können und wobei ein oder mehrere H-Atome durch D, F, Cl, Br, I, CN oder $NO_2$ ersetzt sein können;
$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinvlaruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 Ringatomen, das jeweils mit einem oder mehreren Resten $R^3$ substituiert sein kann, einer Aryloxy- oder Heteroaryloxygruppe mit 5 bis 60 Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;
$R^3$ ist bei jedem Auftreten gleich oder verschieden ausgewählt aus der Gruppe bestehend aus D, F, CN, einer geradkettigen Alkylgruppe mit 1 bis 20 C-Atomen oder einer verzweigten oder cyclischen Alkylgruppe mit 3 bis 20 C-Atomen, wobei eine oder mehrere nicht-benachbarte $CH_2$-Gruppen durch O oder S ersetzt sein können und wobei ein oder mehrere H-Atome durch D, F, oder CN ersetzt sein können oder einem aromatischen oder heteroaromatischen Ringsystem mit 5 bis 30 Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;
x, x1 sind bei jedem Auftreten unabhängig 0, 1, 2, 3 oder 4;
y, z sind jeweils unabhängig voneinander 0, 1 oder 2;
a1, a2 sind jeweils unabhängig voneinander 1, 2, 3, 4 oder 5;
a3 ist 0, 1, 2 oder 3;
a4 ist 0, 1, 2, 3 oder 4; und
a1+a2+a3+a4 ist 3, 4, 5, 6, 7, 8, 9, 10, 11, 12, 13, 14, 15, 16 oder 17.

**14.** Mischung nach Anspruch 13, **dadurch gekennzeichnet, dass** die Mischung aus mindestens einer Verbindung der Formel (1), mindestens einer Verbindung der Formel (2) und einem phosphoreszierenden Emitter besteht.

**15.** Formulierung enthaltend eine Mischung nach Anspruch 13 oder 14 sowie mindestens ein Lösemittel.

## Claims

**1.** Organic electroluminescent device comprising an anode, a cathode and at least one organic layer, comprising at least one light-emitting layer, where the at least one light-emitting layer comprises at least one compound of the formula (1) as host material 1 and at least one compound of the formula (2) as host material 2,

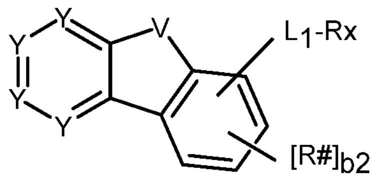

formula (1),

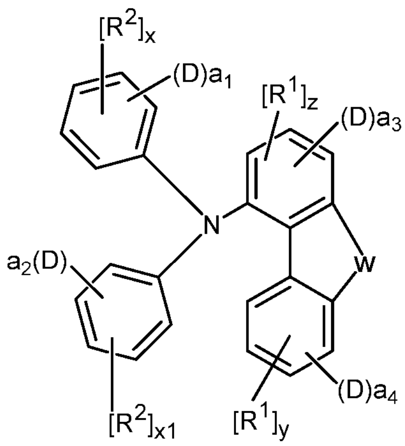

formula (2),

where the following applies to the symbols and indices used:

Y is on each occurrence, independently of one another, N, $[L]_b$-$Ar_2$ or $[L]_{b1}$-$Ar_3$, where precisely two Y stand for N, which are separated by at least one group $[L]_b$-$Ar_2$ or $[L]_{b1}$-$Ar_3$;
V is O or S;
$L_1$ is a single bond or an aromatic or heteroaromatic ring system having 5 to 30 ring atoms, which may be partially or fully deuterated;
Rx is F, Cl, Br, I, CN, $NO_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more H atoms may be replaced by D, F, Cl, Br, I, CN or $NO_2$, an aromatic or heteroaromatic ring system having 5 to 60 ring atoms, which may in each case be substituted by one or more radicals $R^3$, an aryloxy or heteroaryloxy group having 5 to 60 ring atoms, which may be substituted by one or more radicals $R^3$, or a combination of these systems;
b, b1 are in each case, independently of one another, 0 or 1;
b2 is 0, 1, 2 or 3;
L is on each occurrence, identically or differently, an aromatic or heteroaromatic ring system having 5 to 30 ring atoms, which may be partially or fully deuterated;
R# is D, F or an aryl group having 6 to 20 C atoms, which may be substituted by one or more radicals $R^3$;
$Ar_2$, $Ar_3$ are on each occurrence, identically or differently, an aromatic ring system having 6 to 30 ring atoms, which may be substituted by one or more radicals $R^3$, or a heteroaromatic ring system having 5 to 30 ring atoms, which may be substituted by one or more radicals $R^3$;
W is O, S, $C(R)_2$;
R is in each case, independently of one another, a straight-chain or branched alkyl group having 1 to 4 C atoms,

which may be partially or fully deuterated, or an unsubstituted or partially or fully deuterated aromatic ring system having 6 to 18 C atoms, where two substituents R with the C atom to which they are bonded may form a mono- or polycyclic, aliphatic or aromatic or heteroaromatic unsubstituted, partially deuterated or fully deuterated ring system, which may be substituted by one or more substituents $R^3$, with the condition that the ring system and substituents bonded thereto do not contain a carbazole group;

$Ar_1$ is on each occurrence, identically or differently, an aromatic or heteroaromatic ring system having 5 to 30 ring atoms, which may be substituted by one or more radicals $R^3$; two radicals $Ar_1$ that are bonded to the same N atom, P atom or B atom may also be bridged to one another by a single bond or a bridge selected from $C(R^3)_2$, O or S;

$R^1$ is selected on each occurrence, identically or differently, from the group consisting of F, Cl, Br, I, CN, $NO_2$, $P(=O)(Ar_1)_2$, $P(Ar_1)_2$, $B(Ar_1)_2$, $Si(Ar_1)_3$, a straight-chain alkyl, alkoxy or thioalkyl group having 1 to 20 C atoms or a branched or cyclic alkyl, alkoxy or thioalkyl group having 3 to 20 C atoms or an alkenyl group having 2 to 20 C atoms, where one or more non-adjacent $CH_2$ groups may be replaced by C=O, C=S, SO, $SO_2$, O or S and where one or more H atoms may be replaced by D, F, Cl, Br, I, CN or $NO_2$;

$R^2$ is selected on each occurrence, identically or differently, from the group consisting of F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br, I, CN or $NO_2$, an aromatic or heteroaromatic ring system having 5 to 60 ring atoms, which may in each case be substituted by one or more radicals $R^3$, an aryloxy or heteroaryloxy group having 5 to 60 ring atoms, which may be substituted by one or more radicals $R^3$, or a combination of these systems, where two or more adjacent substituents $R^2$ may optionally form a monocyclic or polycyclic, aliphatic, aromatic or heteroaromatic ring system, which may be substituted by one or more radicals $R^3$, with the condition that $R^2$ and substituents bonded thereto do not contain a carbazole group;

$R^3$ is selected on each occurrence, identically or differently, from the group consisting of D, F, CN, a straight-chain alkyl group having 1 to 20 C atoms or a branched or cyclic alkyl group having 3 to 20 C atoms, where one or more non-adjacent $CH_2$ groups may be replaced by O or S and where one or more H atoms may be replaced by D, F or CN, or an aromatic or heteroaromatic ring system having 5 to 30 ring atoms, in which one or more H atoms may be replaced by D, F, Cl, Br, I or CN, and which may be substituted by one or more alkyl groups, in each case having 1 to 4 carbon atoms; two or more adjacent substituents $R^3$ may form a mono- or polycyclic, aliphatic ring system with one another;

x, x1 are on each occurrence, independently, 0, 1, 2, 3 or 4;

y, z are in each case, independently of one another, 0, 1 or 2;

$a_1$, $a_2$ are in each case, independently of one another, 1, 2, 3, 4 or 5;

$a_3$ is 0, 1, 2 or 3;

$a_4$ is 0, 1, 2, 3 or 4; and

$a_1+a_2+a_3+a_4$ is 3, 4, 5, 6, 7, 8, 9, 10, 11, 12, 13, 14, 15, 16 or 17.

2. Organic electroluminescent device according to Claim 1, **characterised in that** host material 1 corresponds to one of the formulae (1a), (1b) or (1c),

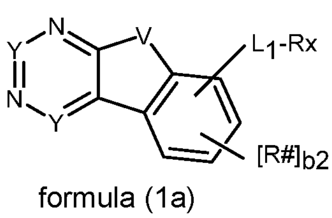

formula (1a) ,

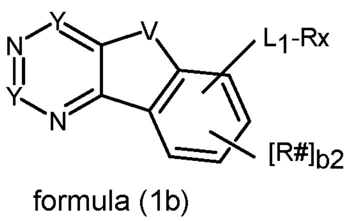

formula (1b) ,

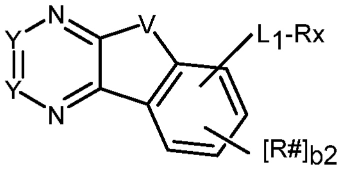

formula (1c)

,

where the symbols Y, V and $L_1$-Rx used have a meaning as in Claim 1.

**3.** Organic electroluminescent device according to Claim 1 or 2, **characterised in that** host material 2 corresponds to the formula (3),

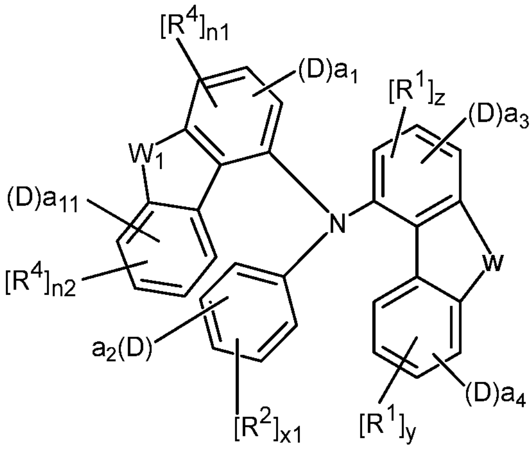

formula (3),

where W, $R^1$, $R^2$, $a_1$, $a_2$, $a_3$, $a_4$, x, y and z have a meaning indicated in Claim 1 and the following applies to the symbols and indices used:

$W_1$ is O, S or $C(R)_2$, where R has a meaning indicated in Claim 1;
$R^4$ is selected on each occurrence, identically or differently, from the group consisting of F, Cl, Br, I, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or
cyclic alkyl, alkoxy or thioalkyl group having 3 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br or I, an aromatic or heteroaromatic ring system having 5 to 60 ring atoms, which may in each case be substituted by one or more radicals $R^3$, where two or more adjacent substituents $R^4$ may optionally form a monocyclic or polycyclic, aliphatic, aromatic or heteroaromatic ring system, which may be substituted by one or more radicals $R^3$, with the condition that $R^4$ and substituents bonded thereto do not contain a carbazole group;
$a_{11}$ is 0, 1, 2, 3 or 4;
n1 is 0, 1 or 2; and
n2 is 0, 1, 2, 3 or 4.

**4.** Organic electroluminescent device according to one or more of Claims 1 to 3, **characterised in that**, in host material 1, Rx denotes an aromatic or heteroaromatic ring system having 5 to 60 ring atoms, which may in each case be substituted by one or more radicals $R^3$.

**5.** Organic electroluminescent device according to one or more of Claims 1 to 4, **characterised in that** host material 2 is fully deuterated.

**6.** Organic electroluminescent device according to one or more of Claims 1 to 5, **characterised in that** it is an electroluminescent device selected from organic light-emitting transistors (OLETs), organic field-quench devices

(OFQDs), organic light-emitting electrochemical cells (OLECs, LECs, LEECs), organic laser diodes (O-lasers) and organic light-emitting diodes (OLEDs).

**7.** Organic electroluminescent device according to one or more of Claims 1 to 6, **characterised in that**, besides the light-emitting layer (EML), it comprises a holeinjection layer (HIL), a hole-transport layer (HTL), an electron-transport layer (ETL), an electron-injection layer (EIL) and/or a hole-blocking layer (HBL).

**8.** Organic electroluminescent device according to one or more of Claims 1 to 7, **characterised in that**, besides the at least one host material 1 and the at least one host material 2, the light-emitting layer comprises at least one phosphorescent emitter.

**9.** Process for the production of a device according to one or more of Claims 1 to 8, **characterised in that** the light-emitting layer is applied by gas-phase deposition or from solution.

**10.** Process according to Claim 9, **characterised in that** the at least one compound of the formula (1) and the at least one compound of the formula (2) are deposited from the gas phase, successively or simultaneously from at least two material sources, optionally with the at least one phosphorescent emitter, and form the light-emitting layer.

**11.** Process according to Claim 9, **characterised in that** the at least one compound of the formula (1) and the at least one compound of the formula (2) are deposited from the gas phase as a mixture, successively or simultaneously with the at least one phosphorescent emitter, and form the light-emitting layer.

**12.** Process according to Claim 9, **characterised in that** the at least one compound of the formula (1) and the at least one compound of the formula (2) are applied from a solution together with the least one phosphorescent emitter in order to form the light-emitting layer.

**13.** Mixture comprising at least one compound of the formula (1) as host material 1 and at least one compound of the formula (2) as host material 2,

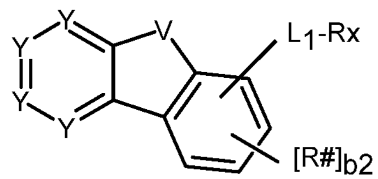

formula (1),

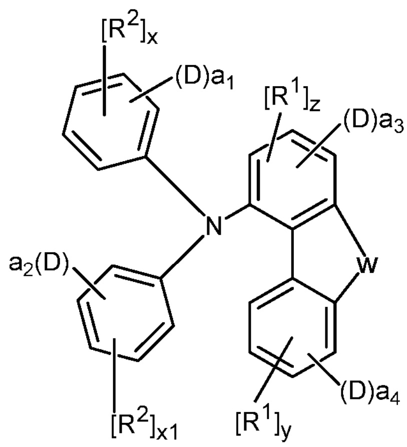

formula (2),

where the following applies to the symbols and indices used:

Y is on each occurrence, independently of one another, N, $[L]_b$-$Ar_2$ or $[L]_{b1}$-$Ar_3$, where precisely two Y stand for N, which are separated by at least one group $[L]_b$-$Ar_2$ or $[L]_{b1}$-$Ar_3$
V is O or S;
$L_1$ is a single bond or an aromatic or heteroaromatic ring system having 5 to 30 ring atoms, which may be partially

or fully deuterated;
Rx is F, Cl, Br, I, CN, $NO_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more H atoms may be replaced by D, F, Cl, Br, I, CN or $NO_2$, an aromatic or heteroaromatic ring system having 5 to 60 ring atoms, which may in each case be substituted by one or more radicals $R^3$, an aryloxy or heteroaryloxy group having 5 to 60 ring atoms, which may be substituted by one or more radicals $R^3$, or a combination of these systems;
b, b1 are in each case, independently of one another, 0 or 1;
b2 is 0, 1, 2 or 3;
L is on each occurrence, identically or differently, an aromatic or heteroaromatic ring system having 5 to 30 ring atoms, which may be partially or fully deuterated;
R# is D, F or an aryl group having 6 to 20 C atoms, which may be substituted by one or more radicals $R^3$;
$Ar_2$, $Ar_3$ are on each occurrence, identically or differently, an aromatic ring system having 6 to 30 ring atoms, which may be substituted by one or more radicals $R^3$, or a heteroaromatic ring system having 5 to 30 ring atoms, which may be substituted by one or more radicals $R^3$;
W is O, S, $C(R)_2$;
R is in each case, independently of one another, a straight-chain or branched alkyl group having 1 to 4 C atoms, which may be partially or fully deuterated, or an unsubstituted or partially or fully deuterated aromatic ring system having 6 to 18 C atoms, where two substituents R with the C atom to which they are bonded may form a mono- or polycyclic, aliphatic or aromatic or heteroaromatic unsubstituted, partially deuterated or fully deuterated ring system, which may be substituted by one or more substituents $R^3$, with the condition that the ring system and substituents bonded thereto do not contain a carbazole group;
$Ar_1$ is on each occurrence, identically or differently, an aromatic or heteroaromatic ring system having 5 to 30 ring atoms, which may be substituted by one or more radicals $R^3$; two radicals $Ar_1$ that are bonded to the same N atom, P atom or B atom may also be bridged to one another by a single bond or a bridge selected from $C(R^3)_2$, O or S;
$R^1$ is selected on each occurrence, identically or differently, from the group consisting of F, Cl, Br, I, CN, $NO_2$, $P(=O)(Ar_1)_2$, $P(Ar_1)_2$, $B(Ar_1)_2$, $Si(Ar_1)_3$, a straight-chain alkyl, alkoxy or thioalkyl group having 1 to 20 C atoms or a branched or cyclic alkyl, alkoxy or thioalkyl group having 3 to 20 C atoms or an alkenyl group having 2 to 20 C atoms, where one or more non-adjacent $CH_2$ groups may be replaced by C=O, C=S, SO, O or S and where one or more H atoms may be replaced by D, F, Cl, Br, I, CN or $NO_2$;
$R^2$ is selected on each occurrence, identically or differently, from the group consisting of F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br, I, CN or $NO_2$, an aromatic or heteroaromatic ring system having 5 to 60 ring atoms, which may in each case be substituted by one or more radicals $R^3$, an aryloxy or heteroaryloxy group having 5 to 60 ring atoms, which may be substituted by one or more radicals $R^3$, or a combination of these systems, where two or more adjacent substituents $R^2$ may optionally form a monocyclic or polycyclic, aliphatic, aromatic or heteroaromatic ring system, which may be substituted by one or more radicals $R^3$, with the condition that $R^2$ and substituents bonded thereto do not contain a carbazole group;
$R^3$ is selected on each occurrence, identically or differently, from the group consisting of D, F, CN, a straight-chain alkyl group having 1 to 20 C atoms or a branched or cyclic alkyl group having 3 to 20 C atoms, where one or more non-adjacent $CH_2$ groups may be replaced by O or S and where one or more H atoms may be replaced by D, F or CN, or an aromatic or heteroaromatic ring system having 5 to 30 ring atoms, in which one or more H atoms may be replaced by D, F, Cl, Br, I or CN and which may be substituted by one or more alkyl groups, in each case having 1 to 4 carbon atoms; two or more adjacent substituents $R^3$ may form a mono- or polycyclic, aliphatic ring system with one another;
x, x1 are on each occurrence, independently, 0, 1, 2, 3 or 4;
y, z are in each case, independently of one another, 0, 1 or 2;
$a_1$, $a_2$ are in each case, independently of one another, 1, 2, 3, 4 or 5;
$a_3$ is 0, 1, 2 or 3;
$a_4$ is 0, 1, 2, 3 or 4; and
$a_1+a_2+a_3+a_4$ is 3, 4, 5, 6, 7, 8, 9, 10, 11, 12, 13, 14, 15, 16 or 17.

14. Mixture according to Claim 13, **characterised in that** the mixture consists of at least one compound of the formula (1), at least one compound of the formula (2) and a phosphorescent emitter.

**15.** Formulation comprising a mixture according to Claim 13 or 14 and at least one solvent.

## Revendications

**1.** Dispositif électroluminescent organique comprenant une anode, une cathode et au moins une couche organique, comprenant au moins une couche émettrice de lumière, où la au moins une couche émettrice de lumière comprend au moins un composé de formule (1) comme matériau hôte 1 et au moins un composé de formule (2) comme matériau hôte 2,

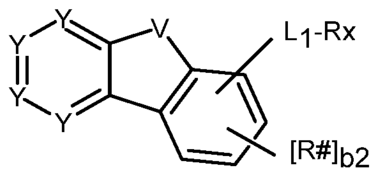

formule (1),

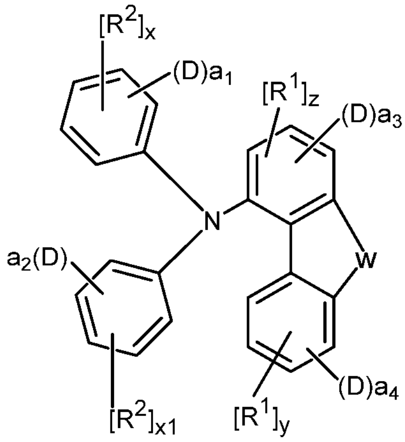

formule (2),

dans lesquelles ce qui suit s'applique aux symboles et indices utilisés :

Y est à chaque occurrence, indépendamment les uns des autres, N, $[L]_b$-$Ar_2$ ou $[L]_{b1}$-$Ar_3$, où précisément deux Y représentent N, qui sont séparés par au moins un groupement $[L]_b$-$Ar_2$ ou $[L]_{b1}$-$Ar_3$ ;
V est O ou S ;
$L_1$ est une liaison simple ou un noyau aromatique ou hétéroaromatique ayant de 5 à 30 atomes de cycle, qui peut être partiellement ou totalement deutérié ;
Rx est F, Cl, Br, I, CN, $NO_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs atomes de H peuvent être remplacés par D, F, Cl, Br, I, CN ou $NO_2$, un noyau aromatique ou hétéroaromatique ayant de 5 à 60 atomes de cycle, qui peut dans chaque cas être substitué par un ou plusieurs radicaux $R^3$, un groupement aryloxy ou hétéroaryloxy ayant de 5 à 60 atomes de cycle, qui peut être substitué par un ou plusieurs radicaux $R^3$, ou une combinaison de ces systèmes ;
b, b1 valent dans chaque cas, indépendamment l'un de l'autre, 0 ou 1 ;
b2 vaut 0, 1, 2 ou 3 ;
L est à chaque occurrence, de manière identique ou différente, un noyau aromatique ou hétéroaromatique ayant de 5 à 30 atomes de cycle qui peut être partiellement ou totalement deutérié ;
R# est D, F ou un groupement aryle ayant de 6 à 20 atomes de C, qui peut être substitué par un ou plusieurs radicaux $R^3$ ;
$Ar_2$, $Ar_3$ sont à chaque occurrence, de manière identique ou différente, un noyau aromatique ayant de 6 à 30 atomes de cycle, qui peut être substitué par un ou plusieurs radicaux $R^3$, ou un noyau hétéroaromatique ayant de 5 à 30 atomes de cycle, qui peut être substitué par un ou plusieurs radicaux $R^3$ ;
W est O, S, $C(R)_2$ ;
R est dans chaque cas, indépendamment les uns des autres, un groupement alkyle à chaîne linéaire ou ramifiée

ayant de 1 à 4 atomes de C, qui peut être partiellement ou totalement deutérié, ou un noyau aromatique non substitué ou partiellement ou totalement deutérié ayant de 6 à 18 atomes de C, où deux substituants R, conjointement avec l'atome de C auquel ils sont liés, peuvent former un noyau aliphatique ou aromatique ou hétéroaromatique, mono- ou polycyclique, non substitué, partiellement deutérié ou totalement deutérié, qui peut être substitué par un ou plusieurs substituants $R^3$, à condition que le noyau et les substituants y étant liés ne contiennent pas de groupement carbazole ;

$Ar_1$ est à chaque occurrence, de manière identique ou différente, un noyau aromatique ou hétéroaromatique ayant de 5 à 30 atomes de cycle, qui peut être substitué par un ou plusieurs radicaux $R^3$ ; deux radicaux $Ar_1$ qui sont liés au même atome de N, atome de P ou atome de B peuvent également être pontés l'un avec l'autre par une liaison simple ou un pont choisi parmi $C(R^3)_2$, O ou S ;

$R^1$ est choisi à chaque occurrence, de manière identique ou différente, dans le groupe constitué par F, Cl, Br, I, CN, $NO_2$, $P(=O)(Ar_1)_2$, $P(Ar_1)_2$, $B(Ar_1)_2$, $Si(Ar_1)_3$, un groupement alkyle, alcoxy ou thioalkyle à chaîne linéaire ayant de 1 à 20 atomes de C ou un groupement alkyle, alcoxy ou thioalkyle ramifié ou cyclique ayant de 3 à 20 atomes de C ou un groupement alcényle ayant de 2 à 20 atomes de C, où un ou plusieurs groupements $CH_2$ non adjacents peuvent être remplacés par C=O, C=S, SO, $SO_2$, O ou S et où un ou plusieurs atomes de H peuvent être remplacés par D, F, Cl, Br, I, CN ou $NO_2$ ;

$R^2$ est choisi à chaque occurrence, de manière identique ou différente, dans le groupe constitué par F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br, I, CN ou $NO_2$, un noyau aromatique ou hétéroaromatique ayant de 5 à 60 atomes de cycle, qui peut dans chaque cas être substitué par un ou plusieurs radicaux $R^3$, un groupement aryloxy ou hétéroaryloxy ayant de 5 à 60 atomes de cycle, qui peut être substitué par un ou plusieurs radicaux $R^3$, ou une combinaison de ces systèmes, où deux, ou plus, substituants $R^2$ adjacents peuvent éventuellement former un noyau aliphatique, aromatique ou hétéroaromatique, monocyclique ou polycyclique, qui peut être substitué par un ou plusieurs radicaux $R^3$, à condition que $R^2$ et les substituants y étant liés ne contiennent pas de groupement carbazole ;

$R^3$ est choisi à chaque occurrence, de manière identique ou différente, dans le groupe constitué par D, F, CN, un groupement alkyle à chaîne linéaire ayant de 1 à 20 atomes de C ou un groupement alkyle ramifié ou cyclique ayant de 3 à 20 atomes de C, où un ou plusieurs groupements $CH_2$ non adjacents peuvent être remplacés par O ou S et où un ou plusieurs atomes de H peuvent être remplacés par D, F ou CN, ou un noyau aromatique ou hétéroaromatique ayant de 5 à 30 atomes de cycle, où un ou plusieurs atomes de H peuvent être remplacés par D, F, Cl, Br, I ou CN et qui peut être substitué par un ou plusieurs groupements alkyle, dans chaque cas ayant de 1 à 4 atomes de carbone ; deux, ou plus, substituants $R^3$ adjacents peuvent former un noyau aliphatique mono- ou polycyclique les uns avec les autres ;

x, x1 valent à chaque occurrence, indépendamment, 0, 1, 2, 3 ou 4 ;

y, z valent dans chaque cas, indépendamment l'un de l'autre, 0, 1 ou 2 ;

$a_1$, $a_2$ valent dans chaque cas, indépendamment l'un de l'autre, 1, 2, 3, 4 ou 5 ;

$a_3$ vaut 0, 1, 2 ou 3 ;

$a_4$ vaut 0, 1, 2, 3 ou 4 ; et

$a_1+a_2+a_3+a_4$ vaut 3, 4, 5, 6, 7, 8, 9, 10, 11, 12, 13, 14, 15, 16 ou 17.

2. Dispositif électroluminescent organique selon la revendication 1, **caractérisé en ce que** le matériau hôte 1 correspond à l'une parmi les formules (1a), (1b) ou (1c),

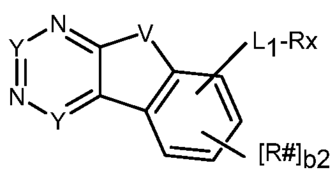

formule (1a) ,

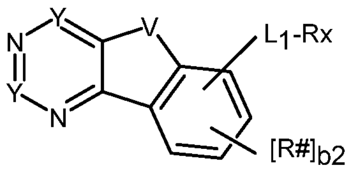

formule (1b) ,

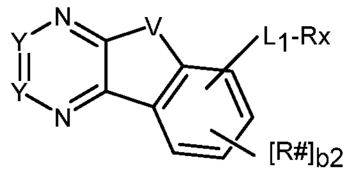

formule (1c) ,

dans lesquelles les symboles Y, V et $L_1$-Rx utilisés revêtent une signification telle que selon la revendication 1.

3. Dispositif électroluminescent organique selon la revendication 1 ou 2, **caractérisé en ce que** le matériau hôte 2 correspond à la formule (3),

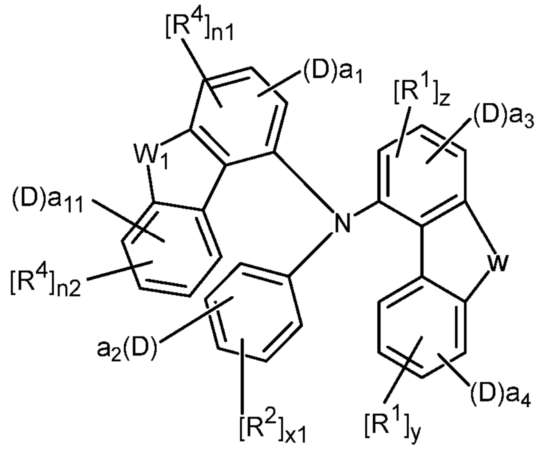

formule (3),

dans laquelle W, $R^1$, $R^2$, $a_1$, $a_2$, $a_3$, $a_4$, x, y et z revêtent une signification indiquée selon la revendication 1 et ce qui suit s'applique aux symboles et indices utilisés :

$W_1$ est O, S ou $C(R)_2$, où R revêt une signification indiquée selon la revendication 1 ;
$R^4$ est choisi à chaque occurrence, de manière identique ou différente, dans le groupe constitué par F, Cl, Br, I, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br ou I, un noyau aromatique ou hétéroaromatique ayant de 5 à 60 atomes de cycle, qui peut dans chaque cas être substitué par un ou plusieurs radicaux $R^3$, où deux, ou plus, substituants $R^4$ adjacents peuvent éventuellement former un noyau aliphatique, aromatique ou hétéroaromatique, monocyclique ou polycyclique, qui peut être substitué par un ou plusieurs radicaux $R^3$, à condition que $R^4$ et les substituants y étant liés ne contiennent pas de groupement carbazole ;
$a_{11}$ vaut 0, 1, 2, 3 ou 4 ;
n1 vaut 0, 1 ou 2 ; et
n2 vaut 0, 1, 2, 3 ou 4.

4. Dispositif électroluminescent organique selon l'une ou plusieurs parmi les revendications 1 à 3, **caractérisé en ce que**, dans le matériau hôte 1, Rx désigne un noyau aromatique ou hétéroaromatique ayant de 5 à 60 atomes de cycle, qui peut dans chaque cas être substitué par un ou plusieurs radicaux $R^3$.

5. Dispositif électroluminescent organique selon l'une ou plusieurs parmi les revendications 1 à 4, **caractérisé en ce que** le matériau hôte 2 est totalement deutérié.

6. Dispositif électroluminescent organique selon l'une ou plusieurs parmi les revendications 1 à 5, **caractérisé en ce qu'**il s'agit d'un dispositif électroluminescent choisi parmi les transistors organiques émetteurs de lumière (OLET), les

dispositifs organiques à extinction de champ (OFQD), les cellules électrochimiques organiques émettrices de lumière (OLEC, LEC, LEEC), les diodes laser organiques (O-lasers) et les diodes électroluminescentes organiques (OLED).

7. Dispositif électroluminescent organique selon l'une ou plusieurs parmi les revendications 1 à 6, **caractérisé en ce que**, outre la couche émettrice de lumière (EML), il comprend une couche d'injection de trous (HIL), une couche de transport de trous (HTL), une couche de transport d'électrons (ETL), une couche d'injection d'électrons (EIL) et/ou une couche de blocage de trous (HBL).

8. Dispositif électroluminescent organique selon l'une ou plusieurs parmi les revendications 1 à 7, **caractérisé en ce que**, outre le au moins un matériau hôte 1 et le au moins un matériau hôte 2, la couche émettrice de lumière comprend au moins un émetteur phosphorescent.

9. Procédé de production d'un dispositif selon l'une ou plusieurs parmi les revendications 1 à 8, **caractérisé en ce que** la couche émettrice de lumière est appliquée par dépôt en phase gazeuse ou à partir d'une solution.

10. Procédé selon la revendication 9, **caractérisé en ce que** le au moins un composé de formule (1) et le au moins un composé de formule (2) sont déposés à partir de la phase gazeuse successivement ou simultanément à partir d'au moins deux sources de matériau, éventuellement avec le au moins un émetteur phosphorescent, et forment la couche émettrice de lumière.

11. Procédé selon la revendication 9, **caractérisé en ce que** le au moins un composé de formule (1) et le au moins un composé de formule (2) sont déposés à partir de la phase gazeuse sous forme de mélange, successivement ou simultanément avec le au moins un émetteur phosphorescent, et forment la couche émettrice de lumière.

12. Procédé selon la revendication 9, **caractérisé en ce que** le au moins un composé de formule (1) et le au moins un composé de formule (2) sont appliqués à partir d'une solution conjointement avec le au moins un émetteur phosphorescent, afin de former la couche émettrice de lumière.

13. Mélange comprenant au moins un composé de formule (1) comme matériau hôte 1 et au moins un composé de formule (2) comme matériau hôte 2,

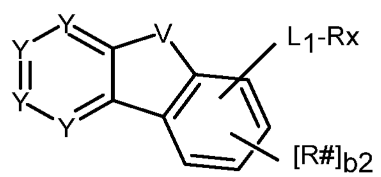

formule (1),

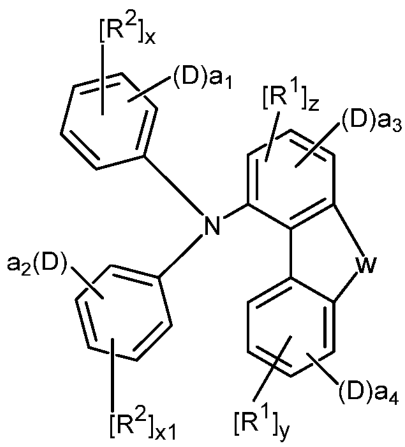

formule (2),

dans lesquelles ce qui suit s'applique aux symboles et indices utilisés :

Y est à chaque occurrence, indépendamment les uns des autres, N, $[L]_b$-$Ar_2$ ou $[L]_{b1}$-$Ar_3$, où précisément deux Y représentent N, qui sont séparés par au moins un groupement $[L]_b$-$Ar_2$ ou $[L]_{b1}$-$Ar_3$ ;

V est O ou S ;

$L_1$ est une liaison simple ou un noyau aromatique ou hétéroaromatique ayant de 5 à 30 atomes de cycle, qui peut être partiellement ou totalement deutérié ;

Rx est F, Cl, Br, I, CN, $NO_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs atomes de H peuvent être remplacés par D, F, Cl, Br, I, CN ou $NO_2$, un noyau aromatique ou hétéroaromatique ayant de 5 à 60 atomes de cycle, qui peut dans chaque cas être substitué par un ou plusieurs radicaux $R^3$, un groupement aryloxy ou hétéroaryloxy ayant de 5 à 60 atomes de cycle, qui peut être substitué par un ou plusieurs radicaux $R^3$, ou une combinaison de ces systèmes ;

b, b1 valent dans chaque cas, indépendamment l'un de l'autre, 0 ou 1 ;

b2 vaut 0, 1, 2 ou 3 ;

L est à chaque occurrence, de manière identique ou différente, un noyau aromatique ou hétéroaromatique ayant de 5 à 30 atomes de cycle qui peut être partiellement ou totalement deutérié ;

R# est D, F ou un groupement aryle ayant de 6 à 20 atomes de C, qui peut être substitué par un ou plusieurs radicaux $R^3$ ;

$Ar_2$, $Ar_3$ sont à chaque occurrence, de manière identique ou différente, un noyau aromatique ayant de 6 à 30 atomes de cycle, qui peut être substitué par un ou plusieurs radicaux $R^3$, ou un noyau hétéroaromatique ayant de 5 à 30 atomes de cycle, qui peut être substitué par un ou plusieurs radicaux $R^3$ ;

W est O, S, $C(R)_2$ ;

R est dans chaque cas, indépendamment les uns des autres, un groupement alkyle à chaîne linéaire ou ramifiée ayant de 1 à 4 atomes de C, qui peut être partiellement ou totalement deutérié, ou un noyau aromatique non substitué ou partiellement ou totalement deutérié ayant de 6 à 18 atomes de C, où deux substituants R, conjointement avec l'atome de C auquel ils sont liés, peuvent former un noyau aliphatique ou aromatique ou hétéroaromatique, mono- ou polycyclique, non substitué, partiellement deutérié ou totalement deutérié, qui peut être substitué par un ou plusieurs substituants $R^3$, à condition que le noyau et les substituants y étant liés ne contiennent pas de groupement carbazole ;

$Ar_1$ est à chaque occurrence, de manière identique ou différente, un noyau aromatique ou hétéroaromatique ayant de 5 à 30 atomes de cycle, qui peut être substitué par un ou plusieurs radicaux $R^3$ ; deux radicaux $Ar_1$ qui sont liés au même atome de N, atome de P ou atome de B peuvent également être pontés l'un avec l'autre par une liaison simple ou un pont choisi parmi $C(R^3)_2$, O ou S ;

$R^1$ est choisi à chaque occurrence, de manière identique ou différente, dans le groupe constitué par F, Cl, Br, I, CN, $NO_2$, $P(=O)(Ar_1)_2$, $P(Ar_1)_2$, $B(Ar_1)_2$, $Si(Ar_1)_3$, un groupement alkyle, alcoxy ou thioalkyle à chaîne linéaire ayant de 1 à 20 atomes de C ou un groupement alkyle, alcoxy ou thioalkyle ramifié ou cyclique ayant de 3 à 20 atomes de C ou un groupement alcényle ayant de 2 à 20 atomes de C, où un ou plusieurs groupements $CH_2$ non adjacents peuvent être remplacés par C=O, C=S, SO, O ou S et où un ou plusieurs atomes de H peuvent être remplacés par D, F, Cl, Br, I, CN ou $NO_2$ ;

$R^2$ est choisi à chaque occurrence, de manière identique ou différente, dans le groupe constitué par F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br, I, CN ou $NO_2$, un noyau aromatique ou hétéroaromatique ayant de 5 à 60 atomes de cycle, qui peut dans chaque cas être substitué par un ou plusieurs radicaux $R^3$, un groupement aryloxy ou hétéroaryloxy ayant de 5 à 60 atomes de cycle, qui peut être substitué par un ou plusieurs radicaux $R^3$, ou une combinaison de ces systèmes, où deux, ou plus, substituants $R^2$ adjacents peuvent éventuellement former un noyau aliphatique, aromatique ou hétéroaromatique, monocyclique ou polycyclique, qui peut être substitué par un ou plusieurs radicaux $R^3$, à condition que $R^2$ et les substituants y étant liés ne contiennent pas de groupement carbazole ;

$R^3$ est choisi à chaque occurrence, de manière identique ou différente, dans le groupe constitué par D, F, CN, un groupement alkyle à chaîne linéaire ayant de 1 à 20 atomes de C ou un groupement alkyle ramifié ou cyclique ayant de 3 à 20 atomes de C, où un ou plusieurs groupements $CH_2$ non

x, x1 adjacents peuvent être remplacés par O ou S et où un ou plusieurs atomes de H peuvent être remplacés par D, F ou CN, ou un noyau aromatique ou hétéroaromatique ayant de 5 à 30 atomes de cycle, où un ou plusieurs atomes de H peuvent être remplacés par D, F, Cl, Br, I ou CN et qui peut être substitué par un ou plusieurs groupements alkyle, dans chaque cas ayant de 1 à 4 atomes de carbone ; deux, ou plus, substituants $R^3$

adjacents peuvent former un noyau aliphatique mono- ou polycyclique les uns avec les autres ; valent à chaque occurrence, indépendamment, 0, 1, 2, 3 ou 4 ;
y, z valent dans chaque cas, indépendamment l'un de l'autre, 0, 1 ou 2 ;
$a_1$, $a_2$ valent dans chaque cas, indépendamment l'un de l'autre, 1, 2, 3, 4 ou 5 ;
$a_3$ vaut 0, 1, 2 ou 3 ;
$a_4$ vaut 0, 1, 2, 3 ou 4 ; et
$a_1+a_2+a_3+a_4$ vaut 3, 4, 5, 6, 7, 8, 9, 10, 11, 12, 13, 14, 15, 16 ou 17.

**14.** Mélange selon la revendication 13, **caractérisé en ce que** le mélange est constitué d'au moins un composé de formule (1), d'au moins un composé de formule (2) et d'un émetteur phosphorescent.

**15.** Formulation comprenant un mélange selon la revendication 13 ou 14 et au moins un solvant.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 17204556 A
- WO 18060307 A
- WO 19229583 A
- WO 20067657 A
- WO 18234932 A
- WO 19058200 A
- WO 19229584 A
- WO 19190101 A
- WO 19190239 A
- WO 2019059577 A
- US 2017186969 A
- WO 2015022051 A
- WO 2017148564 A
- WO 2018083053 A
- CN 112375053
- WO 2019192954 A
- WO 2021156323 A
- WO 21107728 A
- WO 2018060307 A1
- WO 2017148565 A1
- US 2021119135 A1
- US 2021028370 A1
- WO 2019007867 A
- US 7294849 B
- WO 2021107728 A


### In der Beschreibung aufgeführte Nicht-Patentliteratur


- **B. M. S. ARNOLD et al.** *Appl. Phys. Lett.*, 2008, vol. 92, 053301
- **M. L. ALLINGER** ; **H. L. FLANAGAN**. *J. Computa nationale Chem*, 1983, vol. 4 (3), 399